(19) Europäisches Patentamt
European Patent Office
Office européen des brevets

(11) EP 3 617 216 B1

(12) **EUROPEAN PATENT SPECIFICATION**

(45) Date of publication and mention of the grant of the patent:
**01.12.2021 Bulletin 2021/48**

(21) Application number: **19194318.2**

(22) Date of filing: **29.08.2019**

(51) Int Cl.:
***C07F 15/00*** *(2006.01)* ***C09K 11/06*** *(2006.01)*
***H01L 51/50*** *(2006.01)*

(54) **ORGANOMETALLIC COMPOUND, ORGANIC LIGHT-EMITTING DEVICE INCLUDING THE SAME, AND DIAGNOSTIC COMPOSITION INCLUDING THE ORGANOMETALLIC COMPOUND**

ORGANOMETALLISCHE VERBINDUNG, ORGANISCHE LICHTEMITTIERENDE VORRICHTUNG DAMIT UND DIAGNOSEZUSAMMENSETZUNG MIT DER ORGANOMETALLISCHEN VERBINDUNG

COMPOSÉ ORGANOMÉTALLIQUE, DISPOSITIF ÉLECTROLUMINESCENT ORGANIQUE LE COMPRENANT ET COMPOSITION DE DIAGNOSTIC COMPRENANT LE COMPOSÉ ORGANOMÉTALLIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **31.08.2018 KR 20180104040**
**28.08.2019 KR 20190105899**

(43) Date of publication of application:
**04.03.2020 Bulletin 2020/10**

(73) Proprietor: **Samsung Electronics Co., Ltd.**
**Gyeonggi-do 16677 (KR)**

(72) Inventors:
- **CHOI, Hyeonho**
  **16678 Gyeonggi-do (KR)**
- **HWANG, Kyuyoung**
  **16678 Gyeonggi-do (KR)**
- **KWAK, Seungyeon**
  **16678 Gyeonggi-do (KR)**
- **NAM, Youngmin**
  **16678 Gyeonggi-do (KR)**
- **LEE, Kum Hee**
  **16678 Gyeonggi-do (KR)**
- **JEON, Aram**
  **16678 Gyeonggi-do (KR)**
- **CHOI, Whail**
  **16678 Gyeonggi-do (KR)**
- **KIM, Kyungdoc**
  **16678 Gyeonggi-do (KR)**
- **YOO, Jiho**
  **16678 Gyeonggi-do (KR)**
- **CHOI, Younsuk**
  **16678 Gyeonggi-do (KR)**

(74) Representative: **Elkington and Fife LLP**
**Prospect House**
**8 Pembroke Road**
**Sevenoaks, Kent TN13 1XR (GB)**

(56) References cited:
**CN-A- 103 012 490**
**US-A1- 2016 380 216**
**US-A1- 2017 084 849**

- **DATABASE CA [Online] CHEMICAL ABSTRACTS SERVICE, COLUMBUS, OHIO, US; CHENG, CHIEN HONG ET AL: "Iridium complex for organic light emitting diode with excellent brightness and luminous efficiency", XP002796165, retrieved from STN Database accession no. 2014:1368918 & CHENG, CHIEN HONG ET AL: "Iridium complex for organic light emitting diode with excellent brightness and luminous efficiency", TAIWAN., 45PP. CODEN: TWXXA5, 2014,**

Remarks:
The file contains technical information submitted after the application was filed and not included in this specification

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



Printed by Jouve, 75001 PARIS (FR)

## Description

FIELD OF THE INVENTION

One or more embodiments relate to an organometallic compound, an organic light-emitting device including the organometallic compound, and a diagnostic composition including the organometallic compound.

BACKGROUND OF THE INVENTION

Organic light-emitting devices are self-emission devices, which have better characteristics in terms of a viewing angle, response time, brightness, driving voltage, and response speed, and produce full-color images.

In an example, an organic light-emitting device includes an anode, a cathode, and an organic layer between the anode and the cathode, wherein the organic layer includes an emission layer. A hole transport region may be between the anode and the emission layer, and an electron transport region may be between the emission layer and the cathode. Holes provided from the anode may move toward the emission layer through the hole transport region, and electrons provided from the cathode may move toward the emission layer through the electron transport region. The holes and the electrons recombine in the emission layer to produce excitons. These excitons transit from an excited state to a ground state, thereby generating light. TWi421329 and CN103012490 both disclose compounds having carbon atoms as linkers for the two ring systems.

Meanwhile, luminescent compounds may be used to monitor, sense, or detect a variety of biological materials including cells and proteins. An example of the luminescent compounds is a phosphorescent luminescent compound.

SUMMARY OF THE INVENTION

Aspects of the present disclosure provide a novel organometallic compound, an organic light-emitting device including the same, and a diagnostic composition including the organometallic compound.

Additional aspects will be set forth in part in the description which follows and, in part, will be apparent from the description, or may be learned by practice of the presented embodiments.

An aspect of the present disclosure provides an organometallic compound represented by Formula 1 below:

<Formula 1> $M(L_1)_{n1}(L_2)_{n2}$

In Formula 1,

M may be iridium (Ir), osmium (Os), titanium (Ti), hafnium (Hf), europium (Eu), rhodium (Rh), or ruthenium (Ru),
$L_1$ may be a ligand represented by Formula 2,
n1 may be 1, 2, or 3, wherein when n1 is 2 or more, two or more $L_1$(s) may be identical to or different from each other,
$L_2$ may be a monodentate ligand, a bidentate ligand, a tridentate ligand, or a tetradentate ligand,
n2 may be 0, 1, 2, 3, or 4, wherein when n2 is 2 or more, two or more $L_2$(s) may be identical to or different from each other, and
$L_1$ and $L_2$ may be different from each other,

<Formula 2>

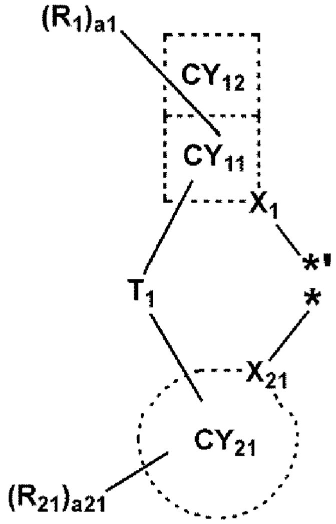

wherein, in Formula 2,

$X_1$ and $X_{21}$ may each independently be C or N,
ring $CY_{11}$, ring $CY_{12}$, and ring $CY_{21}$ may each independently be a $C_5$-$C_{30}$ carbocyclic group or a $C_1$-$C_{30}$ heterocyclic group, and ring $CY_{11}$ and ring $CY_{12}$ may be condensed with each other,
$T_1$ may be *-N($R_2$)-*', *-B($R_2$)-*', *-P($R_2$)-*', *-S-*', *-Se-*', or *-O-*',
wherein * and *' each indicate a binding site to a neighboring atom,
$R_1$ to $R_2$ and $R_{21}$ may each independently be hydrogen, deuterium, -F, -Cl, -Br, -I, - $SF_5$, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic condensed polycyclic group, a substituted or unsubstituted monovalent non-aromatic condensed heteropolycyclic group, -N($Q_1$)($Q_2$), -Si($Q_3$)($Q_4$)($Q_5$), -Ge($Q_3$)($Q_4$)($Q_5$), -B($Q_6$)($Q_7$), -P(=O)($Q_8$)($Q_9$), -P($Q_8$)($Q_9$), or any combination thereof,
a1 and a21 may each independently be an integer from 0 to 20,
two or more of a plurality of $R_1$(s) may optionally be linked to form a $C_5$-$C_{30}$ carbocyclic group that is unsubstituted or substituted with at least one $R_{10a}$ or a $C_1$-$C_{30}$ heterocyclic group that is unsubstituted or substituted with at least one $R_{10a}$,
two or more of a plurality of $R_{21}$(s) may optionally be linked to form a $C_5$-$C_{30}$ carbocyclic group that is unsubstituted or substituted with at least one $R_{10a}$ or a $C_1$-$C_{30}$ heterocyclic group that is unsubstituted or substituted with at least one $R_{10a}$,
two or more of $R_1$ to $R_2$ and $R_{21}$ may optionally be linked to form a $C_5$-$C_{30}$ carbocyclic group that is unsubstituted or substituted with at least one $R_{10a}$ or a $C_1$-$C_{30}$ heterocyclic group that is unsubstituted or substituted with at least one $R_{10a}$,
$R_{10a}$ is the same as defined in connection with $R_{21}$,
* and *' each indicate a binding site to M in Formula 1, and
a substituent(s)at least one substituent of the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_6$-$C_{60}$ aryloxy group, the substituted $C_6$-$C_{60}$ arylthio group, the substituted $C_1$-$C_{60}$ heteroaryl group, the substituted monovalent non-aromatic condensed

polycyclic group, and the substituted monovalent non-aromatic condensed heteropolycyclic group may be:

deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, or a $C_1$-$C_{60}$ alkoxy group;

a $C_1$-$C_{60}$ alkyl group, a $C_2$-$C_{60}$ alkenyl group, a $C_2$-$C_{60}$ alkynyl group, or a $C_1$-$C_{60}$ alkoxy group, each substituted with deuterium, -F, -Cl, -Br, -I, $-CD_3$, $-CD_2H$, $-CDH_2$, $-CF_3$, - $CF_2H$, $-CFH_2$, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, a monovalent non-aromatic condensed heteropolycyclic group, $-N(Q_{11})(Q_{12})$, - $Si(Q_{13})(Q_{14})(Q_{15})$, $-Ge(Q_{13})(Q_{14})(Q_{15})$, $-B(Q_{16})(Q_{17})$, $-P(=O)(Q_{18})(Q_{19})$, $-P(Q_{18})(Q_{19})$, or any combination thereof;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, or a monovalent non-aromatic condensed heteropolycyclic group, each unsubstituted or substituted with deuterium, -F, -Cl, -Br, -I, $-CD_3$, $-CD_2H$, $-CDH_2$, $-CF_3$, - $CF_2H$, $-CFH_2$, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, a monovalent non-aromatic condensed heteropolycyclic group, $-N(Q_{21})(Q_{22})$, - $Si(Q_{23})(Q_{24})(Q_{25})$, $-Ge(Q_{23})(Q_{24})(Q_{25})$, $-B(Q_{26})(Q_{27})$, $-P(=O)(Q_{28})(Q_{29})$, $-P(Q_{28})(Q_{29})$,or any combination thereof;

$-N(Q_{31})(Q_{32})$, $-Si(Q_{33})(Q_{34})(Q_{35})$, $-Ge(Q_{33})(Q_{34})(Q_{35})$, $-B(Q_{36})(Q_{37})$, $-P(=O)(Q_{38})(Q_{39})$, or $-P(Q_{38})(Q_{39})$; or any combination thereof.

In the present specification, $Q_1$ to $Q_9$, $Q_{11}$ to $Q_{19}$, $Q_{21}$ to $Q_{29}$, and $Q_{31}$ to $Q_{39}$ may each independently be hydrogen; deuterium; -F; -Cl; -Br; -I; a hydroxyl group; a cyano group; a nitro group; an amidino group; a hydrazine group; a hydrazone group; a carboxylic acid group or a salt thereof; a sulfonic acid group or a salt thereof; a phosphoric acid group or a salt thereof; a $C_1$-$C_{60}$ alkyl group unsubstituted or substituted with deuterium, a $C_1$-$C_{60}$ alkyl group, a $C_6$-$C_{60}$ aryl group, or any combination thereof; a $C_2$-$C_{60}$ alkenyl group; a $C_2$-$C_{60}$ alkynyl group; a $C_1$-$C_{60}$ alkoxy group; a $C_3$-$C_{10}$ cycloalkyl group; a $C_1$-$C_{10}$ heterocycloalkyl group; a $C_3$-$C_{10}$ cycloalkenyl group; a $C_1$-$C_{10}$ heterocycloalkenyl group; a $C_6$-$C_{60}$ aryl group unsubstituted or substituted with deuterium, a $C_1$-$C_{60}$ alkyl group, a $C_6$-$C_{60}$ aryl group, or any combination thereof; a $C_6$-$C_{60}$ aryloxy group; a $C_6$-$C_{60}$ arylthio group; a $C_7$-$C_{60}$ arylalkyl group; a $C_1$-$C_{60}$ heteroaryl group; a $C_1$-$C_{60}$ heteroaryloxy group; a $C_1$-$C_{60}$ heteroarylthio group; a $C_2$-$C_{60}$ heteroarylalkyl group; a monovalent non-aromatic condensed polycyclic group; or a monovalent non-aromatic condensed heteropolycyclic group.

Another aspect of the present disclosure provides an organic light-emitting device including: a first electrode; a second electrode; and an organic layer disposed between the first electrode and the second electrode and including an emission layer, wherein the organic layer includes at least one organometallic compound.

In the emission layer in the organic layer, the at least one organometallic compound may serve as a dopant.

Another aspect of the present disclosure provides a diagnostic composition including at least one organometallic compound represented by Formula 1.

## BRIEF DESCRIPTION OF THE DRAWING

These and/or other aspects will become apparent and more readily appreciated from the following description of the embodiments, taken in conjunction with FIGURE which is a schematic view of an organic light-emitting device according to an embodiment.

## DETAILED DESCRIPTION OF THE EMBODIMENTS

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly,

the embodiments are merely described below, by referring to the figures, to explain aspects of the present description. As used herein, the term "and/or" includes any and all combinations of one or more of the associated listed items. Expressions such as "at least one of," when preceding a list of elements, modify the entire list of elements and do not modify the individual elements of the list.

An aspect of the present disclosure provides an organometallic compound represented by Formula 1 below:

<Formula 1> $M(L_1)_{n1}(L_2)_{n2}$

In Formula 1, M may be iridium (Ir), osmium (Os), titanium (Ti), hafnium (Hf), europium (Eu), rhodium (Rh), or ruthenium (Ru).

For example, M may be Ir, but embodiments of the present disclosure are not limited thereto.

In Formula 1, $L_1$ may be a ligand represented by Formula 2:

<Formula 2>

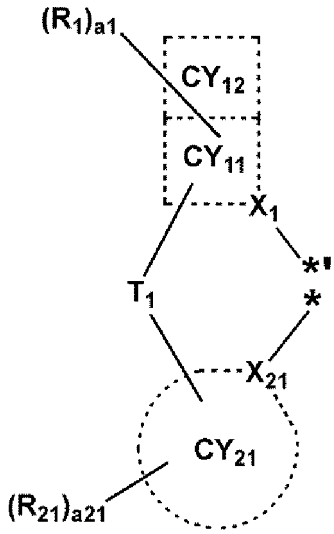

Formula 2 will be understood by referring to a detailed description thereof provided below.

In Formula 1, n1 indicates the number of $L_1$(s), and may be 1, 2, or 3. When n1 is 2 or more, two or more $L_1$(s) may be identical to or different from each other.

In Formula 1, $L_2$ may be a monodentate ligand, a bidentate ligand, a tridentate ligand, or a tetradentate ligand. $L_2$ will be understood by referring to a detailed description thereof provided below.

In Formula 1, n2 indicates the number of $L_2$(s), and may be 0, 1, 2, 3, or 4. When n2 is 2 or more, two or more $L_2$(s) may be identical to or different from each other.

In Formula 1, $L_1$ and $L_2$ may be different from each other. Thus, when n2 in Formula 1 is not 0, the organometallic compound represented by Formula 1 may be a heteroleptic complex.

In one embodiment, in Formula 1, i) M may be Ir or O, and the sum of n1 and n2 may be 3 or 4; or ii) M may be Pt, and the sum of n1 and n2 may be 2.

In one or more embodiments, n2 in Formula 1 may be 1 or 2.

In Formula 2, $X_1$ and $X_{21}$ may each independently be C or N.

For example, $X_1$ may be N, and $X_{21}$ may be C, but embodiments of the present disclosure are not limited thereto.

In Formula 2, a bond between $X_1$ and M in Formula 1 may be a coordinate bond, and a bond between $X_{21}$ and M in Formula 1 may be a covalent bond. In this regard, the organometallic compound represented by Formula 1 may be electrically neutral.

In Formula 2, ring $CY_{11}$, ring $CY_{12}$, and ring $CY_{21}$ may each independently be a $C_5$-$C_{30}$ carbocyclic group or a $C_1$-$C_{30}$ heterocyclic group. Ring $CY_{11}$ and ring $CY_{12}$ may be condensed with each other.

For example, ring $CY_{11}$, ring $CY_{12}$, and ring $CY_{21}$ may each independently be i) a first ring, ii) a second ring, iii) a condensed ring in which two or more first rings are condensed with each other, iv) a condensed ring in which two or more second rings are condensed with each other, or v) a condensed ring in which one or more first rings are condensed with one or more second rings.

The first ring may be a cyclopentane group, a cyclopentadiene group, a furan group, a thiophene group, a pyrrole group, a silole group, an indene group, a benzofuran group, a benzothiophene group, an indole group, a benzosilole group, an oxazole group, an isoxazole group, an oxadiazole group, an isozadiazole group, an oxatriazole group, an isoxatriazole group, a thiazole group, an isothiazole group, a thiadiazole group, an isothiadiazole group, a thiatriazole group, an isothiatriazole group, a pyrazole group, an imidazole group, a triazole group, a tetrazole group, an azasilole group, a diazasilole group, or a triazasilole group.

The second ring may be an admantane group, a norbornane group, a norbornene group, a bicyclo[1.1.1]pentane group, a bicyclo[2.1.1]hexane group, a bicyclo[2.2.1]heptane group, a bicyclo[2.2.2]octane group, a cyclohexane group, a cyclohexene group, a benzene group, a pyridine group, a pyrimidine group, a pyrazine group, a pyridazine group, or a triazine group.

In one embodiment, ring $CY_{11}$, ring $CY_{12}$, and ring $CY_{21}$ may each independently be a cyclopentene group, a cyclohexene group, a benzene group, a naphthalene group, an anthracene group, a phenanthrene group, a triphenylene group, a pyrene group, a chrysene group, a 1,2,3,4-tetrahydronaphthalene group, a pyrrole group, a borole group, a phosphole group, a cyclopentadiene group, a silole group, a germole group, a thiophene group, a selenophene group, a furan group, an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluorene-9-one group, a dibenzothiophene 5,5-dioxide group, an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluorene-9-one group, an azadibenzothiophene 5,5-dioxide group, a pyridine group, a pyrimidine group, a pyrazine group, a pyridazine group, a triazine group, a quinoline group, an isoquinoline group, a benzoquinoline group, a benzoisoquinoline group, a quinoxaline group, a quinazoline group, a phenanthroline group, a pyrazole group, an imidazole group, a triazole group, an azaborole group, an azaphosphole group, an azacyclopentadiene group, an azasilole group, an azagermole group, an azaselenophene group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, or a 5,6,7,8-tetrahydroquinoline group, but embodiments of the present disclosure are not limited thereto.

In one embodiment, ring $CY_{11}$ may be a pyridine group, a quinoline group, an isoquinoline group, a benzoquinoline group, or a benzoisoquinoline group; and/or ring $CY_{12}$ may be a benzene group, a naphthalene group, a phenanthrene group, a pyrrole group, a borole group, a phosphole group, a cyclopentadiene group, a silole group, a germole group, a thiophene group, a selenophene group, a furan group, a pyrazole group, an imidazole group, an azaborole group, an azaphosphole group, an azacyclopentadiene group, an azasilole group, an azagermole group, an azaselenophene group, an oxazole group, an isooxazole group, a thiazole group, or an isothiazole group; and/or ring $CY_{21}$ may be a benzene group, a pyridine group, a pyrimidine group, a naphthalene group, a fluorene group, a carbazole group, a dibenzofuran group, a dibenzothiophene group, or dibenzosilole group, but embodiments of the present disclosure are not limited thereto.

In Formula 2, $T_1$ may be *-N($R_2$)-*', *-B($R_2$)-*', *-P($R_2$)-*', *-S-*', *-Se-*', or *-O-*', wherein * and *' each indicate a binding site to a neighboring atom. $R_2$ and $R_3$ will be understood by referring to a detailed description thereof provided below. $R_2$ and $R_3$ may optionally, be linked via a single bond, a double bond, *-N($R_4$)-*', *-B($R_4$)-*', *-P($R_4$)-*', *-C($R_4$)($R_5$)-*', *-Si($R_4$)($R_5$)-*', *-Ge($R_4$)($R_5$)-*', *-S-*', *-Se-*', *-O-*', *-C(=O)-*', *-S(=O)-*', *-S(=O)$_2$-*', *-C($R_4$)=*', *=C($R_4$)-*', *-C($R_4$)=C($R_5$)-*', *-C(=S)-*', or *-C≡C-*' to form a $C_5$-$C_{30}$ carbocyclic group that is unsubstituted or substituted with at least one $R_{10a}$ or a $C_1$-$C_{30}$ heterocyclic group that is unsubstituted or substituted with at least one $R_{10a}$. $R_{10a}$ is the same as defined in connection with $R_{21}$. The $C_5$-$C_{30}$ carbocyclic group and the $C_1$-$C_{30}$ heterocyclic group are each the same as defined in connection with ring $CY_{21}$.

In one embodiment, $T_1$ in Formula 2 may be *-O-*'. $R_1$ to $R_2$ and $R_{21}$ may each independently be hydrogen, deuterium, -F, -Cl, -Br, -I, - $SF_5$, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic condensed polycyclic group, a substituted or unsubstituted monovalent non-aromatic condensed heteropolycyclic group, -N($Q_1$)($Q_2$), -Si($Q_3$)($Q_4$)($Q_5$), -Ge($Q_3$)($Q_4$)($Q_5$), -B($Q_6$)($Q_7$), -P(=O)($Q_8$)($Q_9$), or

$-P(Q_8)(Q_9)$, wherein $Q_1$ to $Q_9$ will be understood by referring to a detailed description thereof provided below.

In one embodiment, $R_1$ to $R_2$ and $R_{21}$ may each independently be:

hydrogen, deuterium, -F, -Cl, -Br, -I, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, $-SF_5$, $C_1$-$C_{20}$ alkyl group, or a $C_1$-$C_{20}$ alkoxy group;

a $C_1$-$C_{20}$ alkyl group and a $C_1$-$C_{20}$ alkoxy group, each substituted with deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group, a cyclopentyl group, a cyclohexyl group, a cycloheptyl group, a cyclooctyl group, an adamantyl group, a norbornyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a ($C_1$-$C_{20}$ alkyl)cyclopentyl group, a ($C_1$-$C_{20}$ alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantanyl group, a ($C_1$-$C_{20}$ alkyl)norbornanyl group, a ($C_1$-$C_{20}$ alkyl)norbornenyl group, a ($C_1$-$C_{20}$ alkyl)cyclopentenyl group, a ($C_1$-$C_{20}$ alkyl)cyclohexenyl group, a ($C_1$-$C_{20}$ alkyl)cycloheptenyl group, a ($C_1$-$C_{20}$ alkyl)bicyclo[1.1.1]pentyl group, a ($C_1$-$C_{20}$ alkyl)bicyclo[2.1.1]hexyl group, a ($C_1$-$C_{20}$ alkyl)bicyclo[2.2.1]heptyl group, a ($C_1$-$C_{20}$ alkyl)bicyclo[2.2.2]octyl group, a phenyl group, a ($C_1$-$C_{20}$ alkyl)phenyl group, a biphenyl group, a terphenyl group, a naphthyl group, a pyridinyl group, a pyrimidinyl group, or any combination thereof;

a cyclopentyl group, a cyclohexyl group, a cycloheptyl group, a cyclooctyl group, an adamantyl group, a norbornyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a phenyl group, a ($C_1$-$C_{20}$ alkyl)phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, or an azadibenzothiophenyl group, each unsubstituted or substituted with deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a deuterium-containing $C_2$-$C_{20}$ alkyl group, a $C_1$-$C_{20}$ alkoxy group, a cyclopentyl group, a cyclohexyl group, a cycloheptyl group, a cyclooctyl group, an adamantyl group, a norbornyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a ($C_1$-$C_{20}$ alkyl)cyclopentyl group, a ($C_1$-$C_{20}$ alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantanyl group, a ($C_1$-$C_{20}$ alkyl)norbornanyl group, a ($C_1$-$C_{20}$ alkyl)norbornenyl group, a ($C_1$-$C_{20}$ alkyl)cyclopentenyl group, a ($C_1$-$C_{20}$ alkyl)cyclohexenyl group, a ($C_1$-$C_{20}$ alkyl)cycloheptenyl group, a ($C_1$-$C_{20}$ alkyl)bicyclo[1.1.1]pentyl group, a ($C_1$-$C_{20}$ alkyl)bicyclo[2.1.1]hexyl group, a ($C_1$-$C_{20}$ alkyl)bicyclo[2.2.1]heptyl group, a ($C_1$-$C_{20}$ alkyl)bicyclo[2.2.2]octyl group, a phenyl group, a ($C_1$-$C_{20}$ alkyl)phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, or any combination thereof; or

$-N(Q_1)(Q_2)$, $-Si(Q_3)(Q_4)(Q_5)$, $-Ge(Q_3)(Q_4)(Q_5)$, $-B(Q_6)(Q_7)$, $-P(=O)(Q_8)(Q_9)$, or $-P(Q_8)(Q_9)$, and

$Q_1$ to $Q_9$ may each independently be: $-CH_3$, $-CD_3$, $-CD_2H$, $-CDH_2$, $-CH_2CH_3$, $-CH_2CD_3$, $-CH_2CD_2H$, $-CH_2CDH_2$, $-CHDCH_3$, $-CHDCD_2H$, $-CHDCDH_2$, $-CHDCD_3$, $-CD_2CH_3$, $-CD_2CD_3$, $-CD_2CD_2H$, or $-CD_2CDH_2$; or

an n-propyl group, an iso-propyl group, an n-butyl group, a sec-butyl group, an isobutyl group, a tert-butyl group, an n-pentyl group, a tert-pentyl group, a neo-pentyl group, an iso-pentyl group, a sec-pentyl group, a 3-pentyl group, a sec-iso-pentyl group, a phenyl group, a biphenyl group or a naphthyl group, each unsubstituted or substituted with deuterium, a $C_1$-$C_{10}$ alkyl group, a phenyl group, or any combination thereof,

but embodiments of the present disclosure are not limited thereto.

In one or more embodiments, $R_1$ to $R_3$ and $R_{21}$ may each independently be hydrogen, deuterium, -F, a cyano group, a nitro group, $-SF_5$, $-CH_3$, $-CD_3$, $-CD_2H$, $-CDH_2$, - $CF_3$, $-CF_2H$, $-CFH_2$, a group represented by one of Formulae 9-1 to 9-66, a group represented by one of Formulae 9-1 to 9-66 in which at least one hydrogen is substituted with deuterium, a group represented by one of Formulae 10-1 to 10-118, a group represented by one of Formulae 10-1 to 10-118 in which at least one hydrogen is substituted with deuterium, a group represented by one of Formulae 10-201 to 10-342, a group represented by one of Formulae 10-201 to 10-342 in which at least one hydrogen is substituted with deuterium, $-Si(Q_3)(Q_4)(Q_5)$, or $-Ge(Q_3)(Q_4)(Q_5)$ (wherein detailed descriptions of $Q_3$ to $Q_5$ are the same as described above), but embodiments of the present disclosure are not limited thereto:

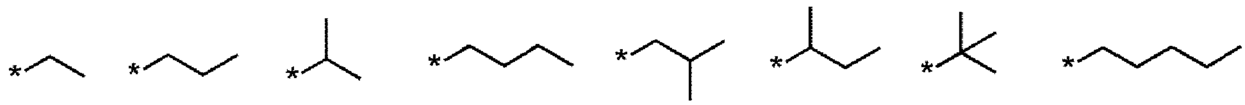

9-1 9-2 9-3 9-4 9-5 9-6 9-7 9-8

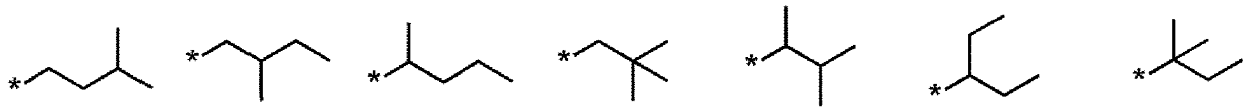

9-9 9-10 9-11 9-12 9-13 9-14 9-15

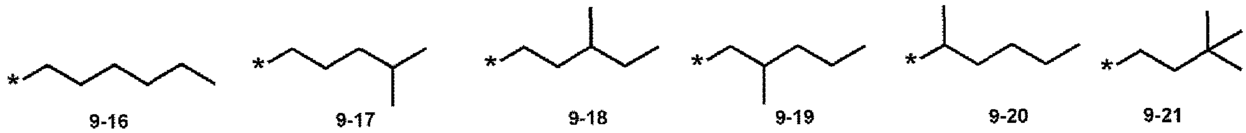

9-16 9-17 9-18 9-19 9-20 9-21

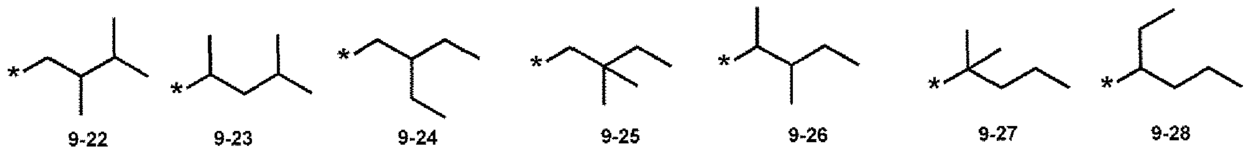

9-22 9-23 9-24 9-25 9-26 9-27 9-28

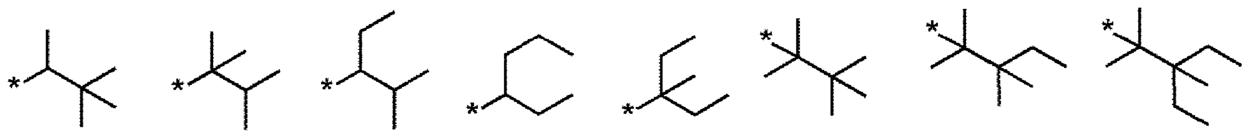

9-29 9-30 9-31 9-32 9-33 9-34 9-35 9-36

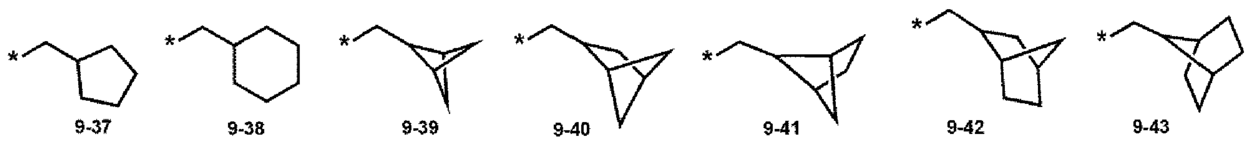

9-37 9-38 9-39 9-40 9-41 9-42 9-43

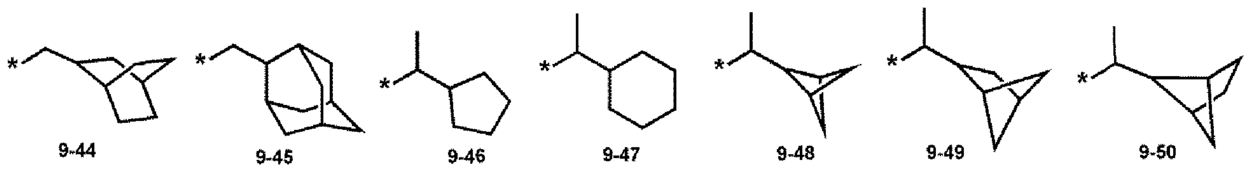

9-44 9-45 9-46 9-47 9-48 9-49 9-50

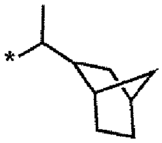
9-51
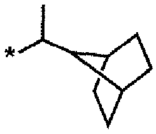
9-52
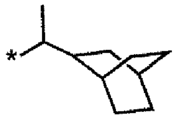
9-53
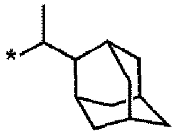
9-54
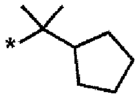
9-55
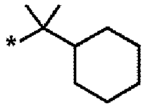
9-56
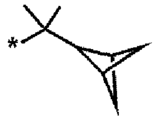
9-57

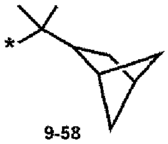
9-58
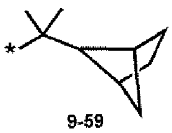
9-59
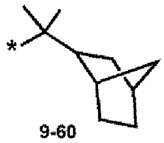
9-60
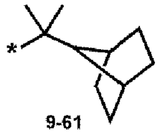
9-61
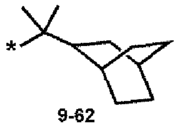
9-62
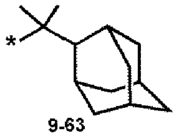
9-63
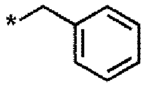
9-64

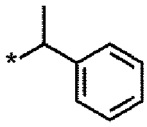
9-65
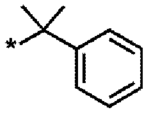
9-66

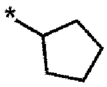
10-1
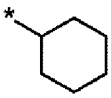
10-2
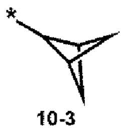
10-3
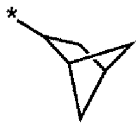
10-4
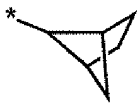
10-5
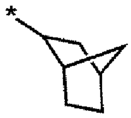
10-6
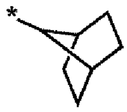
10-7
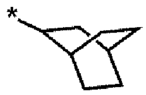
10-8

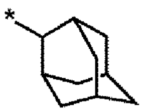
10-9
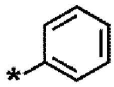
10-10
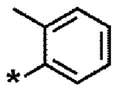
10-11
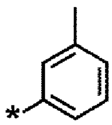
10-12
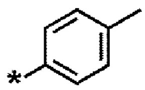
10-13
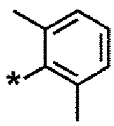
10-14
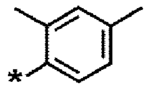
10-15
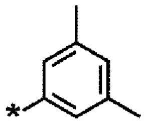
10-16

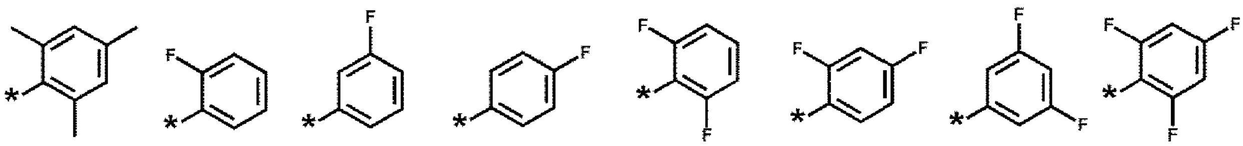
10-17 10-18 10-19 10-20 10-21 10-22 10-23 10-24

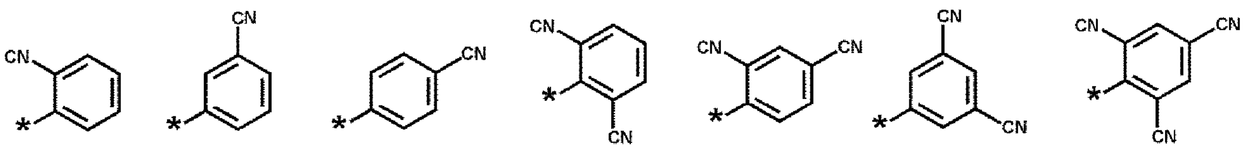
10-25 10-26 10-27 10-28 10-29 10-30 10-31

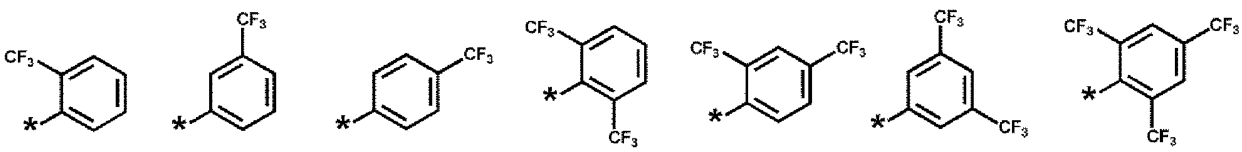
10-32 10-33 10-34 10-35 10-36 10-37 10-38

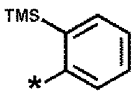
10-39
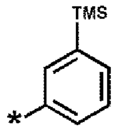
10-40
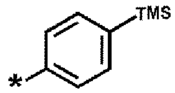
10-41
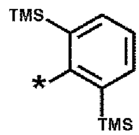
10-42
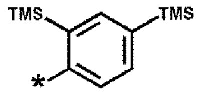
10-43
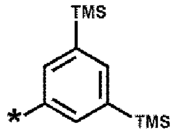
10-44
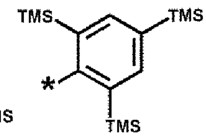
10-45

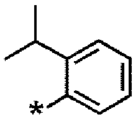
10-46
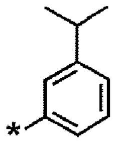
10-47
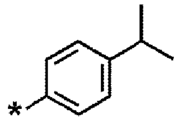
10-48
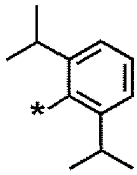
10-49
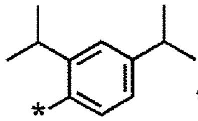
10-50
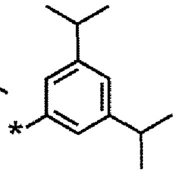
10-51
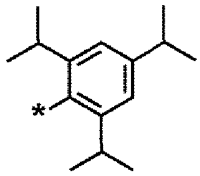
10-52

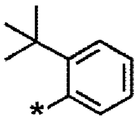
10-53
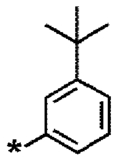
10-54
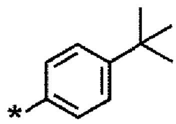
10-55
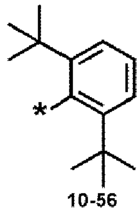
10-56
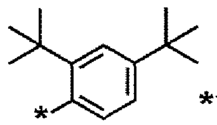
10-57
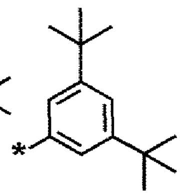
10-58
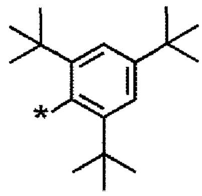
10-59

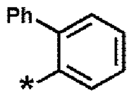
10-60
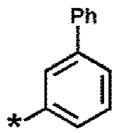
10-61
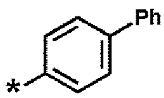
10-62
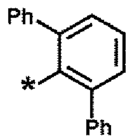
10-63
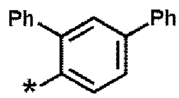
10-64
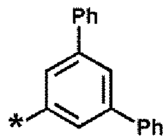
10-65
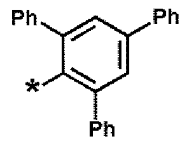
10-66

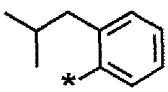
10-67
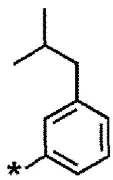
10-68
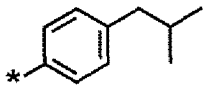
10-69
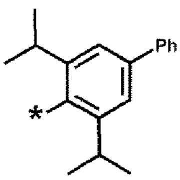
10-70
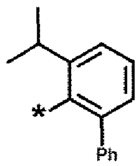
10-71
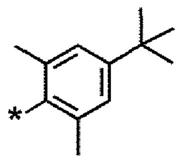
10-72

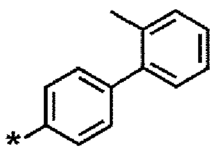
10-73
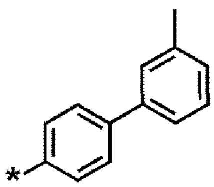
10-74
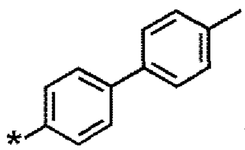
10-75
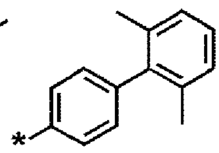
10-76
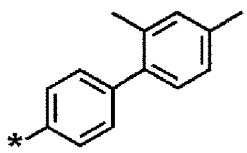
10-77

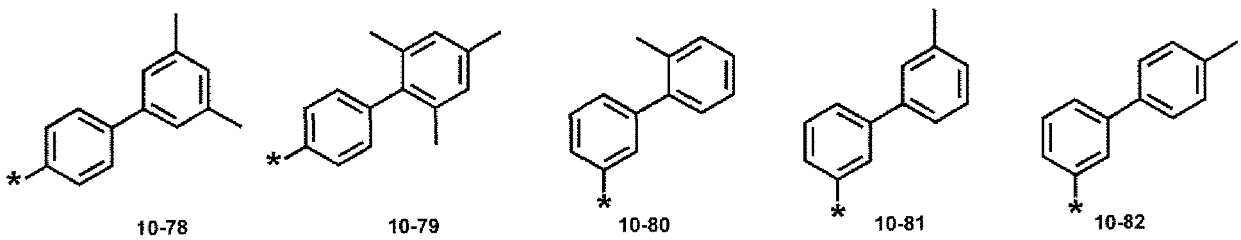
10-78
10-79
10-80
10-81
10-82

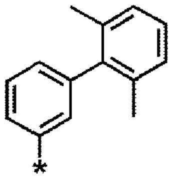
10-83
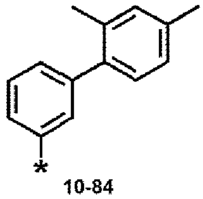
10-84
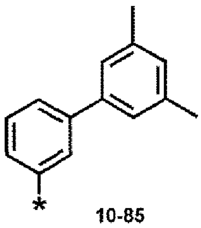
10-85
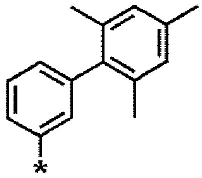
10-86
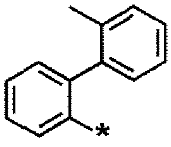
10-87
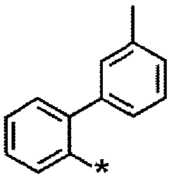
10-88

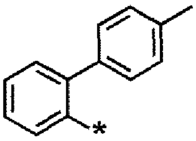
10-89
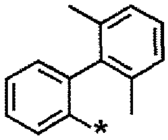
10-90
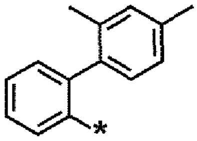
10-91
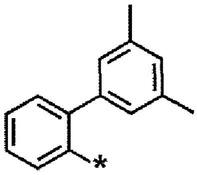
10-92
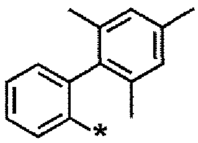
10-93
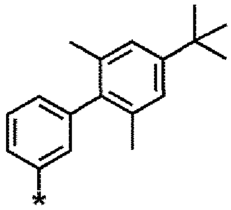
10-94

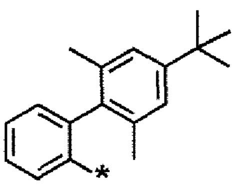
10-95
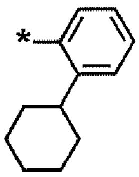
10-96
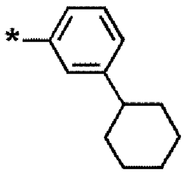
10-97
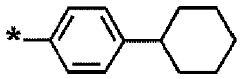
10-98
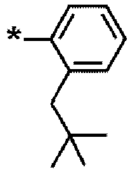
10-99
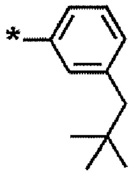
10-100

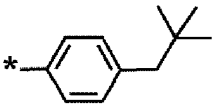
10-101
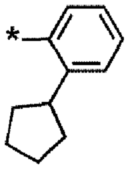
10-102
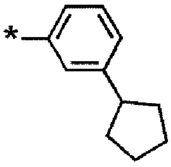
10-103
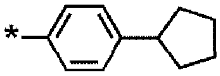
10-104
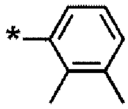
10-105
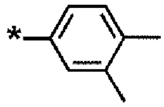
10-106

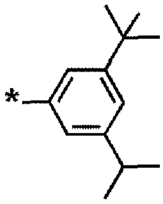
10-107
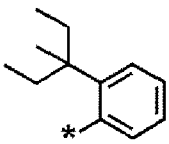
10-108
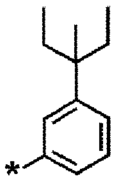
10-109
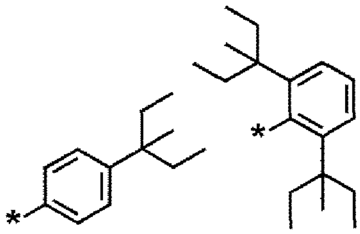
10-110
10-111
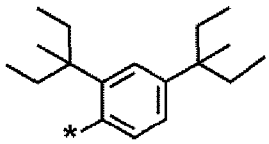
10-112

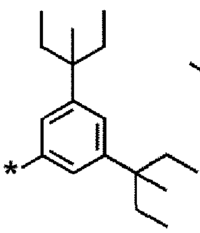
10-113
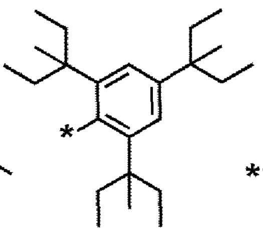
10-114
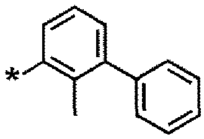
10-115
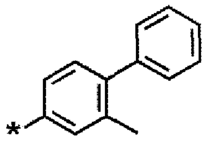
10-116
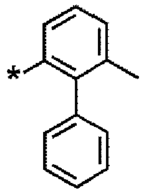
10-117
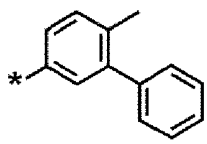
10-118

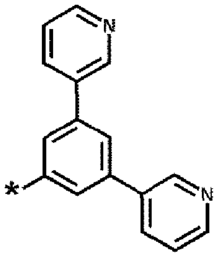 10-201
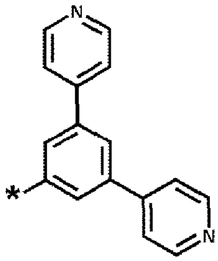 10-202
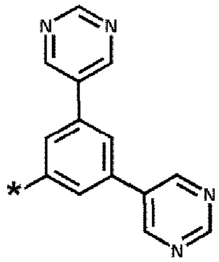 10-203
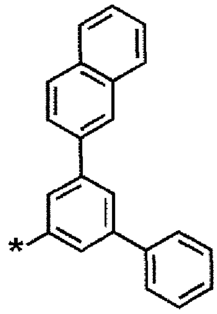 10-204
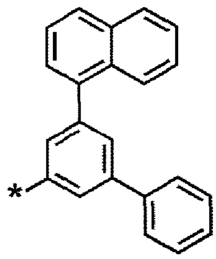 10-205

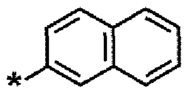 10-206
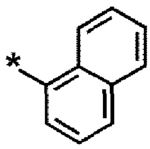 10-207
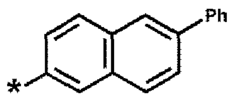 10-208
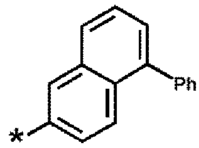 10-209
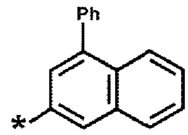 10-210

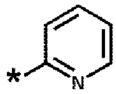 10-211
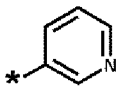 10-212
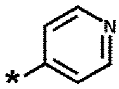 10-213
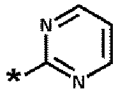 10-214
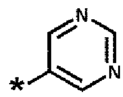 10-215
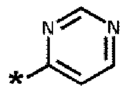 10-216
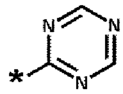 10-217

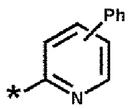 10-218
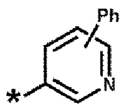 10-219
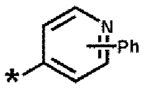 10-220
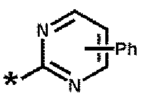 10-221
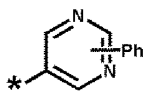 10-222
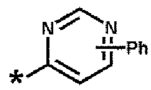 10-223
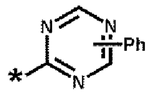 10-224

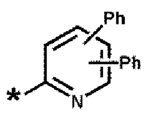 10-225
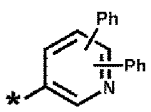 10-226
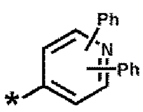 10-227
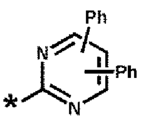 10-228
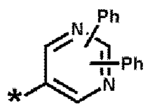 10-229
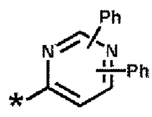 10-230
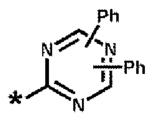 10-231

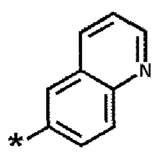 10-232
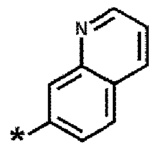 10-233
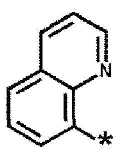 10-234
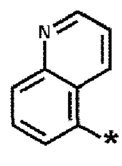 10-235
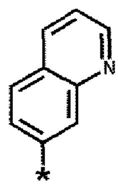 10-236
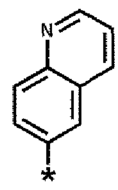 10-237

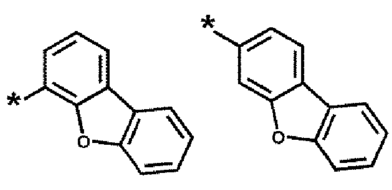 10-238 10-239
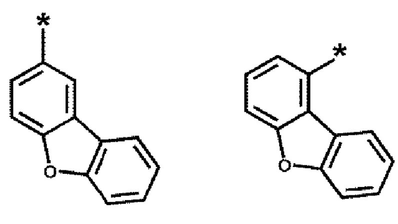 10-240 10-241
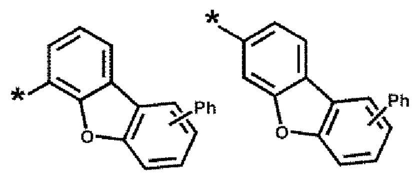 10-242 10-243

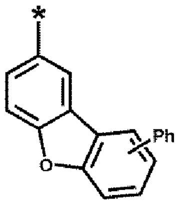
10-244

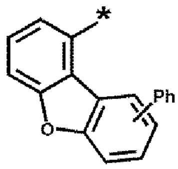
10-245

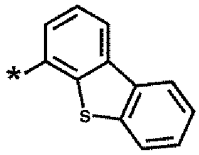
10-246

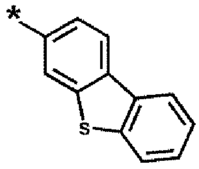
10-247

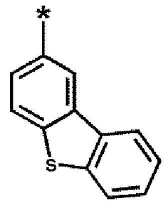
10-248

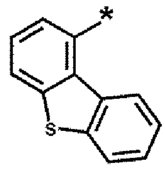
10-249

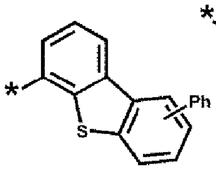
10-250

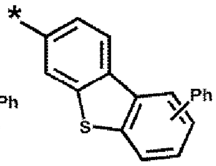
10-251

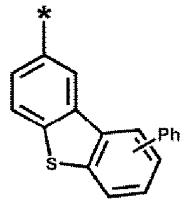
10-252

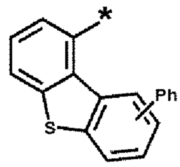
10-253

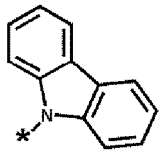
10-254

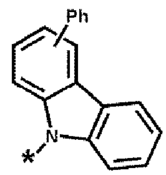
10-255

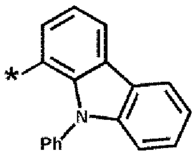
10-256

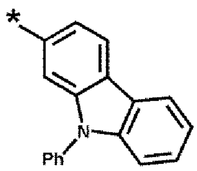
10-257

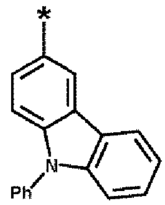
10-258

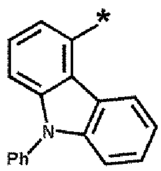
10-259

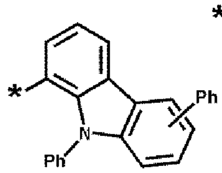
10-260

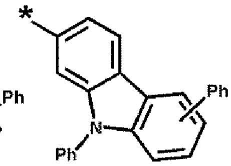
10-261

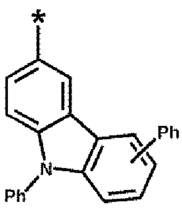
10-262

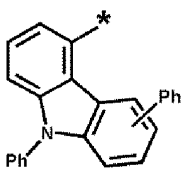
10-263

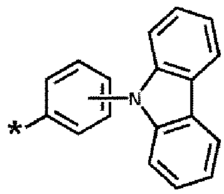
10-264

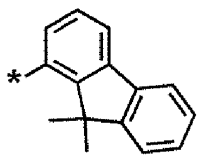
10-265

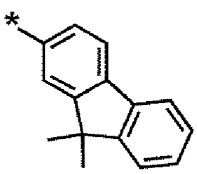
10-266

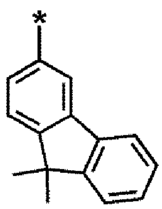
10-267

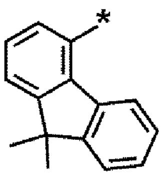
10-268

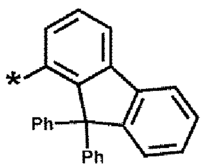
10-269

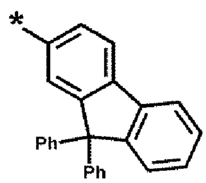
10-270

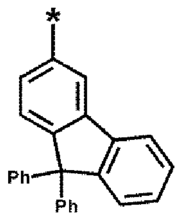
10-271

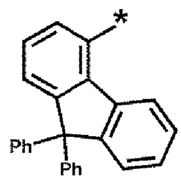
10-272

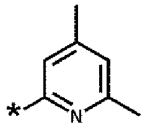
10-273

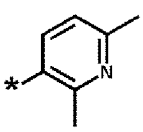
10-274

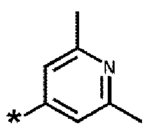
10-275

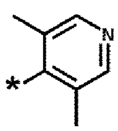
10-276

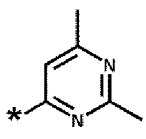
10-277

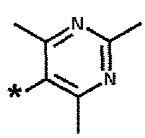
10-278

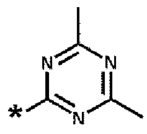
10-279

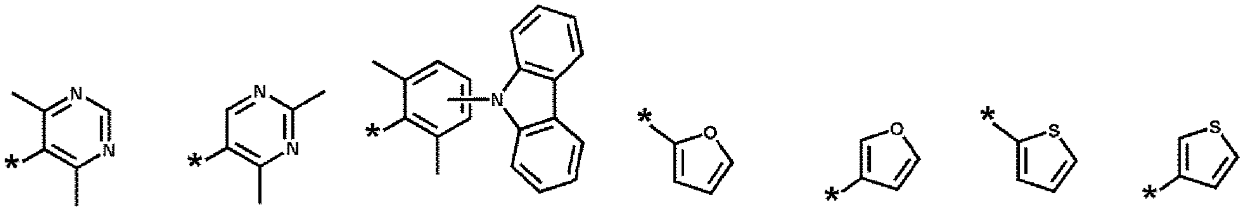

10-280 10-281 10-282 10-283 10-284 10-285 10-286

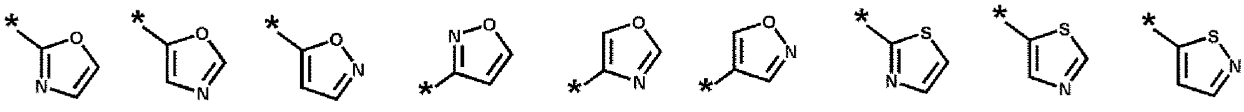

10-287 10-288 10-289 10-290 10-291 10-292 10-293 10-294 10-295

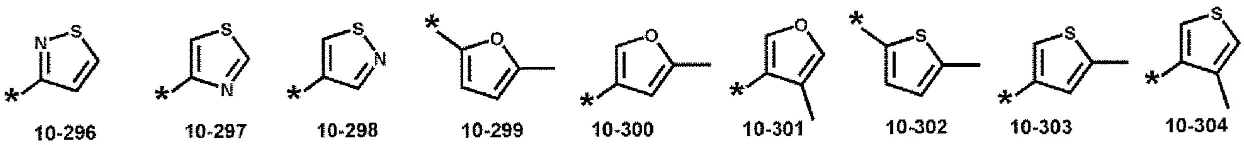

10-296 10-297 10-298 10-299 10-300 10-301 10-302 10-303 10-304

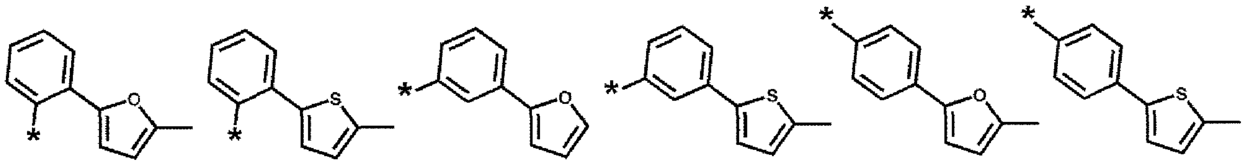

10-305 10-306 10-307 10-308 10-309 10-310

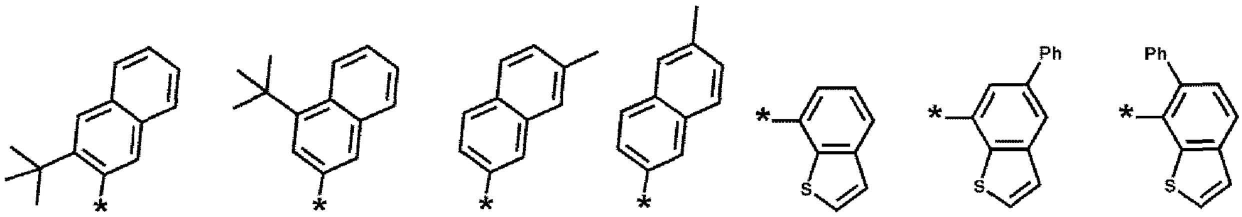

10-311 10-312 10-313 10-314 10-315 10-316 10-317

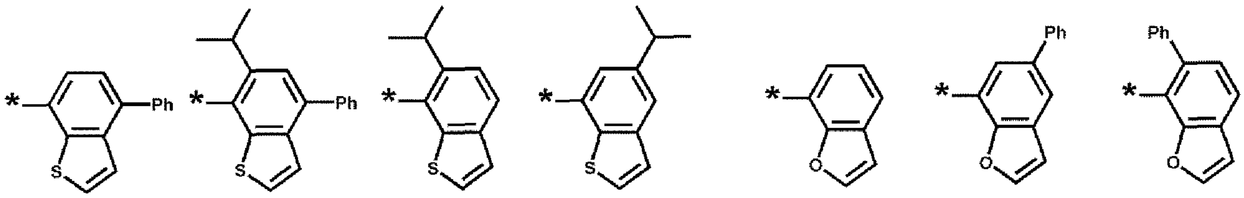

10-318 10-319 10-320 10-321 10-322 10-323 10-324

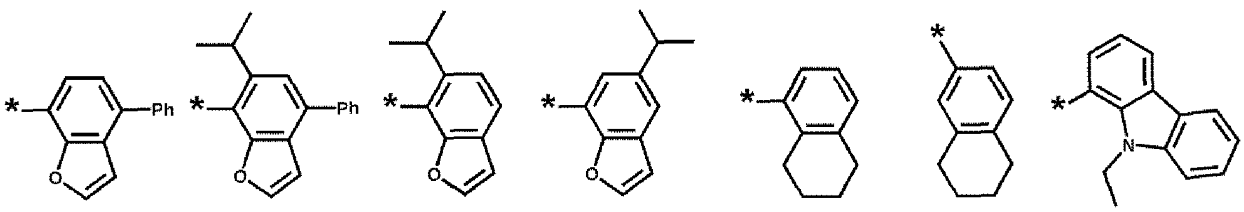

10-325 10-326 10-327 10-328 10-329 10-330 10-331

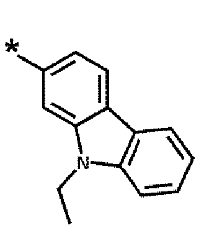 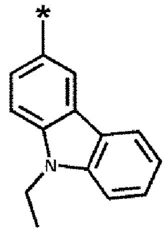 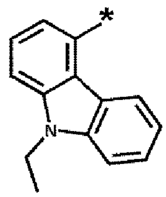 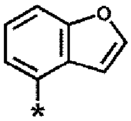 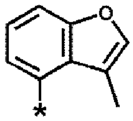 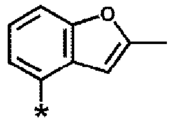

10-332 10-333 10-334 10-335 10-336 10-337

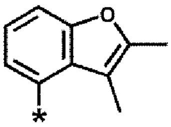 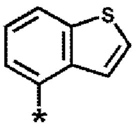 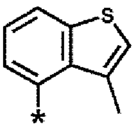 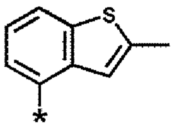 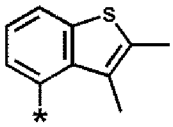

10-338 10-339 10-340 10-341 10-342

In Formulae 9-1 to 9-66, 10-1 to 10-118 and 10-201 to 10-342, * indicates a binding site to a neighboring atom, Ph indicates a phenyl group, or TMS indicates a trimethylsilyl group.

For example, Formula 9-33 may be a branched $C_6$ alkyl group and a tert-butyl group substituted with two methyl groups.

The "group represented by one of Formulae 9-1 to 9-66 in which at least one hydrogen is substituted with deuterium" may be, for example, a group represented by one of Formulae 9-501 to 9-514 and 9-601 to 9-638:

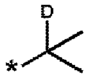 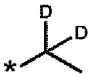 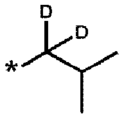 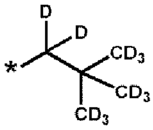 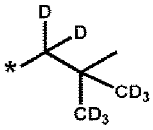 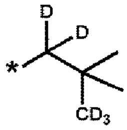 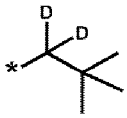

9-501 9-502 9-503 9-504 9-505 9-506 9-507

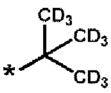 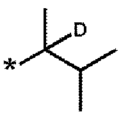 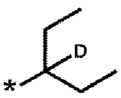 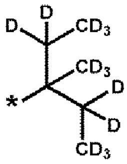 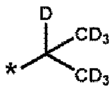 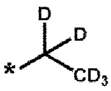 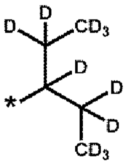

9-508 9-509 9-510 9-511 9-512 9-513 9-514

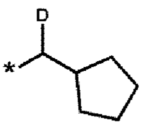 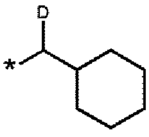 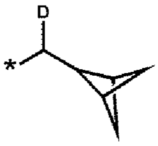 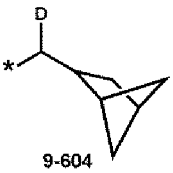 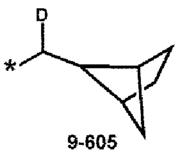 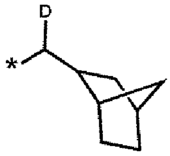 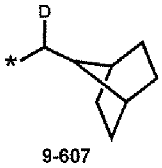

9-601 9-602 9-603 9-604 9-605 9-606 9-607

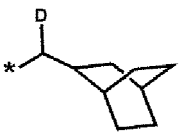 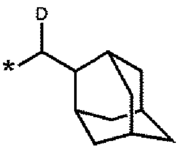 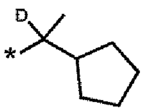 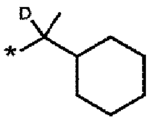 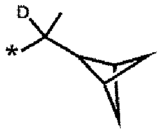 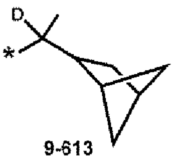

9-608 9-609 9-610 9-611 9-612 9-613

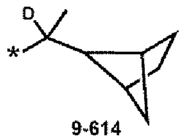
9-614

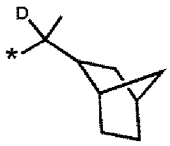
9-615

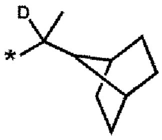
9-616

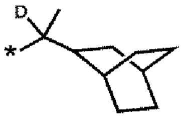
9-617

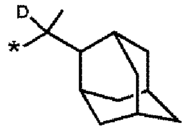
9-618

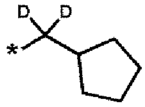
9-619

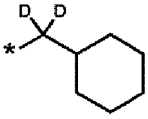
9-620

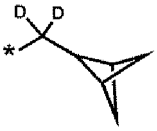
9-621

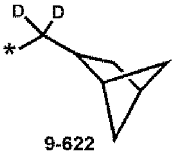
9-622

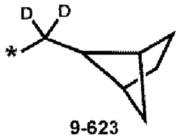
9-623

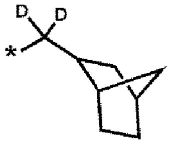
9-624

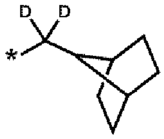
9-625

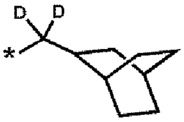
9-626

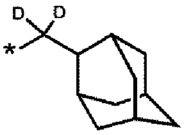
9-627

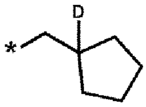
9-628

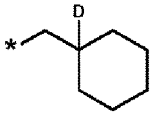
9-629

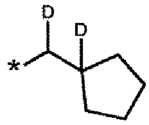
9-630

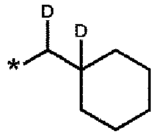
9-631

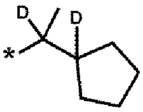
9-632

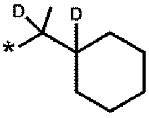
9-633

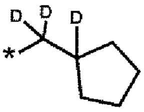
9-634

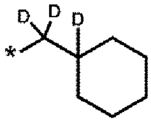
9-635

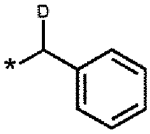
9-636

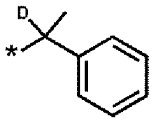
9-637

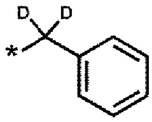
9-638 .

The "group represented by one of Formulae 10-1 to 10-118 in which at least one hydrogen is substituted with deuterium" may be, for example, a group represented by one of Formulae 10-501 to 10-546:

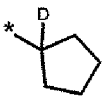
10-501

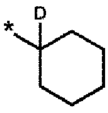
10-502

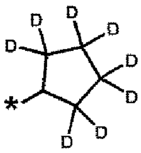
10-503

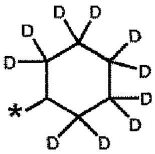
10-504

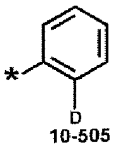
10-505

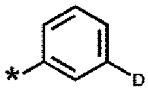
10-506

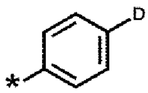
10-507

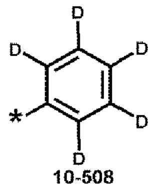
10-508

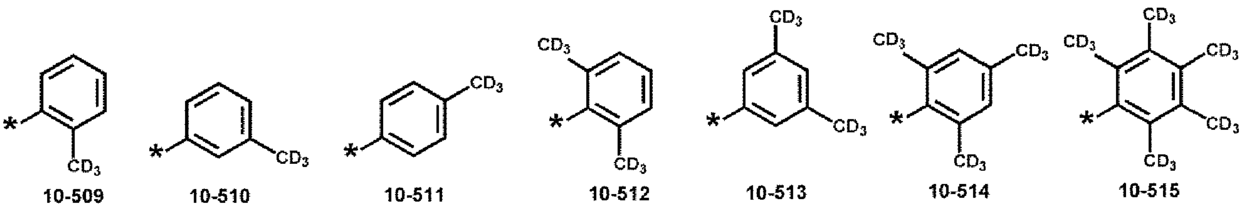
10-509 10-510 10-511 10-512 10-513 10-514 10-515

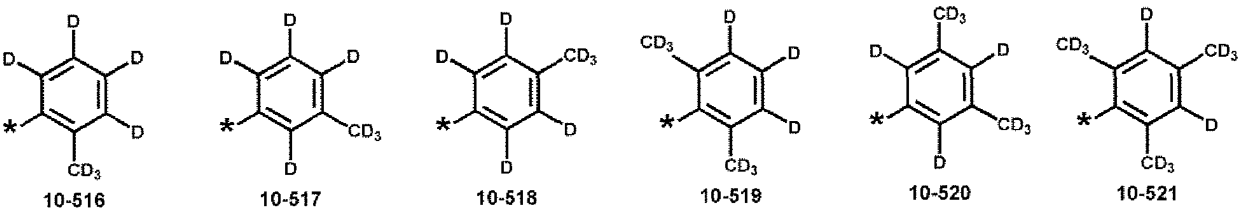
10-516 10-517 10-518 10-519 10-520 10-521

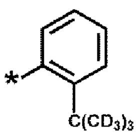 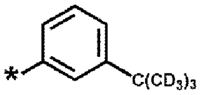 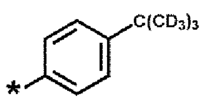 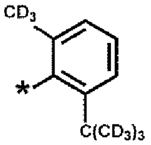 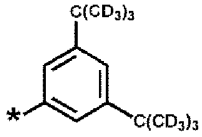 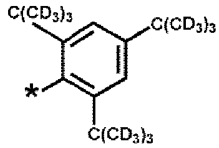

10-522 10-523 10-524 10-525 10-526 10-527

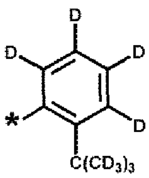 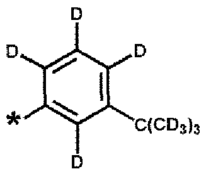 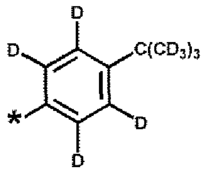 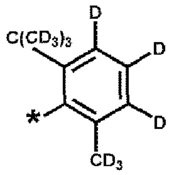 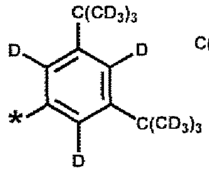 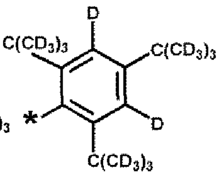

10-528 10-529 10-530 10-531 10-532 10-533

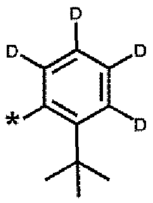 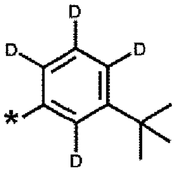 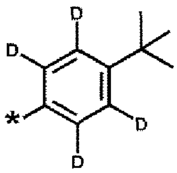 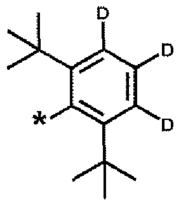 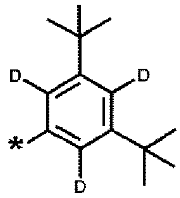 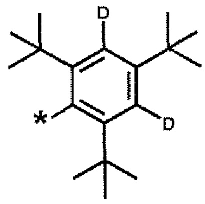

10-534 10-535 10-536 10-537 10-538 10-540

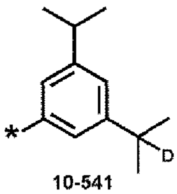 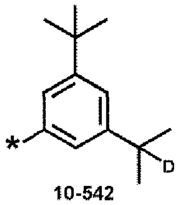 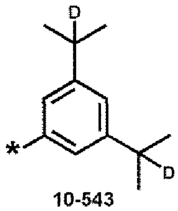 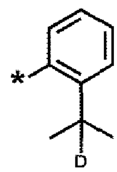 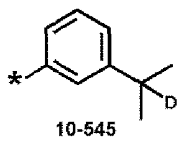 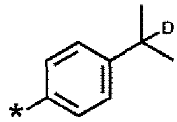

10-541 10-542 10-543 10-544 10-545 10-546

In Formula 2, a1 and a21 each indicate the number of $R_1$(s) and the number of $R_{21}$(s), respectively, and may each independently be an integer from 0 to 20. When a1 is 2 or more, two or more $R_1$(s) may be identical to or different from each other, and when a21 is 2 or more, two or more $R_{21}$(s) may be identical to or different from each other. For example, a1 and a21 may each independently be an integer from 0 to 10, but embodiments of the present disclosure are not limited thereto.

In one embodiment, i) two or more of a plurality of $R_1$(s) in Formula 2 may optionally be linked to form a $C_5$-$C_{30}$ carbocyclic group that is unsubstituted or substituted with at least one $R_{10a}$ or a $C_1$-$C_{30}$ heterocyclic group that is unsubstituted or substituted with at least one $R_{10a}$, ii) two or more of a plurality of $R_{21}$(s) in Formula 2 may optionally be linked to form a $C_5$-$C_{30}$ carbocyclic group that is unsubstituted or substituted with at least one $R_{10a}$ or a $C_1$-$C_{30}$ heterocyclic group that is unsubstituted or substituted with at least one $R_{10a}$, or iii) two or more of $R_1$ to $R_3$ and $R_{21}$ in Formula 2 may optionally be linked to form a $C_5$-$C_{30}$ carbocyclic group that is unsubstituted or substituted with at least one $R_{10a}$ or a $C_1$-$C_{30}$ heterocyclic group that is unsubstituted or substituted with at least one $R_{10a}$. Here, "a $C_5$-$C_{30}$ carbocyclic group that is unsubstituted or substituted with at least one $R_{10a}$ or a $C_1$-$C_{30}$ heterocyclic group that is unsubstituted or substituted with at least one $R_{10a}$" may be, for example, an admantane group, a norbornane group, a norbornene group, a bicyclo[1.1.1]pentane group, a bicyclo[2.1.1]hexane group, a bicyclo[2.2.1]heptane group, a bicyclo[2.2.2]octane group, a cyclopentane group, a cyclohexane group, a cycloheptane group, a cyclopentene group, a cyclohexene group, a cycloheptene group, a benzene group, a naphthalene group, an anthracene group, a phenanthrene group, a triphenylene group, a pyrene group, a chrysene group, a 1,2,3,4-tetrahydronaphthalene group, a pyrrole group, a borole group, a phosphole group, a cyclopentadiene group, a silole group, a germole group, a thiophene group, a selenophene group, a furan group, an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluorene-9-one group, a dibenzothiophene 5,5-dioxide group, an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluorene-9-one group, an azadibenzothiophene 5,5-dioxide group, a pyridine group, a pyrimidine group, a pyrazine group, a pyridazine group, a triazine group, a quinoline group, an isoquinoline group, a benzoquinoline group, a benzoisoquinoline group, a quinoxaline group, a quinazoline group, a phenanthroline group, a pyrazole group, an imidazole group, a triazole group, an azaborole group, an azaphosphole group, an azacyclopentadiene group, an azasilole group, an azagermole group, an azaselenophene group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, or a 5,6,7,8-tetrahydroquinoline group, each unsubstituted or substituted with at least one $R_{10a}$.

Non-limiting examples of the $C_1$-$C_{60}$ alkyl group, the $C_1$-$C_{20}$ alkyl group, and/or the $C_1$-$C_{10}$ alkyl group include a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, or a tert-decyl group, each unsubstituted or substituted with a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, or any combination thereof, and the like, but embodiments of the present disclosure are not limited thereto.

Non-limiting examples of the $C_1$-$C_{60}$ alkoxy group, $C_1$-$C_{20}$ alkoxy group and/or $C_1$-$C_{10}$ alkoxy group include a methoxy group, an ethoxy group, a propoxy group, a buoxy group, or a pentoxy group, and the like, but embodiments of the present disclosure are not limited thereto.

Non-limiting examples of the $C_3$-$C_{10}$ cycloalkyl group include a cyclopropyl group, a cyclobutyl group, a cyclopentyl group, a cyclohexyl group, a cycloheptyl group, a cyclooctyl group, an adamantanyl group, a norbornanyl group, a bicyclo[1.1.1]pentyl group, a bicyclo[2.1.1]hexyl group, a bicyclo[2.2.1]heptyl group, a bicyclo[2.2.2]octyl group, and the like, but embodiments of the present disclosure are not limited thereto.

In Formula 2, * and *' each indicate a binding site to M in Formula 1.

In one embodiment, a group represented by

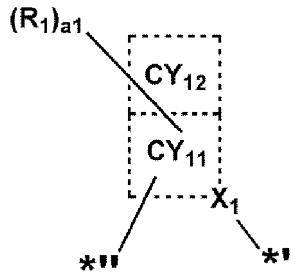

in Formula 2 may be a group represented by one of Formulae CY1-1 to CY1-69:

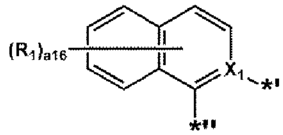

CY1-1

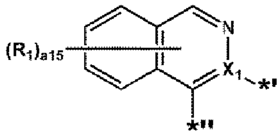

CY1-2

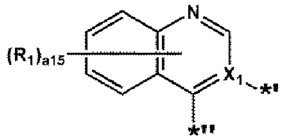

CY1-3

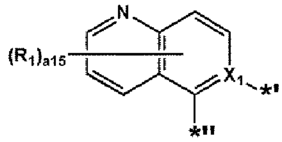

CY1-4

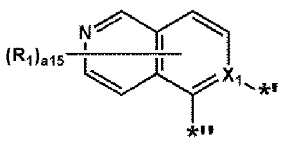
CY1-5

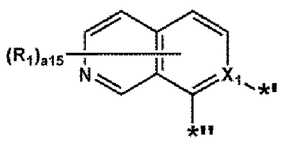
CY1-6

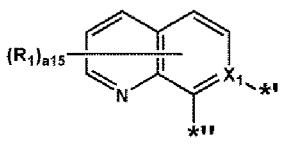
CY1-7

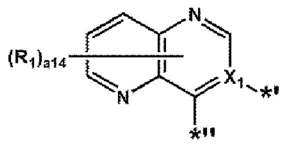
CY1-8

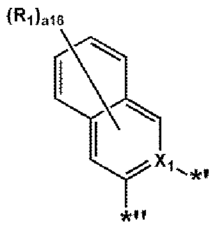
CY1-9

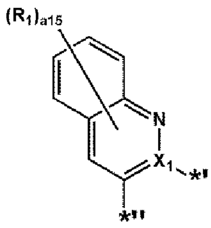
CY1-10

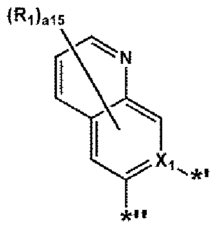
CY1-11

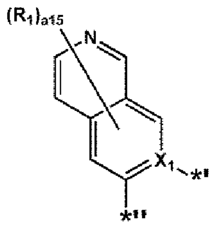
CY1-12

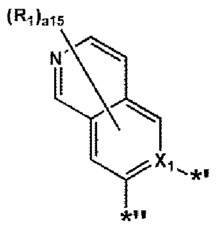
CY1-13

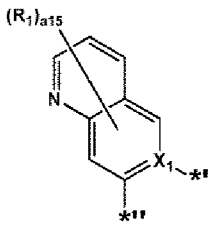
CY1-14

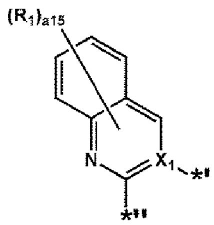
CY1-15

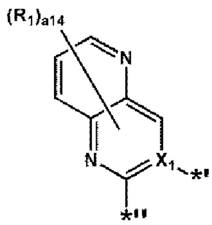
CY1-16

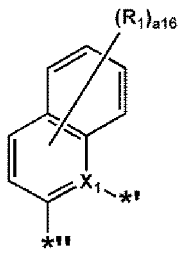
CY1-17

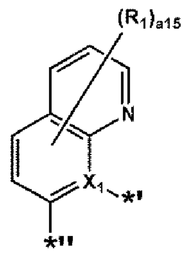
CY1-18

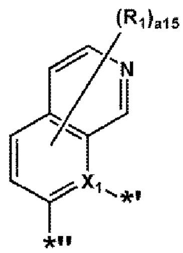
CY1-19

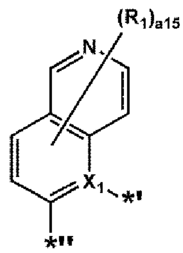
CY1-20

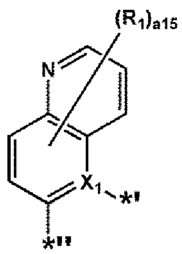
CY1-21

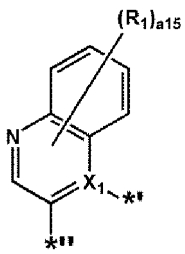
CY1-22

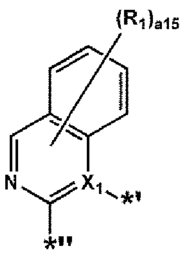
CY1-23

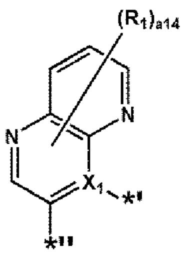
CY1-24

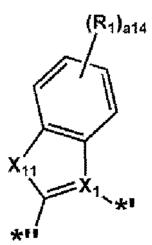
CY1-25

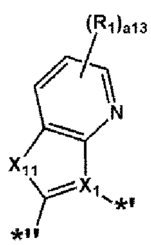
CY1-26

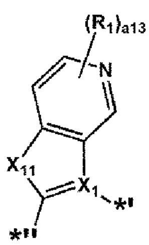
CY1-27

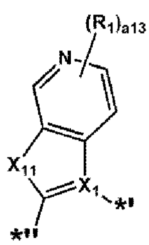
CY1-28

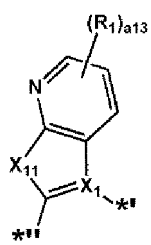
CY1-29

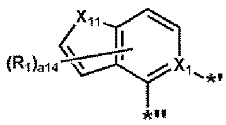
CY1-30

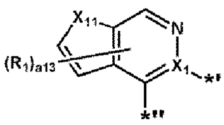
CY1-31

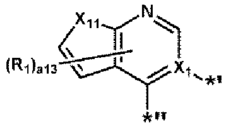
CY1-32

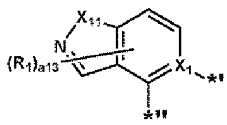
CY1-33

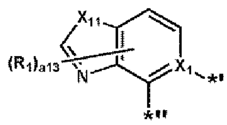
CY1-34

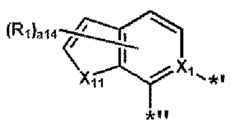
CY1-35

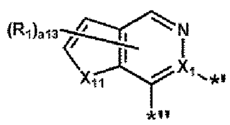
CY1-36

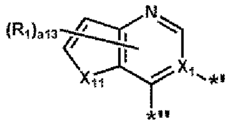
CY1-37

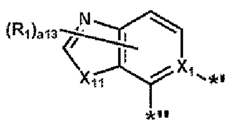
CY1-38

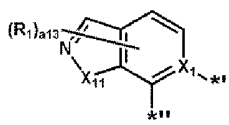
CY1-39

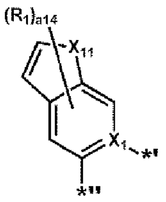
CY1-40

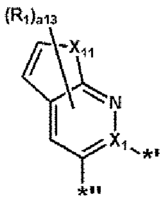
CY1-41

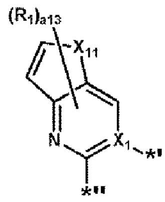
CY1-42

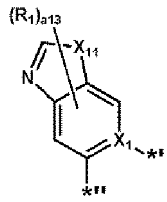
CY1-43

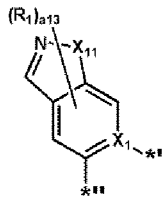
CY1-44

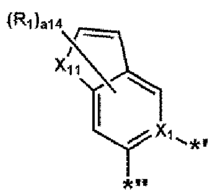
CY1-45

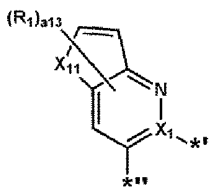
CY1-46

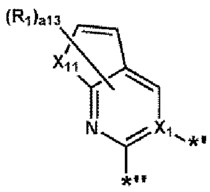
CY1-47

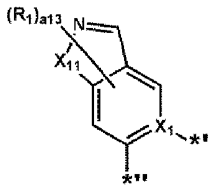
CY1-48

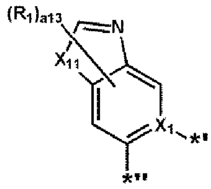
CY1-49

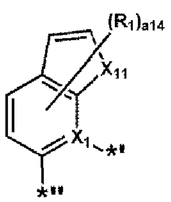
CY1-50

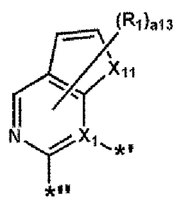
CY1-51

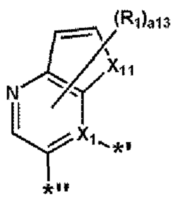
CY1-52

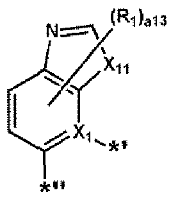
CY1-53

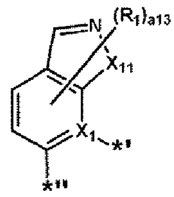
CY1-54

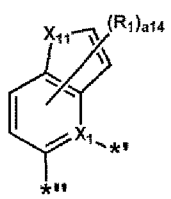
CY1-55

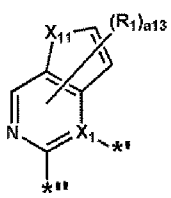
CY1-56

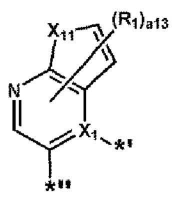
CY1-57

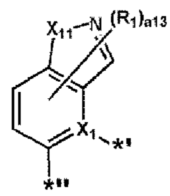
CY1-58

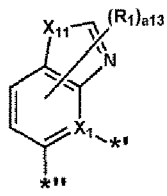
CY1-59

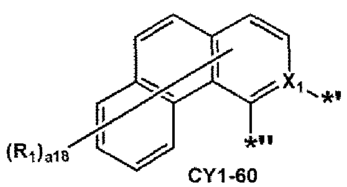
CY1-60

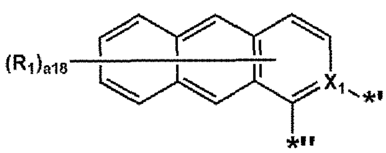
CY1-61

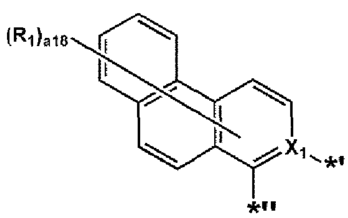
CY1-62

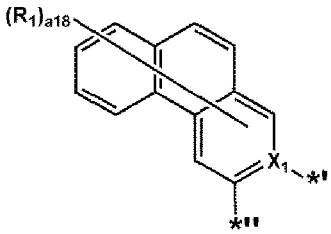

CY1-63

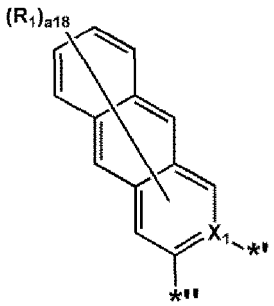

CY1-64

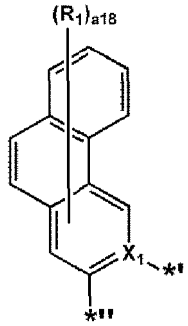

CY1-65

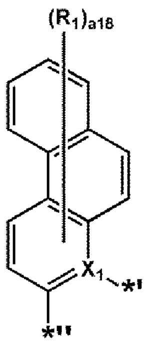

CY1-66

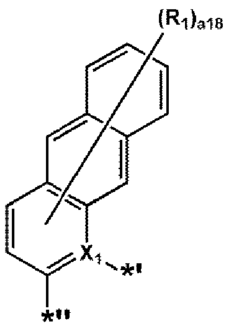

CY1-67

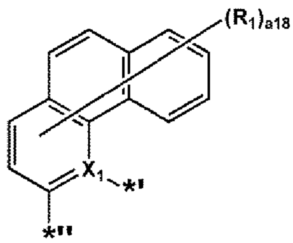

CY1-68

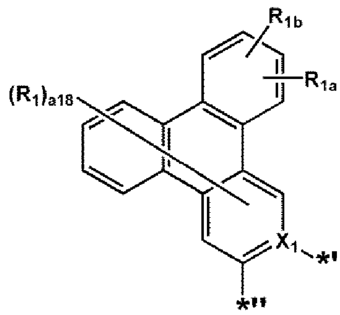

CY1-69

.

In Formulae CY1-1 to CY1-69,

$X_1$ and $R_1$ are the same as described above,
$X_{11}$ may be O, S, Se, $N(R_{19})$, $C(R_{19a})(R_{19b})$, or $Si(R_{19a})(R_{19b})$,
$R_{19}$, $R_{19a}$, $R_{19b}$, $R_{1a}$ and $R_{1b}$ may each be the same as defined in connection with $R_1$,

a18 may be an integer from 0 to 8,
a16 may be an integer from 0 to 6,
a15 may be an integer from 0 to 5,
a14 may be an integer from 0 to 4,
a13 may be an integer from 0 to 3,
*" indicates a binding site to $T_1$ in Formula 2, and
*' indicates a binding site to M in Formula 1.

In one or more embodiments, a group represented by

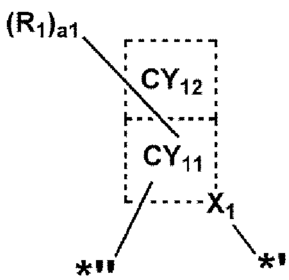

in Formula 2 may be a group represented by one of Formulae CY1(1) to CY1(165):

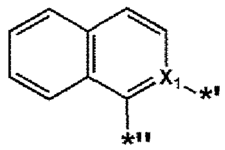

CY1(1)

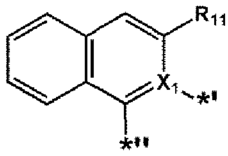

CY1(2)

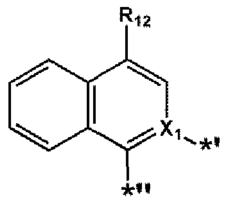

CY1(3)

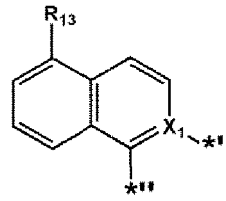

CY1(4)

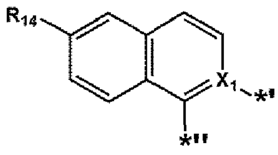

CY1(5)

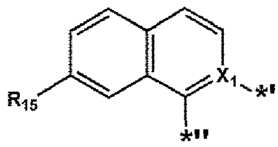

CY1(6)

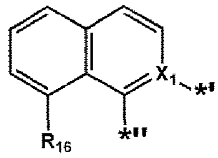

CY1(7)

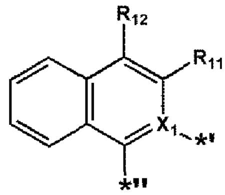

CY1(8)

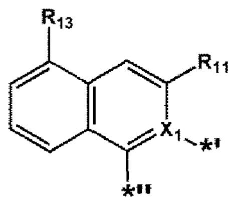

CY1(9)

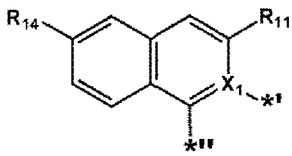

CY1(10)

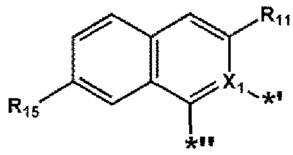

CY1(11)

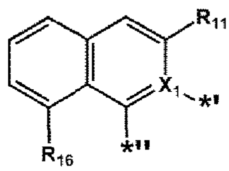

CY1(12)

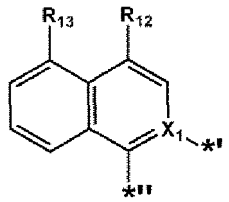

CY1(13)

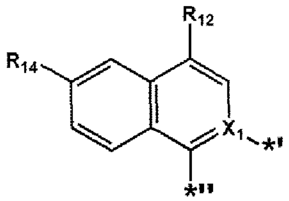

CY1(14)

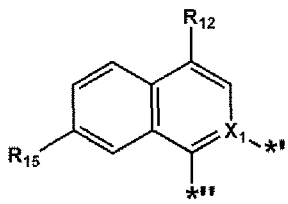

CY1(15)

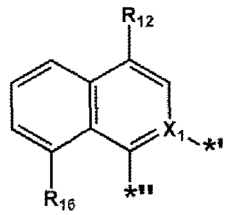

CY1(16)

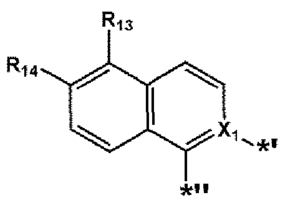

CY1(17)

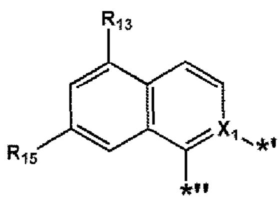

CY1(18)

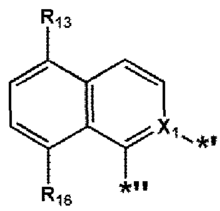

CY1(19)

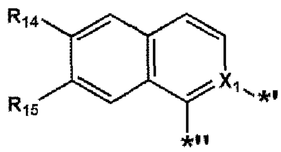

CY1(20)

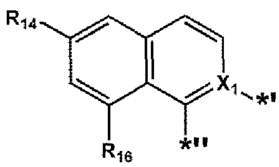

CY1(21)

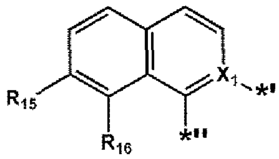

CY1(22)

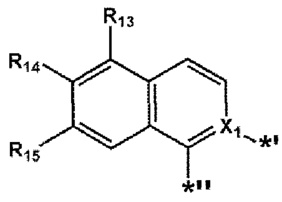

CY1(23)

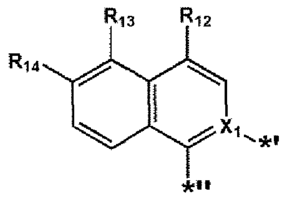

CY1(24)

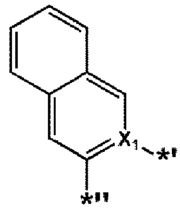

CY1(25)

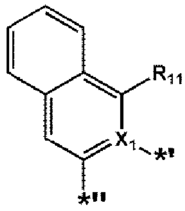

CY1(26)

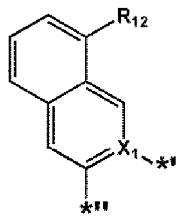

CY1(27)

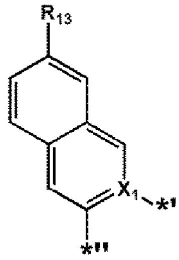

CY1(28)

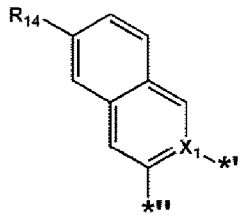

CY1(29)

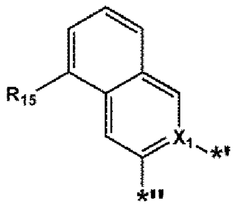

CY1(30)

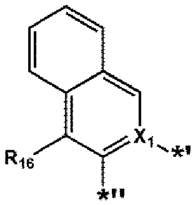

CY1(31)

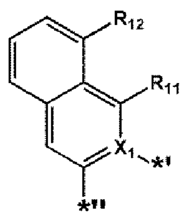

CY1(32)

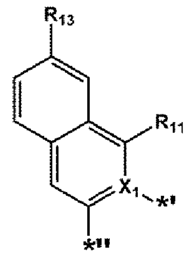

CY1(33)

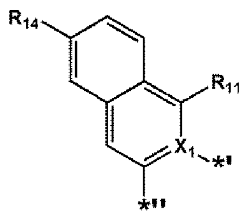

CY1(34)

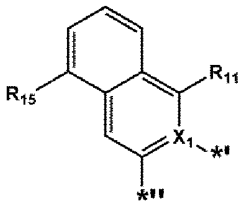

CY1(35)

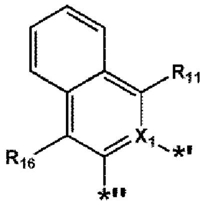

CY1(36)

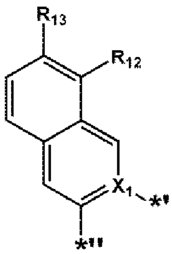

CY1(37)

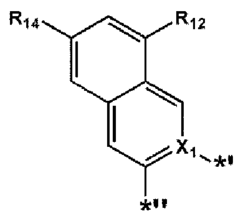

CY1(38)

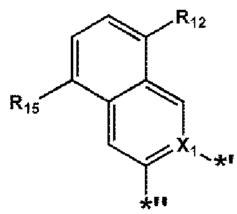

CY1(39)

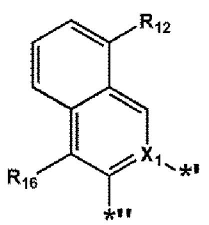

CY1(40)

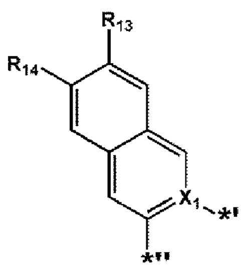

CY1(41)

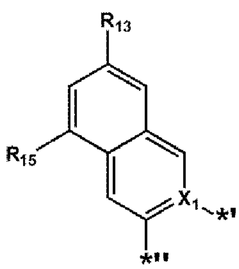

CY1(42)

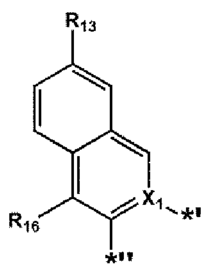

CY1(43)

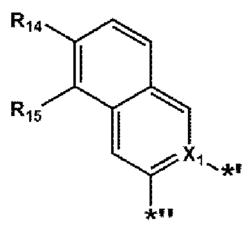

CY1(44)

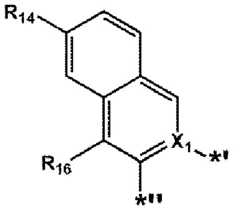
CY1(45)

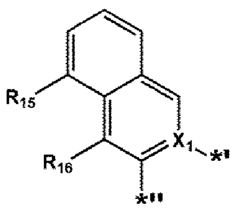
CY1(46)

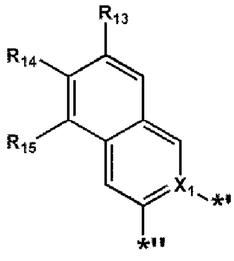
CY1(47)

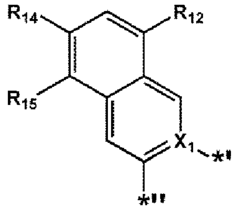
CY1(48)

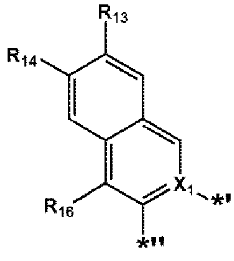
CY1(49)

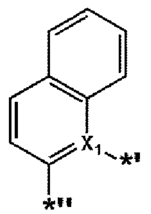
CY1(50)

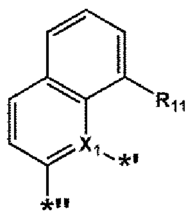
CY1(51)

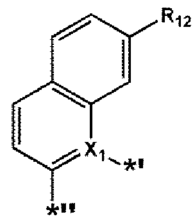
CY1(52)

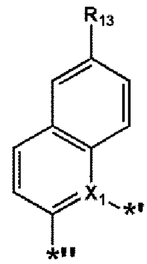
CY1(53)

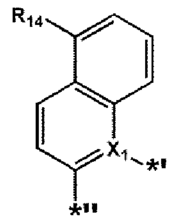
CY1(54)

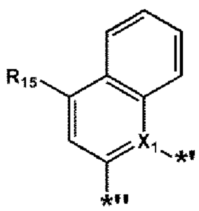
CY1(55)

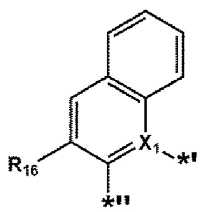
CY1(56)

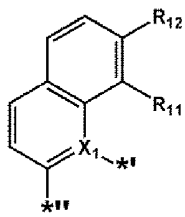
CY1(57)

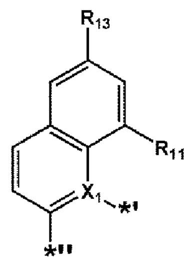
CY1(58)

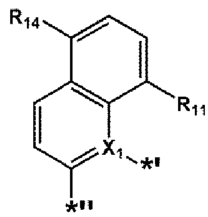
CY1(59)

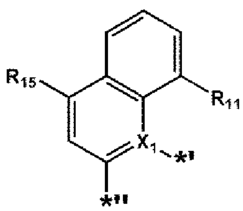
CY1(60)

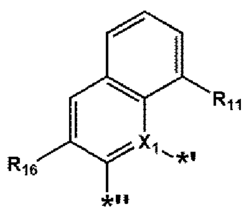
CY1(61)

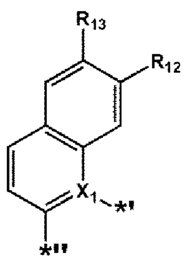
CY1(62)

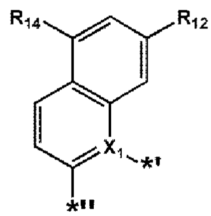
CY1(63)

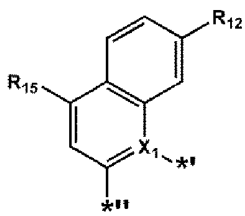
CY1(64)

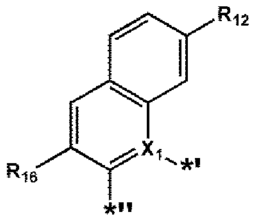
CY1(65)

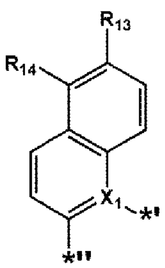
CY1(66)

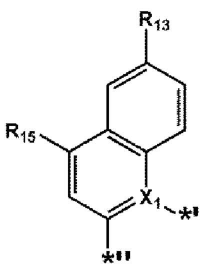
CY1(67)

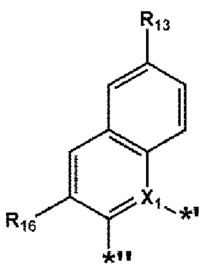
CY1(68)

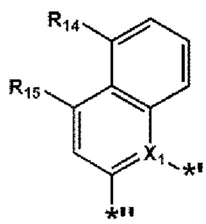
CY1(69)

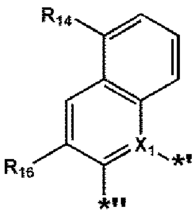
CY1(70)

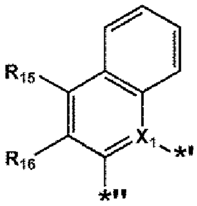
CY1(71)

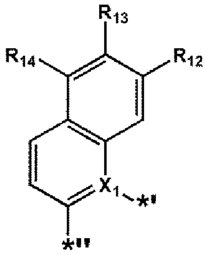
CY1(72)

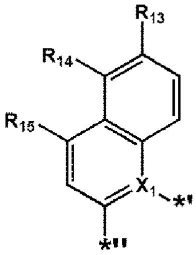
CY1(73)

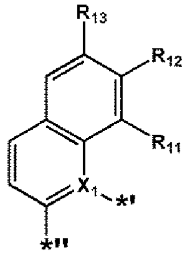
CY1(74)

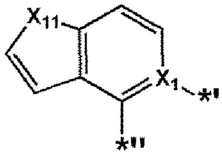
CY1(75)

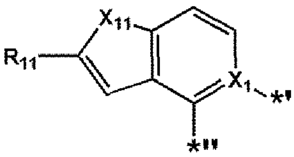
CY1(76)

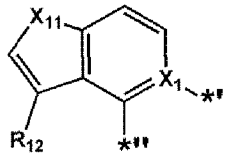
CY1(77)

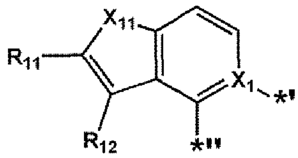
CY1(78)

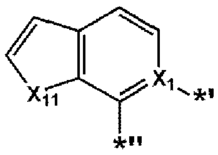
CY1(79)

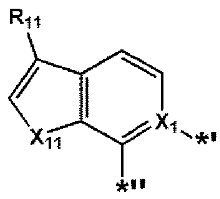
CY1(80)

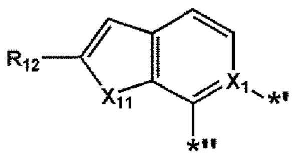
CY1(81)

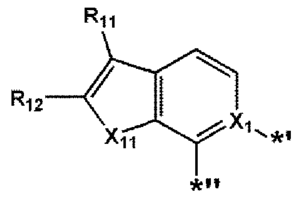
CY1(82)

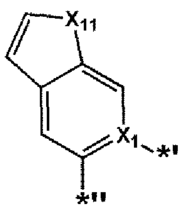
CY1(83)

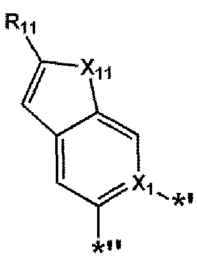
CY1(84)

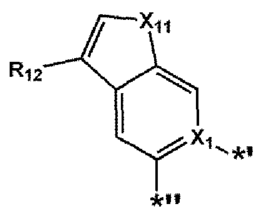
CY1(85)

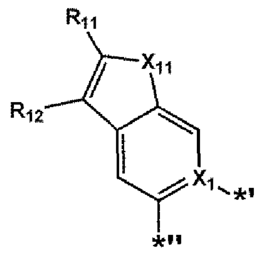
CY1(86)

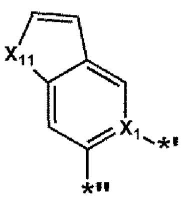
CY1(87)

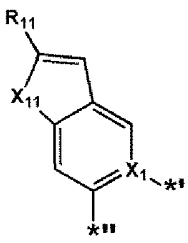
CY1(88)

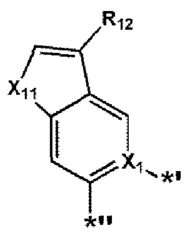
CY1(89)

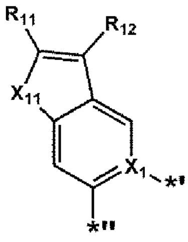
CY1(90)

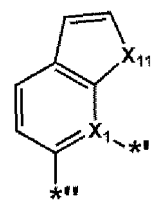
CY1(91)

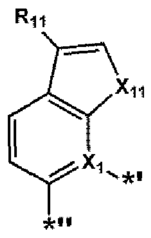
CY1(92)

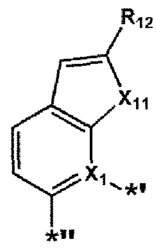
CY1(93)

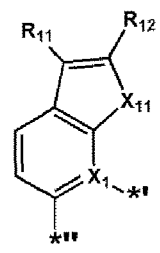
CY1(94)

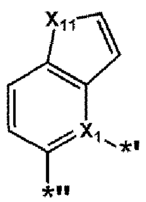
CY1(95)

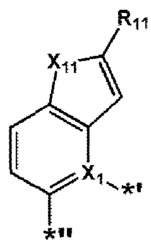
CY1(96)

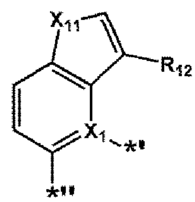
CY1(97)

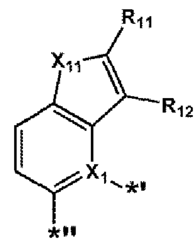
CY1(98)

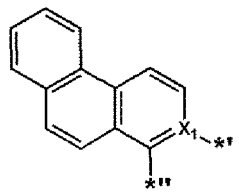
CY1(99)

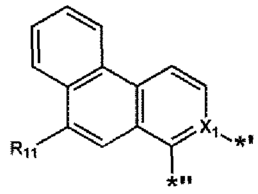
CY1(100)

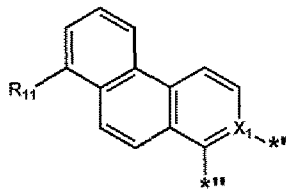
CY1(101)

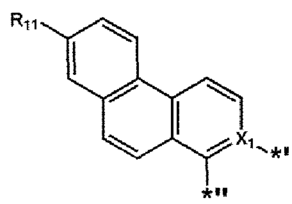
CY1(102)

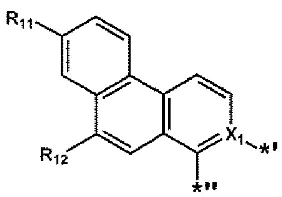
CY1(103)

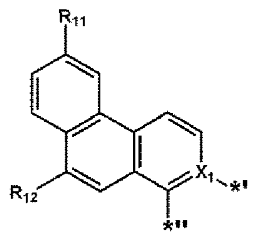
CY1(104)

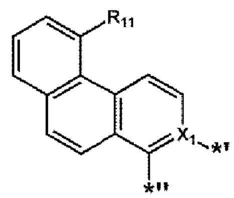
CY1(105)

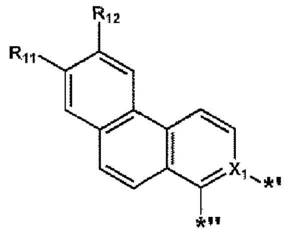
CY1(106)

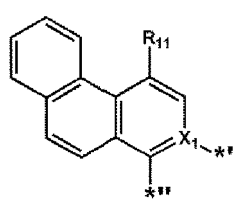
CY1(107)

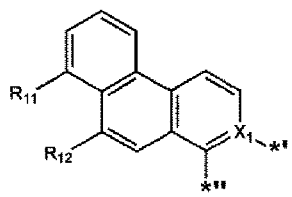
CY1(108)

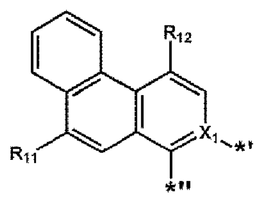
CY1(109)

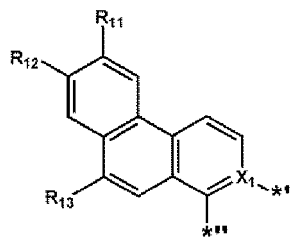
CY1(110)

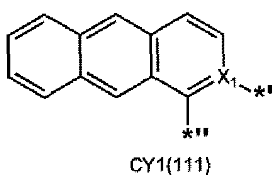
CY1(111)

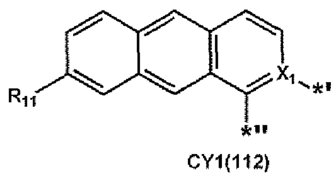
CY1(112)

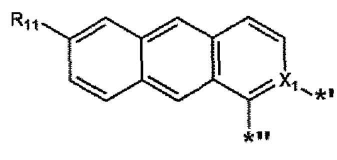
CY1(113)

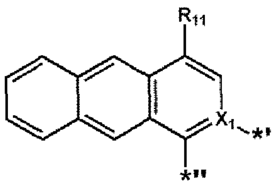
CY1(114)

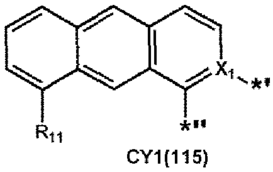
CY1(115)

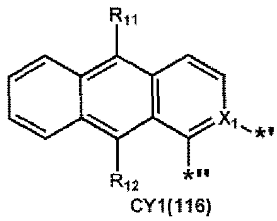
CY1(116)

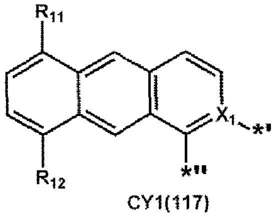
CY1(117)

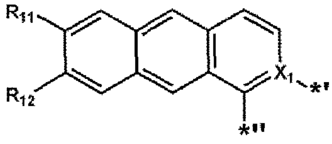
CY1(118)

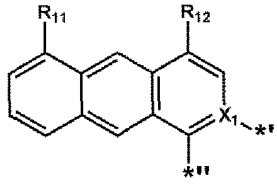
CY1(119)

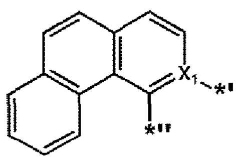
CY1(120)

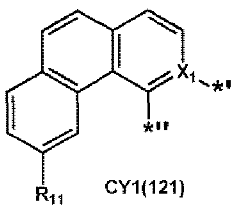
CY1(121)

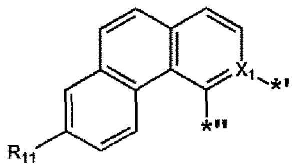
CY1(122)

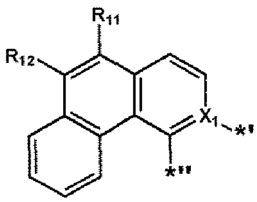
CY1(123)

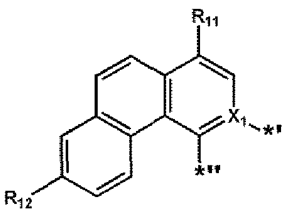
CY1(124)

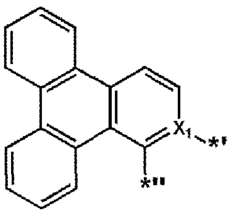
CY1(125)

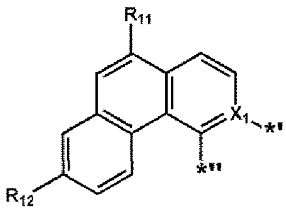
CY1(126)

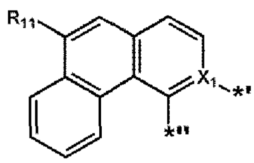
CY1(127)

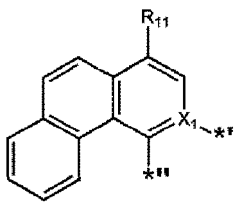
CY1(128)

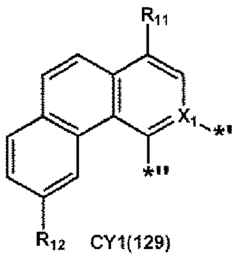
CY1(129)

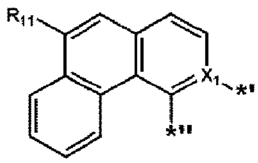
CY1(130)

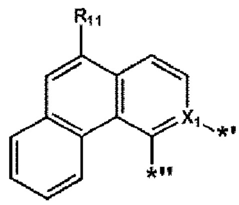
CY1(131)

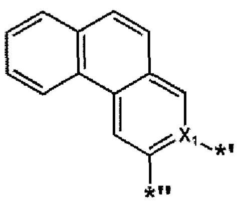
CY1(132)

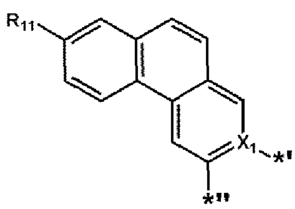
CY1(133)

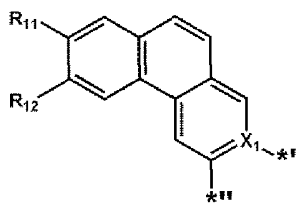
CY1(134)

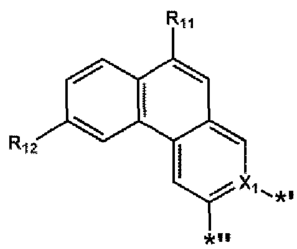
CY1(135)

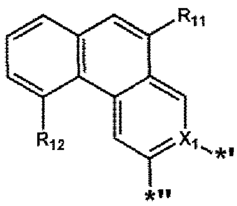
CY1(136)

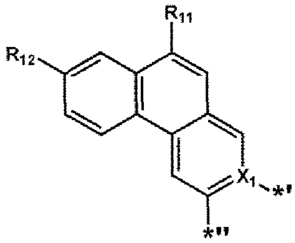
CY1(137)

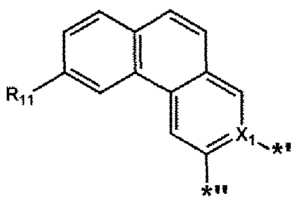
CY1(138)

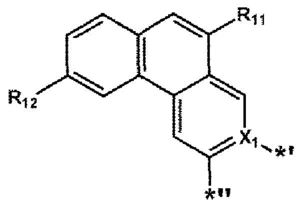
CY1(139)

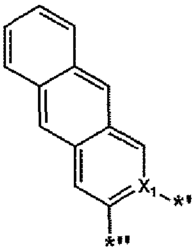
CY1(140)

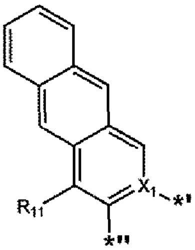
CY1(141)

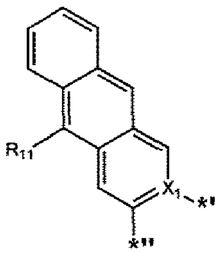
CY1(142)

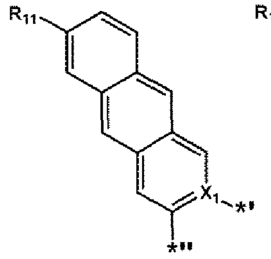
CY1(143)

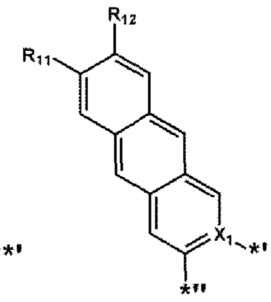
CY1(144)

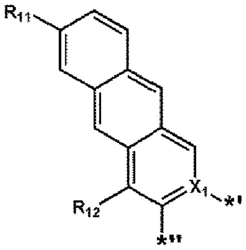
CY1(145)

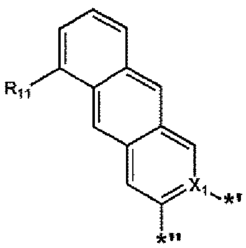
CY1(146)

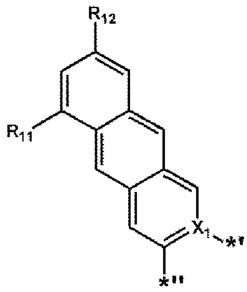
CY1(147)

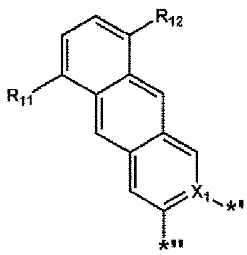
CY1(148)

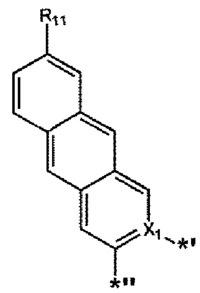
CY1(149)

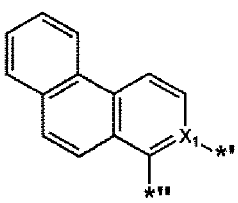
CY1(150)

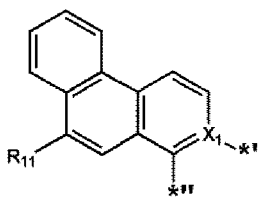
CY1(151)

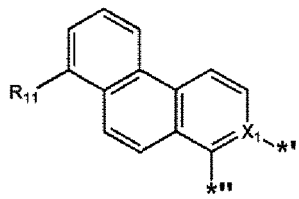
CY1(152)

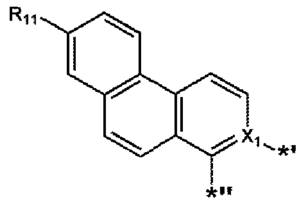
CY1(153)

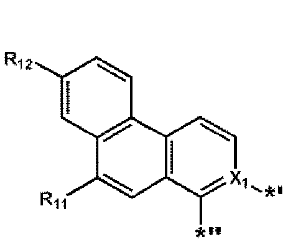
CY1(154)

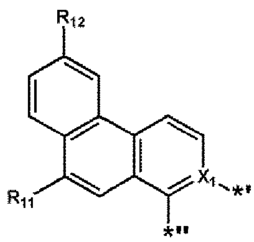
CY1(155)

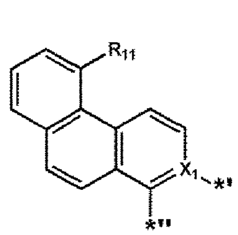
CY1(156)

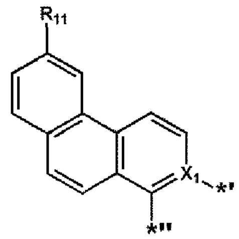
CY1(157)

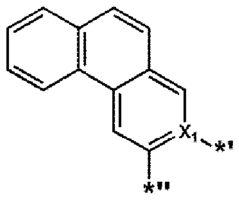
CY1(158)

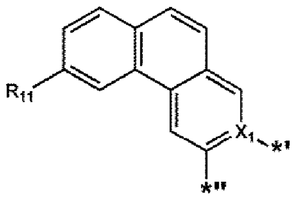
CY1(159)

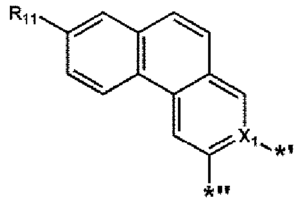
CY1(160)

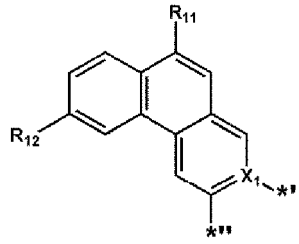
CY1(161)

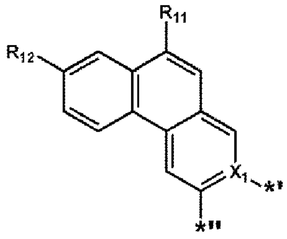
CY1(162)

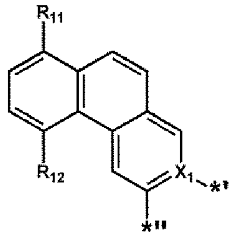
CY1(163)

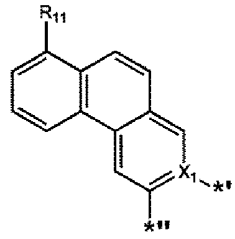
CY1(164)

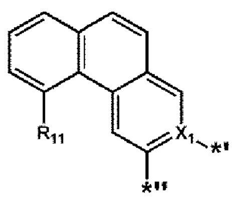
CY1(165)

In Formulae CY1(1) to CY1(165),

$X_1$ and $X_{11}$ are the same as described above,
$R_{11}$ to $R_{16}$ may each be the same as defined in connection with $R_1$, provided that, $R_{11}$ to $R_{16}$ are not hydrogen,
*" indicates a binding site to $T_1$ in Formula 2, and
*' indicates a binding site to M in Formula 1.

In one or more embodiments, a group represented by

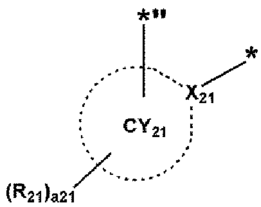

in Formula 2 may be a group represented by one of Formulae CY21-1 to CY21-25:

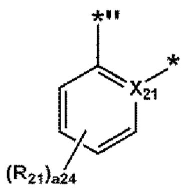
CY21-1

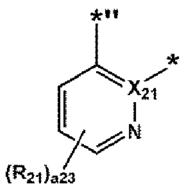
CY21-2

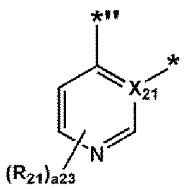
CY21-3

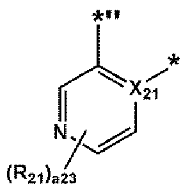
CY21-4

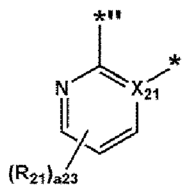
CY21-5

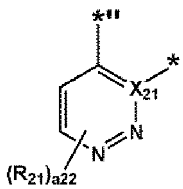
CY21-6

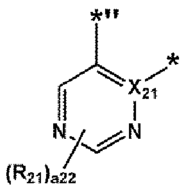
CY21-7

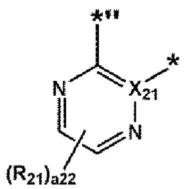
CY21-8

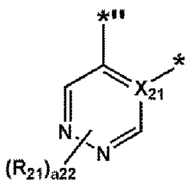
CY21-9

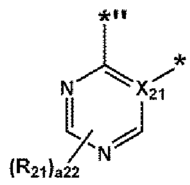
CY21-10

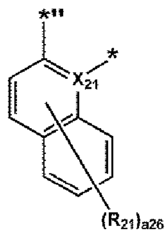
CY21-11

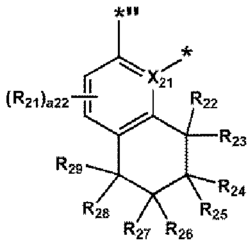
CY21-12

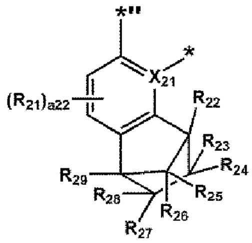
CY21-13

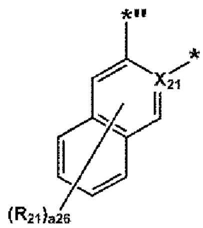
CY21-14

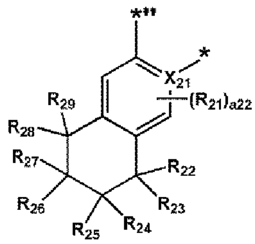
CY21-15

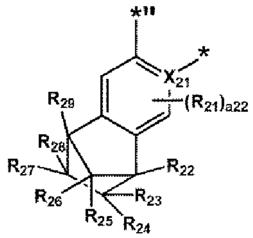
CY21-16

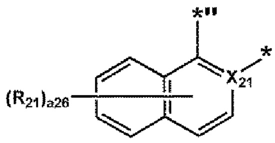
CY21-17

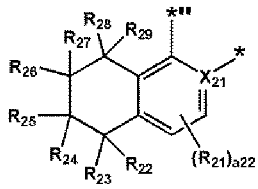
CY21-18

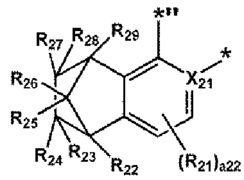
CY21-19

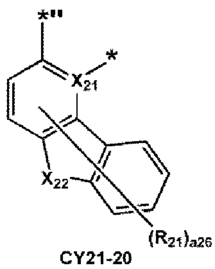
CY21-20

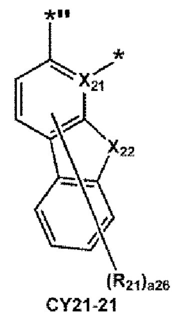
CY21-21

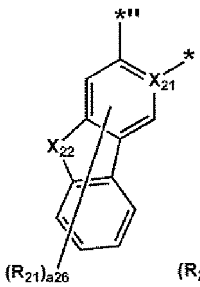
CY21-22

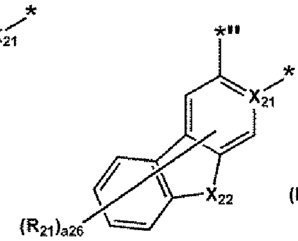
CY21-23

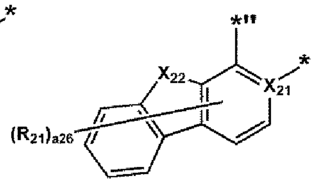
CY21-24

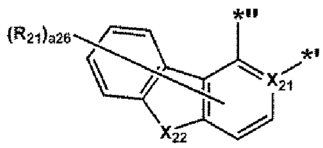
CY21-25

In Formulae CY21-1 to CY21-25,

$X_{21}$ and $R_{21}$ are the same as described above,
$X_{22}$ may be $C(R_{22})(R_{23})$, $N(R_{22})$, O, S, or $Si(R_{22})(R_{23})$,
$R_{22}$ to $R_{29}$ may each be the same as defined in connection with $R_{21}$,
a26 may be an integer from 0 to 6,
a24 may be an integer from 0 to 4,
a23 may be an integer from 0 to 3,
a22 may be an integer from 0 to 2,
*" indicates a binding site to $T_1$ in Formula 2, and
* indicates a binding site to M in Formula 1.

In one or more embodiments, a group represented by

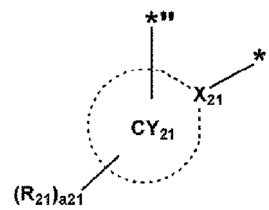

in

Formula 2 may be a group represented by one of Formulae CY21(1) to CY21(56) and CY21-20 to CY21-25:

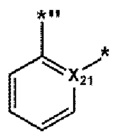
CY21(1)

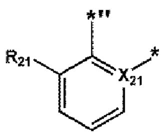
CY21(2)

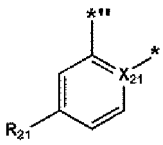
CY21(3)

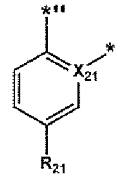
CY21(4)

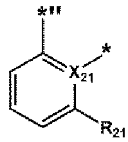
CY21(5)

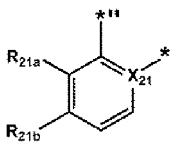
CY21(6)

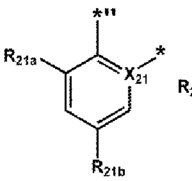
CY21(7)

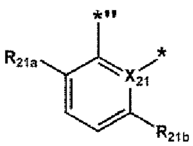
CY21(8)

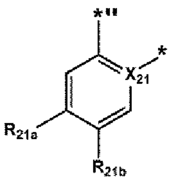
CY21(9)

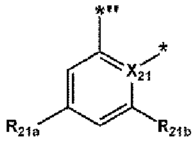
CY21(10)

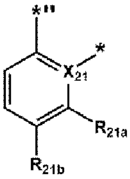
CY21(11)

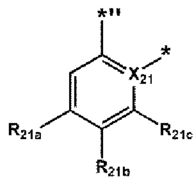
CY21(12)

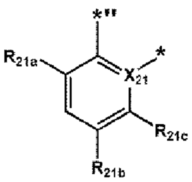
CY21(13)

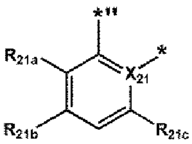
CY21(14)

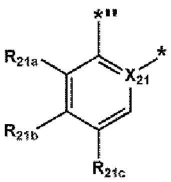
CY21(15)

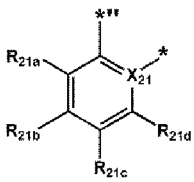
CY21(16)

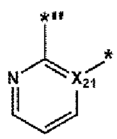
CY21(17)

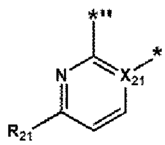
CY21(18)

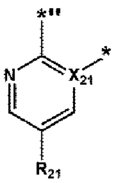
CY21(19)

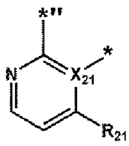
CY21(20)

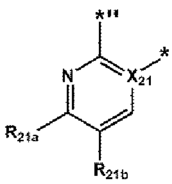
CY21(21)

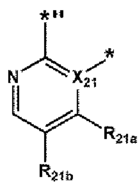
CY21(22)

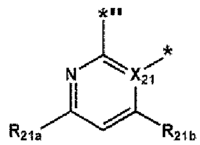
CY21(23)

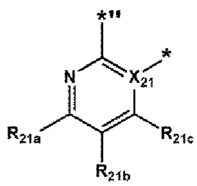
CY21(24)

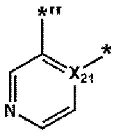
CY21(25)

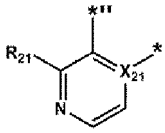
CY21(26)

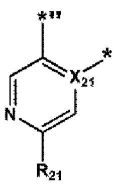
CY21(27)

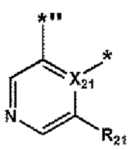
CY21(28)

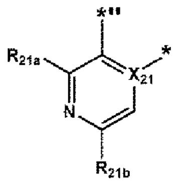
CY21(29)

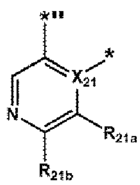
CY21(30)

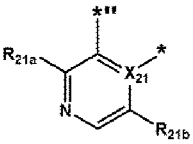
CY21(31)
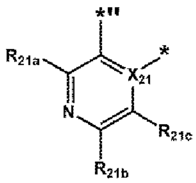
CY21(32)
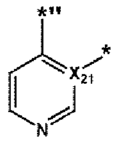
CY21(33)
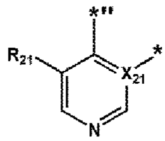
CY21(34)
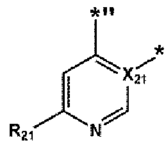
CY21(35)
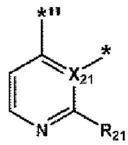
CY21(36)

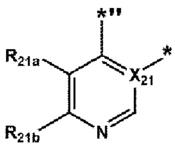
CY21(37)
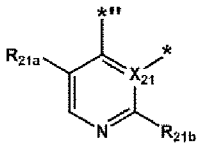
CY21(38)
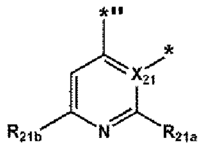
CY21(39)
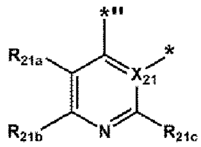
CY21(40)
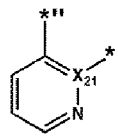
CY21(41)
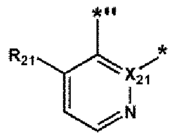
CY21(42)

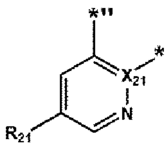
CY21(43)
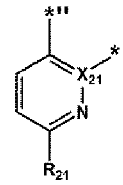
CY21(44)
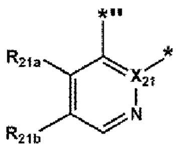
CY21(45)
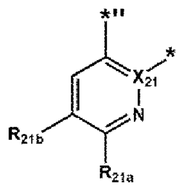
CY21(46)
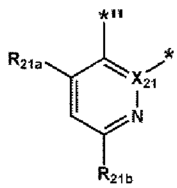
CY21(47)
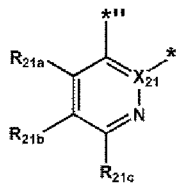
CY21(48)

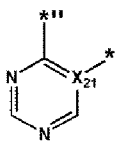
CY21(49)
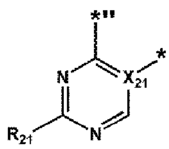
CY21(50)
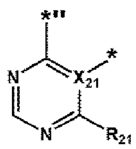
CY21(51)
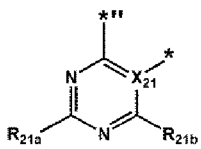
CY21(52)
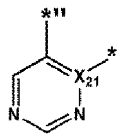
CY21(53)
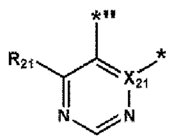
CY21(54)

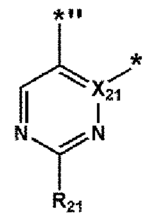
CY21(55)
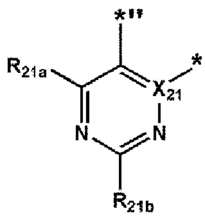
CY21(56) .

In Formulae CY21(1) to CY21(56),

$X_{21}$ and $R_{21}$ are the same as described above,
$R_{21a}$ to $R_{21d}$ may each be the same as defined in connection with $R_{21}$, wherein each of $R_{21}$ and $R_{21a}$ to $R_{21d}$ may not be hydrogen,
*" indicates a binding site to $T_1$ in Formula 2, and
* indicates a binding site to M in Formula 1.

In Formula 1, $L_2$ may be a bidentate ligand each linked to M in Formula 1 via O, S, Se, N, C, P, Si, or As.

In one embodiment, $L_2$ in Formula 1 may be a bidentate ligand represented by Formula 3:

<Formula 3>

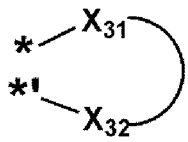

.

In Formula 3,

$X_{31}$ and $X_{32}$ may each independently be O, S, Se, N, C, P, Si, or As,

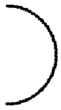

indicates a linking group linking $X_{31}$ and $X_{32}$ together, and
* and *' each indicate a binding site to M in Formula 1.

For example, in Formula 3, $X_{31}$ and $X_{32}$ may each independently be O, S, Se, or N, but embodiments of the present disclosure are not limited thereto.

For example, in Formula 3, i) $X_{31}$ and $X_{32}$ may each be O; or ii) $X_{31}$ may be N, and $X_{32}$ may be C, but embodiments of the present disclosure are not limited thereto.

In one or more embodiments, $L_2$ in Formula 1 may be a monodentate ligand, such as $I^-$, $Br^-$, $Cl^-$, sulfide, nitrate, azide, hydroxide, cyanate, isocyanate, thiocyanate, water, acetonitrile, pyridine, ammonia, carbon monoxide, $P(Ph)_3$, $P(Ph)_2CH_3$, $PPh(CH_3)_2$, or $P(CH_3)_3$, but embodiments of the present disclosure are not limited thereto.

In one or more embodiments, $L_2$ in Formula 1 may be a bidentate ligand, such as oxalate, acetylacetonate, picolinic acid, 1,2-bis(diphenylphosphino)ethane, 1,1-bis(diphenylphosphino)methane, glycinate, or ethylenediamine, but embodiments of the present disclosure are not limited thereto.

In one or more embodiments, $L_2$ in Formula 1 may be a group represented by one of Formulae 3A to 3F:

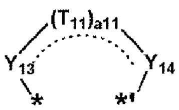
3A

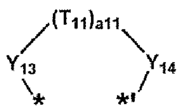
3B

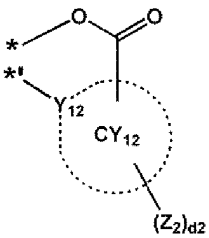
3C

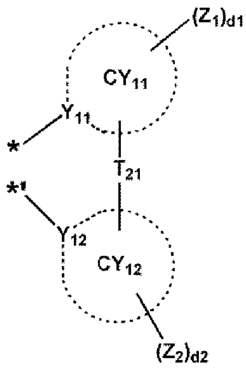
3D

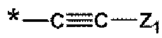
3E

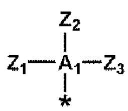
3F

.

In Formulae 3A to 3F,

$Y_{13}$ may be O, N, $N(Z_1)$, $P(Z_1)(Z_2)$, or $As(Z_1)(Z_2)$,
$Y_{14}$ may be O, N, $N(Z_3)$, $P(Z_3)(Z_4)$, or $As(Z_3)(Z_4)$,
$T_{11}$ may be a single bond, a double bond, *-$C(Z_{11})(Z_{12})$-*', *-$C(Z_{11})=C(Z_{12})$-*', *=$C(Z_{11})$-*', *-$C(Z_{11})$=*', *=$C(Z_{11})$-$C(Z_{12})=C(Z_{13})$-*', *-$C(Z_{11})=C(Z_{12})$-$C(Z_{13})$=*', *-$N(Z_{11})$-*', or a $C_5$-$C_{30}$ carbocyclic group unsubstituted or substituted with at least one $Z_{11}$,
a11 may be an integer from 1 to 10, when a11 is 2 or more, two or more $T_{11}$(s) are identical to or different from each other,
$Y_{11}$ and $Y_{12}$ may each independently be C or N,
$T_{21}$ may be a single bond, a double bone, O, S, $C(Z_{11})(Z_{12})$, $Si(Z_{11})(Z_{12})$, or $N(Z_{11})$,

ring $CY_{11}$ and ring $CY_{12}$ may each independently be a $C_5$-$C_{30}$ carbocyclic group or a $C_1$-$C_{30}$ heterocyclic group,
$A_1$ may be P or As,
$Z_1$ to $Z_4$ and $Z_{11}$ to $Z_{13}$ may each be the same as defined in connection with $R_{21}$,
d1 and d2 may each independently be an integer from 0 to 10, and
* and *' each indicate a binding site to M in Formula 1.

In Formulae 3A to 3F, the $C_5$-$C_{30}$ carbocyclic group and the $C_1$-$C_{30}$ heterocyclic group may each be the same as defined in connection with ring $CY_{21}$.

For example, a group represented by

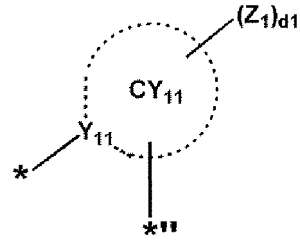

in Formula 3D may be a group represented by one of Formulae CY11-1 to CY11-34, and/or a group represented by

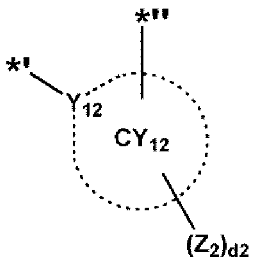

in Formula 3C or 3D may be a group represented by one of Formulae CY12-1 to CY12-34:

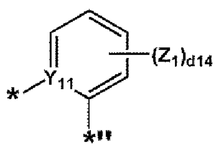
CY11-1

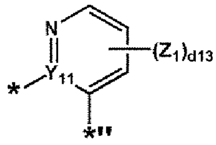
CY11-2

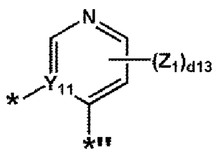
CY11-3

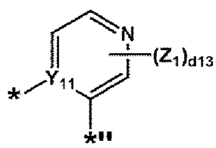
CY11-4

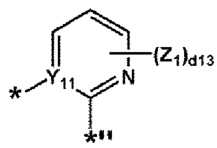
CY11-5

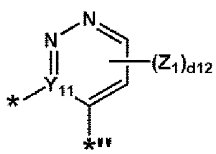
CY11-6

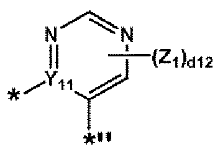
CY11-7

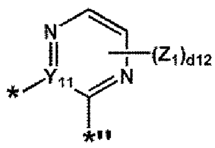
CY11-8

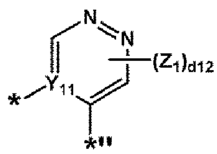
CY11-9

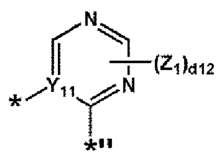
CY11-10

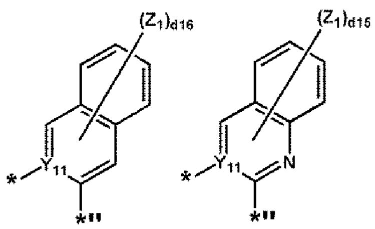
CY11-11 CY11-12

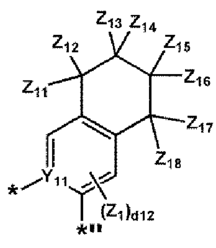
CY11-13

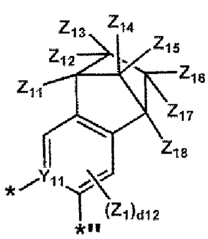
CY11-14

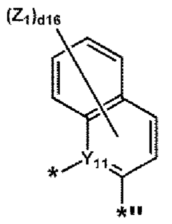
CY11-15

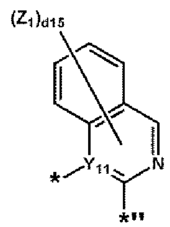
CY11-16

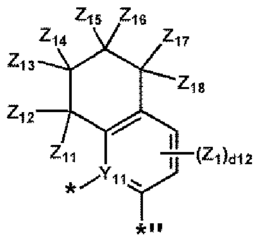
CY11-17

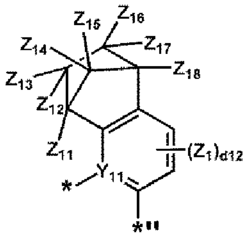
CY11-18

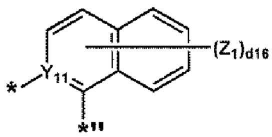
CY11-19

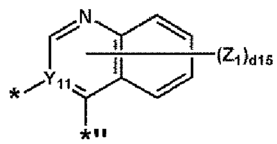
CY11-20

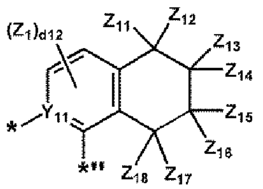
CY11-21

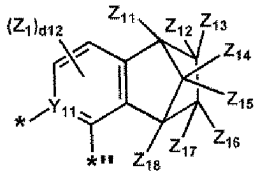
CY11-22

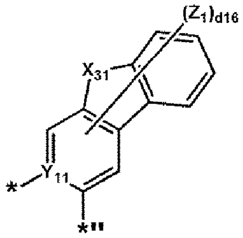
CY11-23

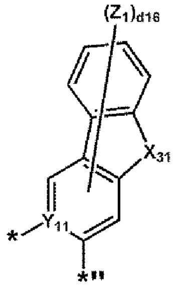
CY11-24

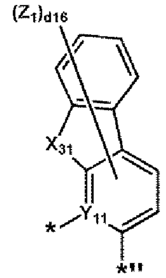
CY11-25

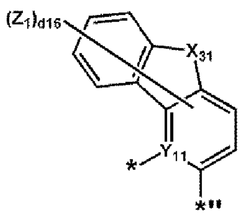
CY11-26

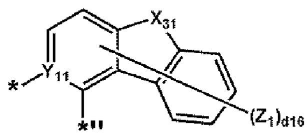
CY11-27

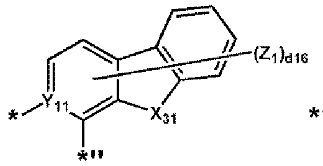
CY11-28

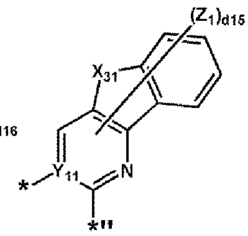
CY11-29

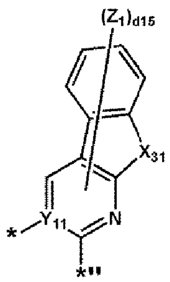
CY11-30

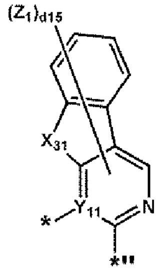
CY11-31

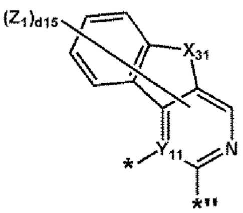
CY11-32

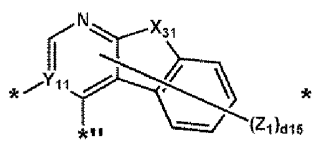
CY11-33

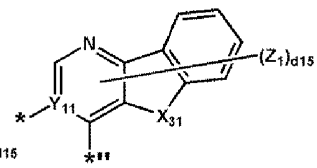
CY11-34

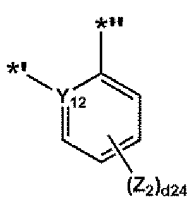
CY12-1

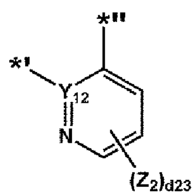
CY12-2

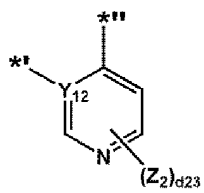
CY12-3

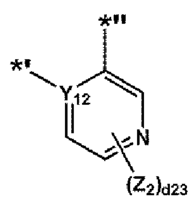
CY12-4

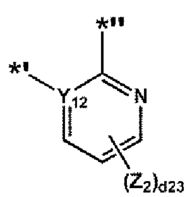
CY12-5

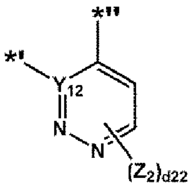
CY12-6

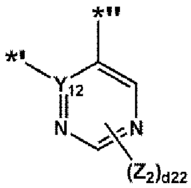
CY12-7

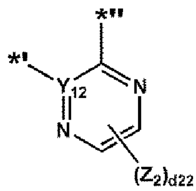
CY12-8

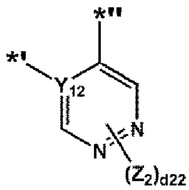
CY12-9

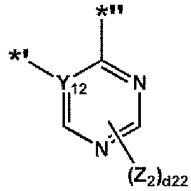
CY12-10

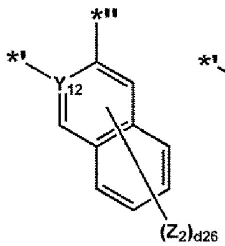
CY12-11

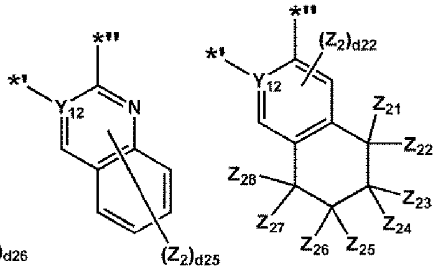
CY12-12

CY12-13

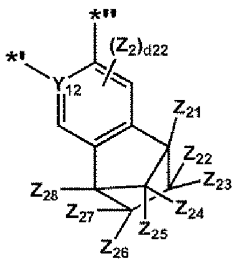
CY12-14

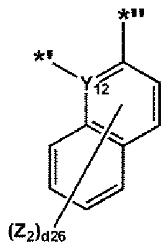
CY12-15

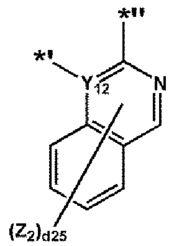
CY12-16

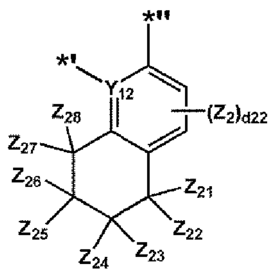
CY12-17

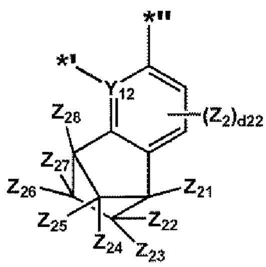
CY12-18

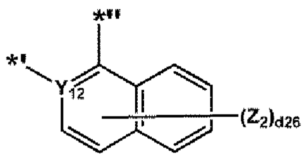
CY12-19

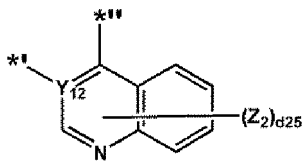
CY12-20

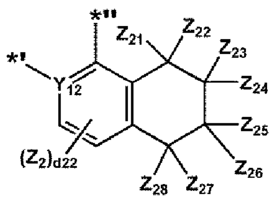
CY12-21

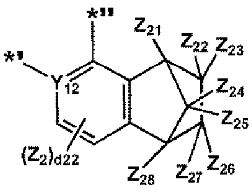
CY12-22

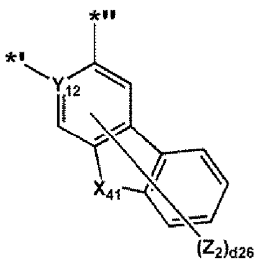
CY12-23

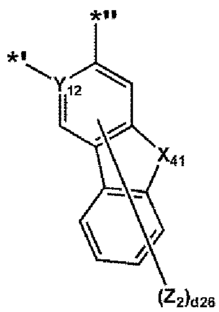
CY12-24

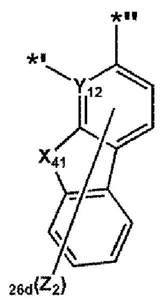
CY12-25

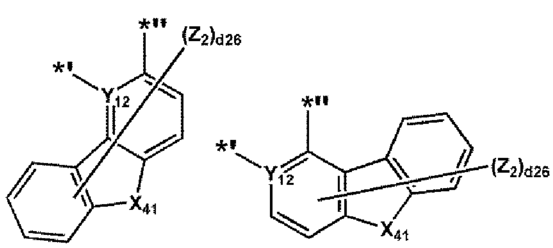
CY12-26

CY12-27

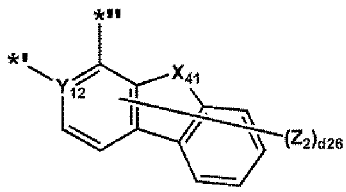
CY12-28

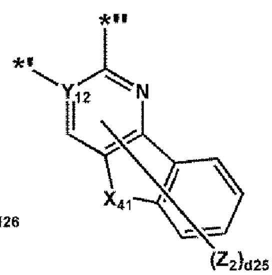
CY12-29

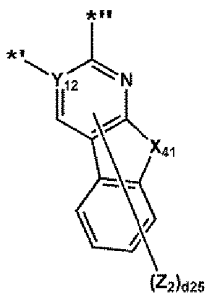
CY12-30

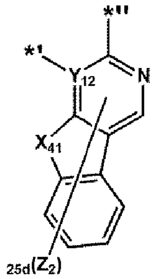
CY12-31

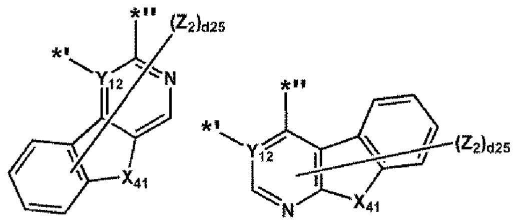
CY12-32

CY12-33

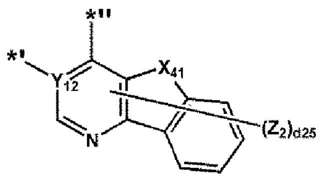
CY12-34

.

In Formulae CY11-1 to CY11-34 and CY12-1 to CY12-34,

X31 may be O, S, $N(Z_{11})$, $C(Z_{11})(Z_{12})$, or $Si(Z_{11})(Z_{12})$,
$X_{41}$ may be O, S, $N(Z_{21})$, $C(Z_{21})(Z_{22})$, or $Si(Z_{21})(Z_{22})$,
$Y_{11}$, $Y_{12}$, $Z_1$, and $Z_2$ are the same as described above,
$Z_{11}$ to $Z_{18}$ and $Z_{21}$ to $Z_{28}$ may each be the same as defined in connection with $R_{21}$,
d12 and d22 may each independently be an integer from 0 to 2,
d13 and d23 may each independently be an integer from 0 to 3,
d14 and d24 may each independently be an integer from 0 to 4,
d15 and d25 may each independently be an integer from 0 to 5,
d16 and d26 may each independently be an integer from 0 to 6, and
in Formulae CY11-1 to CY11-34 and CY12-1 to CY12-34, * and *' each indicate a binding site to M in Formula 1, and *" indicates a binding site to a neighboring atom in Formula 3C or to $T_{21}$ in Formula 3D.

In one embodiment, $L_2$ in Formula 1 may be a group represented by one of Formulae 3-1(1) to 3-1(66) and 3-1(301) to 3-1(309), but embodiments of the present disclosure are not limited thereto:

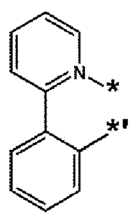
3-1(1)

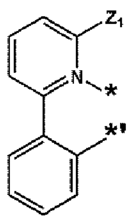
3-1(2)

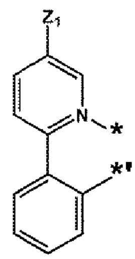
3-1(3)

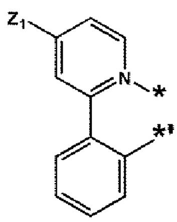
3-1(4)

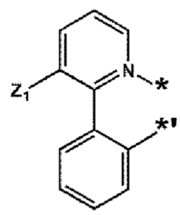
3-1(5)

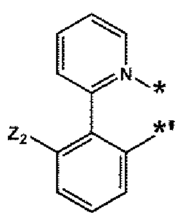
3-1(6)

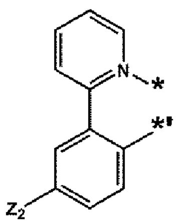
3-1(7)

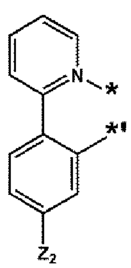
3-1(8)

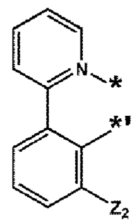
3-1(9)

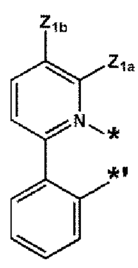
3-1(10)

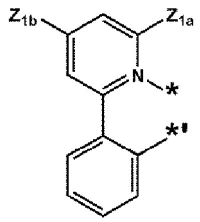
3-1(11)

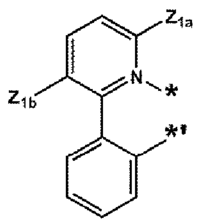
3-1(12)

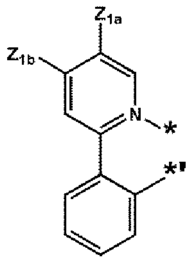
3-1(13)

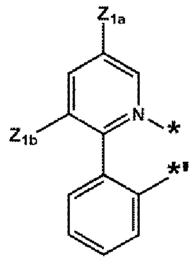
3-1(14)

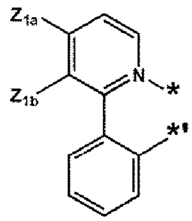
3-1(15)

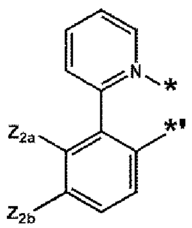
3-1(16)

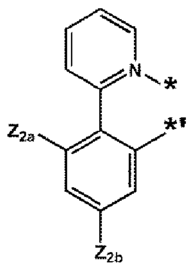
3-1(17)

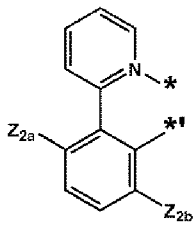
3-1(18)

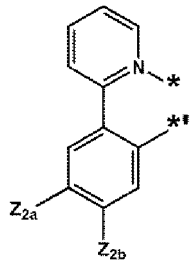
3-1(19)

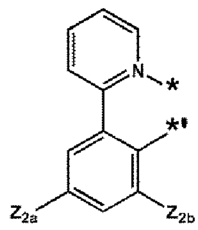
3-1(20)

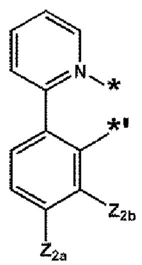
3-1(21)

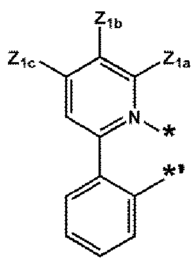
3-1(22)

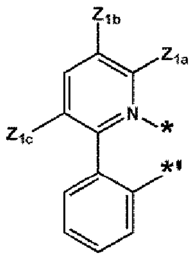
3-1(23)

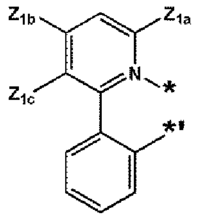
3-1(24)

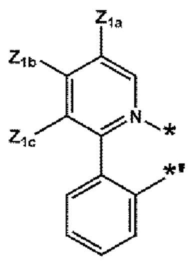
3-1(25)

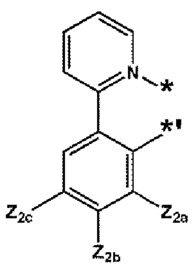
3-1(26)

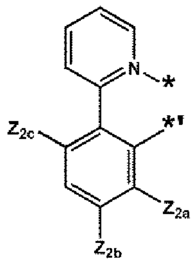
3-1(27)

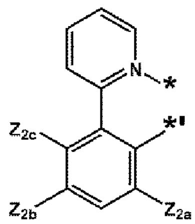
3-1(28)

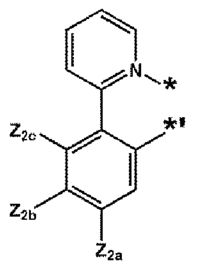
3-1(29)

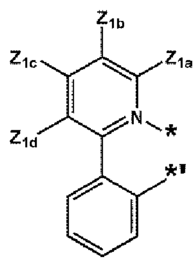
3-1(30)

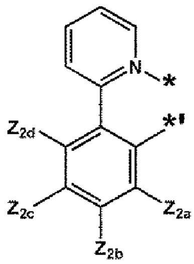
3-1(31)

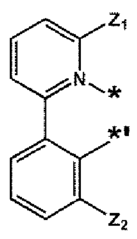
3-1(32)

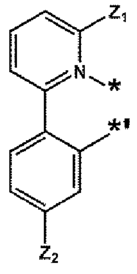
3-1(33)

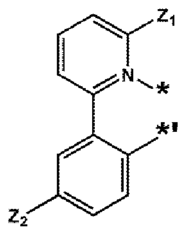
3-1(34)

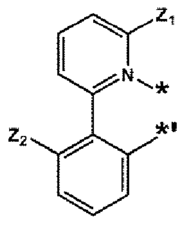
3-1(35)

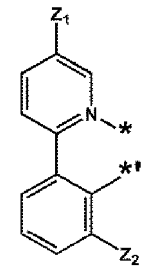
3-1(36)

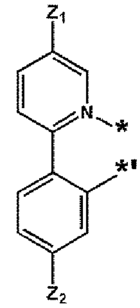
3-1(37)

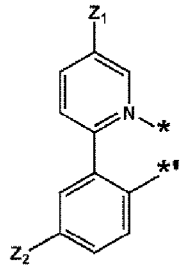
3-1(38)

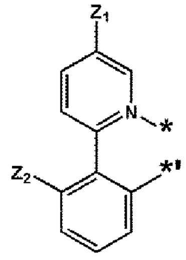
3-1(39)

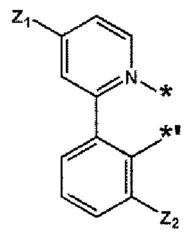
3-1(40)

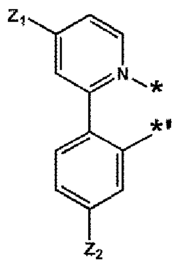
3-1(41)

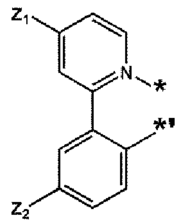
3-1(42)

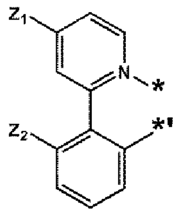
3-1(43)

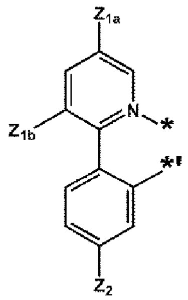
3-1(44)

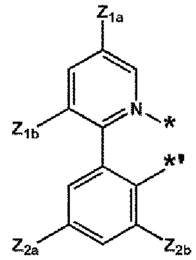
3-1(45)

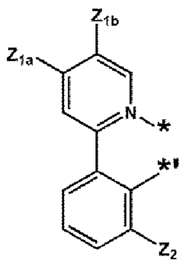
3-1(46)

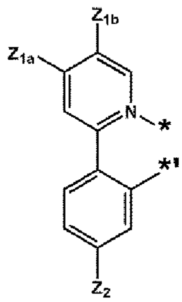
3-1(47)

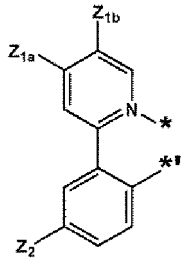
3-1(48)

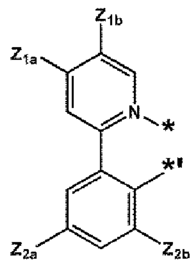
3-1(49)

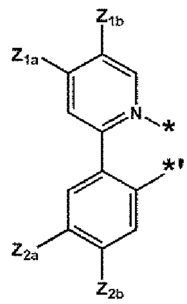
3-1(50)

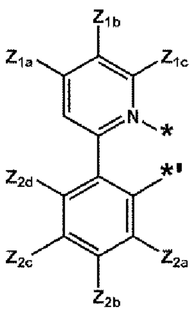
3-1(51)

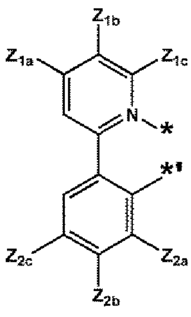
3-1(52)

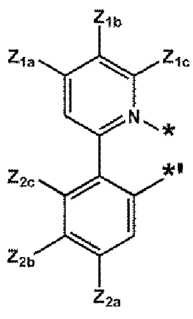
3-1(53)

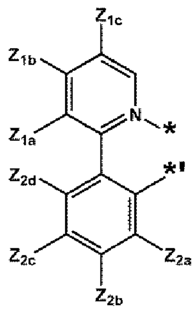
3-1(54)

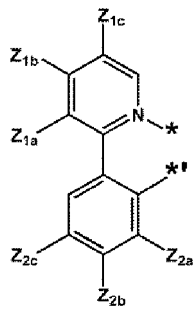
3-1(55)

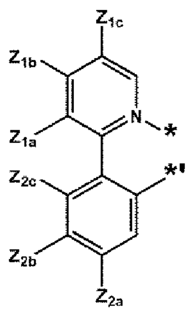
3-1(56)

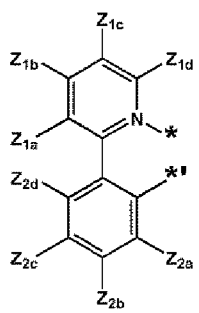
3-1(57)

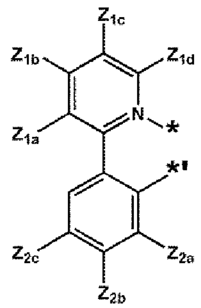
3-1(58)

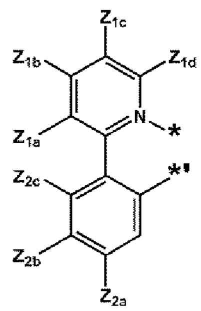
3-1(59)

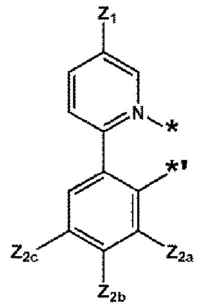
3-1(60)

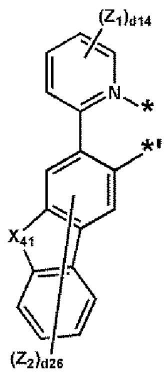
3-1(61)

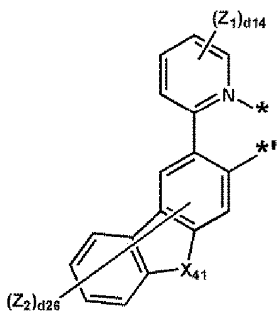
3-1(62)

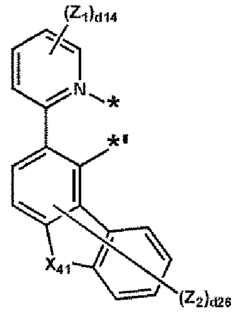
3-1(63)

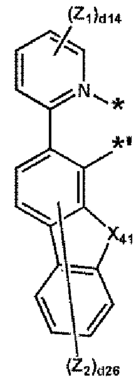
3-1(64)

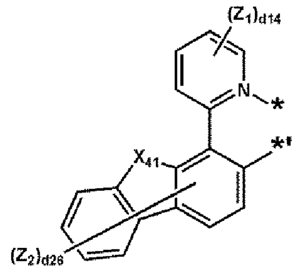
3-1(65)

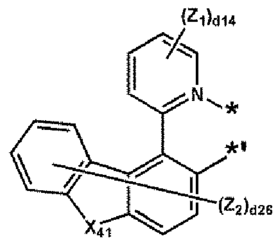
3-1(66)

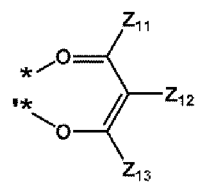
3-1(301)

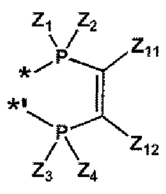
3-1(302)

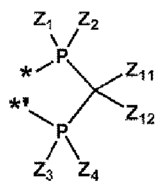
3-1(303)

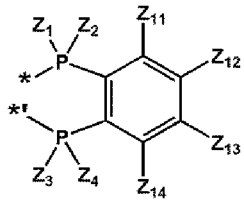
3-1(304)

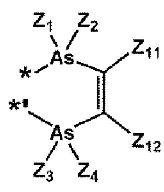
3-1(305)

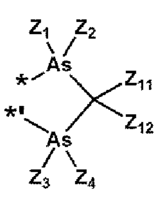
3-1(306)

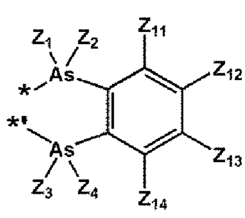
3-1(307)

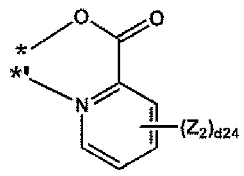
3-1(308)

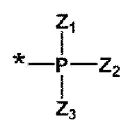
3-1(309)

In Formulae 3-1(1) to 3-1(66) and 3-1(301) to 3-1(309),

$X_{41}$ may be O, S, $N(Z_{21})$, $C(Z_{21})(Z_{22})$, or $Si(Z_{21})(Z_{22})$,
$Z_1$ to $Z_4$, $Z_{1a}$, $Z_{1b}$, $Z_{1c}$, $Z_{1d}$, $Z_{2a}$, $Z_{2b}$, $Z_{2c}$, $Z_{2d}$, and $Z_{11}$ to $Z_{14}$ may each be the same as defined in connection with $R_{21}$,
d14 may be an integer from 0 to 4,
d26 may be an integer from 0 to 6,
* and *' each indicate a binding site to M in Formula 1.

In one embodiment, $L_2$ in Formula 1 may be a group represented by Formula 3-1(301).
In one embodiment, at least one of $Z_{11}$ and $Z_{13}$ in Formula 3-1(301) may not be a methyl group.
In one embodiment, $Z_{11}$ and $Z_{13}$ in Formula 3-1(301) may not be a methyl group, simultaneously.
In one embodiment, at least one of $Z_{11}$ and $Z_{13}$ in Formula 3-1(301) may each independently be a substituted or unsubstituted $C_3$-$C_{60}$ alkyl group, or a substituted or unsubstituted $C_3$-$C_{10}$ cycloalkyl group.
In one embodiment, $Z_{11}$ and $Z_{13}$ in Formula 3-1(301) may each independently be a substituted or unsubstituted $C_3$-$C_{60}$ alkyl group, or a substituted or unsubstituted $C_3$-$C_{10}$ cycloalkyl group.
In one embodiment, at least one of $Z_{11}$ and $Z_{13}$ in Formula 3-1(301) may each independently be a substituted or unsubstituted $C_3$-$C_{10}$ cycloalkyl group.
In one embodiment, $Z_{11}$ and $Z_{13}$ in Formula 3-1(301) may each independently be a substituted or unsubstituted $C_3$-$C_{10}$ cycloalkyl group.
In one embodiment, $Z_{11}$ and $Z_{13}$ in Formula 3-1(301) may each independently be:

a $C_3$-$C_{20}$ alkyl group;
a $C_3$-$C_{20}$ alkyl group substituted with deuterium, a $C_1$-$C_{10}$ alkyl group, a cyclopentyl group, a cyclohexyl group, a cycloheptyl group, a cyclooctyl group, an adamantyl group, a norbornyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a ($C_1$-$C_{20}$ alkyl)cyclopentyl group, a ($C_1$-$C_{20}$ alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantanyl group, a ($C_1$-$C_{20}$ alkyl)norbornanyl group, a ($C_1$-$C_{20}$ alkyl)norbornenyl group, a ($C_1$-$C_{20}$ alkyl)cyclopentenyl group, a ($C_1$-$C_{20}$ alkyl)cyclohexenyl group, a ($C_1$-$C_{20}$ alkyl)cycloheptenyl group, a ($C_1$-$C_{20}$ alkyl)bicyclo[1.1.1]pentyl group, a ($C_1$-$C_{20}$ alkyl)bicyclo[2.1.1]hexyl group, a ($C_1$-$C_{20}$ alkyl)bicyclo[2.2.1]heptyl group, a ($C_1$-$C_{20}$ alkyl)bicyclo[2.2.2]octyl group, or any combination thereof; or
a cyclopentyl group, a cyclohexyl group, a cycloheptyl group, a cyclooctyl group, an adamantyl group, a norbornyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, each unsubstituted or substituted with deuterium, a $C_1$-$C_{20}$ alkyl group, a deuterium-containing $C_2$-$C_{20}$ alkyl group (for example, *-$C(CD_3)_3$), a cyclopentyl group, a cyclohexyl group, a cycloheptyl group, a cyclooctyl group, an adamantyl group, a norbornyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a ($C_1$-$C_{20}$ alkyl)cyclopentyl group, a ($C_1$-$C_{20}$ alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantanyl group, a ($C_1$-$C_{20}$ alkyl)norbornanyl group, a ($C_1$-$C_{20}$ alkyl)norbornenyl group, a ($C_1$-$C_{20}$ alkyl)cyclopentenyl group, a ($C_1$-$C_{20}$ alkyl)cyclohexenyl group, a ($C_1$-$C_{20}$ alkyl)cycloheptenyl group, a ($C_1$-$C_{20}$ alkyl)bicyclo[1.1.1]pentyl group, a ($C_1$-$C_{20}$ alkyl)bicyclo[2.1.1]hexyl group, a ($C_1$-$C_{20}$ alkyl)bicyclo[2.2.1]heptyl group, a ($C_1$-$C_{20}$ alkyl)bicyclo[2.2.2]octyl group, or any combination thereof.

In one embodiment, $L_2$ in Formula 1 may be a group represented by Formula 3-1-1, but embodiments of the present disclosure are not limited thereto:

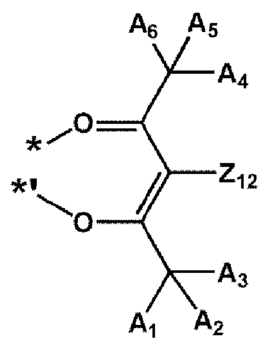

3-1-1 .

In Formula 3-1-1,

$Z_{12}$ may be the same as defined in connection with $R_{21}$,
$A_2$ and $A_5$ may each independently be hydrogen, deuterium, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic condensed polycyclic group, or a substituted or unsubstituted monovalent non-aromatic condensed heteropolycyclic group,
$A_1$, $A_3$, $A_4$, and $A_6$ may each independently be a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic condensed polycyclic group, or a substituted or unsubstituted monovalent non-aromatic condensed heteropolycyclic group,
two or more of $A_1$ to $A_6$ may optionally be linked to form a $C_5$-$C_{30}$ carbocyclic group unsubstituted or substituted with at least one $R_{1a}$ or a $C_1$-$C_{30}$ heterocyclic group unsubstituted or substituted with at least one $R_{1a}$,
$R_{1a}$ may be the same as defined in connection with $Z_{12}$,
a substitute(s) of the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_6$-$C_{60}$ aryloxy group, the substituted $C_6$-$C_{60}$ arylthio group, the substituted $C_1$-$C_{60}$ heteroaryl group, the substituted monovalent non-aromatic condensed polycyclic group, and the substituted monovalent non-aromatic condensed heteropolycyclic group may be:

deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, or a $C_1$-$C_{60}$ alkoxy group;
a $C_1$-$C_{60}$ alkyl group, a $C_2$-$C_{60}$ alkenyl group, a $C_2$-$C_{60}$ alkynyl group, or a $C_1$-$C_{60}$ alkoxy group, each substituted with deuterium, -F, -Cl, -Br, -I, $-CD_3$, $-CD_2H$, $-CDH_2$, $-CF_3$, - $CF_2H$, $-CFH_2$, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, a monovalent non-aromatic condensed heteropolycyclic group, $-N(Q_{11})(Q_{12})$, - $Si(Q_{13})(Q_{14})(Q_{15})$, $-Ge(Q_{13})(Q_{14})(Q_{15})$, $-B(Q_{16})(Q_{17})$, $-P(=O)(Q_{18})(Q_{19})$, $-P(Q_{18})(Q_{19})$, or any combination thereof;
a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, or a monovalent non-aromatic condensed heteropolycyclic group, each unsubstituted or substituted with deuterium, -F, -Cl, -Br, -I, $-CD_3$, $-CD_2H$, $-CDH_2$, $-CF_3$, - $CF_2H$, $-CFH_2$, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, a monovalent non-aromatic condensed heteropolycyclic group, $-N(Q_{21})(Q_{22})$, - $Si(Q_{23})(Q_{24})(Q_{25})$, $-Ge(Q_{23})(Q_{24})(Q_{25})$, $-B(Q_{26})(Q_{27})$, $-P(=O)(Q_{28})(Q_{29})$, $-P(Q_{28})(Q_{29})$, or any combination thereof;
$-N(Q_{31})(Q_{32})$, $-Si(Q_{33})(Q_{34})(Q_{35})$, $-Ge(Q_{33})(Q_{34})(Q_{35})$, $-B(Q_{36})(Q_{37})$, $-P(=O)(Q_{38})(Q_{39})$, or $-P(Q_{38})(Q_{39})$; or any combination thereof.

In the present specification, $Q_{11}$ to $Q_{19}$, $Q_{21}$ to $Q_{29}$, and $Q_{31}$ to $Q_{39}$ may each independently be hydrogen;

deuterium; -F; -Cl; -Br; -I; a hydroxyl group; a cyano group; a nitro group; an amidino group; a hydrazine group; a hydrazone group; a carboxylic acid group or a salt thereof; a sulfonic acid group or a salt thereof; a phosphoric acid group or a salt thereof; a $C_1$-$C_{60}$ alkyl group unsubstituted or substituted with deuterium, a $C_1$-$C_{60}$ alkyl group, a $C_6$-$C_{60}$ aryl group, or any combination thereof; a $C_2$-$C_{60}$ alkenyl group; a $C_2$-$C_{60}$ alkynyl group; a $C_1$-$C_{60}$ alkoxy group; a $C_3$-$C_{10}$ cycloalkyl group; a $C_1$-$C_{10}$ heterocycloalkyl group; a $C_3$-$C_{10}$ cycloalkenyl group; a $C_1$-$C_{10}$ heterocycloalkenyl group; a $C_6$-$C_{60}$ aryl group unsubstituted or substituted with deuterium, a $C_1$-$C_{60}$ alkyl group, a $C_6$-$C_{60}$ aryl group, or any combination thereof; a $C_6$-$C_{60}$ aryloxy group; a $C_6$-$C_{60}$ arylthio group; a $C_7$-$C_{60}$ arylalkyl group; a $C_1$-$C_{60}$ heteroaryl group; a $C_1$-$C_{60}$ heteroaryloxy group; a $C_1$-$C_{60}$ heteroarylthio group; a $C_2$-$C_{60}$ heteroarylalkyl group; a monovalent non-aromatic condensed polycyclic group; or a monovalent non-aromatic condensed heteropolycyclic group.

For example, $A_1$ to $A_6$ and $Z_{12}$ in Formula 3-1-1 may each independently be:

hydrogen, deuterium, a cyano group, $C_1$-$C_{20}$ alkyl group, or a $C_1$-$C_{20}$ alkoxy group;
a $C_1$-$C_{20}$ alkyl group and a $C_1$-$C_{20}$ alkoxy group, each substituted with deuterium, -F, $-CD_3$, $-CD_2H$, $-CDH_2$, $-CF_3$, $-CF_2H$, $-CFH_2$, a cyano group, a $C_1$-$C_{10}$ alkyl group, a cyclopentyl group, a cyclohexyl group, a cycloheptyl group, a cyclooctyl group, an adamantyl group, a norbornyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a ($C_1$-$C_{20}$ alkyl)cyclopentyl group, a ($C_1$-$C_{20}$ alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantanyl group, a ($C_1$-$C_{20}$ alkyl)norbornanyl group, a ($C_1$-$C_{20}$ alkyl)norbornenyl group, a ($C_1$-$C_{20}$ alkyl)cyclopentenyl group, a ($C_1$-$C_{20}$ alkyl)cyclohexenyl group, a ($C_1$-$C_{20}$ alkyl)cycloheptenyl group, a ($C_1$-$C_{20}$ alkyl)bicyclo[1.1.1]pentyl group, a ($C_1$-$C_{20}$ alkyl)bicyclo[2.1.1]hexyl group, a ($C_1$-$C_{20}$ alkyl)bicyclo[2.2.1]heptyl group, a ($C_1$-$C_{20}$ alkyl)bicyclo[2.2.2]octyl group, a phenyl group, a ($C_1$-$C_{20}$ alkyl)phenyl group, a biphenyl group, a terphenyl group, or any combination thereof; or
a cyclopentyl group, a cyclohexyl group, a cycloheptyl group, a cyclooctyl group, an adamantyl group, a norbornyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a phenyl group, a ($C_1$-$C_{20}$ alkyl)phenyl group, a biphenyl group, or a terphenyl group, each unsubstituted or substituted with deuterium, -F, $-CD_3$, $-CD_2H$, $-CDH_2$, $-CF_3$, $-CF_2H$, $-CFH_2$, a cyano group, a $C_1$-$C_{20}$ alkyl group, a deuterium-containing $C_2$-$C_{20}$ alkyl group (for example, *-$C(CD_3)_3$), a cyclopentyl group, a cyclohexyl group, a cycloheptyl group, a cyclooctyl group, an adamantyl group, a norbornyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a ($C_1$-$C_{20}$ alkyl)cyclopentyl group, a ($C_1$-$C_{20}$ alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantanyl group, a ($C_1$-$C_{20}$ alkyl)norbornanyl group, a ($C_1$-$C_{20}$ alkyl)norbornenyl group, a ($C_1$-$C_{20}$ alkyl)cyclopentenyl group, a ($C_1$-$C_{20}$ alkyl)cyclohexenyl group, a ($C_1$-$C_{20}$ alkyl)cycloheptenyl group, a ($C_1$-$C_{20}$ alkyl)bicyclo[1.1.1]pentyl group, a ($C_1$-$C_{20}$ alkyl)bicyclo[2.1.1]hexyl group, a ($C_1$-$C_{20}$ alkyl)bicyclo[2.2.1]heptyl group, a ($C_1$-$C_{20}$ alkyl)bicyclo[2.2.2]octyl group, a phenyl group, a ($C_1$-$C_{20}$ alkyl)phenyl group, a biphenyl group, a terphenyl group, or any combination thereof;
wherein each of $A_1$, $A_3$, $A_4$, and $A_6$ may not be hydrogen nor deuterium.

In one embodiment, $A_1$ to $A_6$ and $Z_{12}$ in Formula 3-1-1 may each independently be:

hydrogen or deuterium;
a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, or a sec-isopentyl group, each unsubstituted or substituted with deuterium, a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, or any combination thereof; or
a cyclopentyl group, a cyclohexyl group, a cycloheptyl group, a cyclooctyl group, an adamantyl group, a norbornyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a phenyl group, a ($C_1$-$C_{20}$ alkyl)phenyl group, a biphenyl group, or a terphenyl group, each unsubstituted or substituted with deuterium, -F, $-CD_3$, $-CD_2H$, $-CDH_2$, $-CF_3$, $-CF_2H$, $-CFH_2$, a cyano group, a $C_1$-$C_{20}$ alkyl group, a deuterium-containing $C_2$-$C_{20}$ alkyl group (for example, *-$C(CD_3)_3$), a cyclopentyl group, a cyclohexyl group, a cycloheptyl group, a cyclooctyl group, an adamantyl group, a norbornyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a ($C_1$-$C_{20}$ alkyl)cyclopentyl group, a ($C_1$-$C_{20}$ alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantanyl group, a ($C_1$-$C_{20}$ alkyl)norbornanyl group, a ($C_1$-$C_{20}$ alkyl)norbornenyl group, a ($C_1$-$C_{20}$ alkyl)cyclopentenyl group, a ($C_1$-$C_{20}$ alkyl)cyclohexenyl group,

a ($C_1$-$C_{20}$ alkyl)cycloheptenyl group, a ($C_1$-$C_{20}$ alkyl)bicyclo[1.1.1]pentyl group, a ($C_1$-$C_{20}$ alkyl)bicyclo[2.1.1]hexyl group, a ($C_1$-$C_{20}$ alkyl)bicyclo[2.2.1]heptyl group, a ($C_1$-$C_{20}$ alkyl)bicyclo[2.2.2]octyl group, a phenyl group, a ($C_1$-$C_{20}$ alkyl)phenyl group, a biphenyl group, a terphenyl group, or any combination thereof;
wherein each of $A_1$, $A_3$, $A_4$, and $A_6$ may not be hydrogen nor deuterium.

In one or more embodiments, all of $A_1$ to $A_6$ in Formula 3-1-1 may not be hydrogen.
In one or more embodiments, all of $A_1$ to $A_6$ in Formula 3-1-1 may not be hydrogen nor deuterium.
In one or more embodiments, $L_1$ in Formula 1 may include at least one deuterium.
In one or more embodiments, $L_1$ in Formula 1 may include at least one fluoro group (-F).
In one or more embodiments, in Formula 2, a1 may not be 0 (zero) and at least one $R_1$ in number of a1 may include at least one deuterium.
In one or more embodiments, in Formula 2, a1 may not be 0 (zero) and at least one $R_1$ in number of a1 may include at least one fluoro group (-F).
In one or more embodiments, in Formula 2, a1 may be 0, 1 or 2.
In one or more embodiments, in Formula 2, a condensed cyclic group in which a ring $CY_{11}$ and a ring $CY_{12}$ are condensed with each other may have two, three or four rings which are condensed with each other.
The organometallic compound represented by Formula 1 may emit visible light having a maximum emission wavelength of, for example, about 450 nm or more and about 700 nm or less. For example, the visible light may be a red light.
The terms "an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluorene-9-one group, and an azadibenzothiophene 5,5-dioxide group" as used herein each refer to a hetero-ring having the same backbone as "an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluorene-9-one group, and a dibenzothiophene 5,5-dioxide group", in which at least one carbon atom constituting a ring of the aforementioned groups is replaced with nitrogen atom.
In one embodiment, the organometallic compound may be one of Compounds 1 to 366, but embodiments of the present disclosure are not limited thereto:

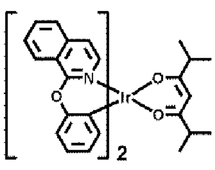
1

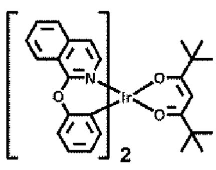
2

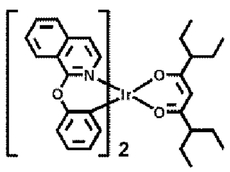
3

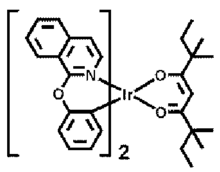
4

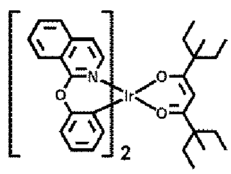
5

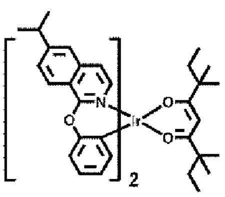
6

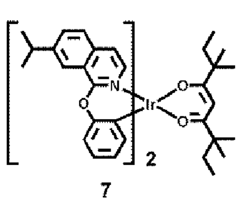
7

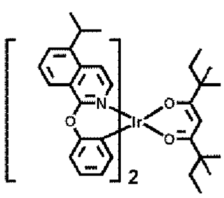
8

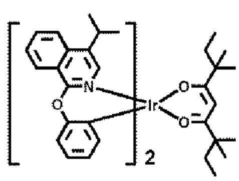
9

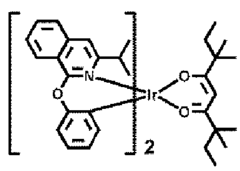
10

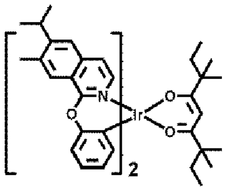
11

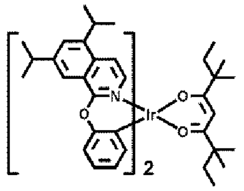
12

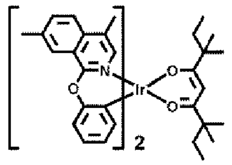
13

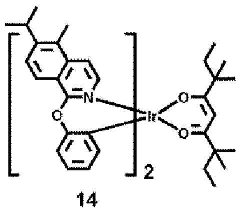
14

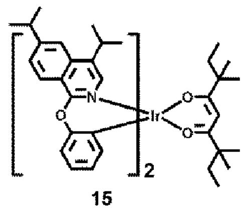
15

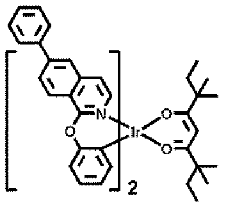
16

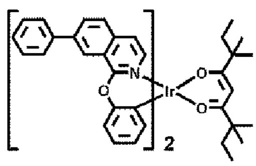
17

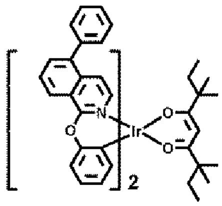
18

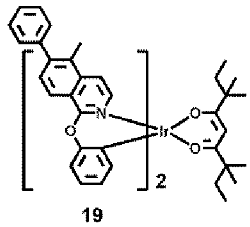
19

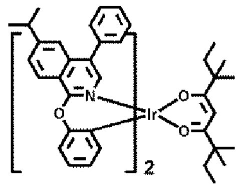
20

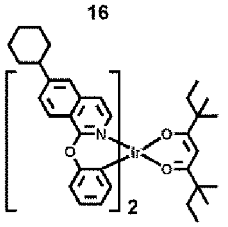
21

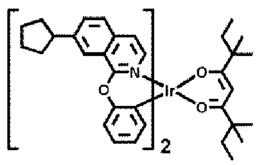
22

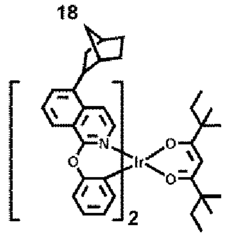
23

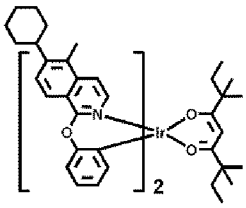
24

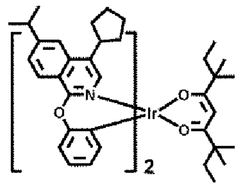
25

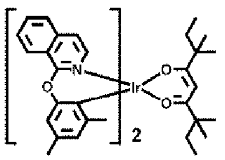
26

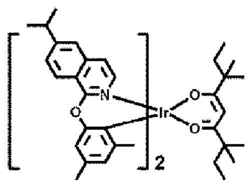
27

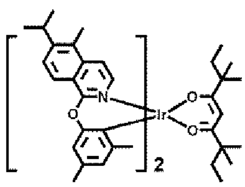
28

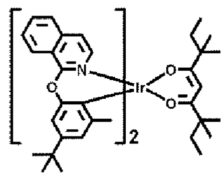
29

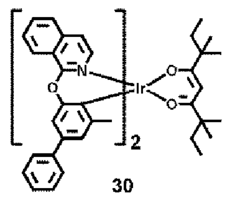
30

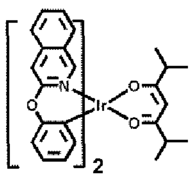
31

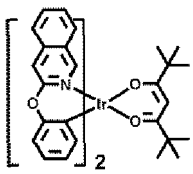
32

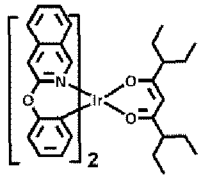
33

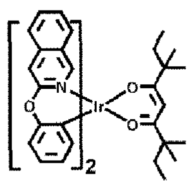
34

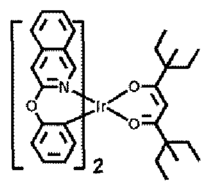
35

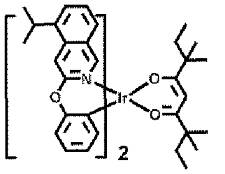
36
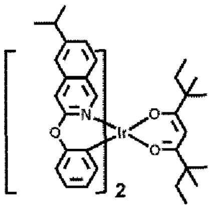
37
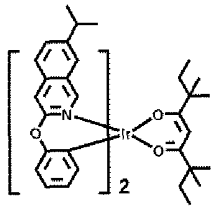
38
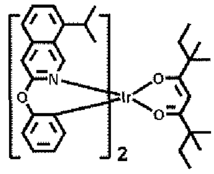
39
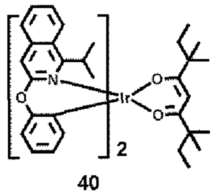
40

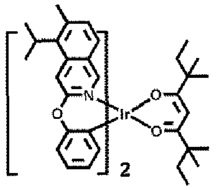
41
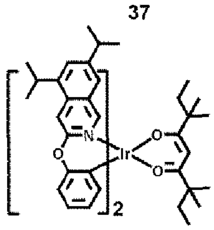
42
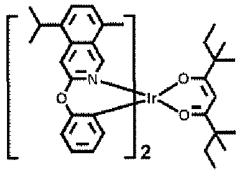
43
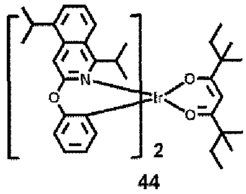
44
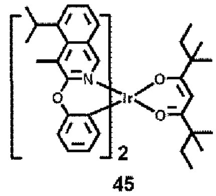
45

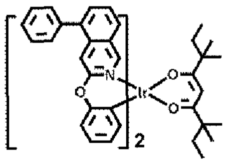
46
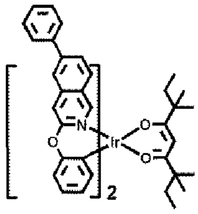
47
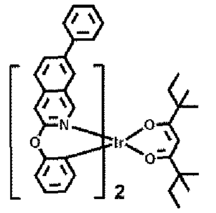
48
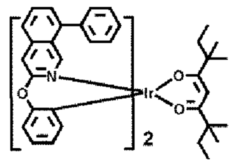
49
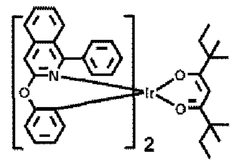
50

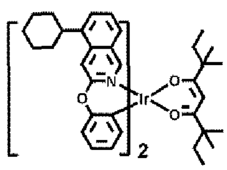
51
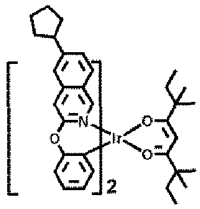
52
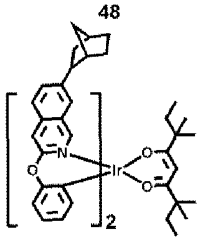
53
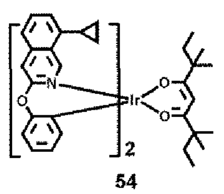
54
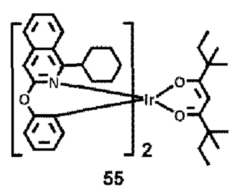
55

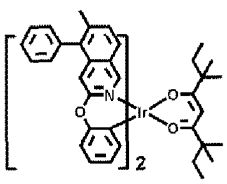
56
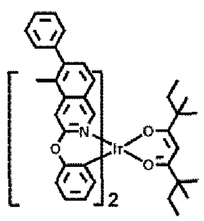
57
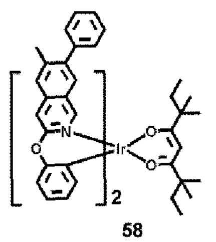
58
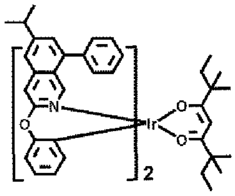
59
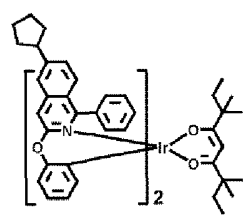
60

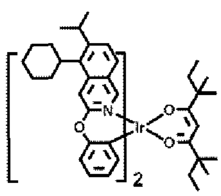
61
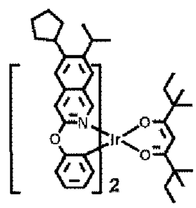
62
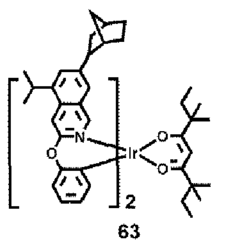
63
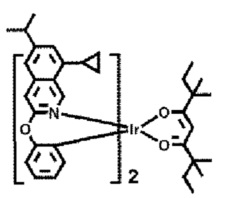
64
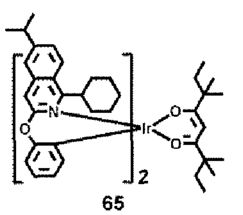
65

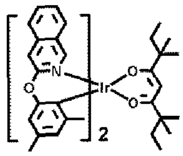
66
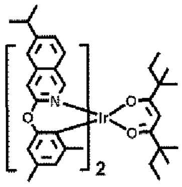
67
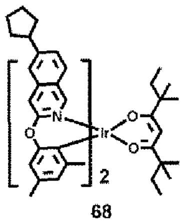
68
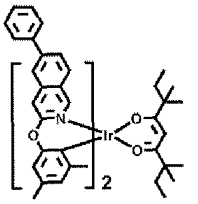
69
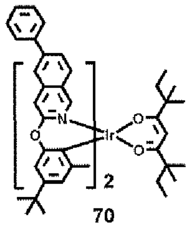
70
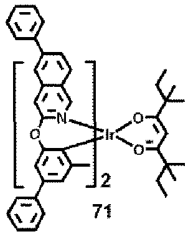
71

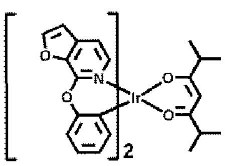
72
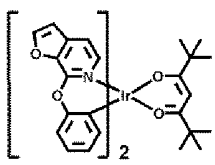
73
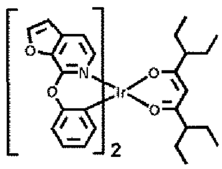
74
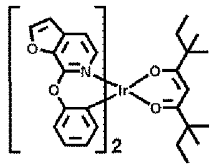
76
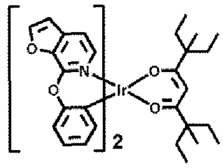
76

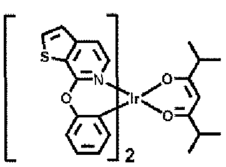
77
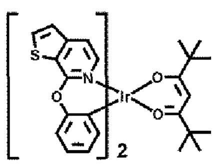
78
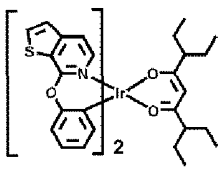
79
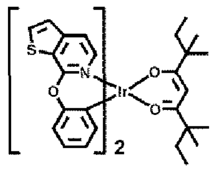
80
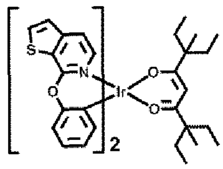
81

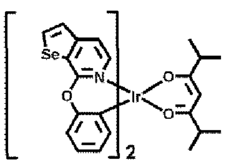
82
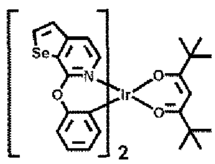
83
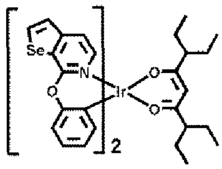
84
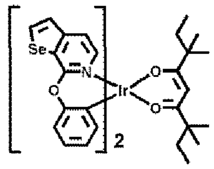
85
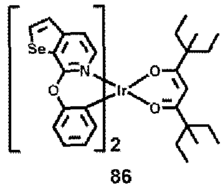
86

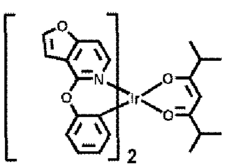
87
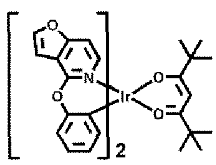
88
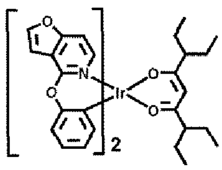
89
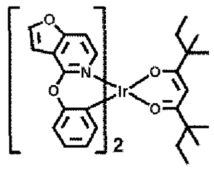
90
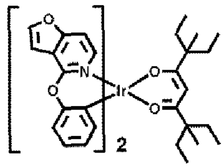
91

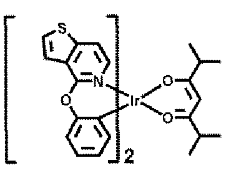
92
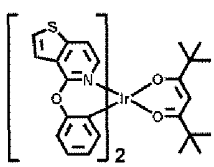
93
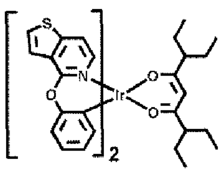
94
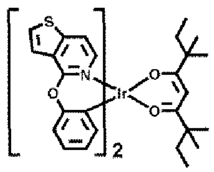
95
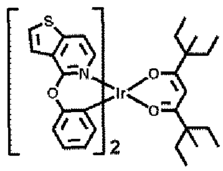
96

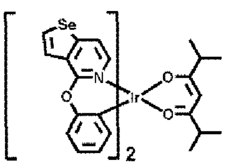
97
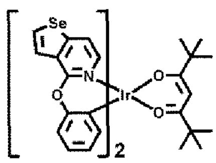
98
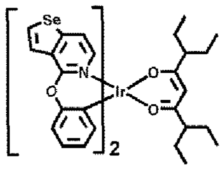
99
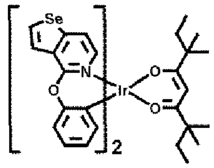
100
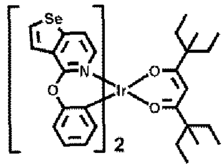
101

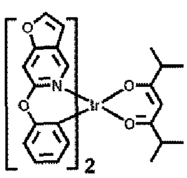
102
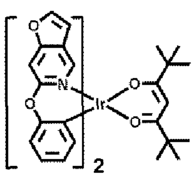
103
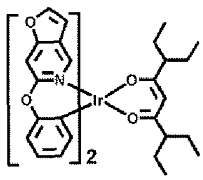
104
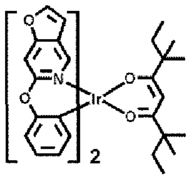
105
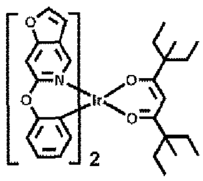
106

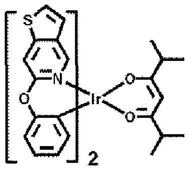
107
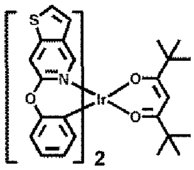
108
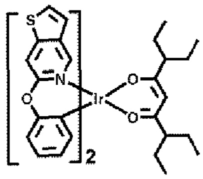
109
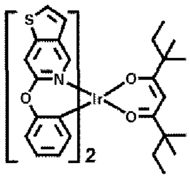
110
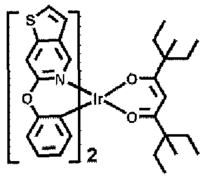
111

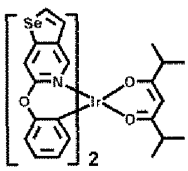
112
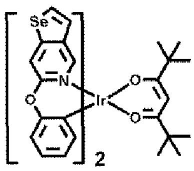
113
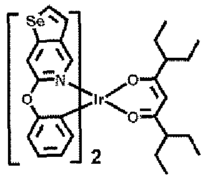
114
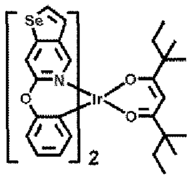
115
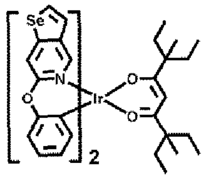
116

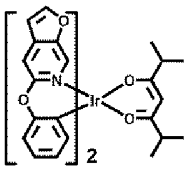
117
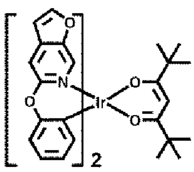
118
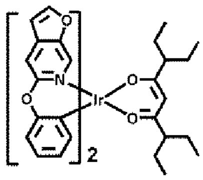
119
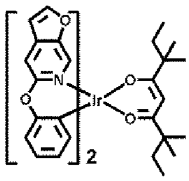
120
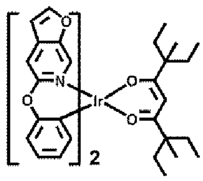
121

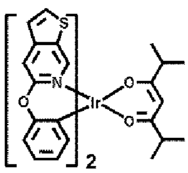
122
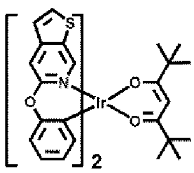
123
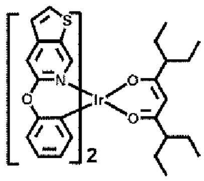
124
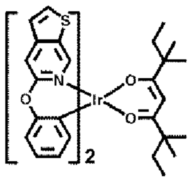
125
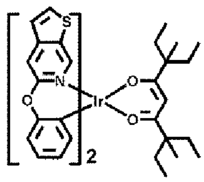
126

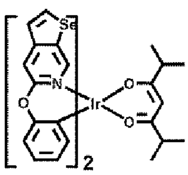
127
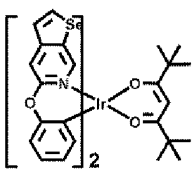
128
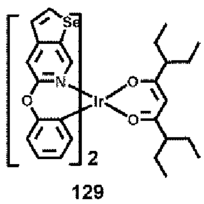
129
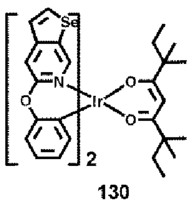
130
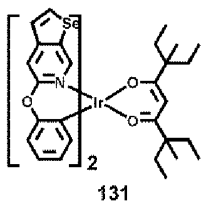
131

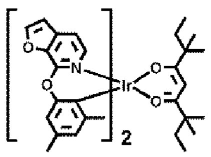
132
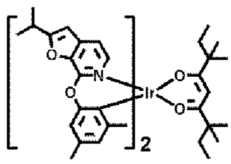
133
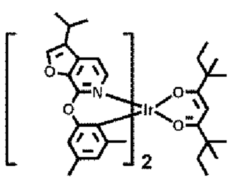
134
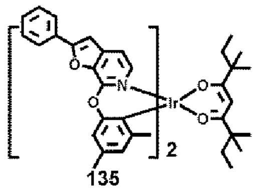
135
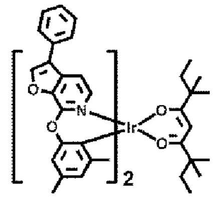
136

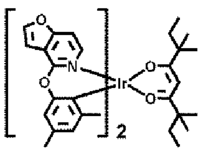
137
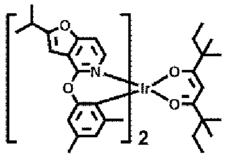
138
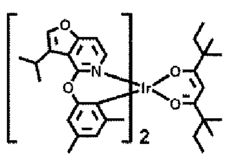
139
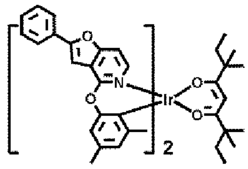
140
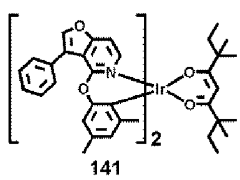
141

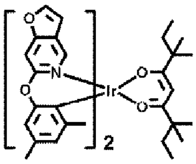
142
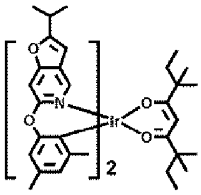
143
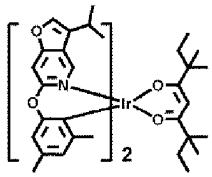
144
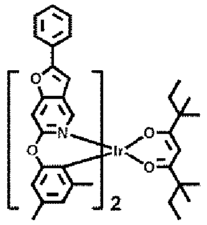
145
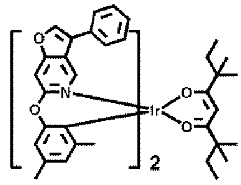
146

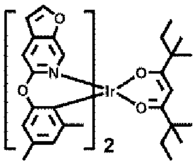
147
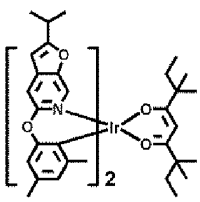
148
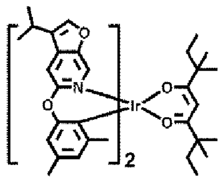
149
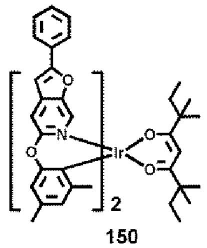
150
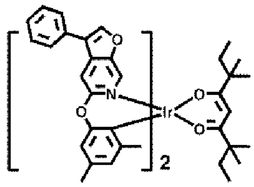
151

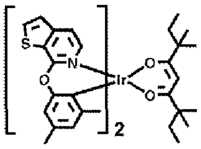
152
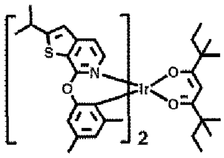
153
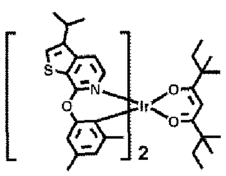
154
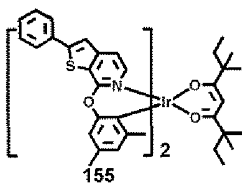
155
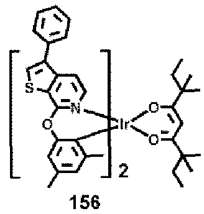
156

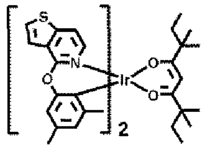
157
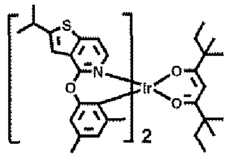
158
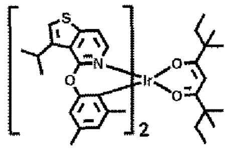
159
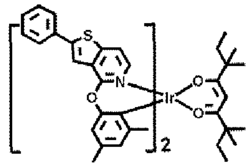
160
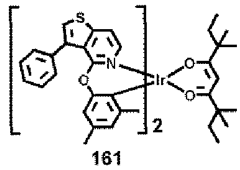
161

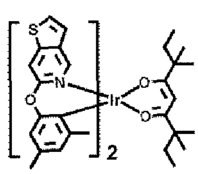
162

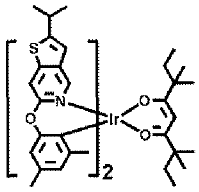
163

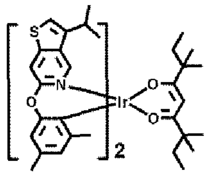
164

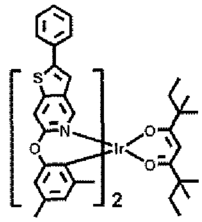
165

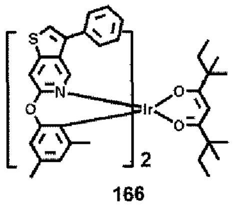
166

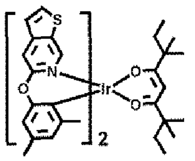
167

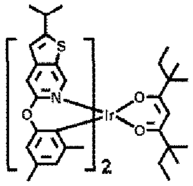
168

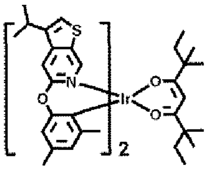
169

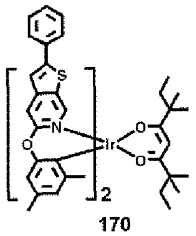
170

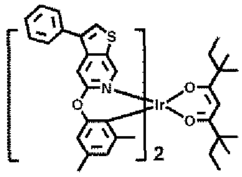
171

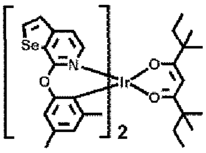
172

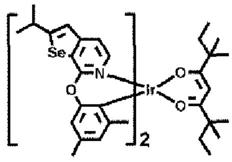
173

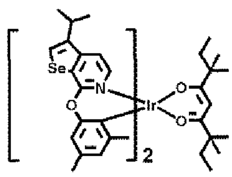
174

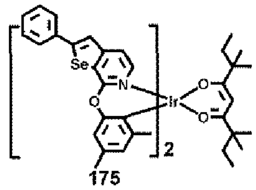
175

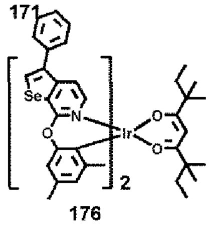
176

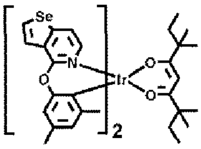
177

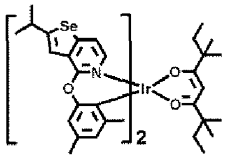
178

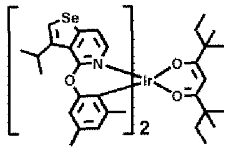
179

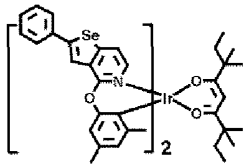
180

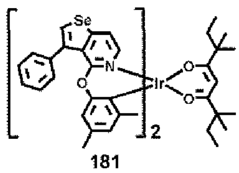
181

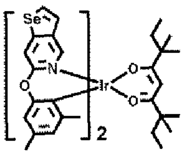
182

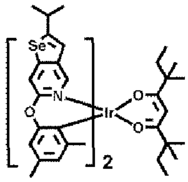
183

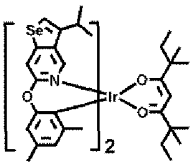
184

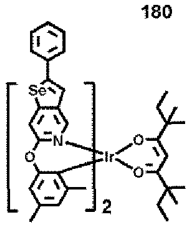
185

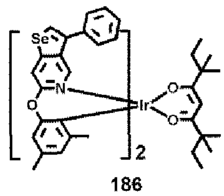
186

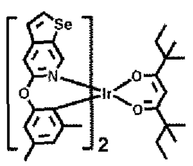
187

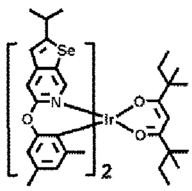
188

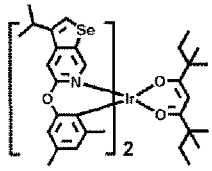
189

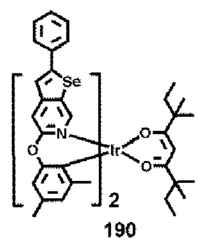
190

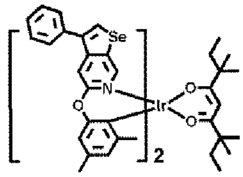
191

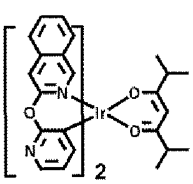
192

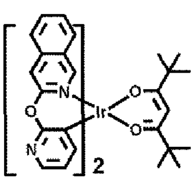
193

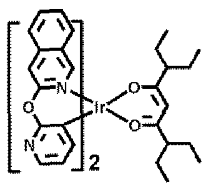
194

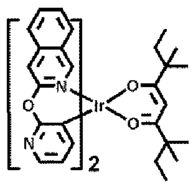
195

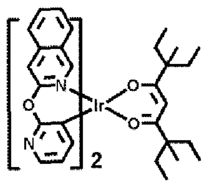
196

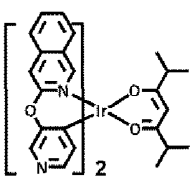
197

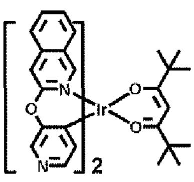
198

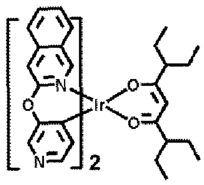
199

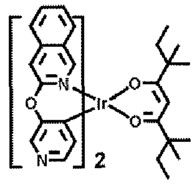
200

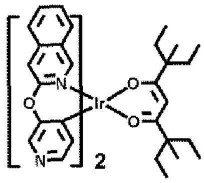
201

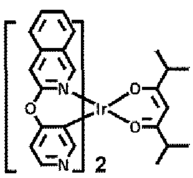
202

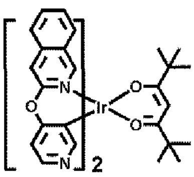
203

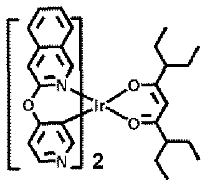
204

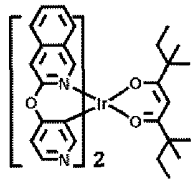
205

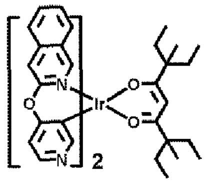
206

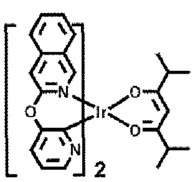
207

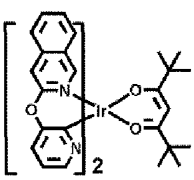
208

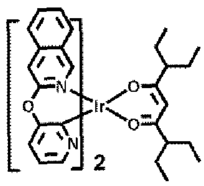
209

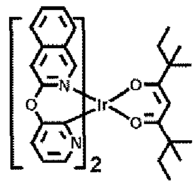
210

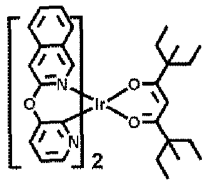
211

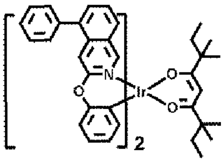
212

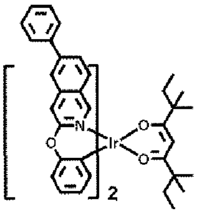
213

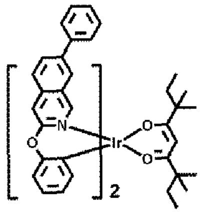
214

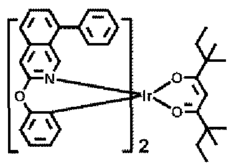
215

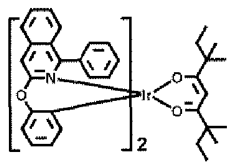
216

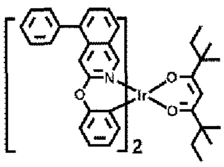
217

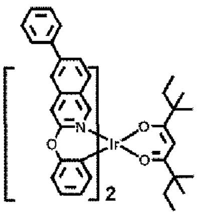
218

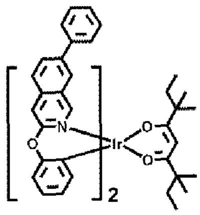
219

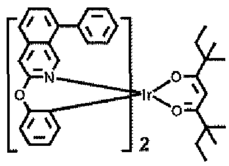
220

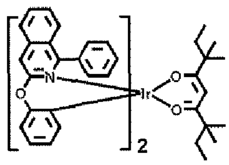
221

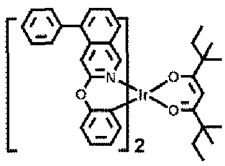
222

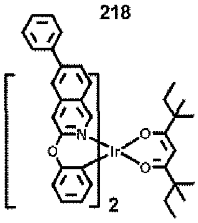
223

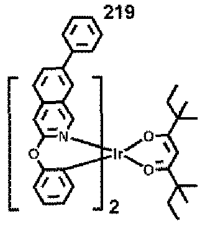
224

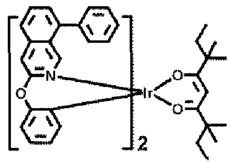
225

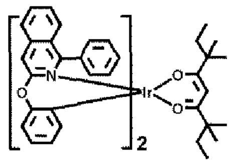
226

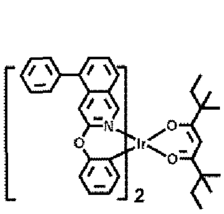
227

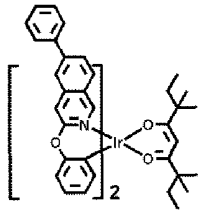
228

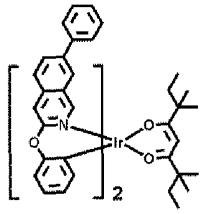
229

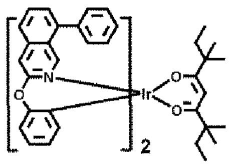
230

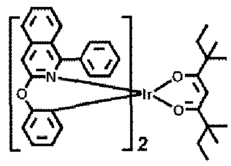
231

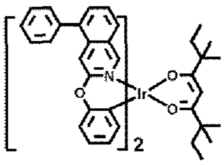
232

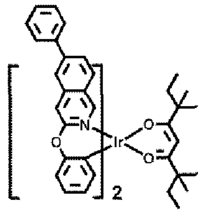
233

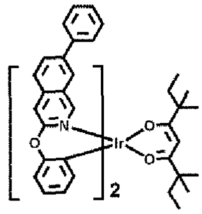
234

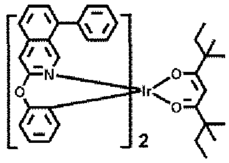
235

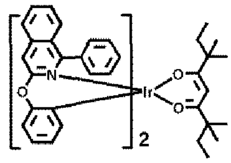
236

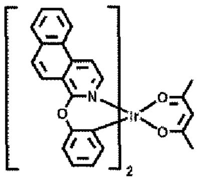
237

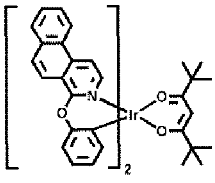
238

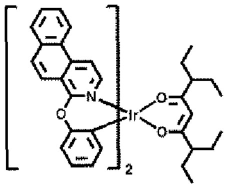
239

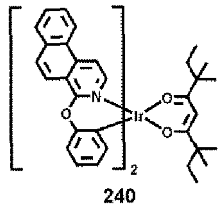
240

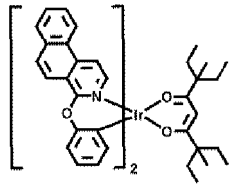
241

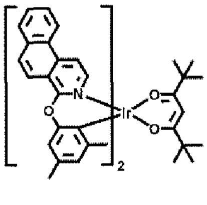
242

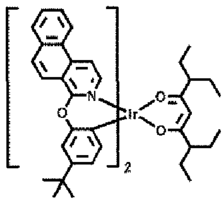
243

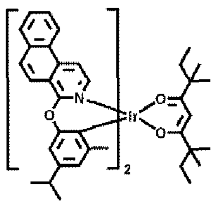
244

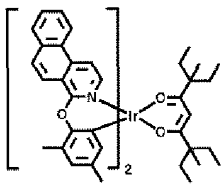
245

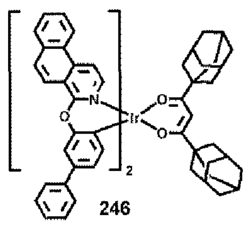
246

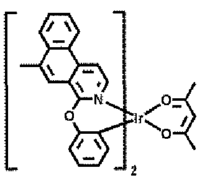
247

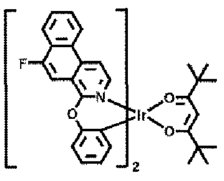
248

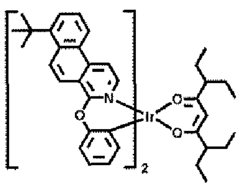
249

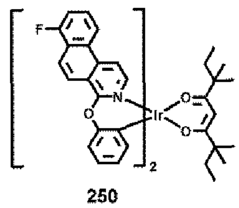
250

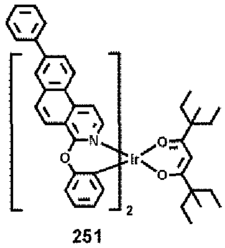
251

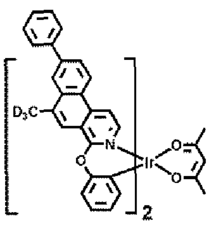
252

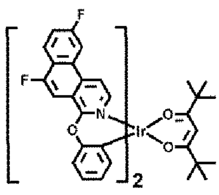
253

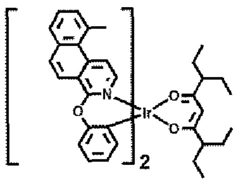
254

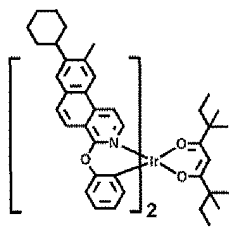
255

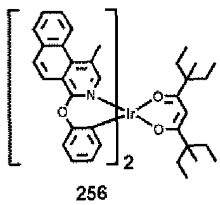
256

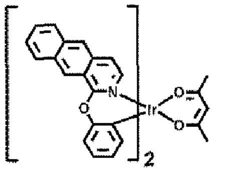
257

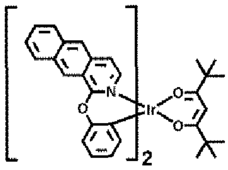
258

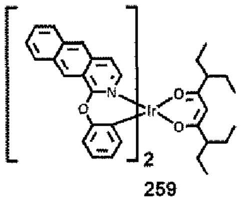
259

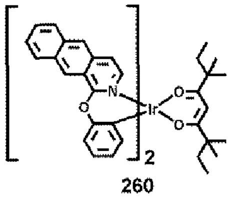
260

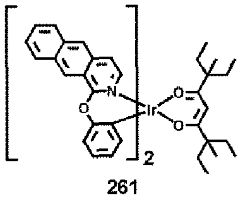
261

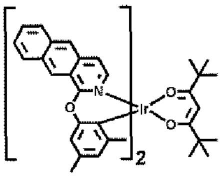
262

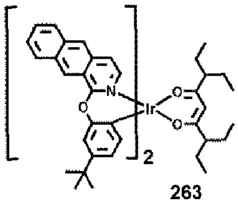
263

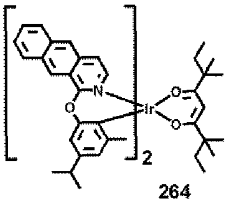
264

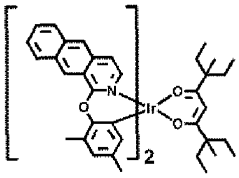
265

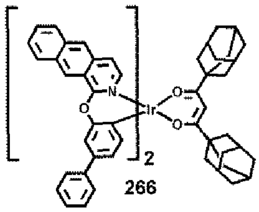
266

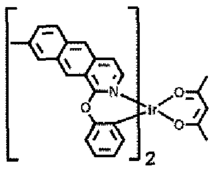
267

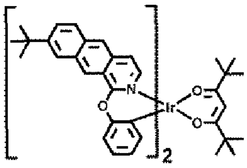
268

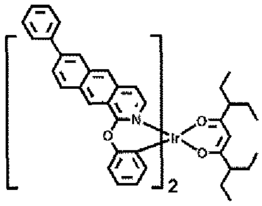
269

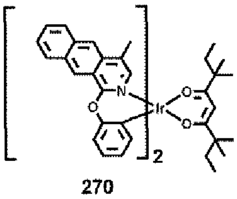
270

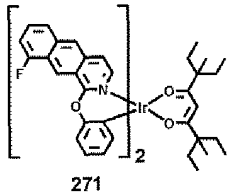
271

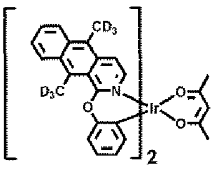
272

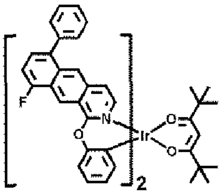
273

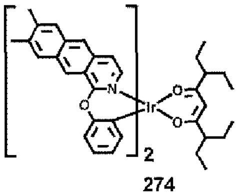
274

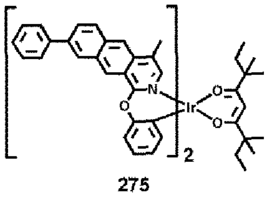
275

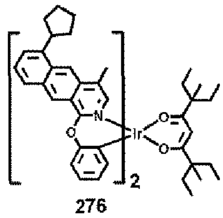
276

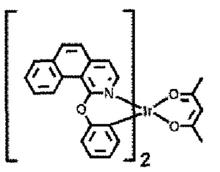
277

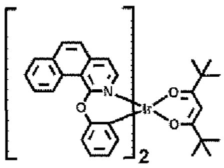
278

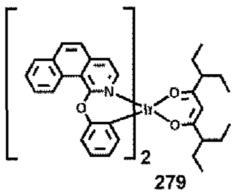
279

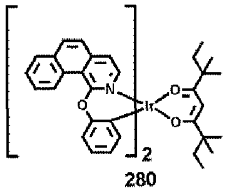
280

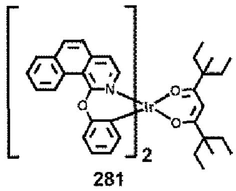
281

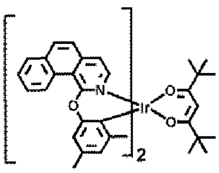
282

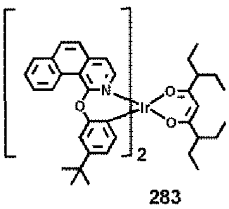
283

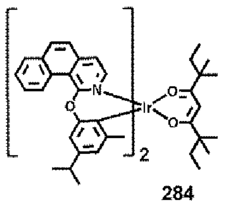
284

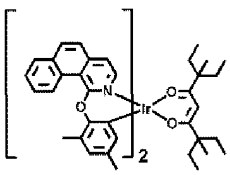
285

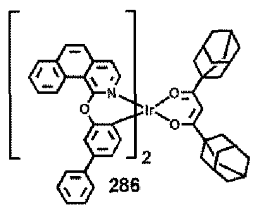
286

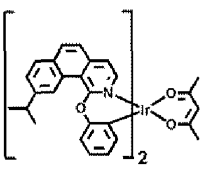
287

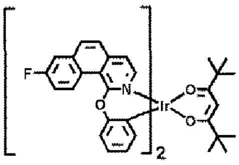
288

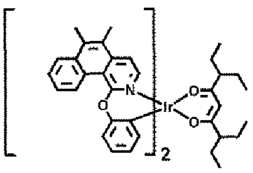
289

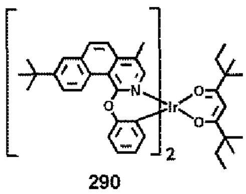
290

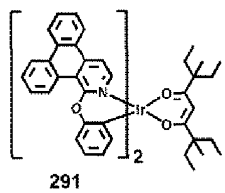
291

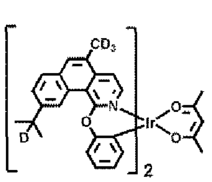
292
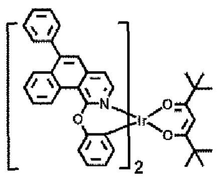
293
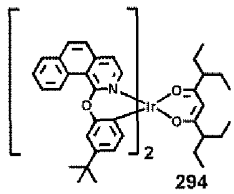
294
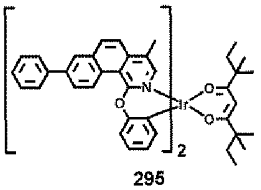
295
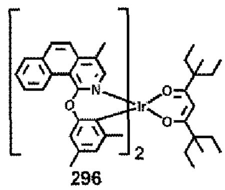
296
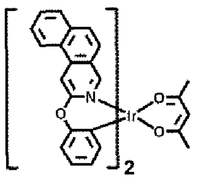
297
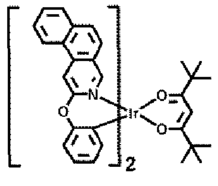
298
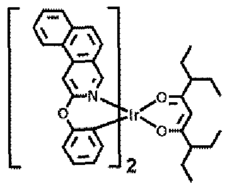
299
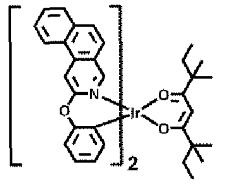
300
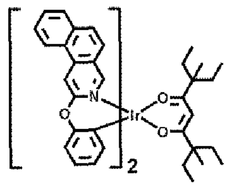
301
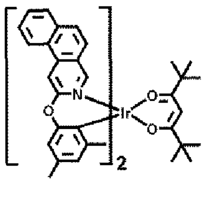
302
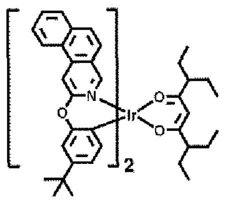
303
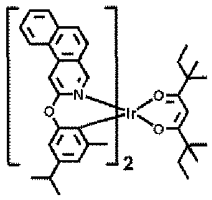
304
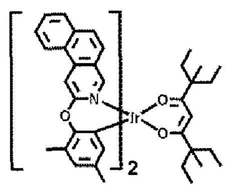
305
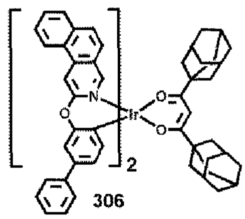
306
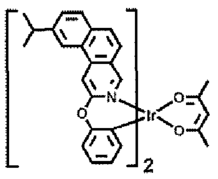
307
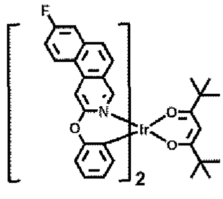
308
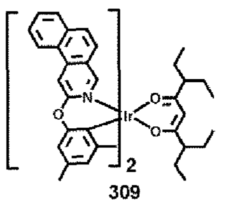
309
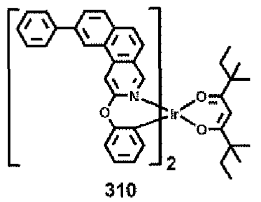
310
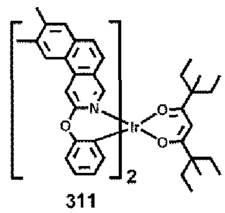
311
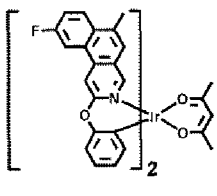
312
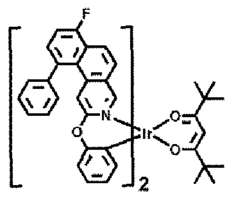
313
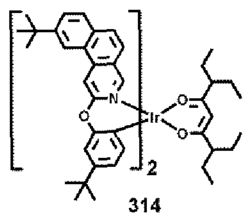
314
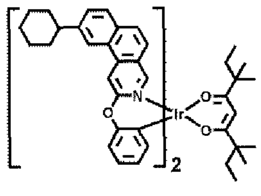
315
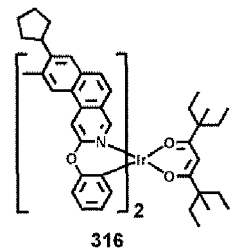
316
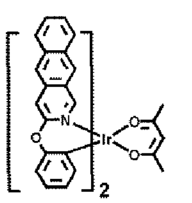
317
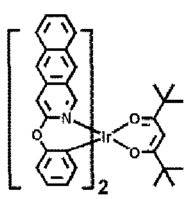
318
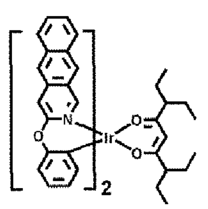
319
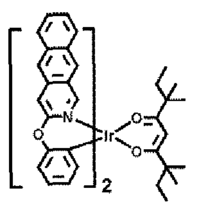
320
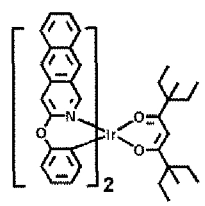
321

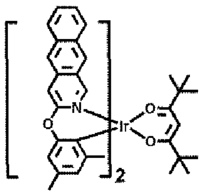
322

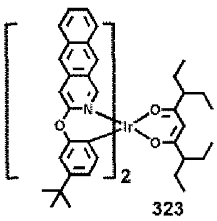
323

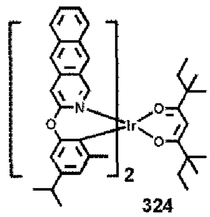
324

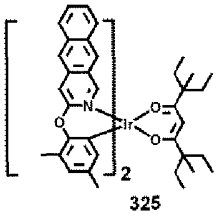
325

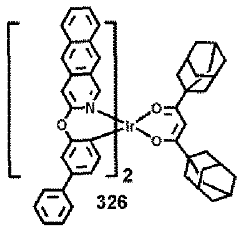
326

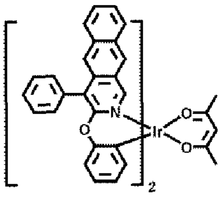
327

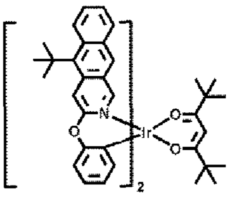
328

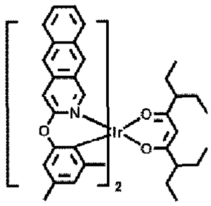
329

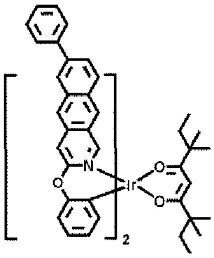
330

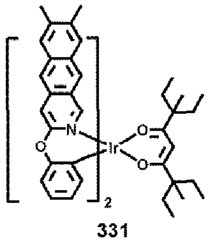
331

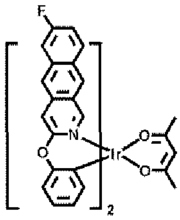
332

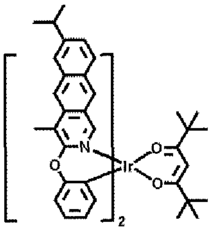
333

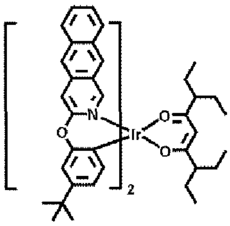
334

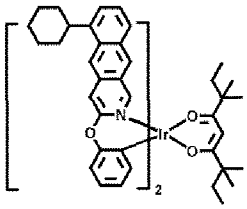
335

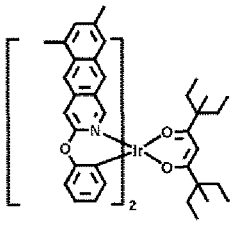
336

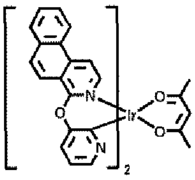
337

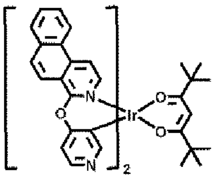
338

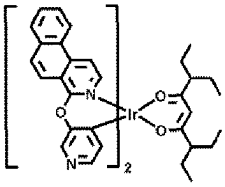
339

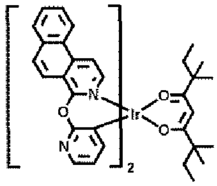
340

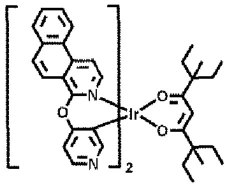
341

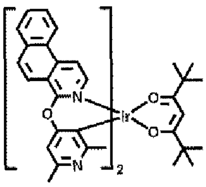
342

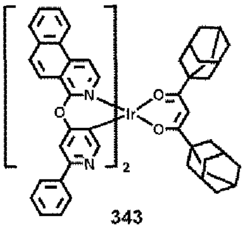
343

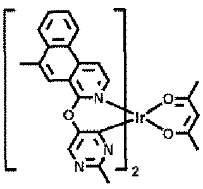
344

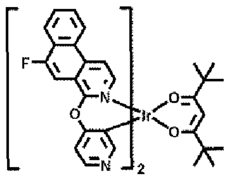
345

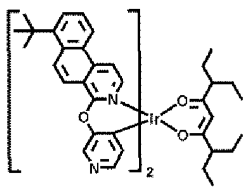
346

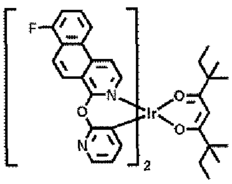
347

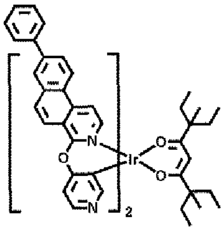
348

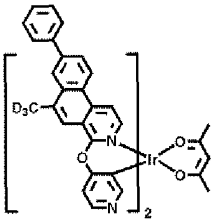
349

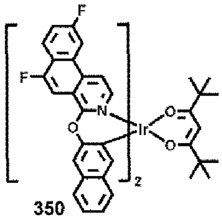
350

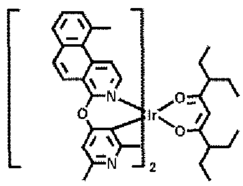
351

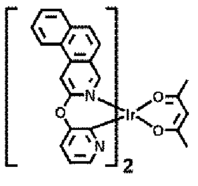
352
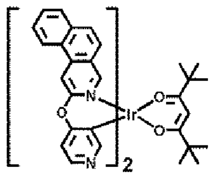
353
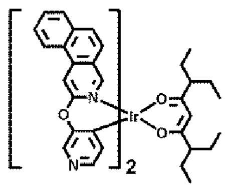
354
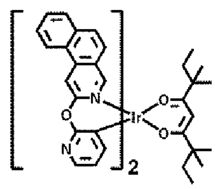
355
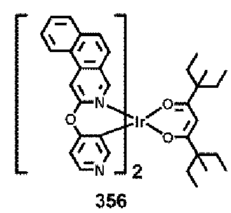
356

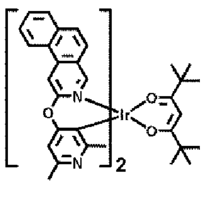
357
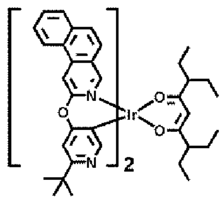
358
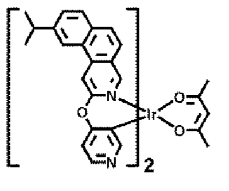
359
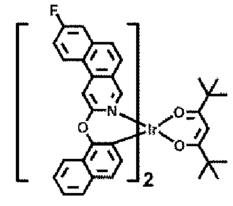
360
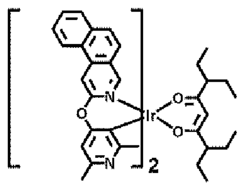
361

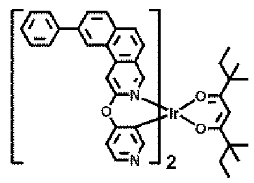
362
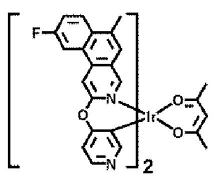
363
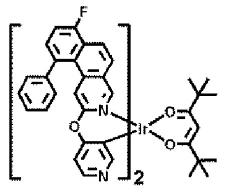
364
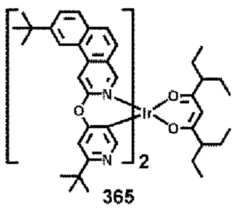
365
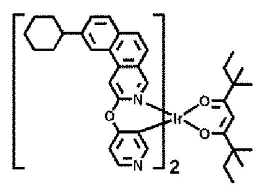
366

.

In the organometallic compound represented by Formula 1, $L_1$ may be a ligand represented by Formula 2, and n1 which indicates the number of $L_1$(s) may be 1, 2, or 3. That is, the organometallic compound may be a ligand linked to metal M, and essentially includes at least one ligand represent by Formula 2.

In Formula 2, ring $CY_{11}$ and ring $CY_{12}$ may be condensed with each other. In this regard, in the ligand represented by Formula 2, a conjugate length of a moiety (a phore) concering a lowest unoccupied molecular orbital (LUMO) may increase, thereby increasing the electron transition. Accordingly, the organometallic compound including the ligand represented by Formula 2 may have increased radiative decay, and therefore, an electronic device, for example, an organic light-emitting device, including the organometallic compound represented by Formula 1 may have improved luminescence efficiency, improved external quantum efficiency and/or improved lifetime.

In addition, $T_1$ in Formula 2 may be *-N($R_2$)-*', *-B($R_2$)-*', *-P($R_2$)-*', *-C($R_2$)($R_3$)-*', *-Si($R_2$)($R_3$)-*', *-Ge($R_2$)($R_3$)-*', *-S-*', *-Se-*', *-O-*', *-C(=O)-*', *-S(=O)-*', *-S(=O)$_2$-*', *-C($R_2$)=*', *=C($R_2$)-*', *-C($R_2$)=C($R_3$)-*', *-C(=S)-*', or *-C≡C-*'. That is, $T_1$ in Formula 2 may not be a single bond. In this regard, a non-covalent electron included in $T_1$ in the organometallic compound represented by Formula 1 may increase a spin-orbital coupling effect between the metal and the ligand, and therefore, an electronic device, for example, an organic light-emitting device, including the organometallic compound represented by Formula 1 may have improved luminescence efficiency, improved external quantum efficiency and/or improved lifetime.

Furthermore, metal M in Formula 1 may be Ir, Os, Ti, Hf, Eu, Rh, or Ru. Although not limited to a particular theory, the organometallic compound represented by Formula 1 and having metal M may have, for example, a large spin-orbital coupling value relative to Pt. In this regard, the interphase transition between a triplet state and a singlet triplet may increase, thereby having relatively quantum luminescence efficiency and relatively short decay time. Therefore, an electronic device, for example, an organic light-emitting device, including the organometallic compound represented by Formula 1 may have improved lifespan.

A highest occupied molecular orbital (HOMO) energy level, a lowest unoccupied molecular orbital (LUMO) energy level, a band gap, a singlet ($S_1$) energy level and a triplet ($T_1$) energy level of some of the organometallic compound represented by Formula 1 were evaluated by using a Gaussian 09 program accompanied with optimization of molecular structure according to B3LYP-based density functional theory (DFT). Results thereof are shown in Table 1 below.

[Table 1]

| Compound No. | HOMO (eV) | LUMO (eV) | Band gap (eV) | $S_1$ (eV) | $T_1$ (eV) |
|---|---|---|---|---|---|
| 2 | -4.69 | -1.59 | 3.10 | 2.37 | 2.46 |
| 32 | -4.71 | -1.94 | 2.77 | 2.14 | 2.10 |
| 33 | -4.70 | -1.94 | 2.76 | 2.14 | 2.10 |
| 47 | -4.67 | -2.20 | 2.47 | 2.06 | 2.03 |
| 69 | -4.51 | -2.01 | 2.50 | 1.93 | 1.90 |

Referring to Table 1, it is confirmed that the organometallic compound represented by Formula 1 has such electric characteristics that are suitable for use in an electric device, for example, for use as a dopant for an organic light-emitting device.

Synthesis methods of the organometallic compound represented by Formula 1 may be recognizable by one of ordinary skill in the art by referring to Synthesis Examples provided below.

The organometallic compound represented by Formula 1 is suitable for use in an organic layer of an organic light-emitting device, for example, for use as a dopant in an emission layer of the organic layer. Thus, another aspect provides an organic light-emitting device that includes: a first electrode; a second electrode; and an organic layer that is disposed between the first electrode and the second electrode and includes an organic layer including an emission layer and at least one of the organometallic compound represented by Formula 1.

The organic light-emitting device may have, due to the inclusion of an organic layer including the organometallic compound represented by Formula 1, a low driving voltage, high external quantum efficiency, a long lifespan, and a low roll-off ratio.

The organometallic compound represented by Formula 1 may be used between a pair of electrodes of an organic light-emitting device. For example, the organometallic compound represented by Formula 1 may be included in the emission layer. In this regard, the organometallic compound may act as a dopant, and the emission layer may further include a host (that is, an amount of the organometallic compound represented by Formula 1 is smaller than an amount of the host). The emission layer may emit visible light having a maximum emission wavelength of, for example, about 450 nm or more and about 700 nm or less.

The expression "(an organic layer) includes at least one organometallic compounds" used herein may include a case in which "(an organic layer) includes identical organometallic compounds represented by Formula 1" and a case in which "(an organic layer) includes two or more different organometallic compounds represented by Formula 1".

For example, the organic layer may include, as the organometallic compound, only Compound 1. In this regard, Compound 1 may exist only in the emission layer of the organic light-emitting device. In one or more embodiments, the organic layer may include, as the organometallic compound, Compound 1 and Compound 2. In this regard, Compound 1 and Compound 2 may exist in an identical layer (for example, Compound 1 and Compound 2 all may exist in an emission layer).

The first electrode may be an anode, which is a hole injection electrode, and the second electrode may be a cathode, which is an electron injection electrode; or the first electrode may be a cathode, which is an electron injection electrode, and the second electrode may be an anode, which is a hole injection electrode.

In one embodiment, in the organic light-emitting device, the first electrode may be an anode, the second electrode may be a cathode, and the organic layer may further include a hole transport region between the first electrode and the emission layer and an electron transport region between the emission layer and the second electrode, wherein the hole transport region may include a hole injection layer, a hole transport layer, an electron blocking layer, or a buffer layer, or any combination thereof, and the electron transport region may include a hole blocking layer, an electron transport layer, an electron injection layer, or any combination thereof.

The term "organic layer" used herein refers to a single layer and/or a plurality of layers disposed between the first electrode and the second electrode of an organic light-emitting device. The "organic layer" may include, in addition to an organic compound, an organometallic complex including metal.

FIGURE is a schematic cross-sectional view of an organic light-emitting device 10 according to an embodiment. Hereinafter, the structure of an organic light-emitting device according to an embodiment and a method of manufacturing an organic light-emitting device according to an embodiment will be described in connection with the FIGURE. The organic light-emitting device 10 includes a first electrode 11, an organic layer 15, and a second electrode 19, which are sequentially stacked.

A substrate may be additionally disposed under the first electrode 11 or above the second electrode 19. For use as the substrate, any substrate that is used in general organic light-emitting devices may be used, and the substrate

may be a glass substrate or a transparent plastic substrate, each having excellent mechanical strength, thermal stability, transparency, surface smoothness, ease of handling, and water resistance.

The first electrode 11 may be formed by depositing or sputtering a material for forming the first electrode 11 on the substrate. The first electrode 11 may be an anode. The material for forming the first electrode 11 may be selected from materials with a high work function to facilitate hole injection. The first electrode 11 may be a reflective electrode, a semi-transmissive electrode, or a transmissive electrode. The material for forming the first electrode may be, for example, indium tin oxide (ITO), indium zinc oxide (IZO), tin oxide ($SnO_2$), and zinc oxide (ZnO). In one or more embodiments, the material for forming the first electrode 11 may be metal, such as magnesium (Mg), aluminum (Al), aluminum-lithium (Al-Li), calcium (Ca), magnesium-indium (Mg-In), or magnesium-silver (Mg-Ag).

The first electrode 11 may have a single-layered structure or a multi-layered structure including two or more layers. For example, the first electrode 11 may have a three-layered structure of ITO/Ag/ITO, but the structure of the first electrode 110 is not limited thereto.

The organic layer 15 is disposed on the first electrode 11.

The organic layer 15 may include a hole transport region, an emission layer, and an electron transport region.

The hole transport region may be disposed between the first electrode 11 and the emission layer.

The hole transport region may include a hole injection layer, a hole transport layer, an electron blocking layer, a buffer layer, or any combination thereof.

The hole transport region may include only either a hole injection layer or a hole transport layer. In one or more embodiments, the hole transport region may have a hole injection layer/hole transport layer structure or a hole injection layer/hole transport layer/electron blocking layer structure, which are sequentially stacked in this stated order from the first electrode 11.

When the hole transport region includes a hole injection layer, the hole injection layer may be formed on the first electrode 11 by using one or more suitable methods, for example, vacuum deposition, spin coating, casting, and/or Langmuir-Blodgett (LB) deposition.

When a hole injection layer is formed by vacuum deposition, the deposition conditions may vary according to a material that is used to form the hole injection layer, and the structure and thermal characteristics of the hole injection layer. For example, the deposition conditions may include a deposition temperature of about 100 °C to about 500 °C, a vacuum pressure of about $10^{-8}$ to about $10^{-3}$ torr (1.33-0.0000133 Pa) and a deposition rate of about 0.01 Å/sec to about 100 Å/sec. However, the deposition conditions are not limited thereto.

When the hole injection layer is formed using spin coating, coating conditions may vary according to the material used to form the hole injection layer, and the structure and thermal properties of the hole injection layer. For example, a coating speed may be from about 2,000 rpm to about 5,000 rpm, and a temperature at which a heat treatment is performed to remove a solvent after coating may be from about 80 °C to about 200 °C. However, the coating conditions are not limited thereto.

Conditions for forming a hole transport layer and an electron blocking layer may be understood by referring to conditions for forming the hole injection layer.

The hole transport region may include m-MTDATA, TDATA, 2-TNATA, NPB, β-NPB, TPD, Spiro-TPD, Spiro-NPB, methylated-NPB, TAPC, HMTPD, 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonicacid (PANI/CSA), polyaniline/poly(4-styrenesulfonate) (PANI/PSS), a compound represented by Formula 201 below, a compound represented by Formula 202 below, or any combination thereof:

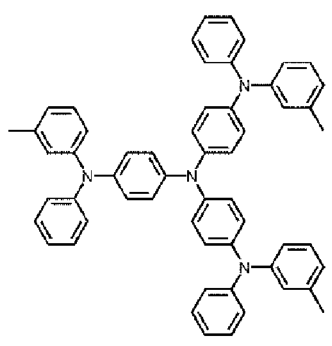

m-MTDATA

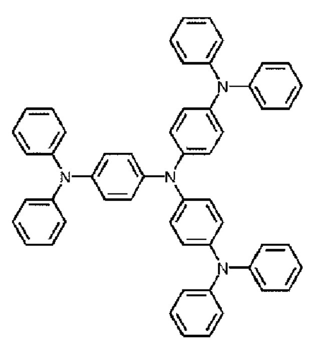

TDATA

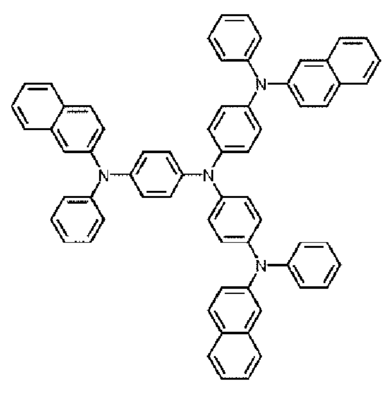

2-TNATA

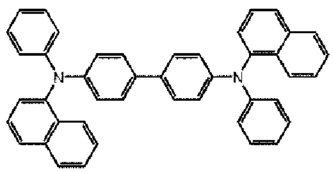

NPB

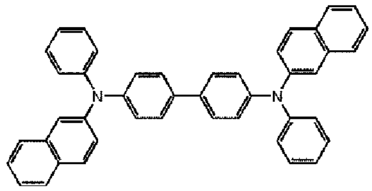

β-NPB

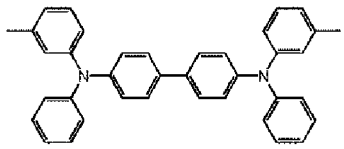

TPD

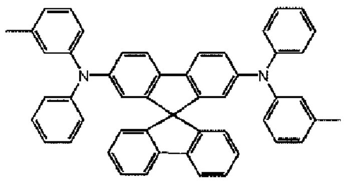

Spiro-TPD

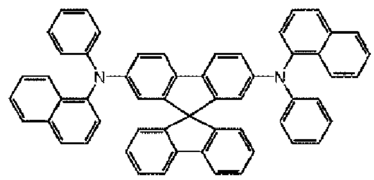

Spiro-NPB

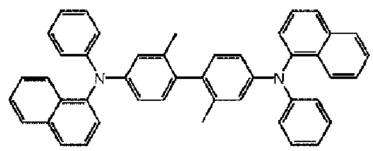

methylated NPB

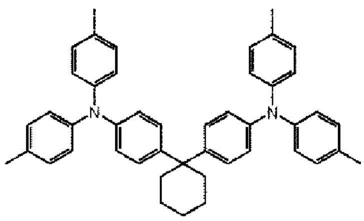

TAPC

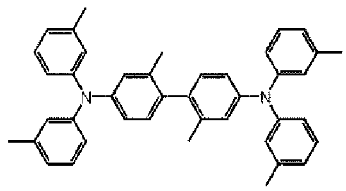

HMTPD

<Formula 201>

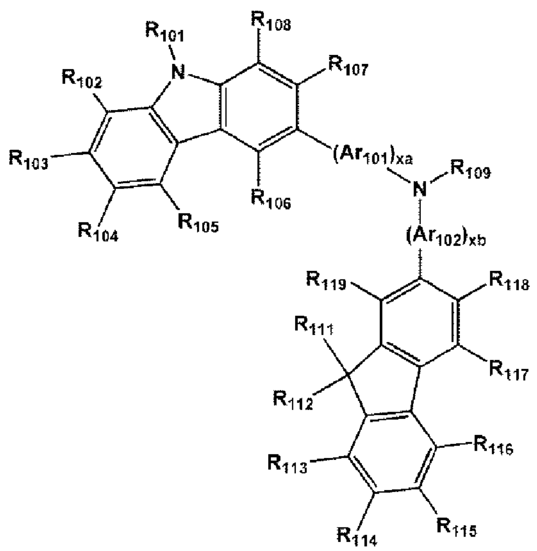

<Formula 202>

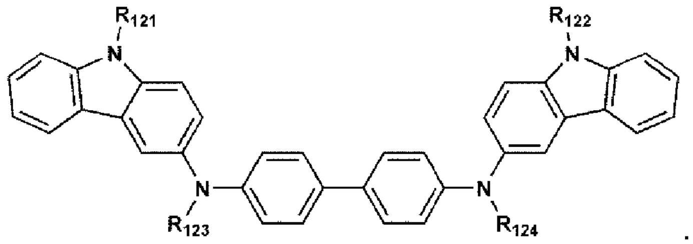

$Ar_{101}$ and $Ar_{102}$ in Formula 201 may each independently be a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, or a pentacenylene group, each unsubstituted or substituted with deuterium, -F, -Cl, -Br, -I, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_3$-$C_{10}$ cycloalkenyl group, a $C_1$-$C_{10}$ heterocycloalkyl group, a $C_1$-$C_{10}$ heterocycloalkenyl group, a C6-C60 aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, a monovalent non-aromatic condensed heteropolycyclic group, or any combination thereof.

In Formula 201, xa and xb may each independently be an integer from 0 to 5, or may be 0, 1, or 2. For example, xa may be 1 and xb may be 0, but xa and xb are not limited thereto.

In Formulae 201 and 202, $R_{101}$ to $R_{108}$, $R_{111}$ to $R_{119}$, and $R_{121}$ to $R_{124}$ may each independently be:

hydrogen, deuterium, -F, -Cl, -Br, -I, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, a $C_1$-$C_{10}$ alkyl group (for example, a methyl group, an ethyl group, a propyl group, a butyl group, pentyl group, a hexyl group, and the like), or a $C_1$-$C_{10}$ alkoxy group (for example, a methoxy group, an ethoxy group, a propoxy group, a butoxy group, a pentoxy group, and the like);

a $C_1$-$C_{10}$ alkyl group or a $C_1$-$C_{10}$ alkoxy group, each substituted with deuterium, -F, -Cl, -Br, -I, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, or any combination thereof; or

a phenyl group, a naphthyl group, an anthracenyl group, a fluorenyl group, or a pyrenyl group, each unsubstituted or substituted with deuterium, -F, -Cl, -Br, -I, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, a $C_1$-$C_{10}$ alkyl group, a $C_1$-$C_{10}$ alkoxy group, or any combination thereof.

In Formula 201, $R_{109}$ may be a phenyl group, a naphthyl group, an anthracenyl group, or a pyridinyl group, each unsubstituted or substituted with deuterium, -F, -Cl, -Br, -I, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a phenyl group, a naphthyl group, an anthracenyl group, a pyridinyl group, or any combination thereof.

In one embodiment, the compound represented by Formula 201 may be represented by Formula 201A, but embodiments of the present disclosure are not limited thereto:

<Formula 201A>

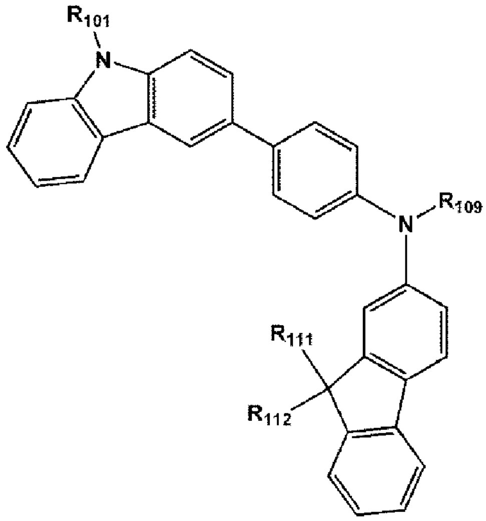

Detailed descriptions about $R_{101}$, $R_{111}$, $R_{112}$, and $R_{109}$ in Formula 201A are already described above.

For example, the compound represented by Formula 201, and the compound represented by Formula 202 may include compounds HT1 to HT20 illustrated below, but are not limited thereto:

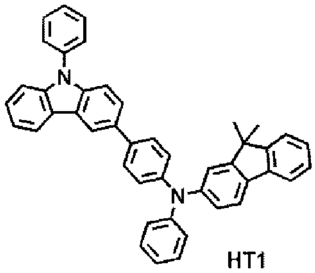
HT1

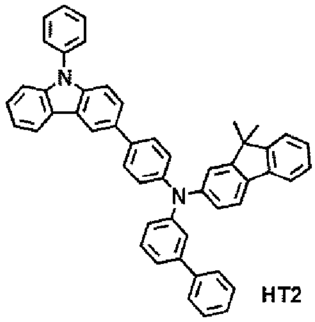
HT2

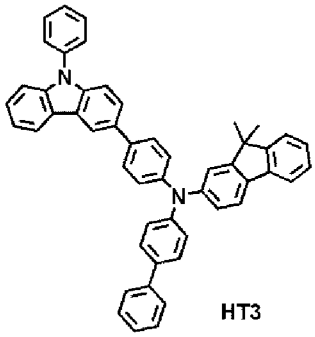
HT3

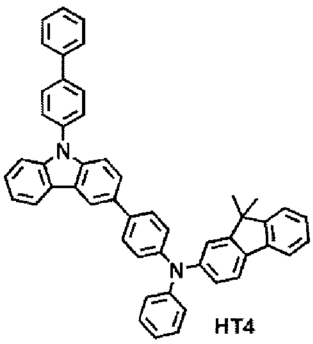
HT4

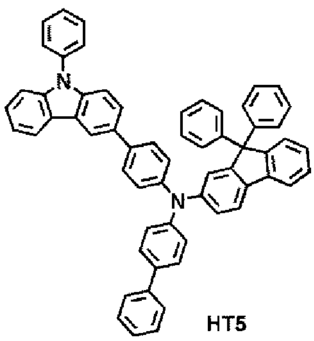
HT5

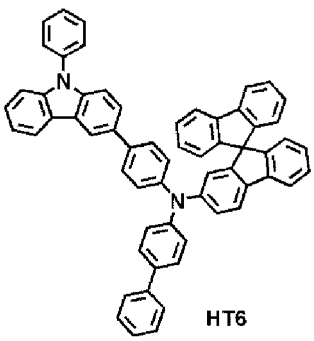
HT6

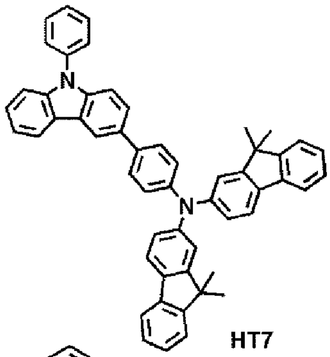

HT7

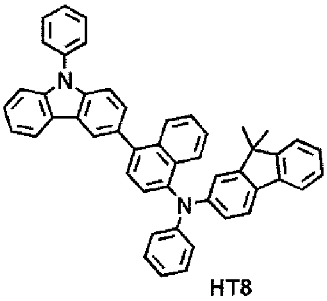

HT8

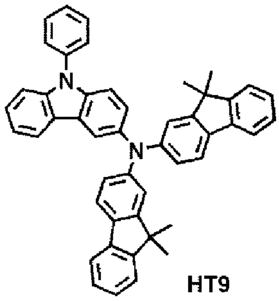

HT9

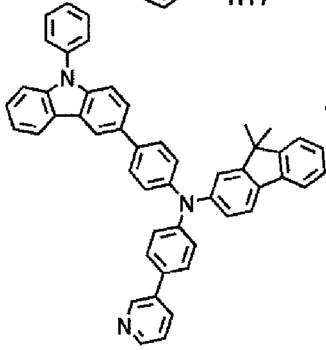

HT10

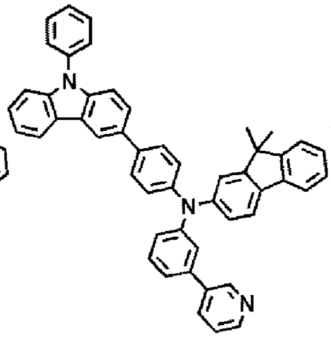

HT11

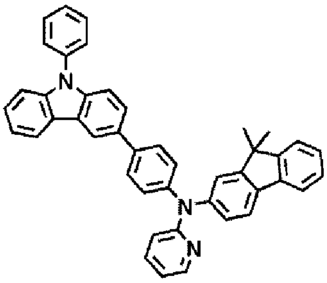

HT12

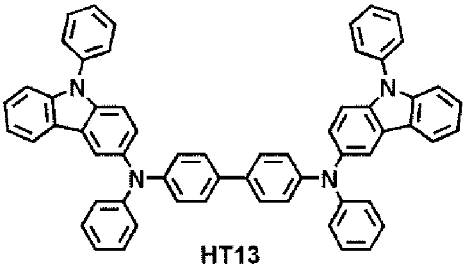

HT13

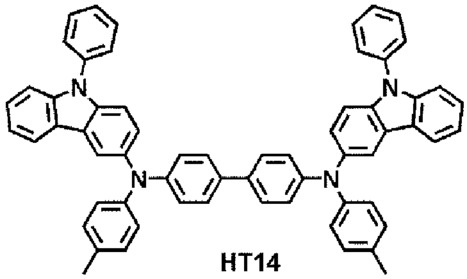

HT14

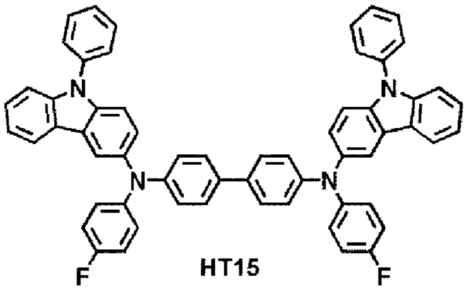

HT15

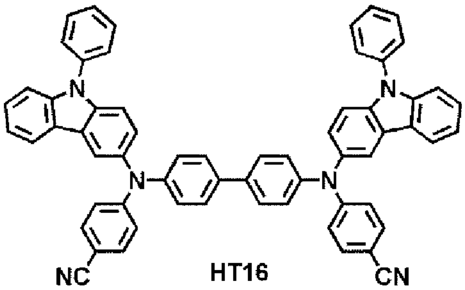

HT16

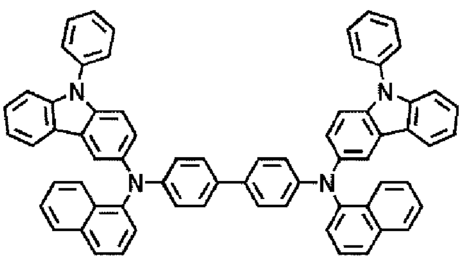

HT17

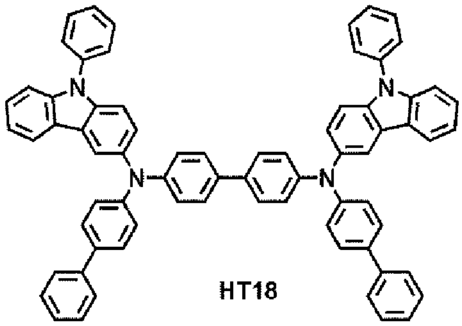

HT18

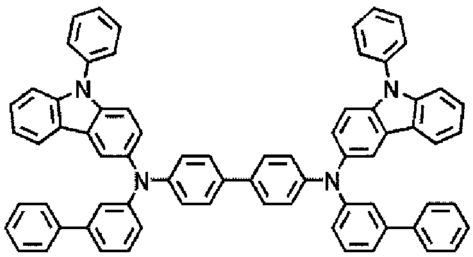

HT19

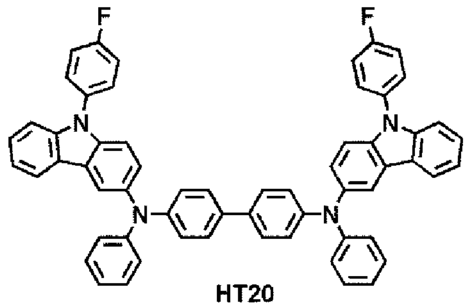

HT20

.

A thickness of the hole transport region may be from about 100 Å to about 10,000 Å, for example, about 100 Å to about 3,000 Å. When the hole transport region includes at least one selected from a hole injection layer and a hole transport layer, a thickness of the hole injection layer may be in a range of about 100 Å to about 10,000 Å, for example, about 100 Å to about 1,000 Å, and a thickness of the hole transport layer may be in a range of about 50 Å to about 2,000 Å, for example about 100 Å to about 1,500 Å. When the thicknesses of the hole transport region, the hole injection layer, and the hole transport layer are within these ranges, satisfactory hole transporting characteristics may be obtained without a substantial increase in driving voltage.

The hole transport region may further include, in addition to these materials, a charge-generation material for the improvement of conductive properties. The charge-generation material may be homogeneously or non-homogeneously dispersed in the hole transport region.

The charge-generation material may be, for example, a p-dopant. The p-dopant may be a quinone derivative, a metal oxide, a cyano group-containing compound, or any combination thereof, but embodiments of the present disclosure are not limited thereto. Non-limiting examples of the p-dopant are a quinone derivative, such as tetracyanoquinonedimethane (TCNQ) or 2,3,5,6-tetrafluoro-tetracyano-1,4-benzoquinonedimethane (F4-TCNQ); a metal oxide, such as a tungsten oxide or a molybdenium oxide; and a cyano group-containing compound, such as Compound HT-D1 below, but are not limited thereto:

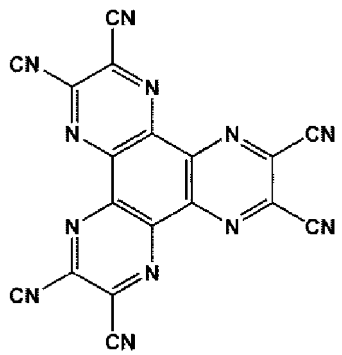

HT-D1

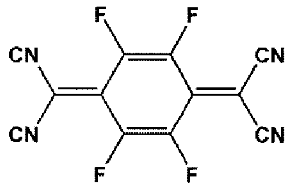

F4-TCNQ

.

The hole transport region may include a buffer layer.

Also, the buffer layer may compensate for an optical resonance distance according to a wavelength of light emitted from the emission layer, and thus, efficiency of a formed organic light-emitting device may be improved.

Meanwhile, when the hole transport region includes an electron blocking layer, a material for the electron blocking layer may be a material for the hole transport region described above and materials for a host to be explained later. However, the material for the electron blocking layer is not limited thereto. For example, when the hole transport region includes an electron blocking layer, a material for the electron blocking layer may be mCP, which will be explained later.

Then, an emission layer may be formed on the hole transport region by vacuum deposition, spin coating, casting, LB deposition, or the like. When the emission layer is formed by vacuum deposition or spin coating, the deposition or coating conditions may be similar to those applied in forming the hole injection layer although the deposition or coating conditions may vary according to a compound that is used to form the emission layer.

The emission layer may include a host and a dopant, and the dopant may include the organometallic compound represented by Formula 1.

The host may include TPBi, TBADN, ADN (also referred to as "DNA"), CBP, CDBP, TCP, mCP, one of Compounds H50 to H52, or any combination thereof:

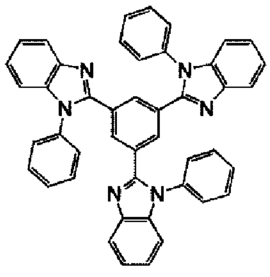

TPBi

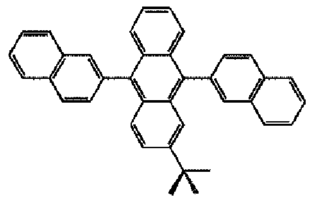

TBADN

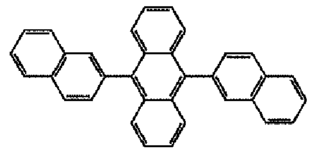

ADN

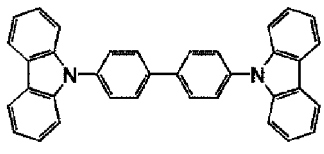

CBP

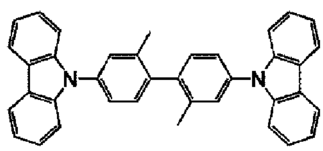

CDBP

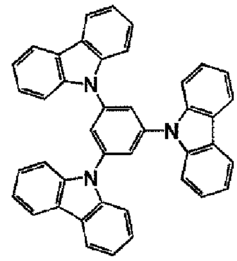

TCP

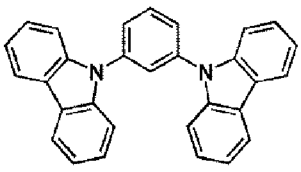

mCP

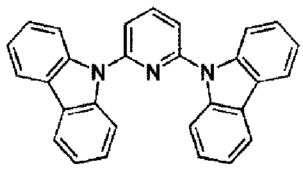

H50

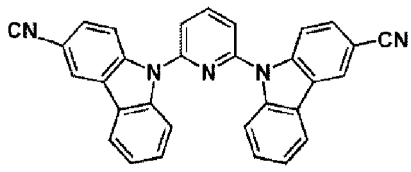

H51

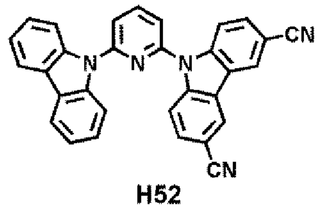

H52

.

When the organic light-emitting device is a full-color organic light-emitting device, the emission layer may be patterned into a red emission layer, a green emission layer, and/or a blue emission layer. In one or more embodiments, due to a stacked structure including a red emission layer, a green emission layer, and/or a blue emission layer, the emission layer may emit white light.

When the emission layer include a host and a dopant, an amount of the dopant may be in a range of about 0.01 parts by weight to about 15 parts by weight based on 100 parts by weight of the host, but embodiments of the present disclosure are not limited thereto.

The dopant may be an organometallic compound represented by Formula 1 described above. For example, the dopant may be a red phosphorescent dopant.

A thickness of the emission layer may be in a range of about 100 Å to about 1,000 Å, for example, about 200 Å to about 600 Å. When the thickness of the emission layer is within this range, excellent light-emission characteristics may be obtained without a substantial increase in driving voltage.

Then, an electron transport region may be disposed on the emission layer.

The electron transport region may include a hole blocking layer, an electron transport layer, an electron injection layer, or any combination thereof.

For example, the electron transport region may have a hole blocking layer/electron transport layer/electron injection layer structure or an electron transport layer/electron injection layer structure, but the structure of the electron

transport region is not limited thereto. The electron transport layer may have a single-layered structure or a multi-layered structure including two or more different materials.

Conditions for forming the hole blocking layer, the electron transport layer, and the electron injection layer which constitute the electron transport region may be understood by referring to the conditions for forming the hole injection layer.

When the electron transport region includes a hole blocking layer, the hole blocking layer may include, for example, BCP, Bphen, BAlq, or any combination thereof, but embodiments of the present disclosure are not limited thereto:

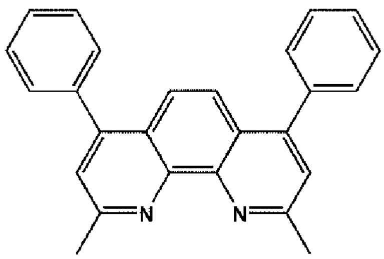

BCP

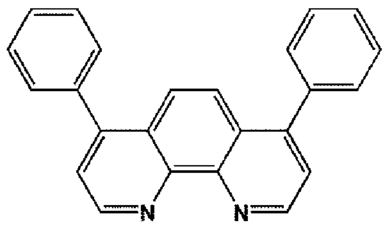

Bphen .

A thickness of the hole blocking layer may be from about 20 Å to about 1,000 Å, for example, about 30 Å to about 300 Å. When the thickness of the hole blocking layer is within these ranges, the hole blocking layer may have excellent hole blocking characteristics without a substantial increase in driving voltage.

The electron transport layer may include BCP, Bphen, $Alq_3$, BAlq, TAZ, NTAZ, or any combination thereof:

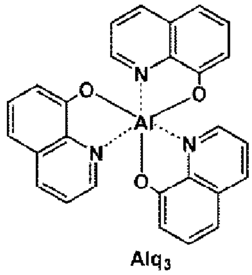

$Alq_3$

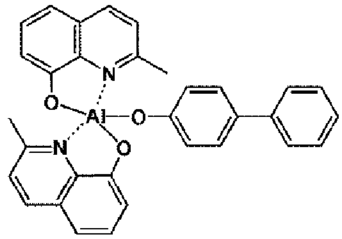

BAlq

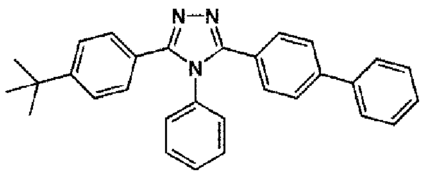

TAZ

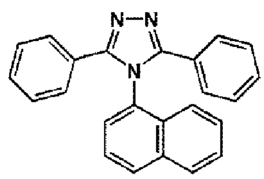

NTAZ .

In one or more embodiments, the electron transport layer may include one of ET1 to ET25 or any combination thereof, but are not limited thereto:

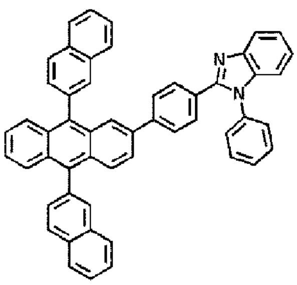

ET1

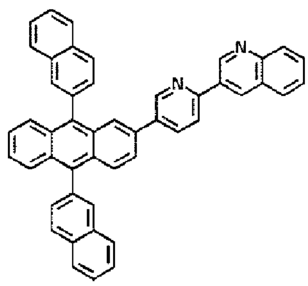

ET2

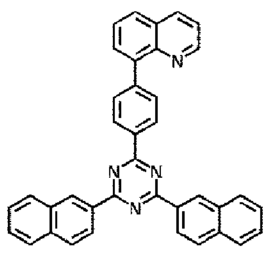

ET3

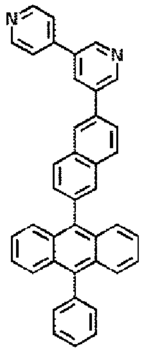

ET4

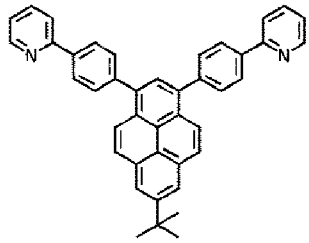

ET5

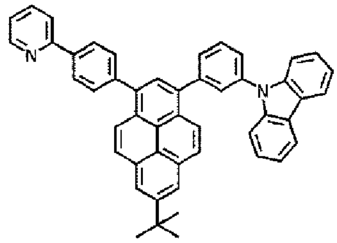

ET6

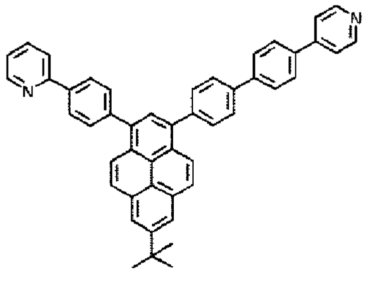

ET7

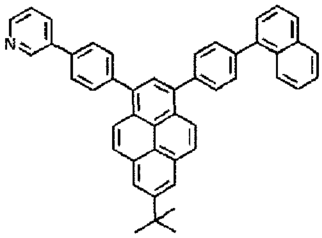

ET8

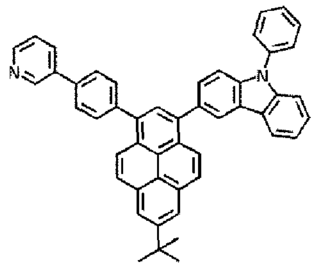

ET9

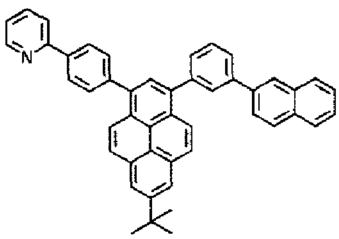

ET10

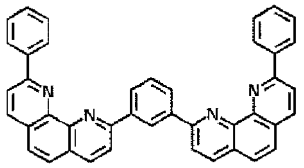

ET11

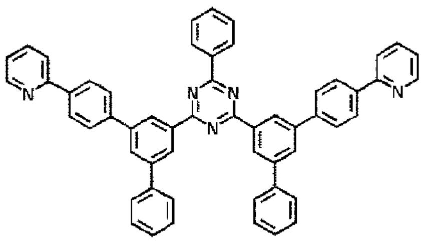

ET12

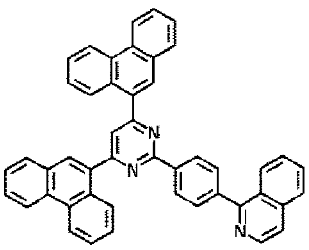

ET13

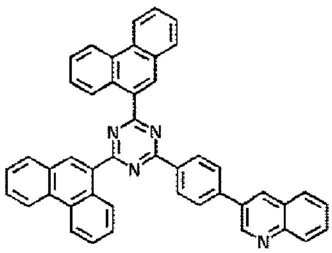

ET14

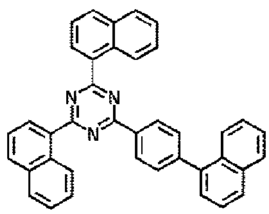

ET15

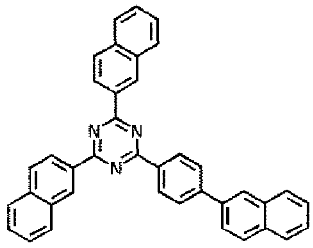

ET16

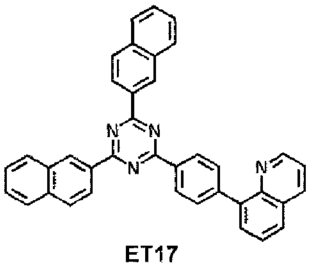

ET17

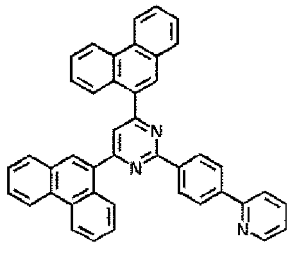

ET18

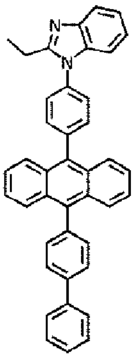

ET19

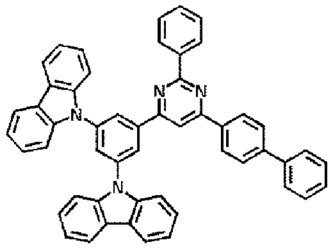

ET20

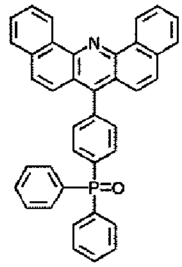

ET21

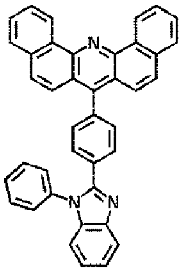

ET22

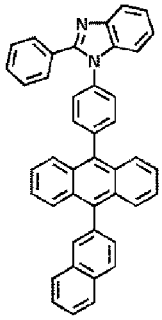

ET23

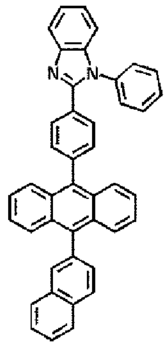

ET24

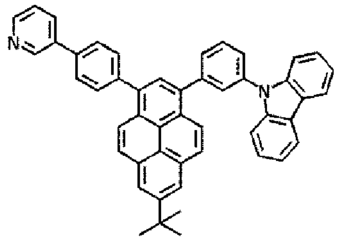

ET25

.

A thickness of the electron transport layer may be from about 100 Å to about 1,000 Å, for example, about 150 Å to about 500 Å. When the thickness of the electron transport layer is within the range described above, the electron transport layer may have satisfactory electron transport characteristics without a substantial increase in driving voltage.

Also, the electron transport layer may further include, in addition to the materials described above, a metal-containing material.

The metal-containing material may include a Li complex. The Li complex may include, for example, Compound ET-D1 (LiQ) or ET-D2:

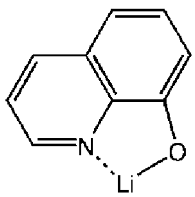

ET-D1

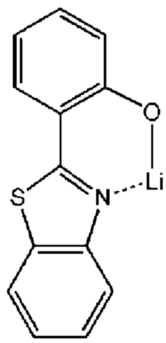

ET-D2

.

The electron transport region may include an electron injection layer that promotes flow of electrons from the second electrode 19 thereinto.

The electron injection layer may include LiF, NaCl, CsF, $Li_2O$, BaO, or any combination thereof.

A thickness of the electron injection layer may be from about 1 Å to about 100 Å, for example, about 3 Å to about 90 Å. When a thickness of the electron injection layer is within these ranges, satisfactory electron injection characteristics may be obtained without substantial increase in driving voltage.

The second electrode 19 is disposed on the organic layer 15. The second electrode 19 may be a cathode. A material for forming the second electrode 19 may be a metal, an alloy, an electrically conductive compound, or any

combination thereof, which have a relatively low work function. For example, lithium (Li), magnesium (Mg), aluminum (Al), aluminum-lithium (Al-Li), calcium (Ca), magnesium-indium (Mg-In), or magnesium-silver (Mg-Ag) may be formed as the material for forming the second electrode 19. To manufacture a top-emission type light-emitting device, a transmissive electrode formed using ITO or IZO may be used as the second electrode 19.

Hereinbefore, the organic light-emitting device according to an embodiment has been described in connection with the FIGURE.

Another aspect of the present disclosure provides a diagnostic composition including at least one organometallic compound represented by Formula 1.

The organometallic compound represented by Formula 1 provides high luminescence efficiency. Accordingly, a diagnostic composition including the organometallic compound may have high diagnostic efficiency.

The diagnostic composition may be used in various applications including a diagnosis kit, a diagnosis reagent, a biosensor, and a biomarker.

The term "$C_1$-$C_{60}$ alkyl group" as used herein refers to a linear or branched saturated aliphatic hydrocarbon monovalent group having 1 to 60 carbon atoms, and examples thereof include a methyl group, an ethyl group, a propyl group, an isobutyl group, a sec-butyl group, a tert-butyl group, a pentyl group, an isoamyl group, and a hexyl group. The term "$C_1$-$C_{60}$ alkylene group" as used herein refers to a divalent group having the same structure as the $C_1$-$C_{60}$ alkyl group.

The term "$C_1$-$C_{60}$ alkoxy group" used herein refers to a monovalent group represented by -$OA_{101}$ (wherein $A_{101}$ is the $C_1$-$C_{60}$ alkyl group), and examples thereof include a methoxy group, an ethoxy group, and an isopropyloxy group.

The term "$C_2$-$C_{60}$ alkenyl group" as used herein refers to a hydrocarbon group having at least one carbon-carbon double bond in the middle or at the terminus of the $C_2$-$C_{60}$ alkyl group, and examples thereof include an ethenyl group, a propenyl group, and a butenyl group. The term "$C_2$-$C_{60}$ alkenylene group" as used herein refers to a divalent group having the same structure as the $C_2$-$C_{60}$ alkenyl group.

The term "$C_2$-$C_{60}$ alkynyl group" as used herein refers to a hydrocarbon group having at least one carbon-carbon triple bond in the middle or at the terminus of the $C_2$-$C_{60}$ alkyl group, and examples thereof include an ethynyl group, and a propynyl group. The term "$C_2$-$C_{60}$ alkynylene group" as used herein refers to a divalent group having the same structure as the $C_2$-$C_{60}$ alkynyl group.

The term "$C_3$-$C_{10}$ cycloalkyl group" as used herein refers to a monovalent saturated hydrocarbon monocyclic group having 3 to 10 carbon atoms, and non-limiting examples thereof include a cyclopropyl group, a cyclobutyl group, a cyclopentyl group, a cyclohexyl group, and a cycloheptyl group. The term "$C_3$-$C_{10}$ cycloalkylene group" as used herein refers to a divalent group having the same structure as the $C_3$-$C_{10}$ cycloalkyl group.

The term "$C_1$-$C_{10}$ heterocycloalkyl group" as used herein refers to a monovalent saturated monocyclic group having at least one heteroatom selected from N, O, P, Si and S as a ring-forming atom and 1 to 10 carbon atoms, and non-limiting examples thereof include a tetrahydrofuranyl group, and a tetrahydrothiophenyl group. The term "$C_1$-$C_{10}$ heterocycloalkylene group" as used herein refers to a divalent group having the same structure as the $C_1$-$C_{10}$ heterocycloalkyl group.

The term "$C_3$-$C_{10}$ cycloalkenyl group" as used herein refers to a monovalent monocyclic group that has 3 to 10 carbon atoms and at least one carbon-carbon double bond in the ring thereof and no aromaticity, and non-limiting examples thereof include a cyclopentenyl group, a cyclohexenyl group, and a cycloheptenyl group. The term "$C_3$-$C_{10}$ cycloalkenylene group" as used herein refers to a divalent group having the same structure as the $C_3$-$C_{10}$ cycloalkenyl group.

The term "$C_1$-$C_{10}$ heterocycloalkenyl group" as used herein refers to a monovalent monocyclic group that has at least one heteroatom selected from N, O, P, Si, and S as a ring-forming atom, 1 to 10 carbon atoms, and at least one carbon-carbon double bond in its ring. Examples of the $C_1$-$C_{10}$ heterocycloalkenyl group are a 2,3-dihydrofuranyl group, and a 2,3-dihydrothiophenyl group. The term "$C_1$-$C_{10}$ heterocycloalkenylene group" as used herein refers to a divalent group having the same structure as the $C_1$-$C_{10}$ heterocycloalkenyl group.

The term "$C_6$-$C_{60}$ aryl group" as used herein refers to a monovalent group having a carbocyclic aromatic system having 6 to 60 carbon atoms, and the term "$C_6$-$C_{60}$ arylene group" as used herein refers to a divalent group having a carbocyclic aromatic system having 6 to 60 carbon atoms. Non-limiting examples of the $C_6$-$C_{60}$ aryl group include a phenyl group, a naphthyl group, an anthracenyl group, a phenanthrenyl group, a pyrenyl group, and a chrysenyl group. When the $C_6$-$C_{60}$ aryl group and the $C_6$-$C_{60}$ arylene group each include two or more rings, the rings may be fused to each other.

The term "$C_7$-$C_{60}$ alkylaryl group" as used herein refers to a $C_6$-$C_{60}$ aryl group substituted with at least one $C_1$-$C_{60}$ alkyl group.

The term "$C_1$-$C_{60}$ heteroaryl group," used herein, refers to a monovalent group having a cyclic aromatic system that has at least one heteroatom selected from N, O, P, Si, and S as a ring-forming atom, in addition to 1 to 60 carbon atoms. The term "$C_1$-$C_{60}$ heteroarylene group" as used herein refers to a divalent group having a cyclic aromatic system that has at least one heteroatom selected from N, O, P, Si, and S as a ring-forming atom, in addition to 1 to 60 carbon

atoms. Non-limiting examples of the $C_1$-$C_{60}$ heteroaryl group include a pyridinyl group, a pyrimidinyl group, a pyrazinyl group, a pyridazinyl group, a triazinyl group, a quinolinyl group, and an isoquinolinyl group. When the $C_1$-$C_{60}$ heteroaryl group and the $C_1$-$C_{60}$ heteroarylene group each include two or more rings, the rings may be fused to each other.

The term "$C_2$-$C_{60}$ alkylheteroaryl group" as used herein refers to a $C_1$-$C_{60}$ heteroaryl group substituted with at least one $C_1$-$C_{60}$ alkyl group.

The term "$C_6$-$C_{60}$ aryloxy group" used herein indicates -$OA_{102}$ (wherein $A_{102}$ is the C6-C60 aryl group), and a $C_6$-$C_{60}$ arylthio group used herein indicates -$SA_{103}$ (wherein $A_{103}$ is the $C_6$-$C_{60}$ aryl group).

The term "monovalent non-aromatic condensed polycyclic group" as used herein refers to a monovalent group (for example, having 8 to 60 carbon atoms) having two or more rings condensed to each other, only carbon atoms as ring-forming atoms, and no aromaticity in its entire molecular structure. Examples of the monovalent non-aromatic condensed polycyclic group include a fluorenyl group. The term "divalent non-aromatic condensed polycyclic group" as used herein refers to a divalent group having the same structure as the monovalent non-aromatic condensed polycyclic group.

The term "monovalent non-aromatic condensed heteropolycyclic group" as used herein refers to a monovalent group (for example, having 2 to 60 carbon atoms) having two or more rings condensed to each other, a heteroatom selected from N, O, P, Si, and S, other than carbon atoms, as a ring-forming atom, and no aromaticity in its entire molecular structure. Non-limiting examples of the monovalent non-aromatic condensed heteropolycyclic group include a carbazolyl group. The term "divalent non-aromatic condensed heteropolycyclic group" as used herein refers to a divalent group having the same structure as the monovalent non-aromatic condensed heteropolycyclic group.

The term "$C_5$-$C_{30}$ carbocyclic group" as used herein refers to a saturated or unsaturated cyclic group having, as a ring-forming atom, 5 to 30 carbon atoms only. The $C_5$-$C_{30}$ carbocyclic group may be a monocyclic group or a polycyclic group.

The term "$C_1$-$C_{30}$ heterocyclic group" as used herein refers to a saturated or unsaturated cyclic group having, as a ring-forming atom, at least one heteroatom selected from N, O, Si, P, and S other than 1 to 30 carbon atoms. The $C_1$-$C_{30}$ heterocyclic group may be a monocyclic group or a polycyclic group.

A substituent(s) of the substituted $C_5$-$C_{30}$ carbocyclic group, the substituted $C_2$-$C_{30}$ heterocyclic group, the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted C6-C60 aryl group, the substituted $C_6$-$C_{60}$ aryloxy group, the substituted $C_6$-$C_{60}$ arylthio group, the substituted $C_1$-$C_{60}$ heteroaryl group, the substituted monovalent non-aromatic condensed polycyclic group, and the substituted monovalent non-aromatic condensed heteropolycyclic group may be:

deuterium, -F, -Cl, -Br, -I, -$CD_3$, -$CD_2H$, -$CDH_2$, -$CF_3$, -$CF_2H$, -$CFH_2$, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, or a $C_1$-$C_{60}$ alkoxy group;

a $C_1$-$C_{60}$ alkyl group, a $C_2$-$C_{60}$ alkenyl group, a $C_2$-$C_{60}$ alkynyl group, or a $C_1$-$C_{60}$ alkoxy group, each substituted with deuterium, -F, -Cl, -Br, -I, -$CD_3$, -$CD_2H$, -$CDH_2$, -$CF_3$, - $CF_2H$, -$CFH_2$, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, a monovalent non-aromatic condensed heteropolycyclic group, -N($Q_{11}$)($Q_{12}$), -Si($Q_{13}$)($Q_{14}$)($Q_{15}$), -Ge($Q_{13}$)($Q_{14}$)($Q_{15}$), -B($Q_{16}$)($Q_{17}$), -P(=O)($Q_{18}$)($Q_{19}$), -P($Q_{18}$)($Q_{19}$), or any combination thereof;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a C6-C60 arylthio group, a $C_1$-$C_{60}$ heteroaryl group, a monovalent non-aromatic condensed polycyclic group, or a monovalent non-aromatic condensed heteropolycyclic group, each unsubstituted or substituted with deuterium, -F, -Cl, -Br, -I, -$CD_3$, -$CD_2H$, -$CDH_2$, -$CF_3$, - $CF_2H$, -$CFH_2$, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a C3-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, a monovalent non-aromatic condensed heteropolycyclic group, -N($Q_{21}$)($Q_{22}$), - Si(Q23)(Q24)(Q25), -Ge($Q_{23}$)($Q_{24}$)($Q_{25}$), -B($Q_{26}$)($Q_{27}$), -P(=O)($Q_{28}$)($Q_{29}$), -P(Q28)(Q29), or any combination thereof;

-N(Q31)(Q32), -Si($Q_{33}$)($Q_{34}$)($Q_{35}$), -Ge($Q_{33}$)($Q_{34}$)($Q_{35}$), -B($Q_{36}$)($Q_{37}$), -P(=O)($Q_{38}$)($Q_{39}$), -P(Q38)(Q39), or any combination thereof; or
any combination thereof.

In the present specification, $Q_1$ to $Q_9$, $Q_{11}$ to $Q_{19}$, $Q_{21}$ to $Q_{29}$, and $Q_{31}$ to $Q_{39}$ may each independently be hydrogen; deuterium; -F; -Cl; -Br; -I; a hydroxyl group; a cyano group; a nitro group; an amidino group; a hydrazine group; a hydrazone group; a carboxylic acid group or a salt thereof; a sulfonic acid group or a salt thereof; a phosphoric acid group or a salt thereof; a $C_1$-$C_{60}$ alkyl group unsubstituted or substituted with deuterium, a $C_1$-$C_{60}$ alkyl group, a $C_6$-$C_{60}$ aryl group, or any combination thereof; a $C_2$-$C_{60}$ alkenyl group; a $C_2$-$C_{60}$ alkynyl group; a $C_1$-$C_{60}$ alkoxy group; a $C_3$-$C_{10}$ cycloalkyl group; a $C_1$-$C_{10}$ heterocycloalkyl group; a $C_3$-$C_{10}$ cycloalkenyl group; a $C_1$-$C_{10}$ heterocycloalkenyl group; a $C_6$-$C_{60}$ aryl group unsubstituted or substituted with deuterium, a $C_1$-$C_{60}$ alkyl group, a $C_6$-$C_{60}$ aryl group, or any combination thereof; a $C_6$-$C_{60}$ aryloxy group; a $C_6$-$C_{60}$ arylthio group; a $C_7$-$C_{60}$ arylalkyl group; a $C_1$-$C_{60}$ heteroaryl group; a $C_1$-$C_{60}$ heteroaryloxy group; a $C_1$-$C_{60}$ heteroarylthio group; a $C_2$-$C_{60}$ heteroarylalkyl group; a monovalent non-aromatic condensed polycyclic group; or a monovalent non-aromatic condensed heteropolycyclic group.

Hereinafter, a compound and an organic light-emitting device according to embodiments are described in detail with reference to Synthesis Example and Examples. However, the organic light-emitting device is not limited thereto. The wording "B was used instead of A" used in describing Synthesis Examples means that an amount of B used was identical to an amount of A used, in terms of a molar equivalent.

[Examples]

## <u>Synthesis Example 1 (Compound 2)</u>

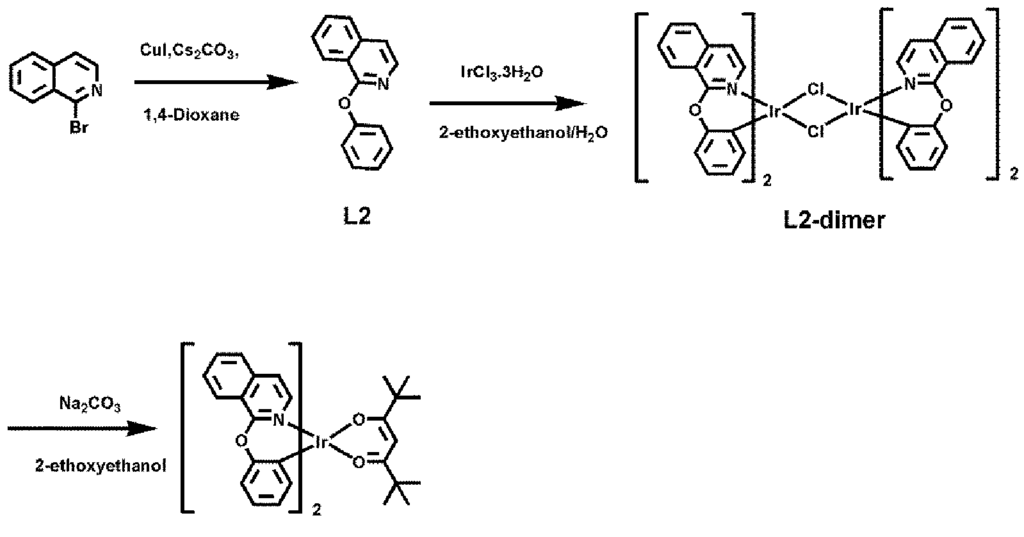


L2

L2-dimer

2

1) Synthesis of Intermediate L2

1-bromo-isoquinoline (6.58 g, 31.64 mmol), phenol (3.28 g, 34.80 mmol), CuI (0.603 g, 3.06 mmol) and $Cs_2CO_3$ (20.62 g, 63.28 mmol), and pyridine-2-carboxylic acid (0.78 g, 6.33 mmol) were mixed with 160 mL of 1,4-dioxane, and the mixed solution was stirred under reflux for 18 hours. After the reaction temperature was lowered to room temperature, a solid produced therein was separated by filtration. A solvent was removed from a filtrate obtained therefrom under reduced pressure, and an extraction process was performed on a resulting residue by using methylenechloride (MC) to obtain an organic layer. Anhydrous magnesium sulfate ($MgSO_4$) was added to a resulting product obtained therefrom to remove moisture, and the resulting solution was filtered. A solvent was removed from the filtrate obtained therefrom under reduced pressure, and a resulting residue was purified by column chromatography under conditions of EA (ethyl acetate) :Hexane = 1:10, thereby obtaining 6.46 g (92 %) of Intermediate L2.

MALDI-TOFMS (m/z): $C_{15}H_{11}NO$ ($M^+$) 222.

2) Synthesis of Intermediate L2-dimer

Intermediate L2 (6.33 g, 28.62 mmol) and iridium chloride (4.49 g, 12.72 mmol) were mixed with 60 mL of ethoxyethanol and 20 mL of distilled water, and the mixed solution was stirred under reflux for 24 hours. After completion of the reaction, the reaction temperature was lowered to room temperature, a solid produced therein was separated by filtration, and a resulting filtrate was sufficiently washed using water/methanol/hexane in the stated order. A solid obtained therefrom was then dried in a vacuum oven, thereby obtaining Intermediate L2-dimer (3.69 g, 43 %).

3) Synthesis of Compound 2

Intermediate L2-dimer (3.28 g, 2.45 mmol), 2,2,6,6-tetramethylheptane-3,5-dione (4.52 g, 24.5 mmol), and $Na_2CO_3$ (2.59 g, 24.5 mmol) were mixed with 50 mL of ethoxyethanol, and the mixed solution was heated at a temperature of 90 °C for 18 hours while being stirred. A mixture obtained therefrom was filtered, and a resulting solid was sufficiently washed using ethanol, and then, subjected to column chromatography under conditions of dichloromethane:n-hexane=1:1 (v/v), thereby obtaining Compound 2 (1.40 g, 35 %). Compound 2 was identified by Mass Spectrum and HPLC.

HRMS(MALDI) calcd for $C_{41}H_{39}IrN_2O_4$: m/z 816.2539, Found: 816.2540.

## Synthesis Example 2 (Compound 3)

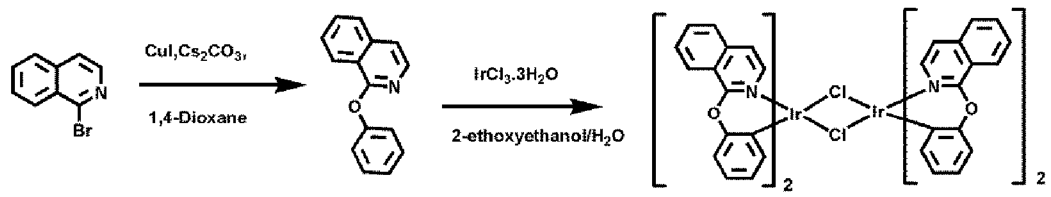


L2

L2-dimer

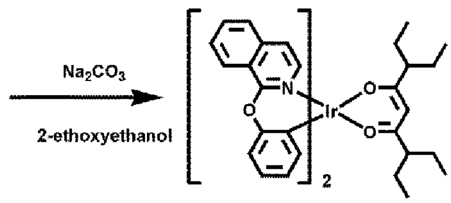


3

Compound 3 (1.6 g, 39 %) was obtained in the same manner as in the synthesis of Compound 2 of Synthesis Example 1, except that 3,7-diethylnonane-4,6-dione (5.20 g, 24.5 mmol) was used instead of 2,2,6,6-tetramethylheptane-3,5-dione. Compound 3 was identified by Mass Spectrum and HPLC.

HRMS(MALDI) calcd for $C_{43}H_{43}IrN_2O_4$: m/z 844.2852, Found: 844.2851.

## Synthesis Example 3 (Compound 32)

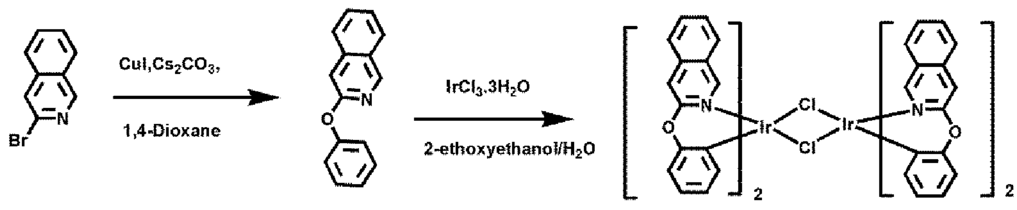


L32 L32-dimer

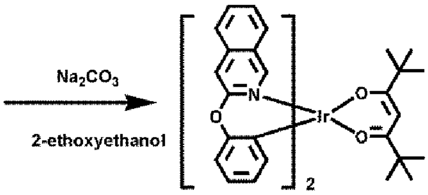


32

1) Synthesis of Intermediate L32

Intermediate L32 (6.4 g, 91 %) was obtained in the same manner as in the synthesis of Intermediate L2 of Synthesis Example 1, except that 3-bromoisoquinoline (5.20 g, 24.5 mmol) was formed instead of 1-bromo-isoquinoline.
MALDI-TOFMS (m/z): $C_{15}H_{11}NO$ ($M^+$) 222.

2) Synthesis of Intermediate L32-dimer

Intermediate L32-dimer (4.5 g, 53 %) was obtained in the same manner as in the synthesis of Intermediate L2-dimer of Synthesis Example 1, except that Intermediate L32 (5.20 g, 24.5 mmol) was used instead of Intermediate L2.

3) Synthesis of Compound 32

Compound 32 (1.3 g, 46 %) was obtained in the same manner as in the synthesis of Compound 2 of Synthesis Example 1, except that Intermediate L32-dimer (2.29 g, 1.72 mmol) was used instead of Intermediate L2-dimer. Compound 32 was identified by Mass Spectrum and HPLC.
HRMS(MALDI) calcd for $C_{41}H_{39}IrN_2O_4$: m/z 816.2539, Found: 816.2540.

## Synthesis Example 4 (Compound 33)

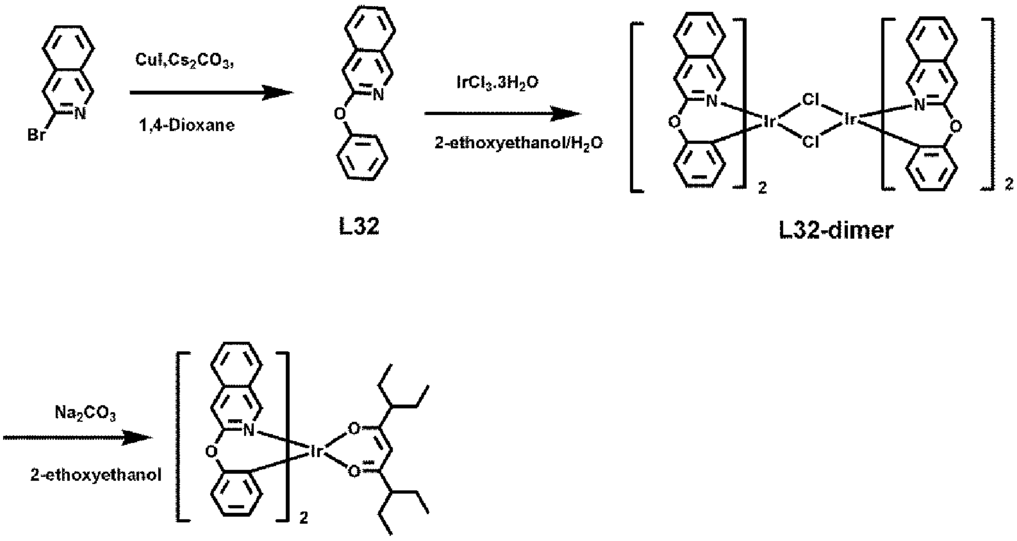


L32

L32-dimer

33

Compound 33 (1.1 g, 39 %) was obtained in the same manner as in the synthesis of Compound 32 of Synthesis Example 3, except that 3,7-diethylnonane-4,6-dione (3.52 g, 16.6 mmol) was used instead of 2,2,6,6-tetramethylheptane-3,5-dione. Compound 33 was identified by Mass Spectrum and HPLC.

HRMS(MALDI) calcd for $C_{43}H_{43}IrN_2O_4$: m/z 844.2852, Found: 844.2851.

## Synthesis Example 5 (Compound 47)

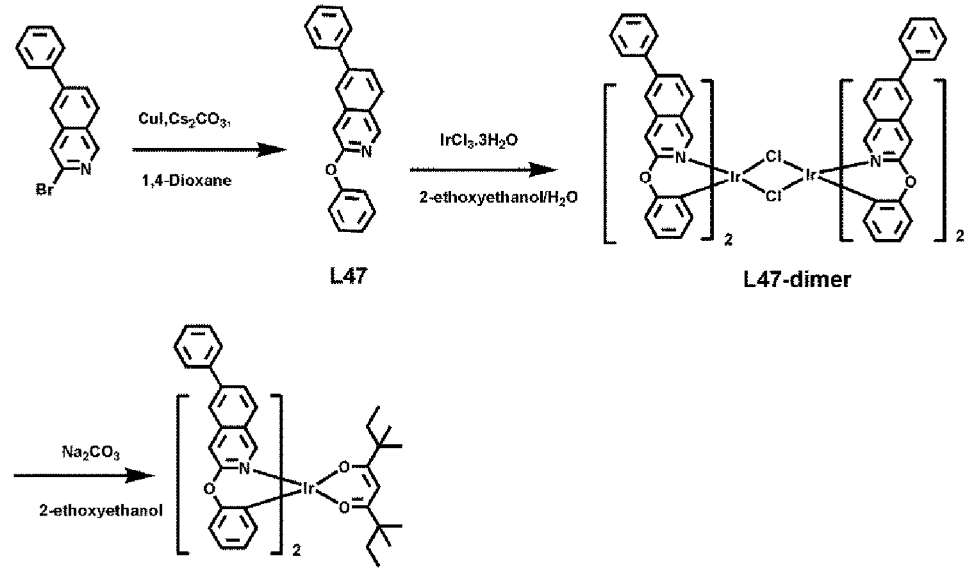


L47

L47-dimer

47

1) Synthesis of Intermediate L47

Intermediate L47 (3.8 g, 95 %) was obtained in the same manner as in the synthesis of Intermediate L2 of Synthesis Example 1, except that 3-bromo-6-phenylisoquinoline (3.82 g, 13.5 mmol) was used instead of 1-bromo-isoquinoline.

MALDI-TOFMS (m/z): $C_{21}H_{15}NO$ $(M^+)$ 298.

2) Synthesis of Intermediate L47-dimer

Intermediate L47-dimer (2.2 g, 47 %) was obtained in the same manner as in the synthesis of Intermediate L2-dimer of Synthesis Example 1, except that Intermediate L47 (3.8 g, 12.7 mmol) was used instead of Intermediate L2.

3) Synthesis of Compound 47

Compound 47 (1.3 g, 46 %) was obtained in the same manner as in the synthesis of Compound 2 of Synthesis Example 1, except that Intermediate L47-dimer (2.2 g, 1.72 mmol) was used instead of Intermediate L2-dimer and 3,3,7,7-tetramethylnonane-4,6-dione was used instead of 2,2,6,6-tetramethylheptane-3,5-dione. Compound 47 was identified by Mass Spectrum and HPLC.
HRMS(MALDI) calcd for $C_{55}H_{51}IrN_2O_4$: m/z 996.3478, Found: 996.3477.

## Synthesis Example 6 (Compound 69)

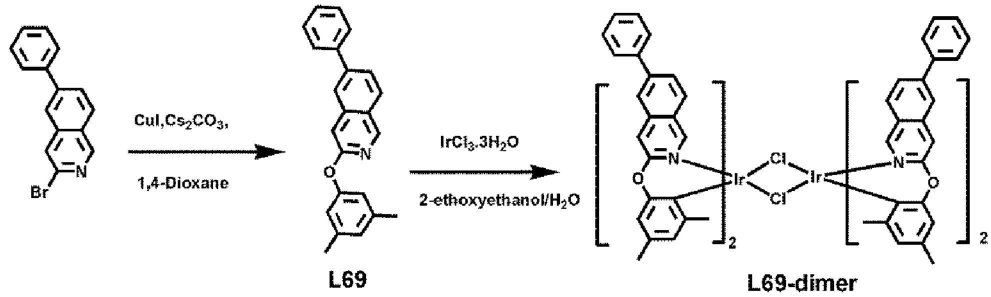


L69 L69-dimer

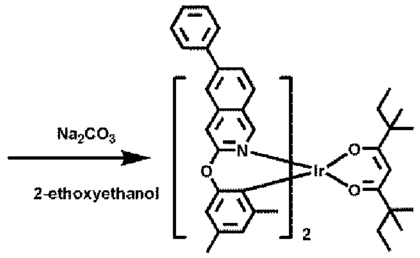


69

1) Synthesis of Intermediate L69

Intermediate L69 (3.2 g, 91 %) was obtained in the same manner as in the synthesis of Intermediate L47 of Synthesis Example 5, except that 3,5-dimethylphenol (1.45 g, 11.83 mmol) was used instead of phenol.
MALDI-TOFMS (m/z): $C_{23}H_{19}NO$ ($M^+$) 326.

2) Synthesis of Intermediate L69-dimer

Intermediate L69-dimer (1.9 g, 50 %) was obtained in the same manner as in the synthesis of Intermediate L47-dimer of Synthesis Example 5, except that Intermediate L69 (3.2 g, 9.76 mmol) was used instead of Intermediate L47.

3) Synthesis of Compound 69

Compound 69 (0.98 g, 43 %) was obtained in the same manner as in the synthesis of Compound 47 of Synthesis Example 5, except that Intermediate L69-dimer (1.9 g, 1.09 mmol) was used instead of Intermediate L47-dimer. Compound 69 was identified by Mass Spectrum and HPLC.
HRMS(MALDI) calcd for $C_{59}H_{59}IrN_2O_4$: m/z 1052.4104, Found: 1052.4102.

## Synthesis Example 7 (Compound 239)

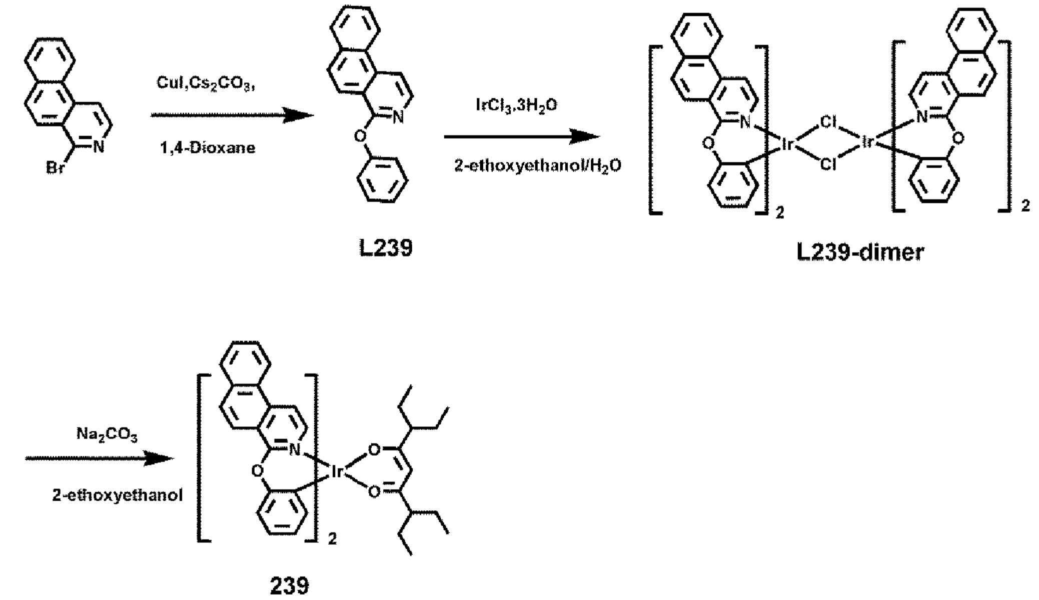


L239

L239-dimer

239

1) Synthesis of Intermediate L239

Intermediate L239 (4.4 g, 84 %) was obtained in the same manner as in the synthesis of Intermediate L2 of Synthesis Example 1, except that 4-bromobenzo[f]isoquinoline (5.0 g, 19.35 mmol) was used instead of 1-bromo-isoquinoline.

2) Synthesis of Intermediate L239-dimer

Intermediate L239-dimer (1.8 g, 45 %) was obtained in the same manner as in the synthesis of Intermediate L2-dimer of Synthesis Example 1, except that Intermediate L239 (3.2 g, 11.71 mmol) was used instead of Intermediate L2.

3) Synthesis of Compound 239

Compound 239 (0.54 g, 27 %) was obtained in the same manner as in the synthesis of Compound 2 of Synthesis Example 1, except that Intermediate L239-dimer (1.6 g, 1.06 mmol) was used instead of Intermediate L2-dimer. Compound 239 was identified by Mass Spectrum and HPLC.

HRMS(MALDI) calcd for $C_{51}H_{47}IrN_2O_4$: m/z 944.3165, Found: 944.3161.

**Example 1**

A glass substrate, on which ITO was deposited to as an anode, was cut to a size of 50 mm x 50 mm x 0.5 mm, sonicated with isopropyl alcohol and pure water each for 5 minutes, and then cleaned by exposure to ultraviolet rays and ozone for 30 minutes. Then, the glass substrate was provided to a vacuum deposition apparatus.

2-TNATA was vacuum-deposited on the anode to form a hole injection layer having a thickness of 600 Å, and 4,4'-bis[N-(1-naphthyl)-N-phenylamino]biphenyl (NPB) was vacuum-deposited on the hole injection layer to form a hole transport layer having a thickness of 1,350 Å.

Then, CBP (host) and Compound 2 (dopant) were co-deposited on the hole transport layer at a weight ratio of 98:2 to form an emission layer having a thickness of 400 Å.

Afterwards, BCP was vacuum-deposited on the emission layer to form a hole blocking layer having a thickness of 50 Å, $Alq_3$ was vacuum-deposited on the hole blocking layer to form an electron transport layer having a thickness of 350 Å, LiF was vacuum-deposited on the electron transport layer to form an electron injection layer having a thickness of 10 Å, and Al was deposited on the electron injection layer to form a cathode having a thickness of 120 Å, thereby completing the manufacture of an organic light-emitting device:

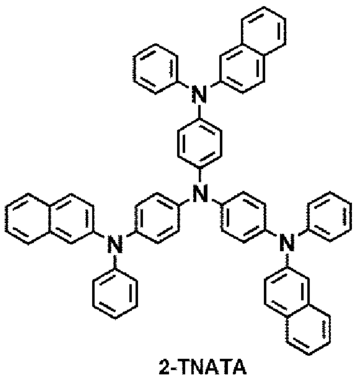

2-TNATA

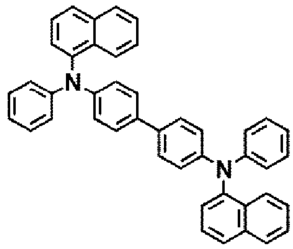

NPB

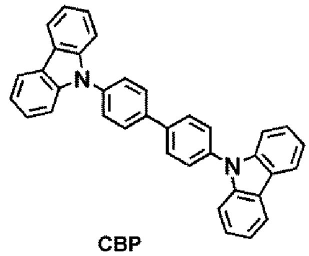

CBP

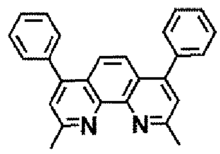

BCP

**Examples 2 to 6 and Comparative Examples A, E, and G**

Organic light-emitting devices were manufactured in the same manner as in Example 1, except that Compounds shown in Table 2 were each used instead of Compound 2 as a dopant in forming an emission layer.

**Evaluation Example** 1: **Evaluation of characteristics of organic light-emitting device**

The driving voltage, maximum value of external quantum efficiency (Max EQE), roll-off ratio, half-width and maximum emission wavelength of a main peak in an EL spectrum, and lifespan ($LT_{97}$) of the organic light-emitting devices manufactured according to Examples 1 to 6 and Comparative Examples A, E, and G were evaluated, and results thereof are shown in Table 2. A current-voltage meter (Keithley 2400) and a luminance meter (Minolta Cs-1000A) were used as evaluation devices, and the lifespan ($LT_{97}$) (at 3,500 nit) indicates an amount of time that lapsed when luminance was 97 % of initial luminance (100 %). The roll-off ratio was calculated by using Equation 20:

<Equation 20>

$$\text{Roll-off ratio} = \{1 - (\text{efficiency (at 3,500 nit)} / \text{maximum emission efficiency})\} \times 100\%$$

[Table 2]

| | Dopant in emission layer | Drivingvoltage (V) | Max EQE (%) | Roll-Off ratio (%) | $LT_{97}$ (hr) (at 3,500 nit) |
|---|---|---|---|---|---|
| Example 1 | 2 | 4.7 | 23.2 | 10 | 205 |
| Example 2 | 69 | 3.2 | 31.9 | 3 | 557 |
| Example 3 | 33 | 4.5 | 27.8 | 8 | 745 |
| Example 4 | 32 | 4.3 | 27.9 | 7 | 472 |
| Example 5 | 47 | 3.6 | 29.3 | 10 | 580 |
| Example 6 | 239 | 4.0 | 30.2 | 5 | 480 |
| Comparative Example A | A | 8.8 | 5.5 | 39 | 0.2 |

(continued)

| | Dopant in emission layer | Driving voltage (V) | Max EQE (%) | Roll-Off ratio (%) | $LT_{97}$ (hr) (at 3,500 nit) |
|---|---|---|---|---|---|
| Comparative Example E | E | 6.4 | 16.4 | 25 | 52 |
| Comparative Example G | G | 5.8 | 22.3 | 13 | 175 |

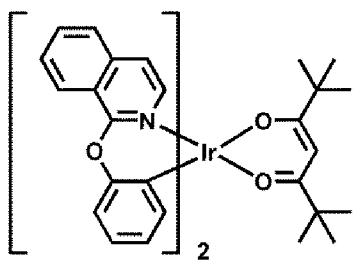

2

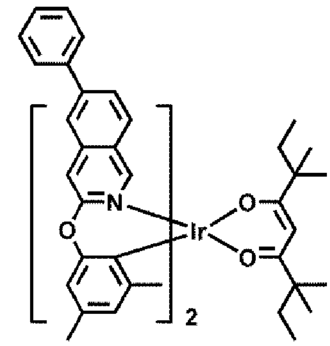

69

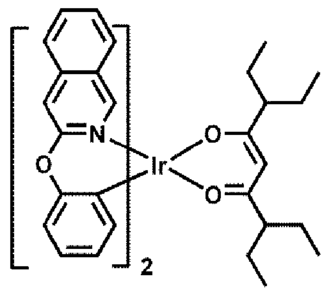

33

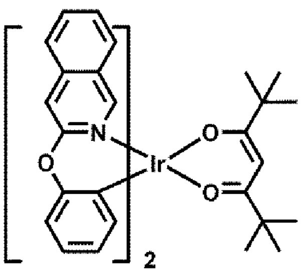

32

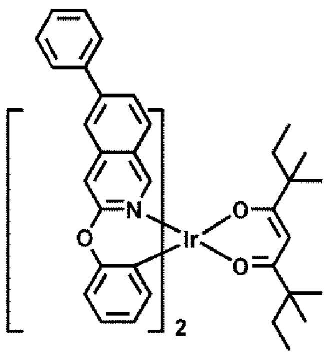

47

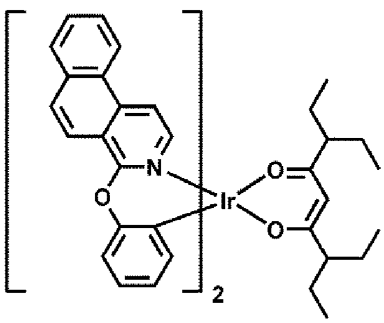

239

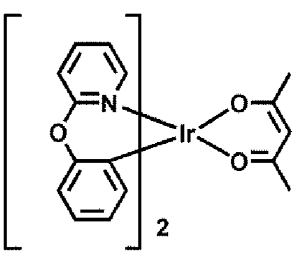

A

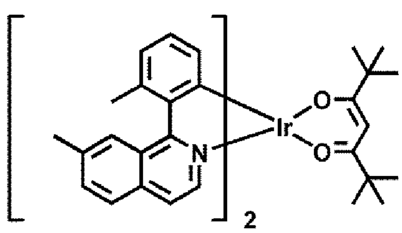

E

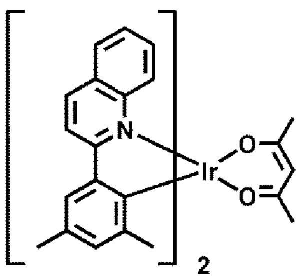

G

From Table 2, it was confirmed that the organic light-emitting devices of Examples 1 to 6 had improved driving voltage, improved external quantum efficiency, improved roll-off ratio, and improved lifespan characteristics, as compared with those of the organic light-emitting devices of Comparative Examples A, E, and G.

According to the one or more embodiments, the organometallic compound has excellent electric characteristics. For example, an organic light-emitting device including the organometallic compound may have improved driving voltage, improved external quantum efficiency, improved roll-off ratio, and improved lifespan characteristics. In addition, the organometallic compound may have excellent phosphorescence characteristics, and in this regard, a diagnostic composition including the organometallic compound may have high diagnostic efficiency.

It should be understood that embodiments described herein should be considered in a descriptive sense only and not for purposes of limitation. Descriptions of features or aspects within each embodiment should typically be considered as available for other similar features or aspects in other embodiments.

While one or more embodiments have been described with reference to the figures, it will be understood by those of ordinary skill in the art that various changes in form and details may be made therein without departing from the scope as defined by the following claims.

## Claims

**1.** An organometallic compound represented by Formula 1:

<Formula 1> $M(L_1)_{n1}(L_2)_{n2}$

wherein, in Formula 1,

M is iridium (Ir), osmium (Os), titanium (Ti), hafnium (Hf), europium (Eu), rhodium (Rh), or ruthenium (Ru),
$L_1$ is a ligand represented by Formula 2,
n1 is 1, 2, or 3, and when n1 is 2 or more, two or more $L_1$(s) are identical to or different from each other,
$L_2$ is a monodentate ligand, a bidentate ligand, a tridentate ligand, or a tetradentate ligand,
n2 is 0, 1, 2, 3, or 4, and when n2 is 2 or more, two or more $L_2$(s) are identical to or different from each other, and $L_1$ and $L_2$ are different from each other,

<Formula 2>

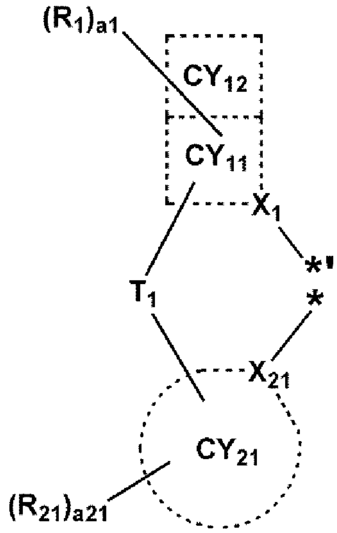

wherein, in Formula 2,

$X_1$ and $X_{21}$ are each independently C or N,
ring $CY_{11}$, ring $CY_{12}$, and ring $CY_{21}$ are each independently a $C_5$-$C_{30}$ carbocyclic group or a $C_1$-$C_{30}$ heterocyclic group, wherein ring $CY_{11}$ and ring $CY_{12}$ are condensed with each other,
$T_1$ is *-N($R_2$)-*', *-B($R_2$)-*', *-P($R_2$)-*', *-S-*', *-Se-*', or *-O-*', wherein * and *' each indicate a binding site to a neighboring atom,
$R_1$ to $R_2$ and $R_{21}$ are each independently hydrogen, deuterium, -F, -Cl, -Br, -I, -$SF_5$, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a

substituted or unsubstituted $C_6$-$C_{60}$ arylthio group, a substituted or unsubstituted $C_1$-$C_{60}$ heteroaryl group, a substituted or unsubstituted monovalent non-aromatic condensed polycyclic group, a substituted or unsubstituted monovalent non-aromatic condensed heteropolycyclic group, $-N(Q_1)(Q_2)$, $-Si(Q_3)(Q_4)(Q_5)$, $-Ge(Q_3)(Q_4)(Q_5)$, $-B(Q_6)(Q_7)$, $-P(=O)(Q_8)(Q_9)$, or $-P(Q_8)(Q_9)$,

a1 and a21 are each independently an integer from 0 to 20,

two or more of a plurality of $R_1$(s) are optionally linked to form a $C_5$-$C_{30}$ carbocyclic group that is unsubstituted or substituted with at least one $R_{10a}$ or a $C_1$-$C_{30}$ heterocyclic group that is unsubstituted or substituted with at least one $R_{10a}$,

two or more of a plurality of $R_{21}$(s) are optionally linked to form a $C_5$-$C_{30}$ carbocyclic group that is unsubstituted or substituted with at least one $R_{10a}$ or a $C_1$-$C_{30}$ heterocyclic group that is unsubstituted or substituted with at least one $R_{10a}$,

two or more of $R_1$ to $R_3$ and $R_{21}$ are optionally linked to form a $C_5$-$C_{30}$ carbocyclic group that is unsubstituted or substituted with at least one $R_{10a}$ or a $C_1$-$C_{30}$ heterocyclic group that is unsubstituted or substituted with at least one $R_{10a}$,

$R_{10a}$ is the same as defined in connection with $R_{21}$,

* and *' each indicate a binding site to M in Formula 1, and

a substituent(s) of the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_6$-$C_{60}$ aryloxy group, the substituted $C_6$-$C_{60}$ arylthio group, the substituted $C_1$-$C_{60}$ heteroaryl group, the substituted monovalent non-aromatic condensed polycyclic group, and the substituted monovalent non-aromatic condensed heteropolycyclic group is:

deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, or a $C_1$-$C_{60}$ alkoxy group;

a $C_1$-$C_{60}$ alkyl group, a $C_2$-$C_{60}$ alkenyl group, a $C_2$-$C_{60}$ alkynyl group, or a $C_1$-$C_{60}$ alkoxy group, each substituted with deuterium, -F, -Cl, -Br, -I, $-CD_3$, $-CD_2H$, $-CDH_2$, $-CF_3$, - $CF_2H$, $-CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a monovalent non-aromatic condensed polycyclic group, a monovalent non-aromatic condensed heteropolycyclic group, $-N(Q_{11})(Q_{12})$, - $Si(Q_{13})(Q_{14})(Q_{15})$, $-Ge(Q_{13})(Q_{14})(Q_{15})$, $-B(Q_{16})(Q_{17})$, $-P(=O)(Q_{16})(Q_{19})$, $-P(Q_{18})(Q_{19})$, or any combination thereof;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a C6-$C_{60}$ arylthio group, a $C_1$-$C_{60}$ heteroaryl group, a monovalent non-aromatic condensed polycyclic group, or a monovalent non-aromatic condensed heteropolycyclic group, each unsubstituted or substituted with deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, a monovalent non-aromatic condensed heteropolycyclic group, $-N(Q_{21})(Q_{22})$, - $Si(Q_{23})(Q_{24})(Q_{25})$, $-Ge(Q_{23})(Q_{24})(Q_{25})$, $-B(Q_{26})(Q_{27})$, $-P(=O)(Q_{26})(Q_{19})$, -P(Q28)(Q29), or any combination thereof;

$-N(Q_{31})(Q_{32})$, $-Si(Q_{33})(Q_{34})(Q_{35})$, $-Ge(Q_{33})(Q_{34})(Q_{35})$, $-B(Q_{36})(Q_{37})$, $-P(=O)(Q_{38})(Q_{39})$, or -P(Q38)(Q39); or any combination thereof, and

$Q_1$ to $Q_9$, $Q_{11}$ to $Q_{19}$, $Q_{21}$ to $Q_{29}$, and $Q_{31}$ to $Q_{39}$ are each independently hydrogen; deuterium; -F; -Cl; -Br; -I; a hydroxyl group; a cyano group; a nitro group; an amidino group; a hydrazine group; a hydrazone group; a carboxylic acid group or a salt thereof; a sulfonic acid group or a salt thereof; a phosphoric acid group or a salt thereof; a $C_1$-$C_{60}$ alkyl group unsubstituted or substituted with deuterium, a $C_1$-$C_{60}$ alkyl group, a $C_6$-$C_{60}$ aryl group, or any combination thereof; a $C_2$-$C_{60}$ alkenyl group; a $C_2$-$C_{60}$ alkynyl group; a $C_1$-$C_{60}$ alkoxy group; a $C_3$-$C_{10}$ cycloalkyl group; a $C_1$-$C_{10}$ heterocycloalkyl group; a $C_3$-$C_{10}$ cycloalkenyl group; a

$C_1$-$C_{10}$ heterocycloalkenyl group; a $C_6$-$C_{60}$ aryl group unsubstituted or substituted with deuterium, a $C_1$-$C_{60}$ alkyl group, a $C_6$-$C_{60}$ aryl group, or any combination thereof; a $C_6$-$C_{60}$ aryloxy group; a $C_6$-$C_{60}$ arylthio group; a $C_7$-$C_{60}$ arylalkyl group; a $C_1$-$C_{60}$ heteroaryl group; a $C_1$-$C_{60}$ heteroaryloxy group; a $C_1$-$C_{60}$ heteroarylthio group; a $C_2$-$C_{60}$ heteroarylalkyl group; a monovalent non-aromatic condensed polycyclic group; or a monovalent non-aromatic condensed heteropolycyclic group.

**2.** The organometallic compound of claim 1, wherein

M is Ir or Os, and the sum of n1 and n2 is 3 or 4; and/or
wherein
$X_1$ is N and $X_{21}$ is C.

**3.** The organometallic compound of claims 1 or 2, wherein

ring $CY_{11}$, ring $CY_{12}$, and ring $CY_{21}$ are each independently a cyclopentene group, a cyclohexene group, a benzene group, a naphthalene group, an anthracene group, a phenanthrene group, a triphenylene group, a pyrene group, a chrysene group, a 1,2,3,4-tetrahydronaphthalene group, a pyrrole group, a borole group, a phosphole group, a cyclopentadiene group, a silole group, a germole group, a thiophene group, a selenophene group, a furan group, an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluorene-9-one group, a dibenzothiophene 5,5-dioxide group, an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluorene-9-one group, an azadibenzothiophene 5,5-dioxide group, a pyridine group, a pyrimidine group, a pyrazine group, a pyridazine group, a triazine group, a quinoline group, an isoquinoline group, a benzoquinoline group, a benzoisoquinoline group, a quinoxaline group, a quinazoline group, a phenanthroline group, a pyrazole group, an imidazole group, a triazole group, an azaborole group, an azaphosphole group, an azacyclopentadiene group, an azasilole group, an azagermole group, an azaselenophene group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, or a 5,6,7,8-tetrahydroquinoline group; and/or
wherein $T_1$ is *-O-*'.

**4.** The organometallic compound of any of claims 1-3, wherein
$R_1$ to $R_2$ and $R_{21}$ are each independently:

hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, $-SF_5$, $C_1$-$C_{20}$ alkyl group, or a $C_1$-$C_{20}$ alkoxy group;
a $C_1$-$C_{20}$ alkyl group and a $C_1$-$C_{20}$ alkoxy group, each substituted with deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group, a cyclopentyl group, a cyclohexyl group, a cycloheptyl group, a cyclooctyl group, an adamantyl group, a norbornyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a ($C_1$-$C_{20}$ alkyl)cyclopentyl group, a ($C_1$-$C_{20}$ alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantanyl group, a ($C_1$-$C_{20}$ alkyl)norbornanyl group, a ($C_1$-$C_{20}$ alkyl)norbornenyl group, a ($C_1$-$C_{20}$ alkyl)cyclopentenyl group, a ($C_1$-$C_{20}$ alkyl)cyclohexenyl group, a ($C_1$-$C_{20}$ alkyl)cycloheptenyl group, a ($C_1$-$C_{20}$ alkyl)bicyclo[1.1.1]pentyl group, a ($C_1$-$C_{20}$ alkyl)bicyclo[2.1,1]hexyl group, a ($C_1$-$C_{20}$ alkyl)bicyclo[2.2.1]heptyl group, a ($C_1$-$C_{20}$ alkyl)bicyclo[2.2.2]octyl group, a phenyl group, a ($C_1$-$C_{20}$ alkyl)phenyl group, a biphenyl group, a terphenyl group, a naphthyl group, a pyridinyl group, a pyrimidinyl group, or any combination thereof;
a cyclopentyl group, a cyclohexyl group, a cycloheptyl group, a cyclooctyl group, an adamantyl group, a norbornyl

group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a phenyl group, a ($C_1$-$C_{20}$ alkyl)phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, or an azadibenzothiophenyl group, each unsubstituted or substituted with deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a deuterium-containing $C_2$-$C_{20}$ alkyl group, a $C_1$-$C_{20}$ alkoxy group, a cyclopentyl group, a cyclohexyl group, a cycloheptyl group, a cyclooctyl group, an adamantyl group, a norbornyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a ($C_1$-$C_{20}$ alkyl)cyclopentyl group, a ($C_1$-$C_{20}$ alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantanyl group, a ($C_1$-$C_{20}$ alkyl)norbornanyl group, a ($C_1$-$C_{20}$ alkyl)norbornenyl group, a ($C_1$-$C_{20}$ alkyl)cyclopentenyl group, a ($C_1$-$C_{20}$ alkyl)cyclohexenyl group, a ($C_1$-$C_{20}$ alkyl)cycloheptenyl group, a ($C_1$-$C_{20}$ alkyl)bicyclo[1.1.1]pentyl group, a ($C_1$-$C_{20}$ alkyl)bicyclo[2.1.1]hexyl group, a ($C_1$-$C_{20}$ alkyl)bicyclo[2.2.1]heptyl group, a ($C_1$-$C_{20}$ alkyl)bicyclo[2.2.2]octyl group, a phenyl group, a ($C_1$-$C_{20}$ alkyl)phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, or any combination thereof; or

$-N(Q_1)(Q_2)$, $-Si(Q_3)(Q_4)(Q_5)$, $-Ge(Q_3)(Q_4)(Q_5)$, $-B(Q_6)(Q_7)$, $-P(=O)(Q_6)(Q_9)$, or $-P(Q_6)(Q_9)$, and

$Q_1$ to $Q_9$ are each independently:

$-CH_3$, $-CD_3$, $-CD_2H$, $-CDH_2$, $-CH_2CH_3$, $-CH_2CD_3$, $-CH_2CD_2H$, $-CH_2CDH_2$, $-CHDCH_3$, $-CHDCD_2H$, $-CHDCDH_2$, $-CHDCD_3$, $-CD_2CD_3$, $-CD_2CD_2H$, or $-CD_2CDH_2$; or

an n-propyl group, an iso-propyl group, an n-butyl group, a sec-butyl group, an isobutyl group, a tert-butyl group, an n-pentyl group, a tert-pentyl group, a neo-pentyl group, an iso-pentyl group, a sec-pentyl group, a 3-pentyl group, a sec-iso-pentyl group, a phenyl group, a biphenyl group or a naphthyl group, each unsubstituted or substituted with deuterium, a $C_1$-$C_{10}$ alkyl group, a phenyl group, or any combination thereof.

**5.** The organometallic compound of any of claims 1-4, wherein a group represented by

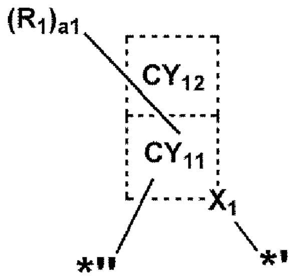

in Formula 2 is a group represented by one of Formulae CY1-1 to CY1-69:

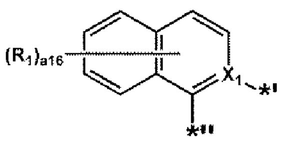
CY1-1

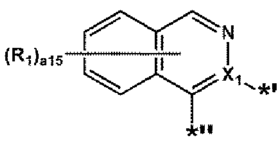
CY1-2

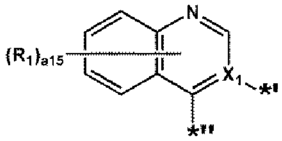
CY1-3

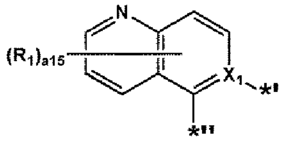
CY1-4

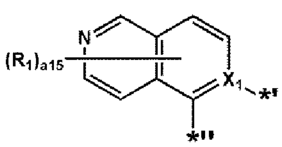
CY1-5

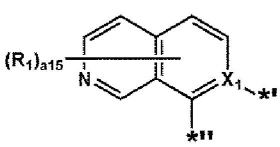
CY1-6

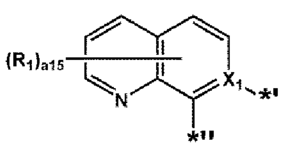
CY1-7

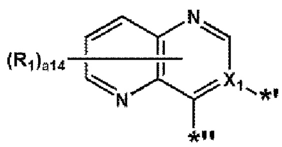
CY1-8

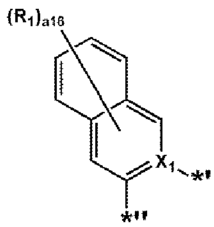
CY1-9

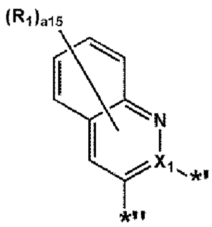
CY1-10

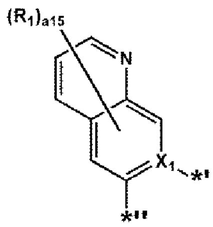
CY1-11

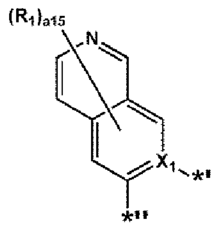
CY1-12

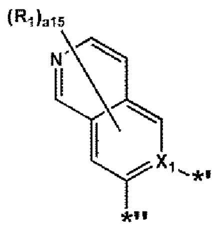
CY1-13

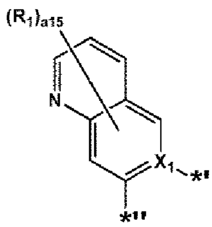
CY1-14

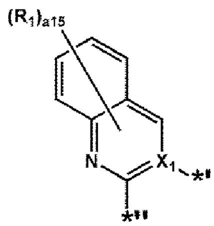
CY1-15

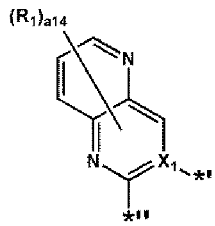
CY1-16

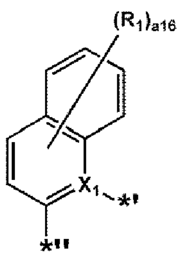
CY1-17

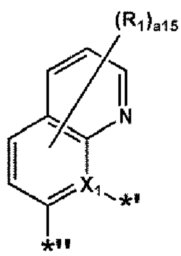
CY1-18

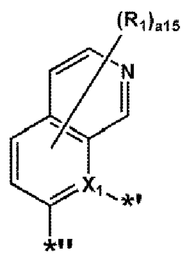
CY1-19

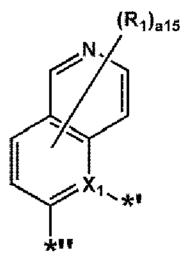
CY1-20

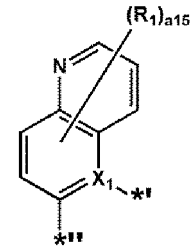
CY1-21

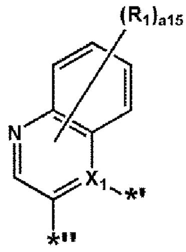
CY1-22

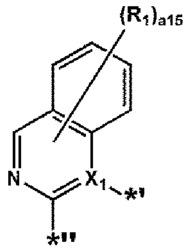
CY1-23

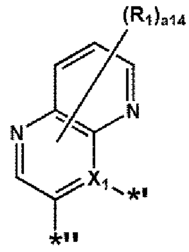
CY1-24

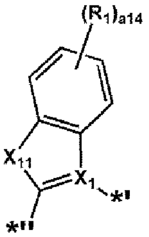
CY1-25

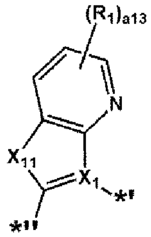
CY1-26

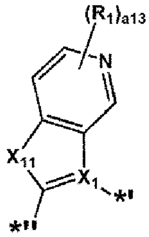
CY1-27

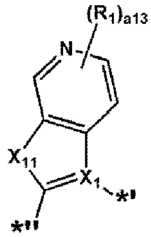
CY1-28

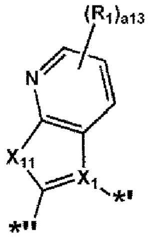
CY1-29

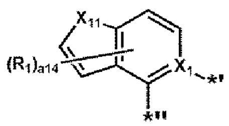
CY1-30

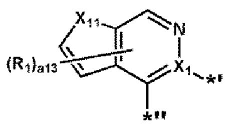
CY1-31

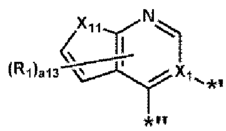
CY1-32

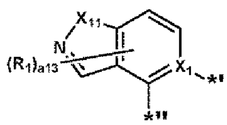
CY1-33

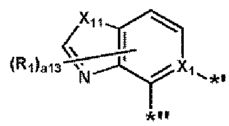
CY1-34

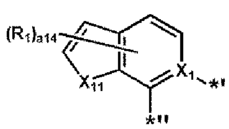
CY1-35

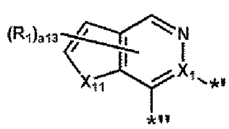
CY1-36

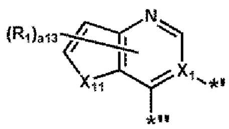
CY1-37

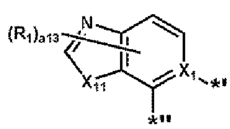
CY1-38

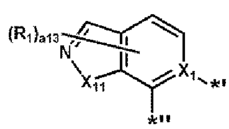
CY1-39

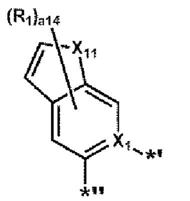
CY1-40

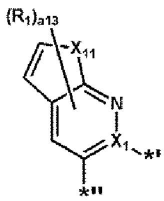
CY1-41

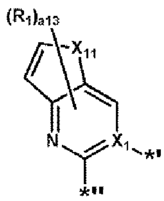
CY1-42

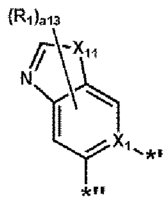
CY1-43

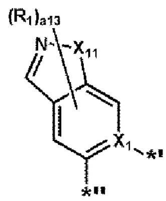
CY1-44

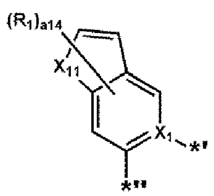
CY1-45

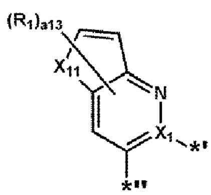
CY1-46

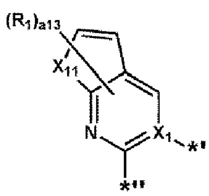
CY1-47

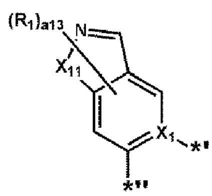
CY1-48

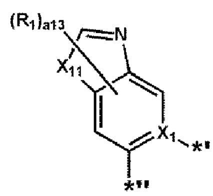
CY1-49

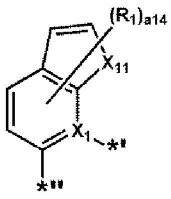
CY1-50

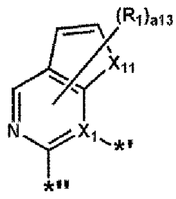
CY1-51

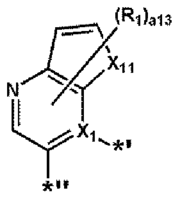
CY1-52

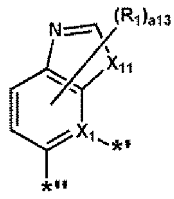
CY1-53

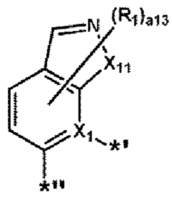
CY1-54

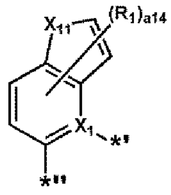
CY1-55

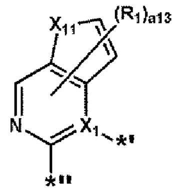
CY1-56

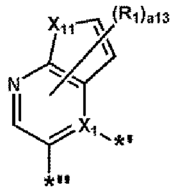
CY1-57

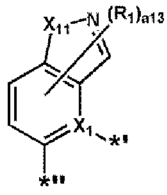
CY1-58

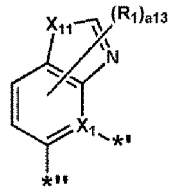
CY1-59

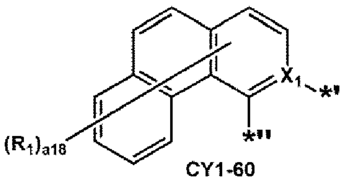
CY1-60

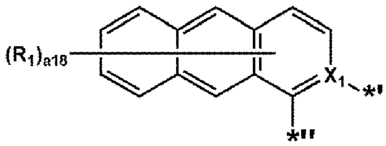
CY1-61

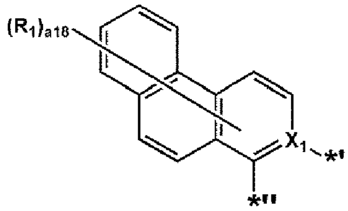
CY1-62

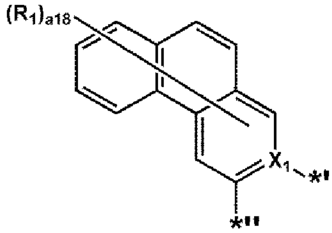
CY1-63

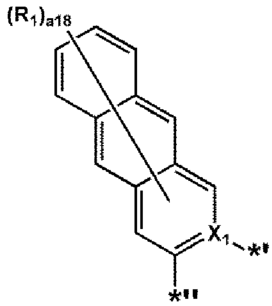
CY1-64

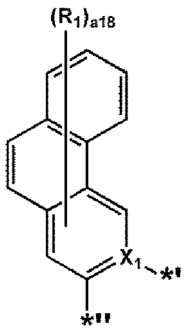
CY1-65

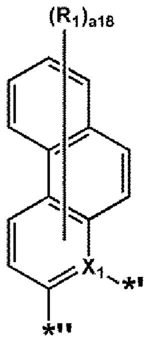
CY1-66

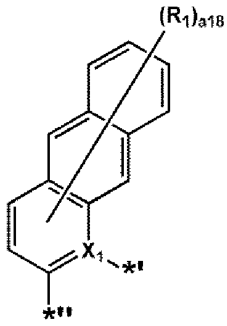
CY1-67

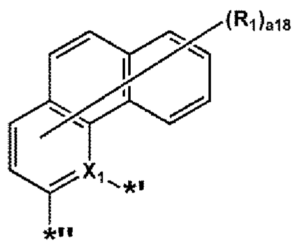
CY1-68

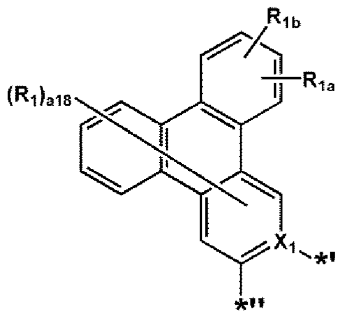
CY1-69

,

wherein, in Formulae CY1-1 to CY1-69,

$X_1$ and $R_1$ are each the same as defined in claim 1,

$X_{11}$ is O, S, Se, $N(R_{19})$, $C(R_{19a})(R_{19b})$, or $Si(R_{19a})(R_{19b})$,
$R_{19}$, $R_{19a}$, $R_{19b}$, $R_{1a}$ and $R_{1b}$ are each the same as defined in connection with $R_1$ in claim 1,
a18 is an integer from 0 to 8,
a16 is an integer from 0 to 6,
a15 is an integer from 0 to 5,
a14 is an integer from 0 to 4,
a13 is an integer from 0 to 3,
*" indicates a binding site to $T_1$ in Formula 2, and
*' indicates a binding site to M in Formula 1.

**6.** The organometallic compound of any of claims 1-5, wherein a group represented by

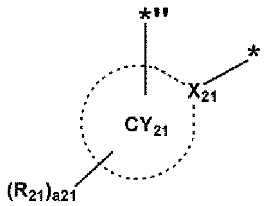

in Formula 2 is a group represented by one of Formulae CY21-1 to CY21-25:

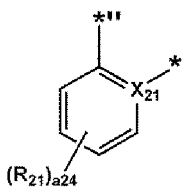
CY21-1

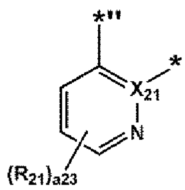
CY21-2

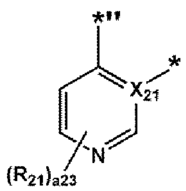
CY21-3

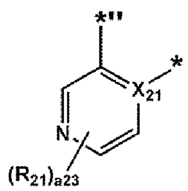
CY21-4

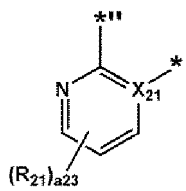
CY21-5

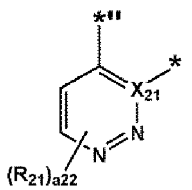
CY21-6

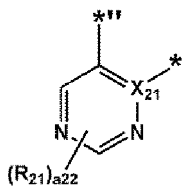
CY21-7

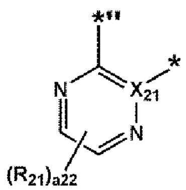
CY21-8

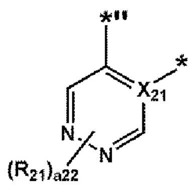
CY21-9

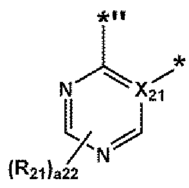
CY21-10

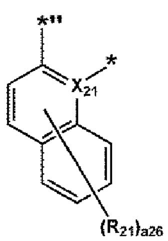
CY21-11

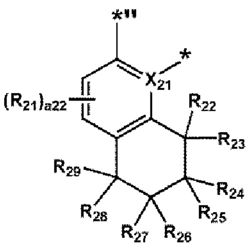
CY21-12

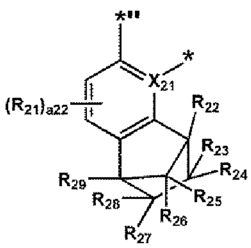
CY21-13

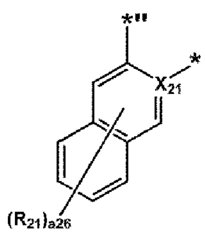
CY21-14

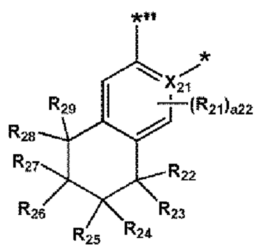
CY21-15

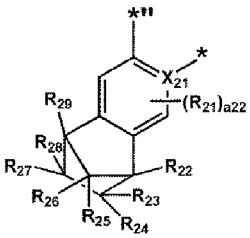

CY21-16

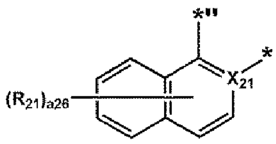

CY21-17

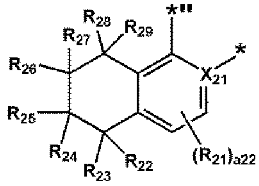

CY21-18

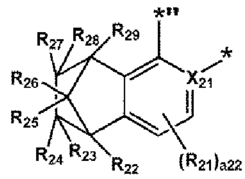

CY21-19

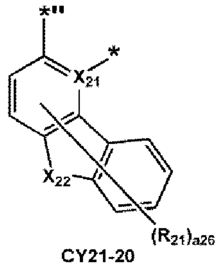

CY21-20

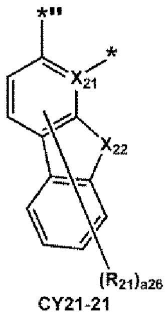

CY21-21

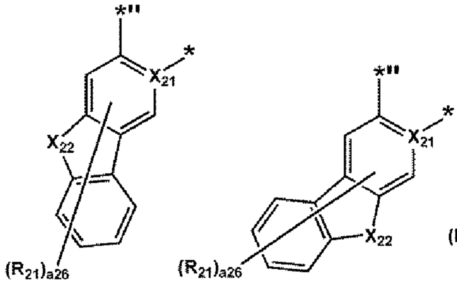

CY21-22

CY21-23

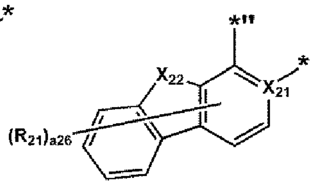

CY21-24

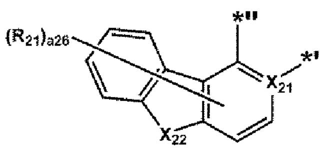

CY21-25

,

wherein, in Formulae CY21-1 to CY21-25,

$X_{21}$ and $R_{21}$ are each the same as defined in claim 1,
$X_{22}$ is $C(R_{22})(R_{23})$, $N(R_{22})$, O, S, or $Si(R_{22})(R_{23})$,
$R_{22}$ to $R_{29}$ are each the same as defined in connection with $R_{21}$ in claim 1,
a26 is an integer from 0 to 6,
a24 is an integer from 0 to 4,
a23 is an integer from 0 to 3,
a22 is an integer from 0 to 2,
*" indicates a binding site to $T_1$ in Formula 2, and
*' indicates a binding site to M in Formula 1;

preferably wherein
a group represented by

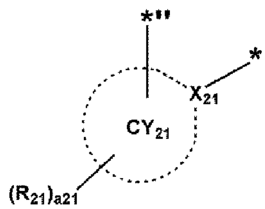

in Formula 2 is a group represented by one of Formulae CY21(1) to CY21(56) and Formula CY21-20 to CY21-25:

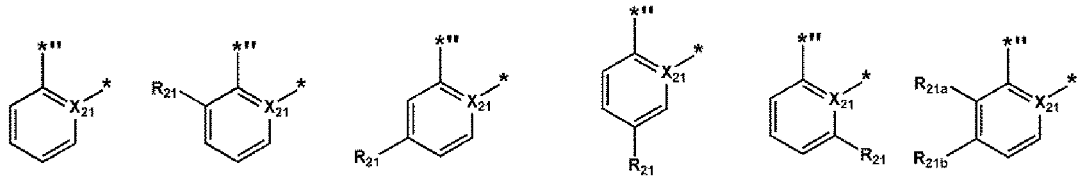

CY21(1) CY21(2) CY21(3) CY21(4) CY21(5) CY21(6)

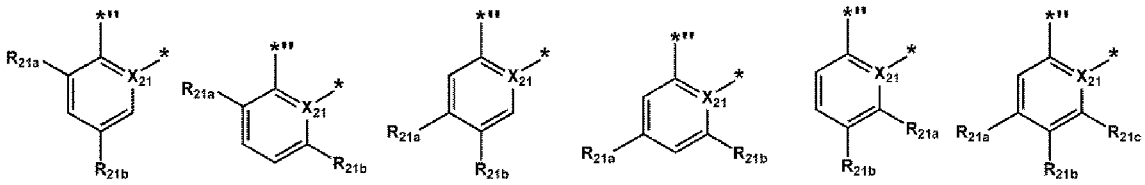

CY21(7) CY21(8) CY21(9) CY21(10) CY21(11) CY21(12)

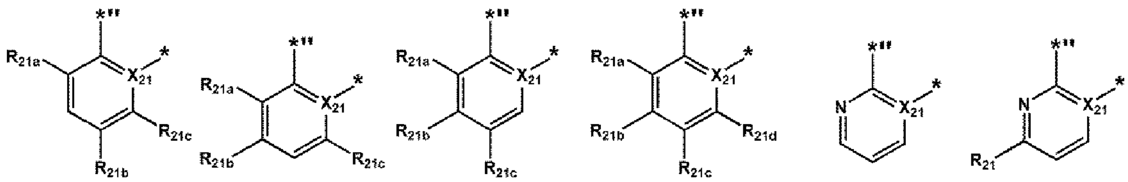

CY21(13) CY21(14) CY21(15) CY21(16) CY21(17) CY21(18)

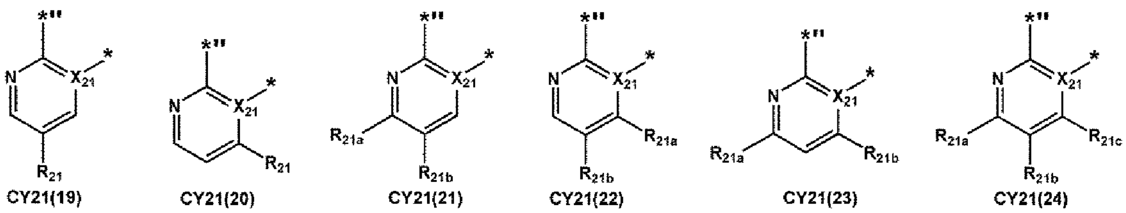

CY21(19) CY21(20) CY21(21) CY21(22) CY21(23) CY21(24)

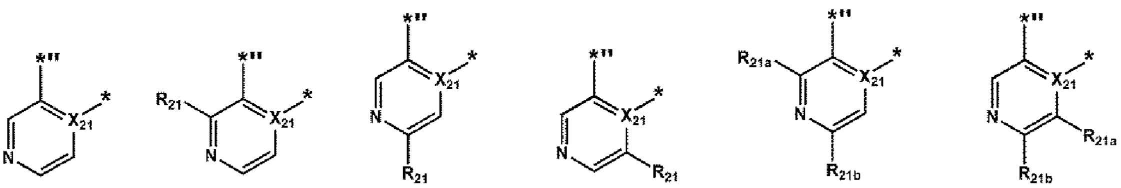

CY21(25) CY21(26) CY21(27) CY21(28) CY21(29) CY21(30)

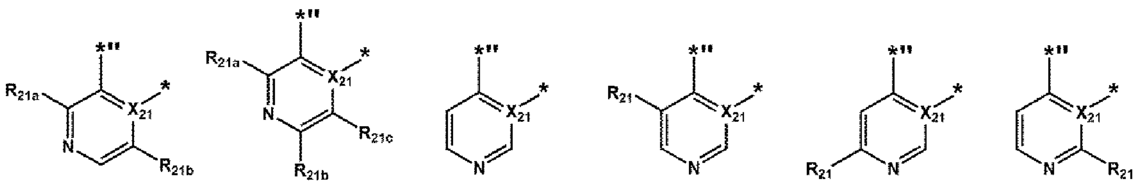

CY21(31) CY21(32) CY21(33) CY21(34) CY21(35) CY21(36)

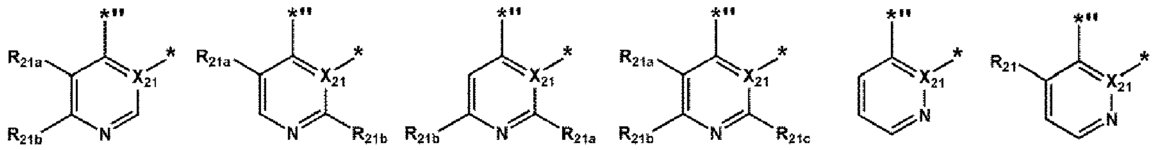

CY21(37) CY21(38) CY21(39) CY21(40) CY21(41) CY21(42)

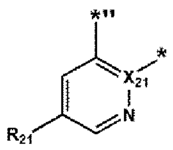
CY21(43)

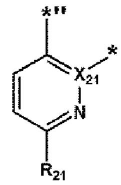
CY21(44)

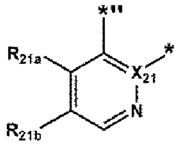
CY21(45)

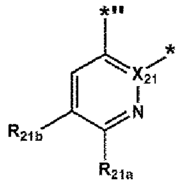
CY21(46)

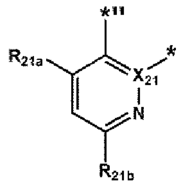
CY21(47)

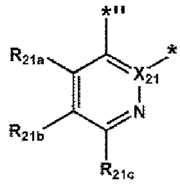
CY21(48)

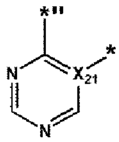
CY21(49)

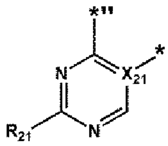
CY21(50)

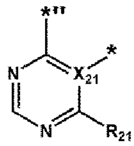
CY21(51)

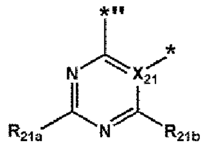
CY21(52)

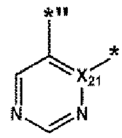
CY21(53)

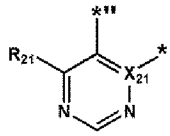
CY21(54)

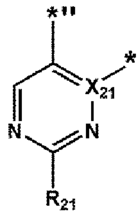
CY21(55)

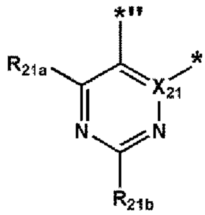
CY21(56) ,

wherein, in Formulae CY21(1) to CY21(56),

$X_{21}$ and $R_{21}$ are each the same as defined in claim 1
$R_{21a}$ to $R_{21d}$ are each the same as defined in connection with $R_{21}$ in claim 1, wherein each of $R_{21}$ and $R_{21a}$ to $R_{21d}$ is not hydrogen,
*" indicates a binding site to $T_1$ in Formula 2, and
*' indicates a binding site to M in Formula 1.

**7.** The organometallic compound of any of claims 1-6, wherein
$L_2$ in Formula 1 is a bidentate ligand each linked to M in Formula 1 via O, S, Se, N, C, P, Si, or As.

**8.** The organometallic compound of any of claims 1-6, wherein

$L_2$ in Formula 1 is a bidentate ligand represented by Formula 3.

<Formula 3>

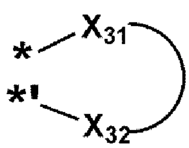
,

wherein, in Formula 3, $X_{31}$ and $X_{32}$ are each independently O, S, Se, or N,

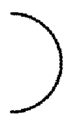

indicates a linking group linking $X_{31}$ and $X_{32}$ together, and
* and *' each indicate a binding site to M in Formula 1.

**9.** The organometallic compound of any of claims 1-6, wherein $L_2$ in Formula 1 is a group represented by one of Formulae 3A to 3F:

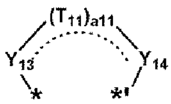
3A

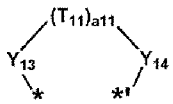
3B

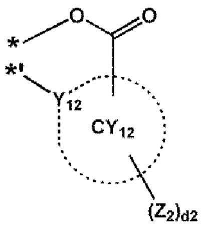
3C

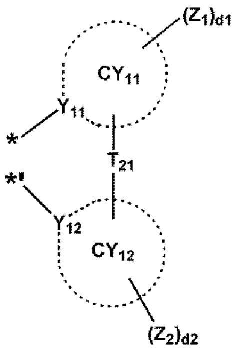
3D

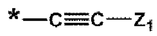
3E

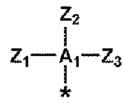
3F ,

wherein, in Formulae 3A to 3F,

$Y_{13}$ is O, N, $N(Z_1)$, $P(Z_1)(Z_2)$, or $As(Z_1)(Z_2)$,
$Y_{14}$ is O, N, $N(Z_3)$, $P(Z_3)(Z_4)$, or $As(Z_3)(Z_4)$,
$T_{11}$ is a single bond, a double bond, *-$C(Z_{11})(Z_{12})$-*', *-$C(Z_{11})$=$C(Z_{12})$-*', *=$C(Z_{11})$-*', *-$C(Z_{11})$=*', *=$C(Z_{11})$-$C(Z_{12})$=$C(Z_{13})$-*', *-$C(Z_{11})$=$C(Z_{12})$-$C(Z_{13})$=*', *-$N(Z_{11})$-*', or a $C_5$-$C_{30}$ carbocyclic group unsubstituted or substituted with at least one $Z_{11}$,
a11 is an integer from 1 to 10, when a11 is 2 or more, two or more $T_{11}$(s) are identical to or different from each other,
$Y_{11}$ and $Y_{12}$ are each independently C or N,
$T_{21}$ is a single bond, a double bone, O, S, $C(Z_{11})(Z_{12})$, $Si(Z_{11})(Z_{12})$, or $N(Z_{11})$
ring $CY_{11}$ and ring $CY_{12}$ are each independently a $C_5$-$C_{30}$ carbocyclic group or a C1-$C_{30}$ heterocyclic group,
$A_1$ is P or As,
$Z_1$ to $Z_4$ and $Z_{11}$ to $Z_{13}$ are each the same as defined in connection with $R_{21}$ in claim 2,
d1 and d2 are each independently an integer from 0 to 10, and
* and *' each indicate a binding site to M in Formula 1.

**10.** The organometallic compound of any of claims 1-6, wherein $L_2$ in Formula 1 is a group represented by one of Formulae 3-1(1) to 3-1(66) and 3-1(301) to 3-1(309):

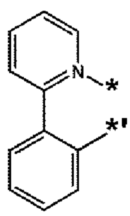
3-1(1)

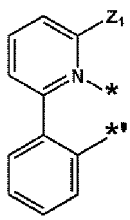
3-1(2)

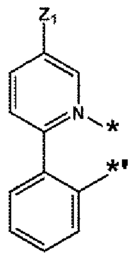
3-1(3)

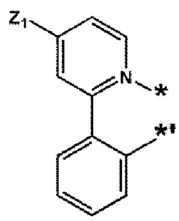
3-1(4)

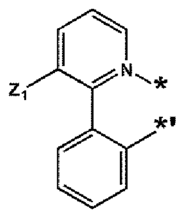
3-1(5)

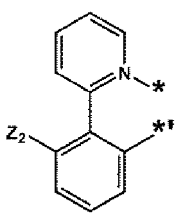
3-1(6)

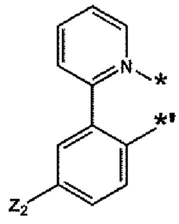
3-1(7)

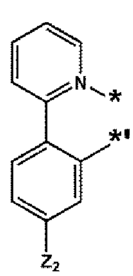
3-1(8)

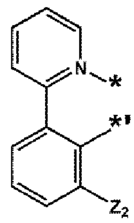
3-1(9)

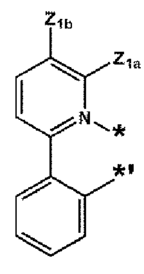
3-1(10)

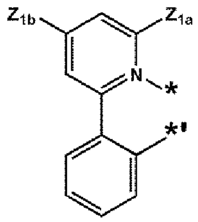
3-1(11)

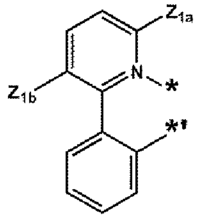
3-1(12)

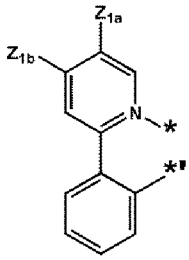
3-1(13)

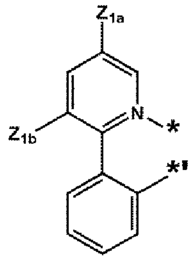
3-1(14)

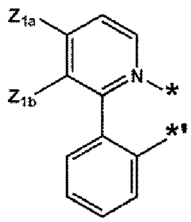
3-1(15)

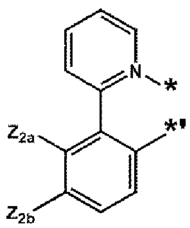
3-1(16)

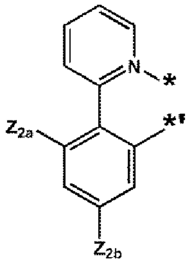
3-1(17)

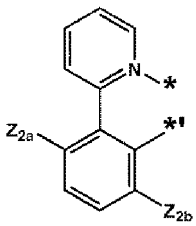
3-1(18)

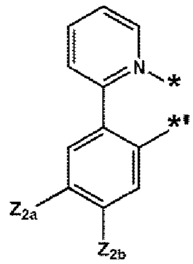
3-1(19)

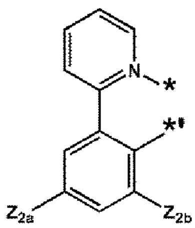
3-1(20)

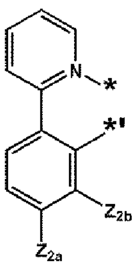
3-1(21)

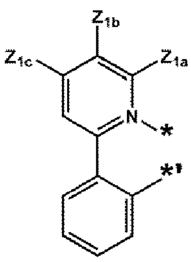
3-1(22)

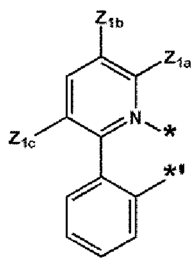
3-1(23)

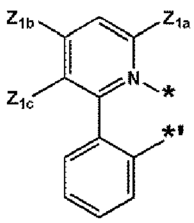
3-1(24)

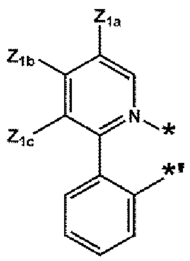
3-1(25)

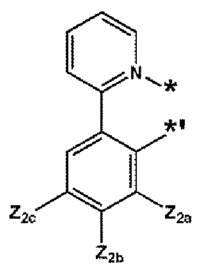
3-1(26)

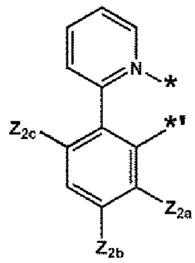
3-1(27)

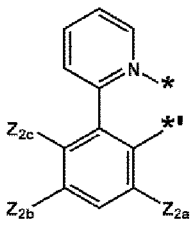
3-1(28)

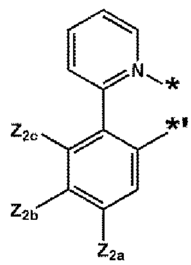
3-1(29)

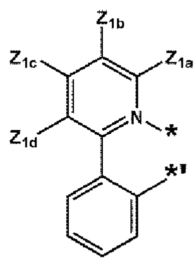
3-1(30)

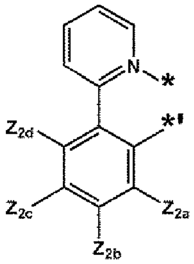
3-1(31)

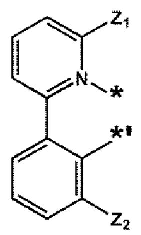
3-1(32)

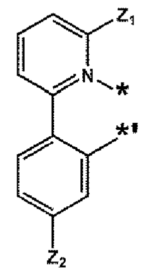
3-1(33)

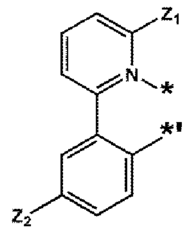
3-1(34)

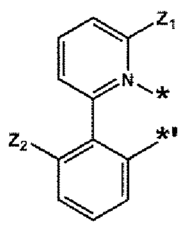
3-1(35)

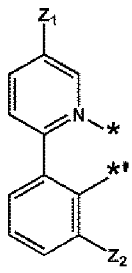
3-1(36)

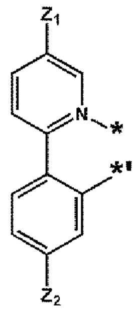
3-1(37)

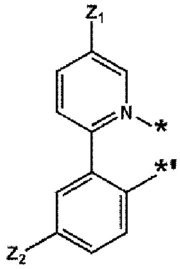
3-1(38)

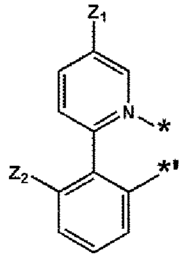
3-1(39)

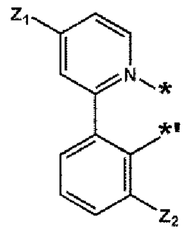
3-1(40)

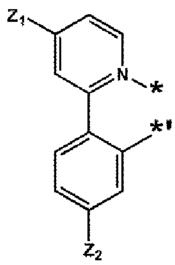
3-1(41)

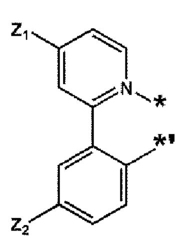
3-1(42)

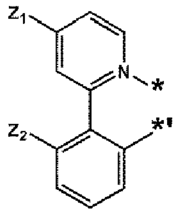
3-1(43)

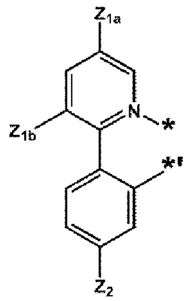
3-1(44)

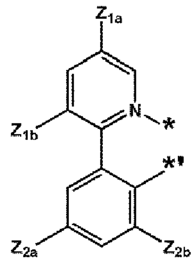
3-1(45)

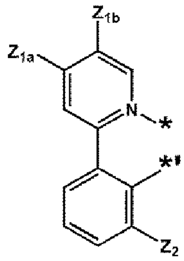
3-1(46)

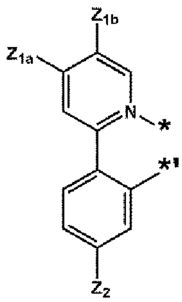
3-1(47)

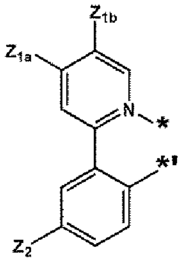
3-1(48)

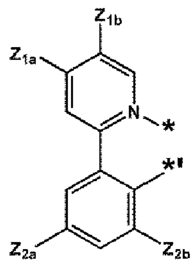
3-1(49)

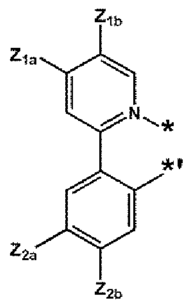
3-1(50)

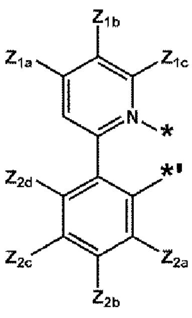
3-1(51)

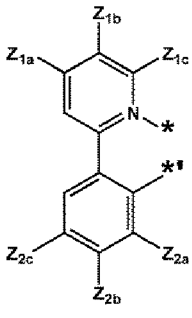
3-1(52)

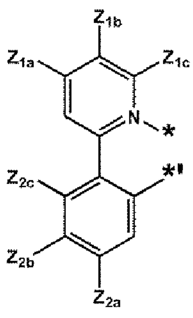
3-1(53)

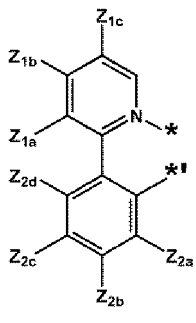
3-1(54)

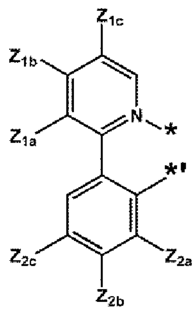
3-1(55)

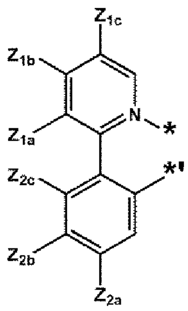
3-1(56)

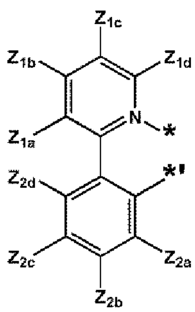
3-1(57)

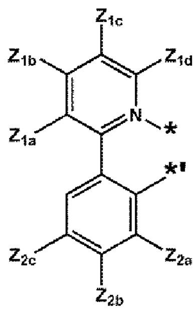
3-1(58)

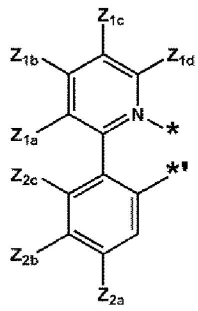
3-1(59)

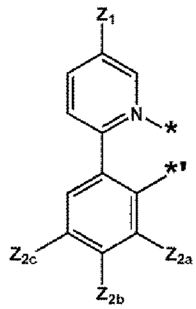
3-1(60)

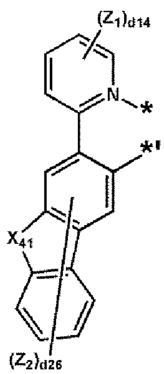
3-1(61)

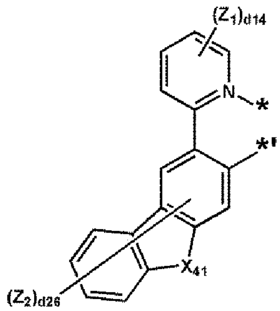
3-1(62)

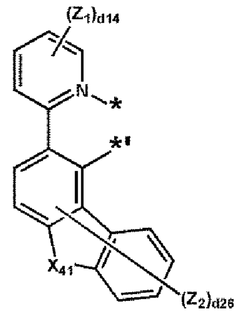
3-1(63)

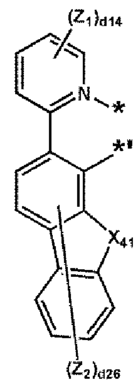
3-1(64)

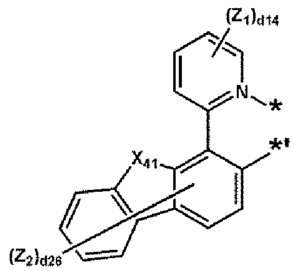
3-1(65)

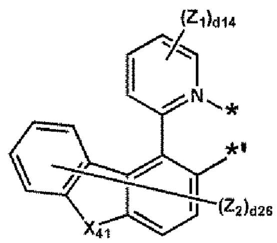
3-1(66)

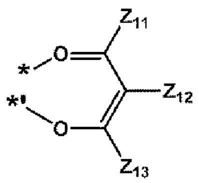
3-1(301)

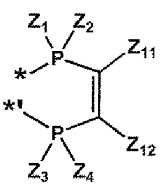
3-1(302)

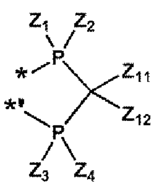
3-1(303)

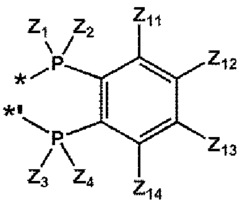
3-1(304)

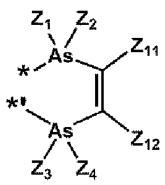
3-1(305)

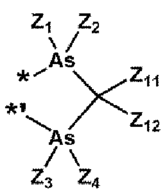
3-1(306)

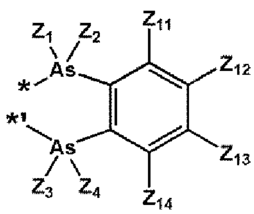
3-1(307)

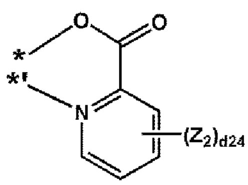
3-1(308)

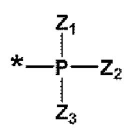
3-1(309)

,

wherein, in Formulae 3-1(1) to 3-1(66) and 3-1(301) to 3-1(309),

$X_{41}$ is O, S, $N(Z_{21})$, $C(Z_{21})(Z_{22})$, or $Si(Z_{21})(Z_{22})$,
$Z_1$ to $Z_4$, $Z_{1a}$, $Z_{1b}$, $Z_{1c}$, $Z_{1d}$, $Z_{2a}$, $Z_{2b}$, $Z_{2c}$, $Z_{2d}$, and $Z_{11}$ to $Z_{14}$ are each the same as defined in connection with $R_{21}$ in claim 1,
d14 is an integer from 0 to 4,
d26 is an integer from 0 to 6, and
* and *' each indicate a binding site to M in Formula 1.

**11.** The organometallic compound of any of claims 1-6, wherein $L_2$ in Formula 1 is a group represented by Formula 3-1-1:

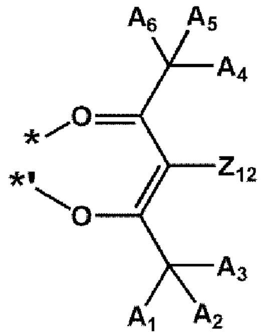

3-1-1 ,

wherein, in Formula 3-1-1,

$Z_{12}$ is the same as defined in connection with $R_{21}$ in claim 1,
$A_2$ and $A_5$ are each independently hydrogen, deuterium, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic condensed polycyclic group, or a substituted or unsubstituted monovalent non-aromatic condensed heteropolycyclic group,
$A_1$, $A_3$, $A_4$, and $A_6$ are each independently a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic condensed polycyclic group, or a substituted or unsubstituted monovalent non-aromatic condensed heteropolycyclic group,
two or more of $A_1$ to $A_6$ are optionally be linked to form a $C_5$-$C_{30}$ carbocyclic group unsubstituted or substituted with at least one $R_{1a}$ or a $C_1$-$C_{30}$ heterocyclic group unsubstituted or substituted with at least one $R_{1a}$,
$R_{1a}$ is the same as defined in connection with $Z_{12}$,
a substitute(s) of the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_6$-$C_{60}$ aryloxy group, the substituted $C_6$-$C_{60}$ arylthio group, the substituted $C_1$-$C_{60}$ heteroaryl group, the substituted monovalent non-aromatic condensed polycyclic group, and the substituted monovalent non-aromatic condensed heteropolycyclic group is:

deuterium, -F, -Cl, -Br, -I, $-CD_3$, $-CD_2H$, $-CDH_2$, $-CF_3$, $-CF_2H$, $-CFH_2$, a hydroxyl group, a cyano group, a

nitro group, an amino group, an amidino group, a hydrazino group, a hydrazono group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, or a $C_1$-$C_{60}$ alkoxy group

a $C_1$-$C_{60}$ alkyl group, a $C_2$-$C_{60}$ alkenyl group, a $C_2$-$C_{60}$ alkynyl group, or a $C_1$-$C_{60}$ alkoxy group, each substituted with deuterium, -F, -Cl, -Br, -I, $-CD_3$, $-CD_2H$, $-CDH_2$, $-CF_3$, - $CF_2H$, $-CFH_2$, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, a monovalent non-aromatic condensed heteropolycyclic group, $-N(Q_{11})(Q_{12})$,$-Si(Q_{13})(Q_{14})(Q_{15})$, $-Ge(Q_{13})(Q_{14})(Q_{15})$, $-B(Q_{16})(Q_{17})$, $-P(=O)(Q_{18})(Q_{19})$, $-P(Q_{18})(Q_{19})$, or any combination thereof;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a C6-$C_{60}$ arylthio group, a $C_1$-$C_{60}$ heteroaryl group, a monovalent non-aromatic condensed polycyclic group, or a monovalent non-aromatic condensed heteropolycyclic group, each unsubstituted or substituted with deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, a monovalent non-aromatic condensed heteropolycyclic group, $-N(Q_{21})(Q_{22})$, $-Si(Q_{23})(Q_{24})(Q_{25})$, $-Ge(Q_{23})(Q_{24})(Q_{25})$, $-B(Q_{26})(Q_{27})$, $-P(=O)(Q_{26})(Q_{29})$, $-P(Q_{28})(Q_{29})$, or any combination thereof;

$-N(Q_{31})(Q_{32})$, $-Si(Q_{33})(Q_{34})(Q_{35})$, $-Ge(Q_{33})(Q_{34})(Q_{35})$, $-B(Q_{36})(Q_{37})$, $-P(=O)(Q_{38})(Q_{39})$, or $-P(Q_{38})(Q_{39})$; or any combination thereof, and

$Q_{11}$ to $Q_{19}$, $Q_{21}$ to $Q_{29}$, and $Q_{31}$ to $Q_{39}$ are each independently hydrogen; deuterium; -F; -Cl; -Br; -I; a hydroxyl group; a cyano group; a nitro group; an amidino group; a hydrazine group; a hydrazone group; a carboxylic acid group or a salt thereof; a sulfonic acid group or a salt thereof; a phosphoric acid group or a salt thereof; a $C_1$-$C_{60}$ alkyl group unsubstituted or substituted with deuterium, a $C_1$-$C_{60}$ alkyl group, a $C_6$-$C_{60}$ aryl group, or any combination thereof; a $C_2$-$C_{60}$ alkenyl group; a $C_2$-$C_{60}$ alkynyl group; a $C_1$-$C_{60}$ alkoxy group; a $C_3$-$C_{10}$ cycloalkyl group; a $C_1$-$C_{10}$ heterocycloalkyl group; a $C_3$-$C_{10}$ cycloalkenyl group; a $C_1$-$C_{10}$ heterocycloalkenyl group; a $C_6$-$C_{60}$ aryl group unsubstituted or substituted with deuterium, a $C_1$-$C_{60}$ alkyl group, a $C_6$-$C_{60}$ aryl group, or any combination thereof; a $C_6$-$C_{60}$ aryloxy group; a $C_6$-$C_{60}$ arylthio group; a $C_7$-$C_{60}$ arylalkyl group; a $C_1$-$C_{60}$ heteroaryl group; a $C_1$-$C_{60}$ heteroaryloxy group; a $C_1$-$C_{60}$ heteroarylthio group; a $C_2$-$C_{60}$ heteroarylalkyl group; a monovalent non-aromatic condensed polycyclic group; or a monovalent non-aromatic condensed heteropolycyclic group.

**12.** The organometallic compound of claim 1, wherein the organometallic compound is one of Compounds 1 to 366:

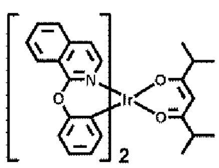
1

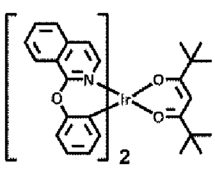
2

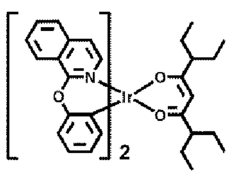
3

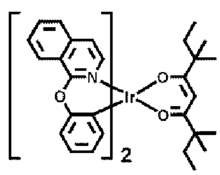
4

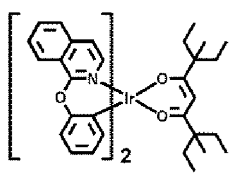
5

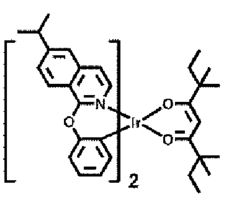
6

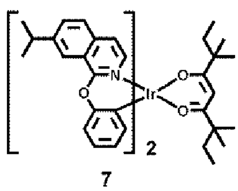
7

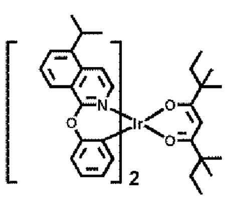
8

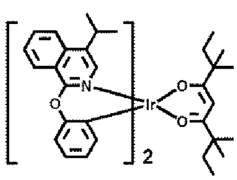
9

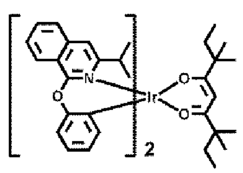
10

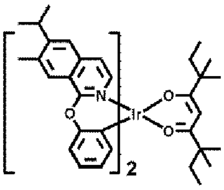
11

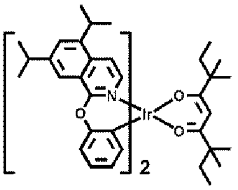
12

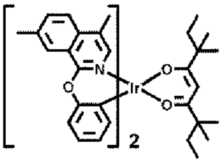
13

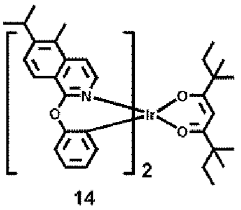
14

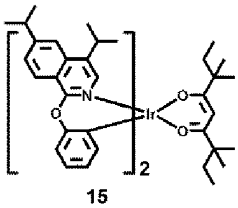
15

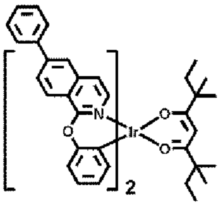
16

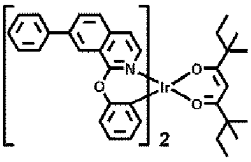
17

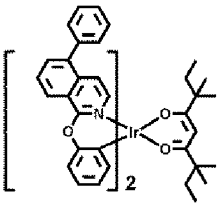
18

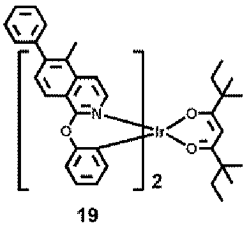
19

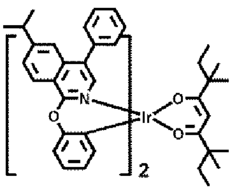
20

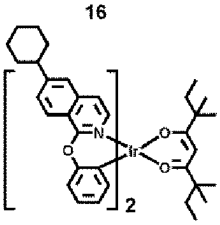
21

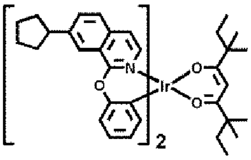
22

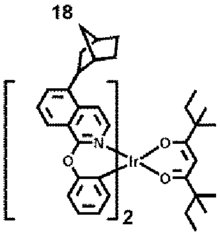
23

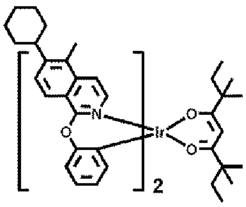
24

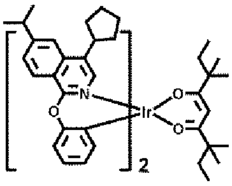
25

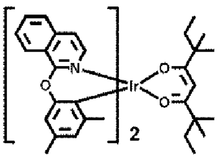
26

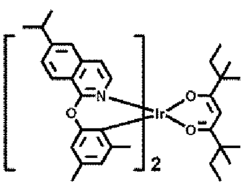
27

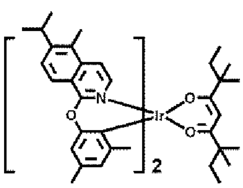
28

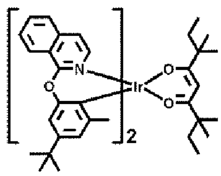
29

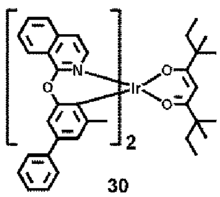
30

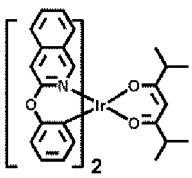
31

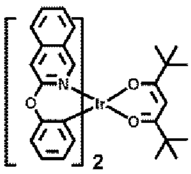
32

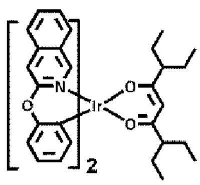
33

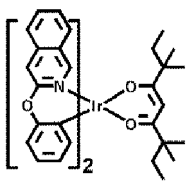
34

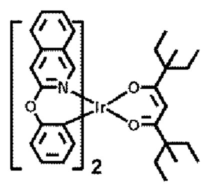
35

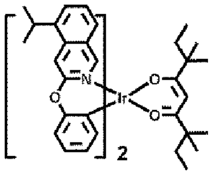
36
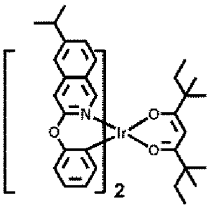
37
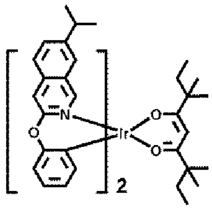
38
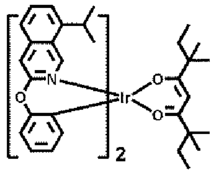
39
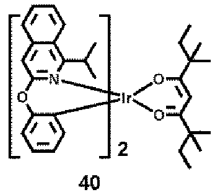
40
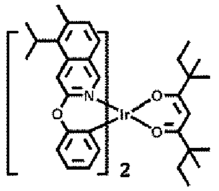
41
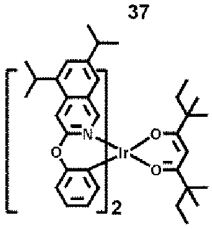
42
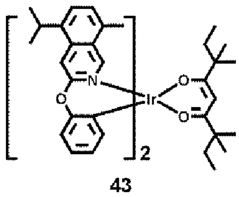
43
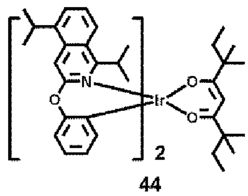
44
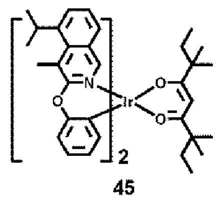
45
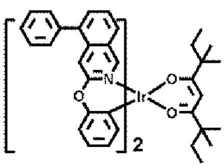
46
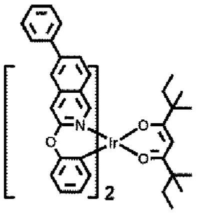
47
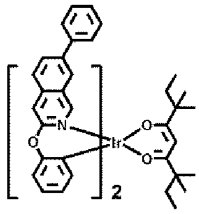
48
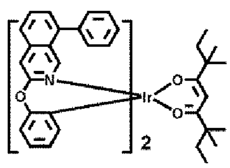
49
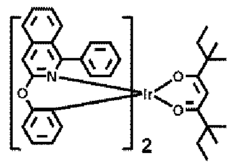
50
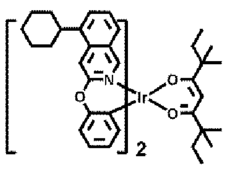
51
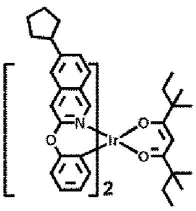
52
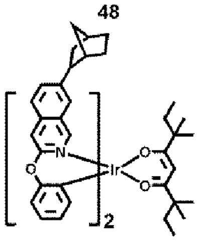
53
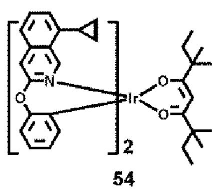
54
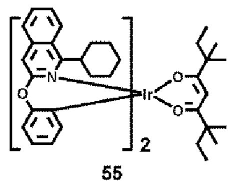
55
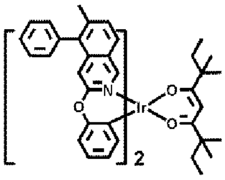
56
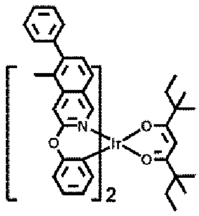
57
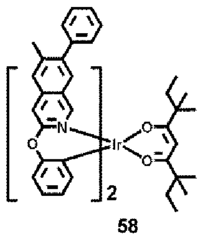
58
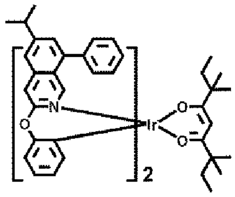
59
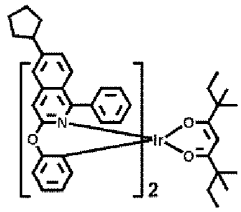
60
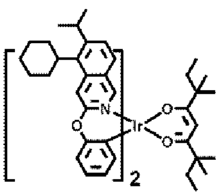
61
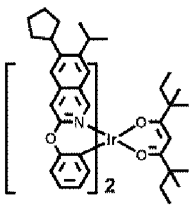
62
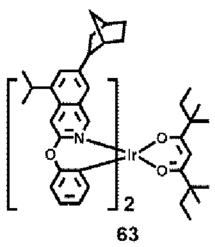
63
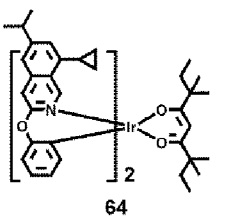
64
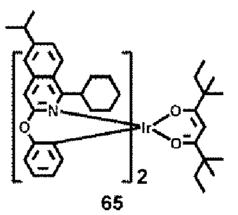
65

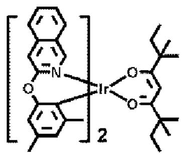
66
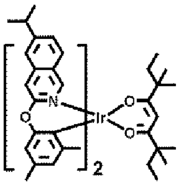
67
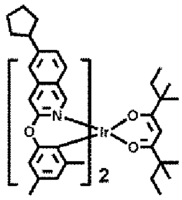
68
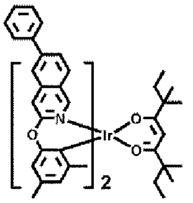
69
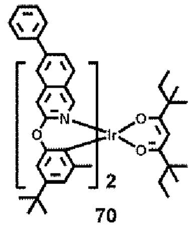
70
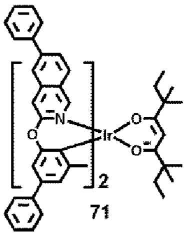
71

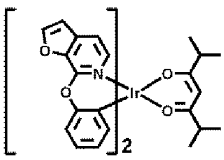
72
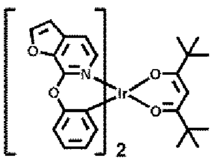
73
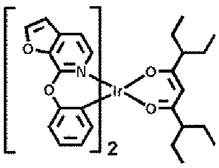
74
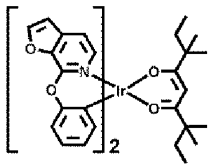
76
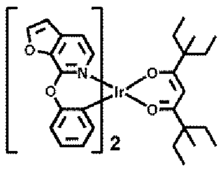
76

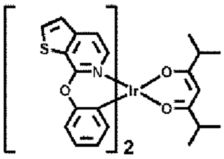
77
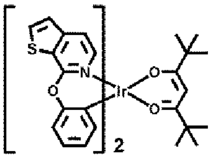
78
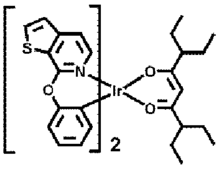
79
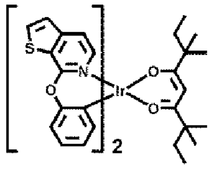
80
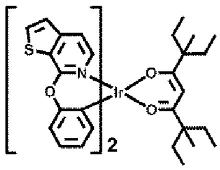
81

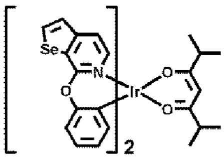
82
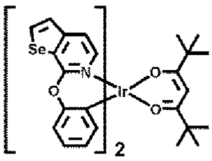
83
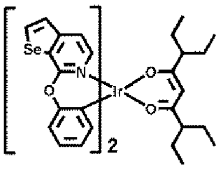
84
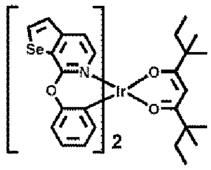
85
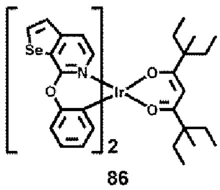
86

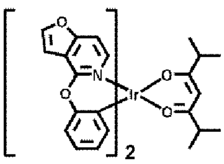
87
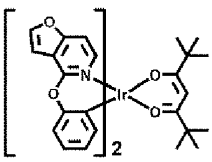
88
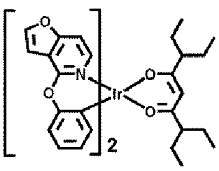
89
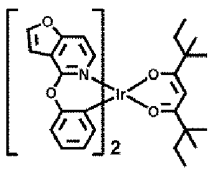
90
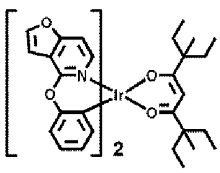
91

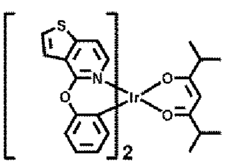
92
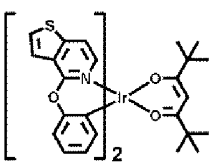
93
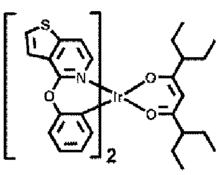
94
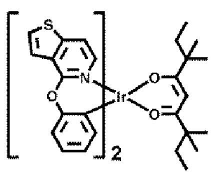
95
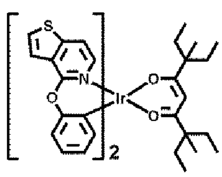
96

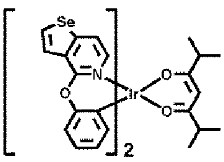
97
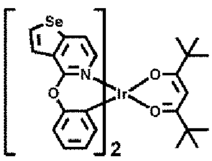
98
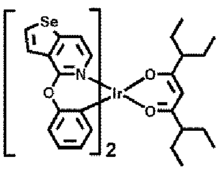
99
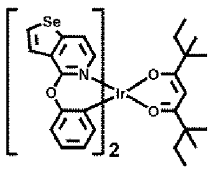
100
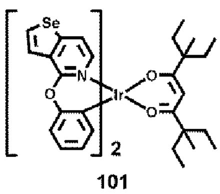
101

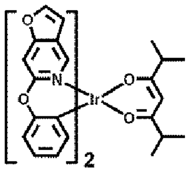
102
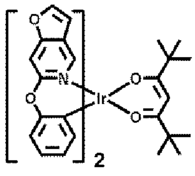
103
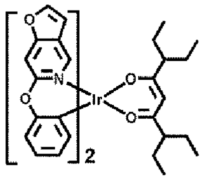
104
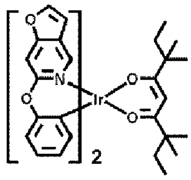
105
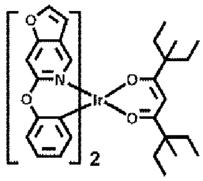
106
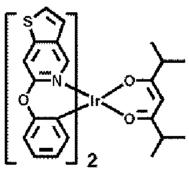
107
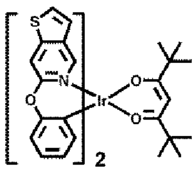
108
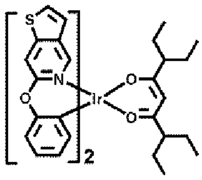
109
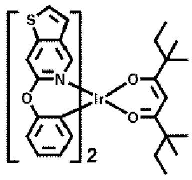
110
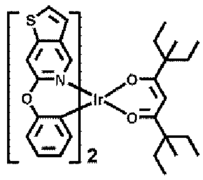
111
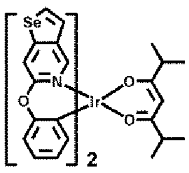
112
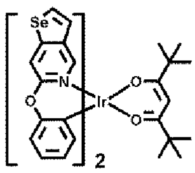
113
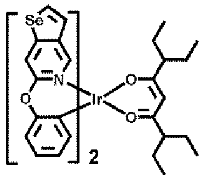
114
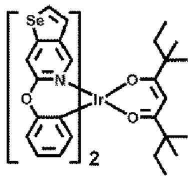
115
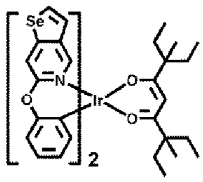
116
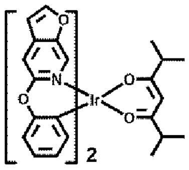
117
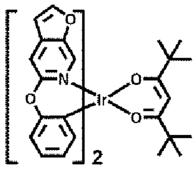
118
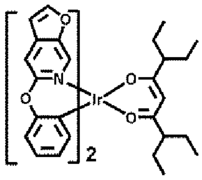
119
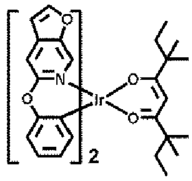
120
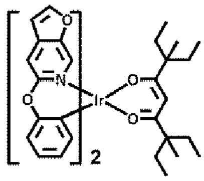
121
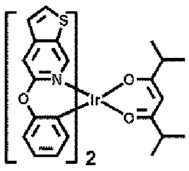
122
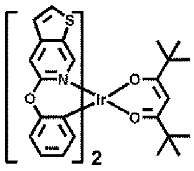
123
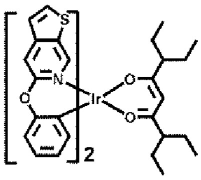
124
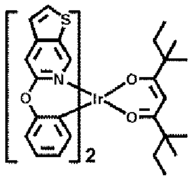
125
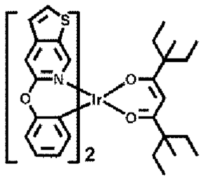
126
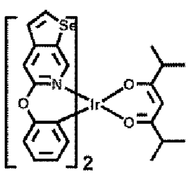
127
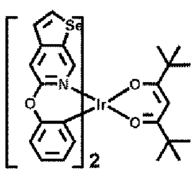
128
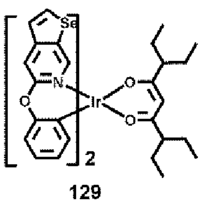
129
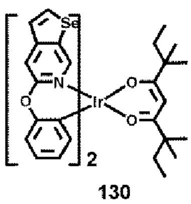
130
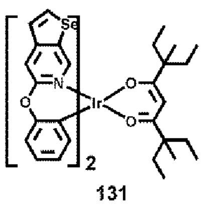
131

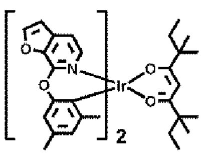
132
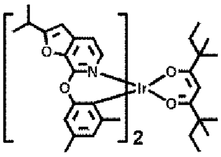
133
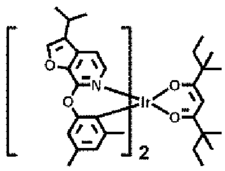
134
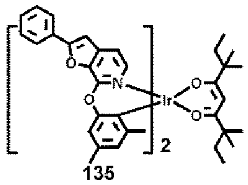
135
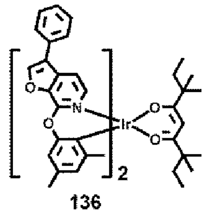
136
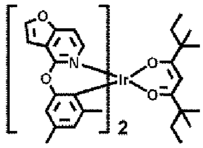
137
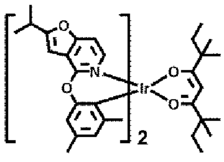
138
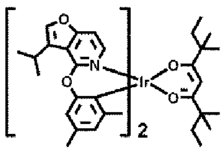
139
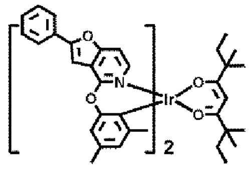
140
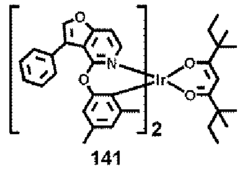
141
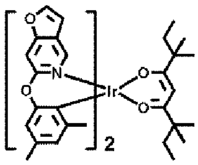
142
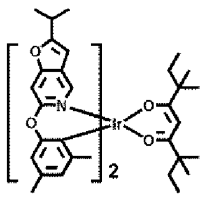
143
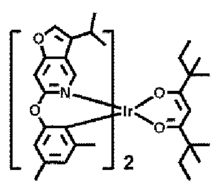
144
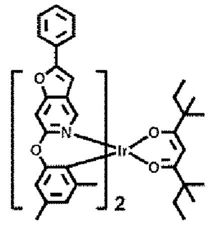
145
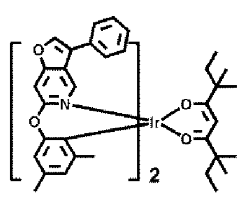
146
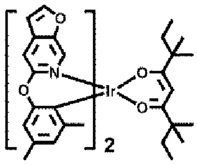
147
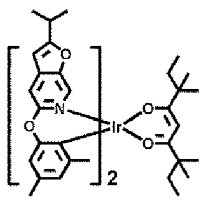
148
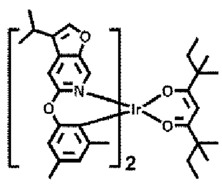
149
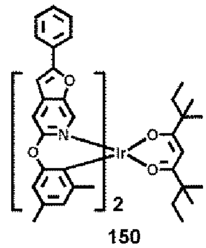
150
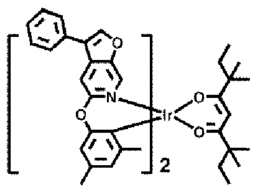
151
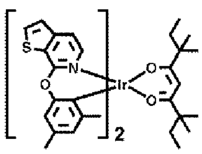
152
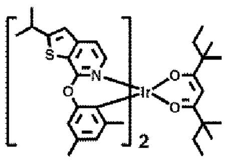
153
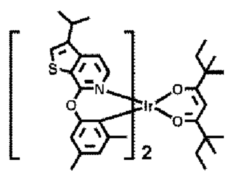
154
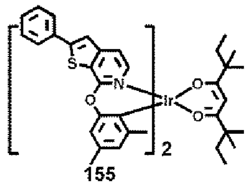
155
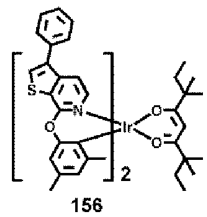
156
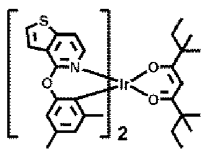
157
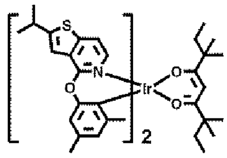
158
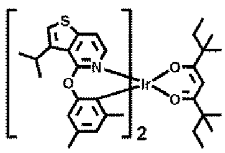
159
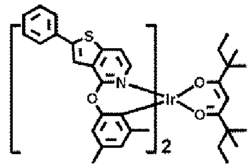
160
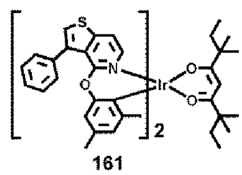
161
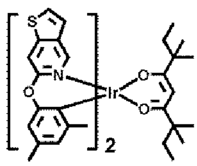
162
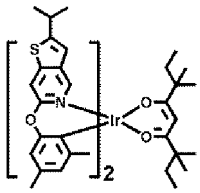
163
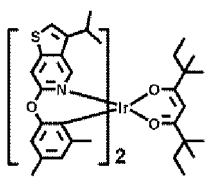
164
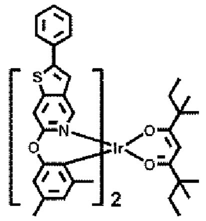
165
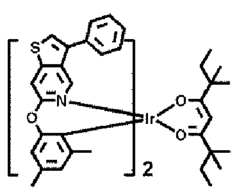
166

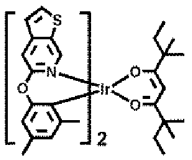
167

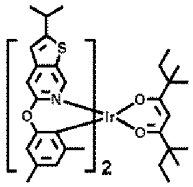
168

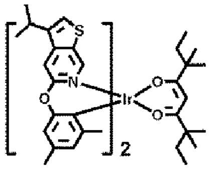
169

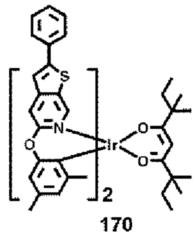
170

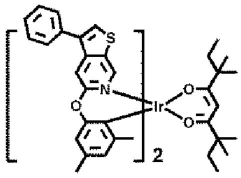
171

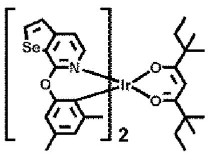
172

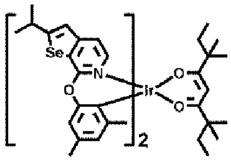
173

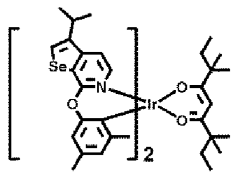
174

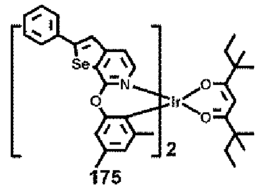
175

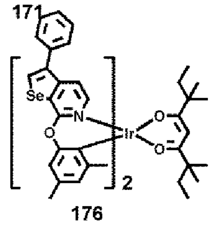
176

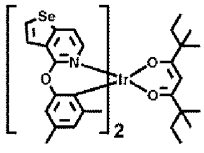
177

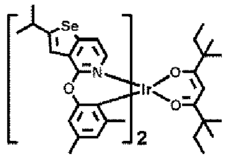
178

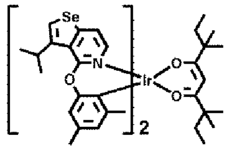
179

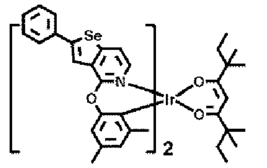
180

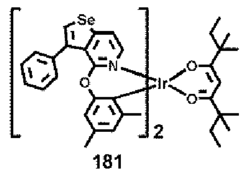
181

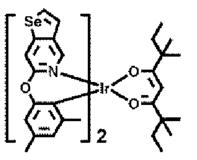
182

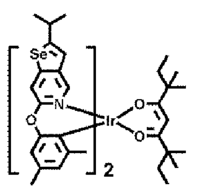
183

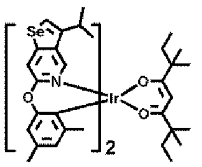
184

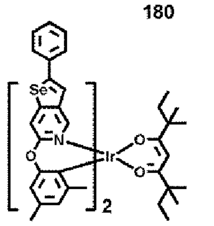
185

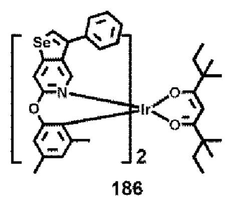
186

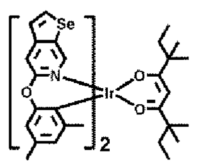
187

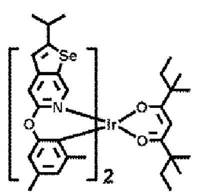
188

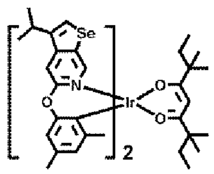
189

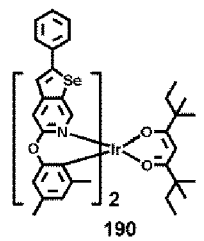
190

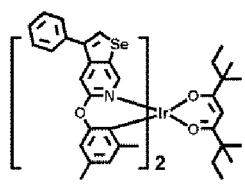
191

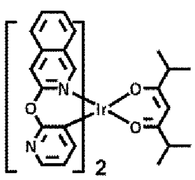
192

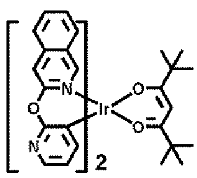
193

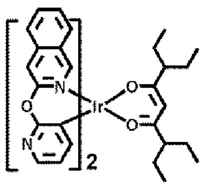
194

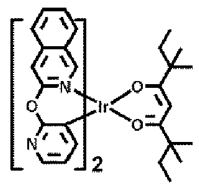
195

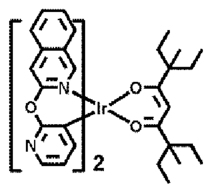
196

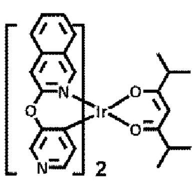
197

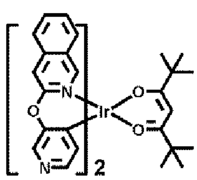
198

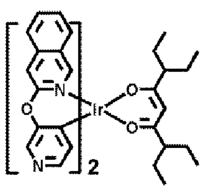
199

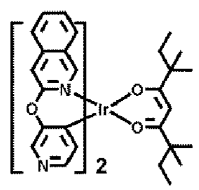
200

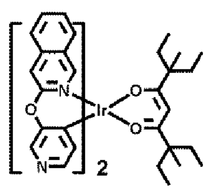
201

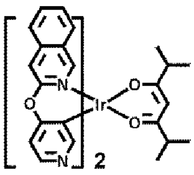
202

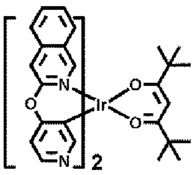
203

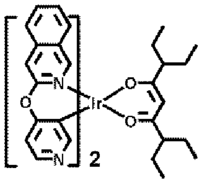
204

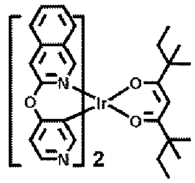
205

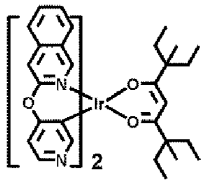
206

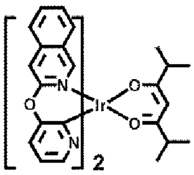
207

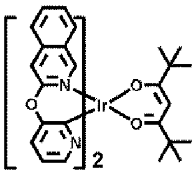
208

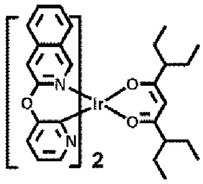
209

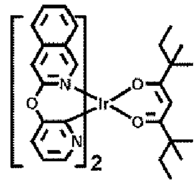
210

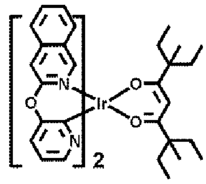
211

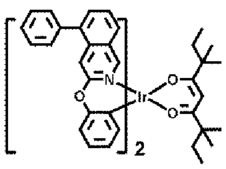
212

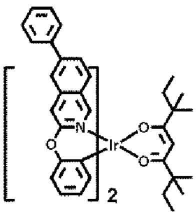
213

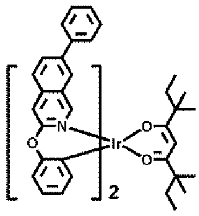
214

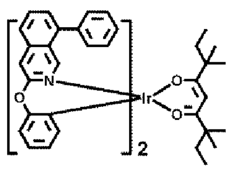
215

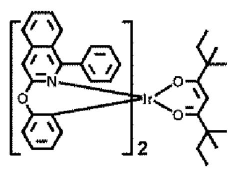
216

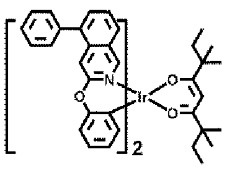
217

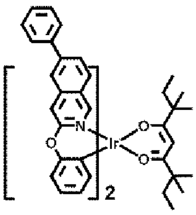
218

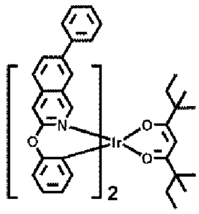
219

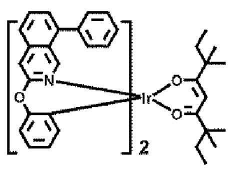
220

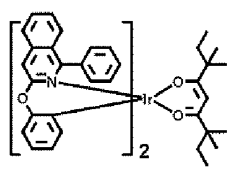
221

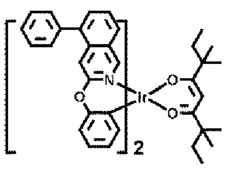
222

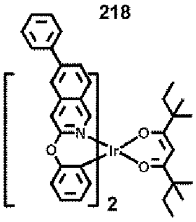
223

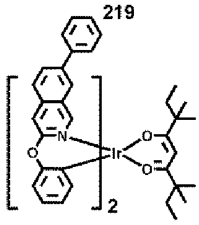
224

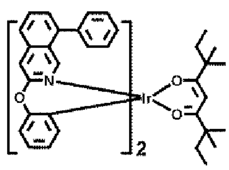
225

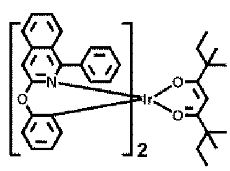
226

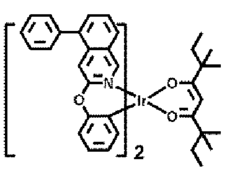
227

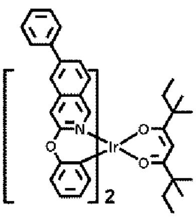
228

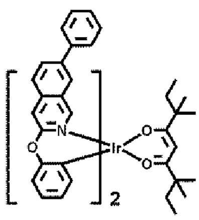
229

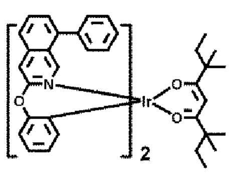
230

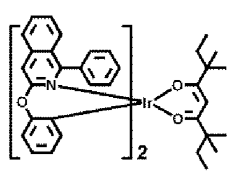
231

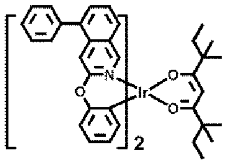
232
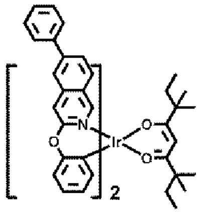
233
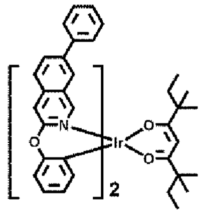
234
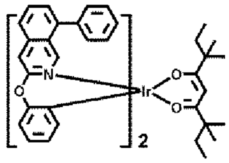
235
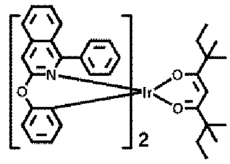
236

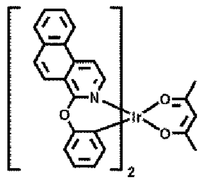
237
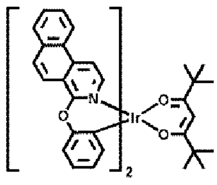
238
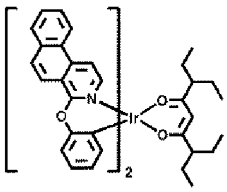
239
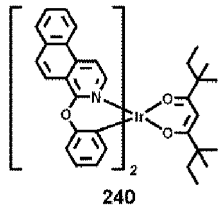
240
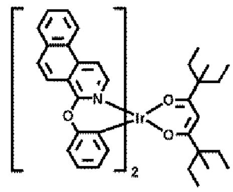
241

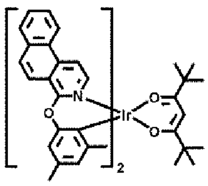
242
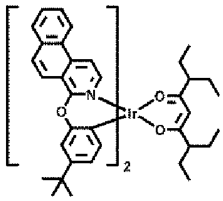
243
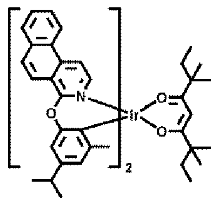
244
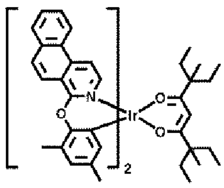
245
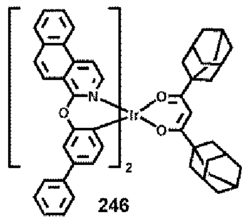
246

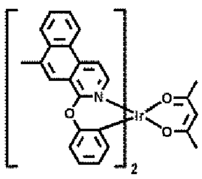
247
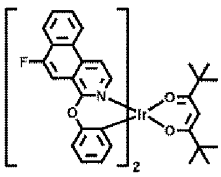
248
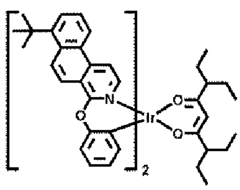
249
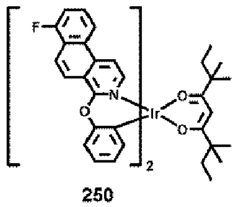
250
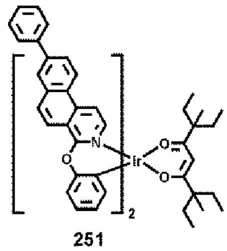
251

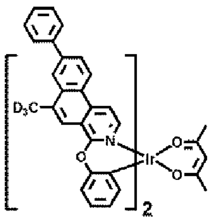
252
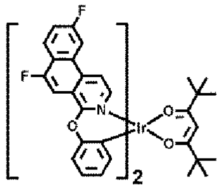
253
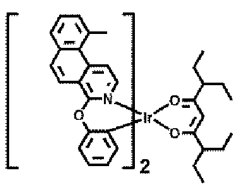
254
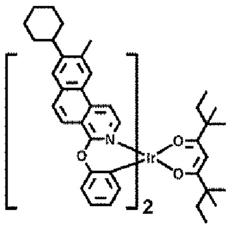
255
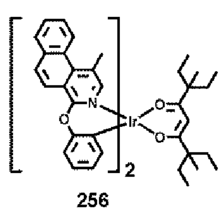
256

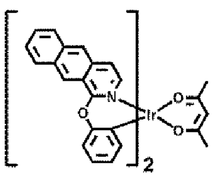
257
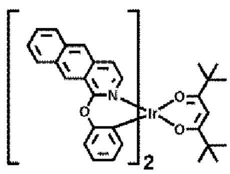
258
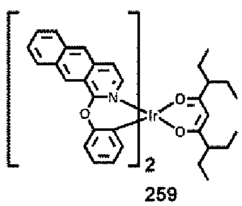
259
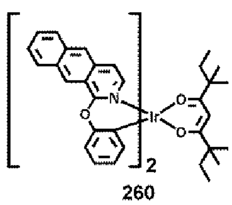
260
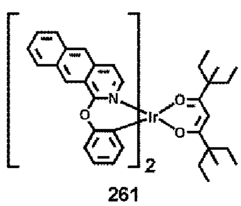
261

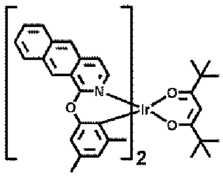

262

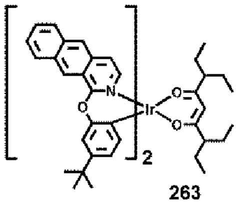

263

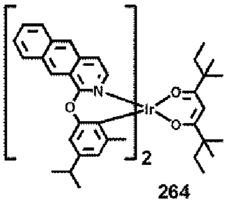

264

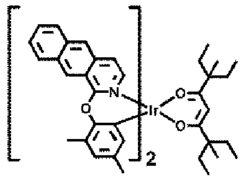

265

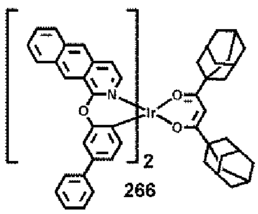

266

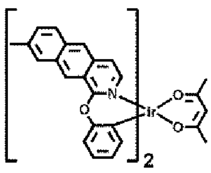

267

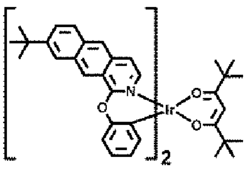

268

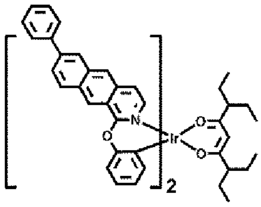

269

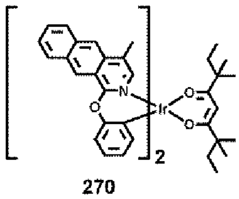

270

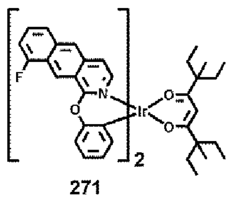

271

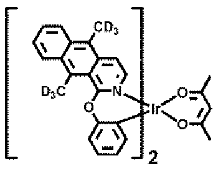

272

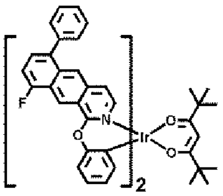

273

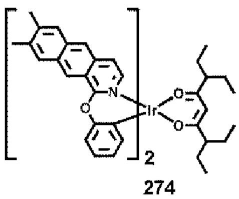

274

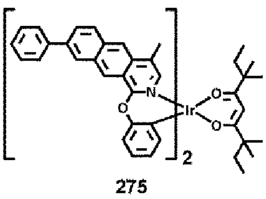

275

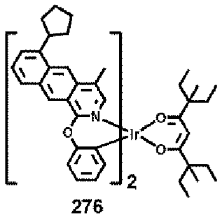

276

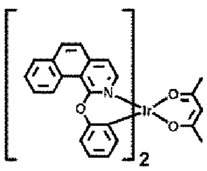

277

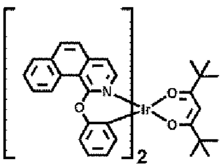

278

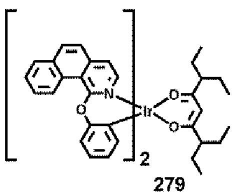

279

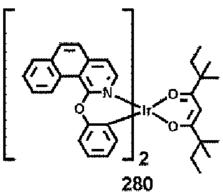

280

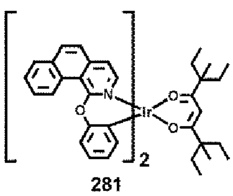

281

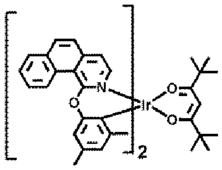

282

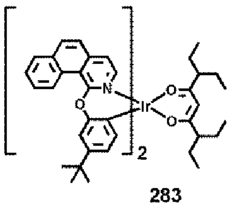

283

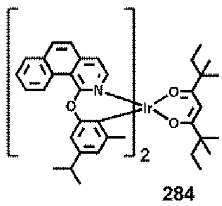

284

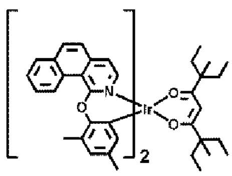

285

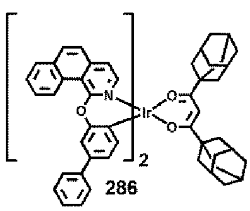

286

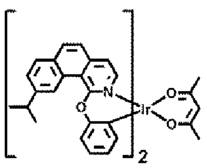

287

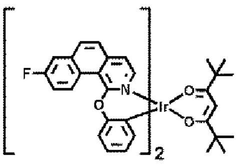

288

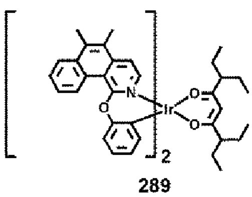

289

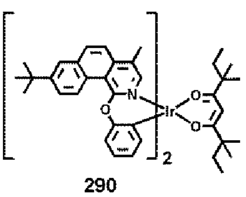

290

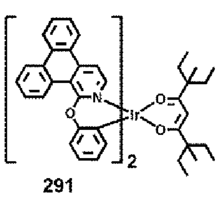

291

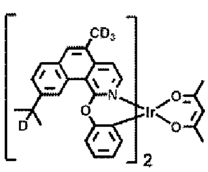

292

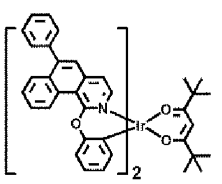

293

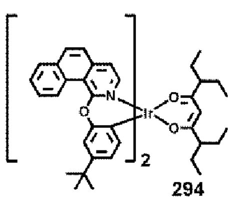

294

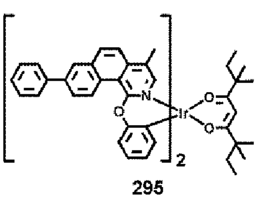

295

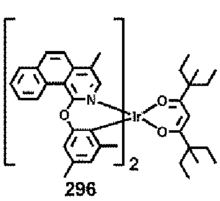

296

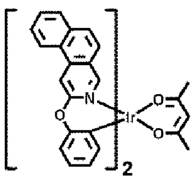
297
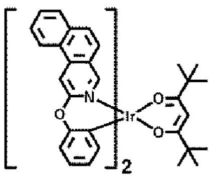
298
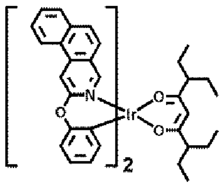
299
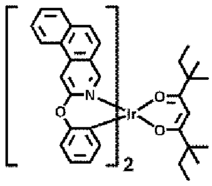
300
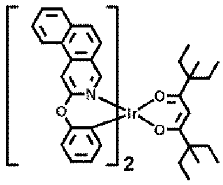
301

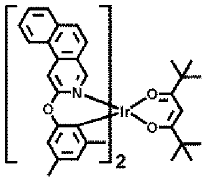
302
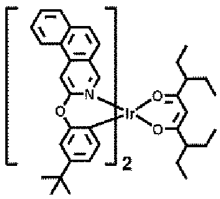
303
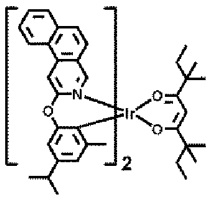
304
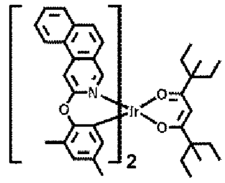
305
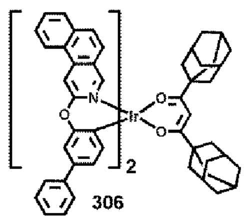
306

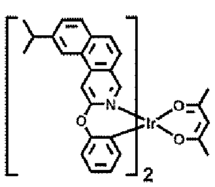
307
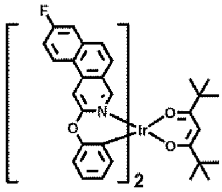
308
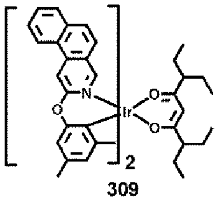
309
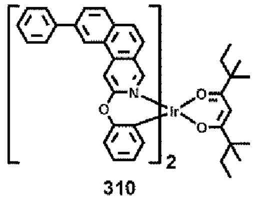
310
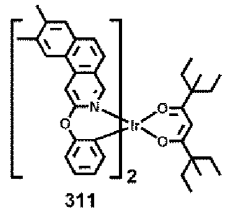
311

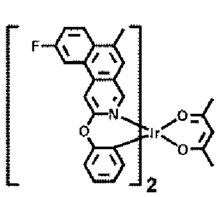
312
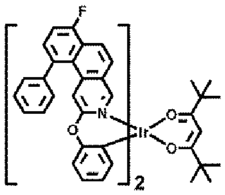
313
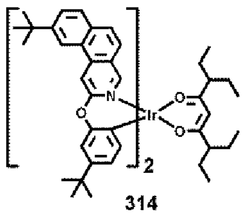
314
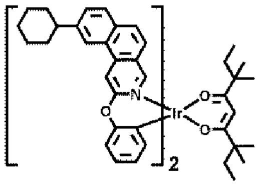
315
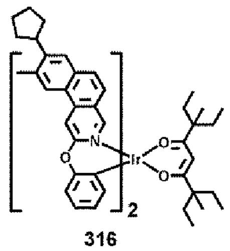
316

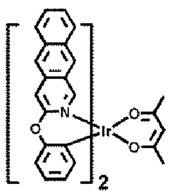
317
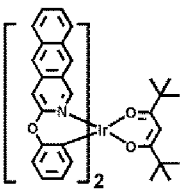
318
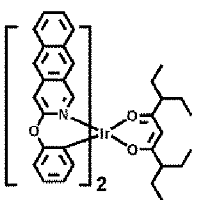
319
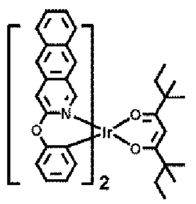
320
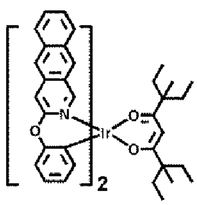
321

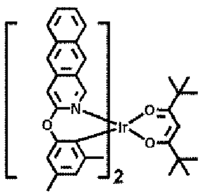
322
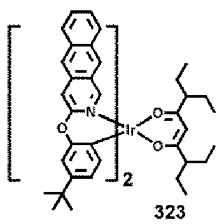
323
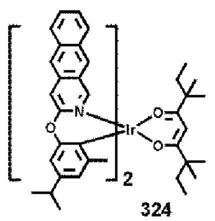
324
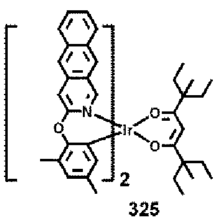
325
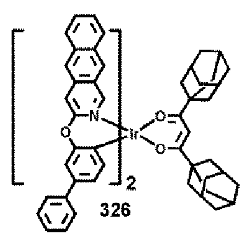
326

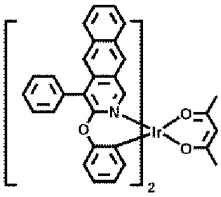
327
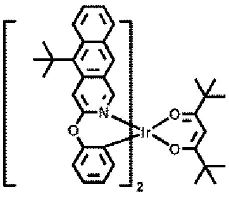
328
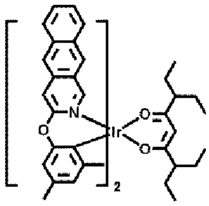
329
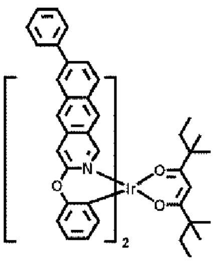
330
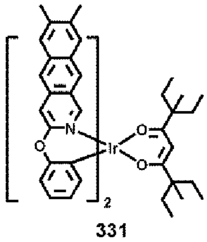
331

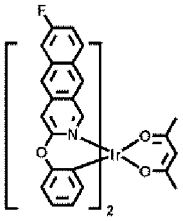
332
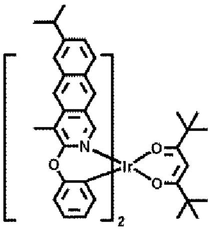
333
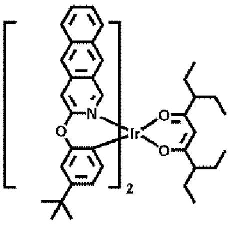
334
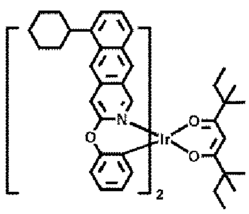
335
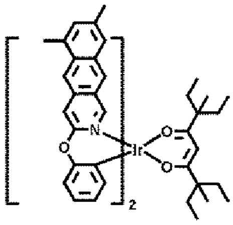
336

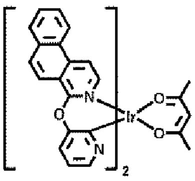
337
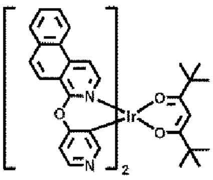
338
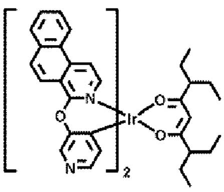
339
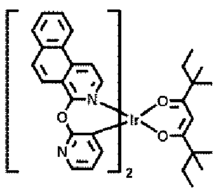
340
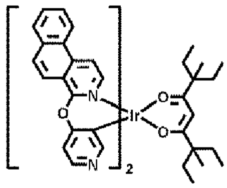
341

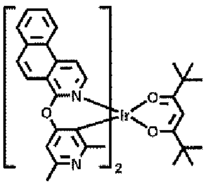
342
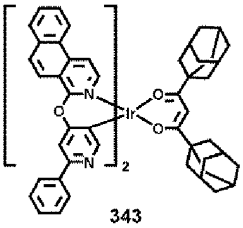
343
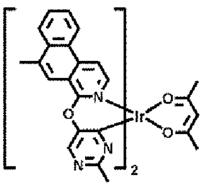
344
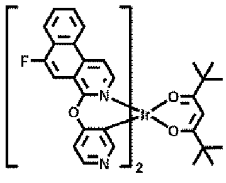
345
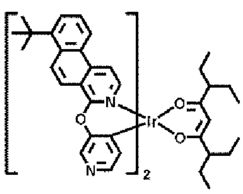
346

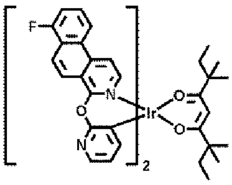
347
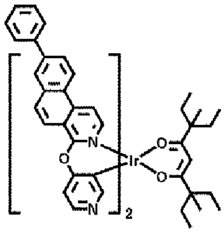
348
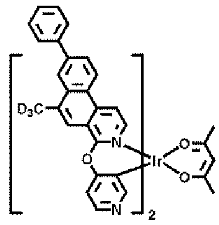
349
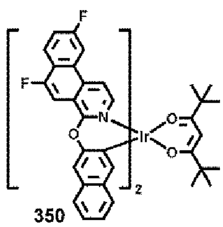
350
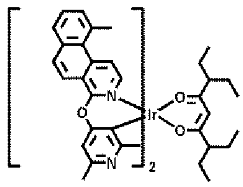
351

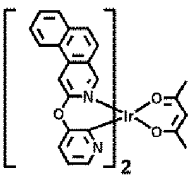
352
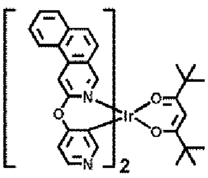
353
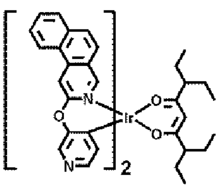
354
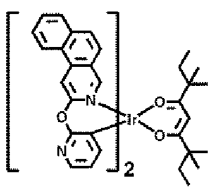
355
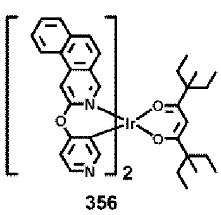
356

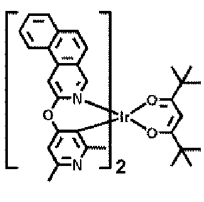

357

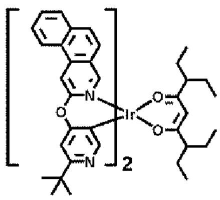

358

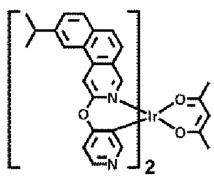

359

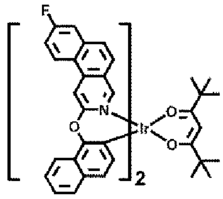

360

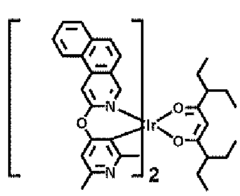

361

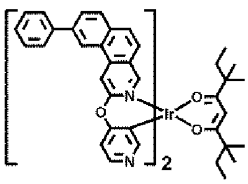

362

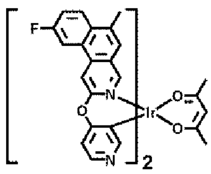

363

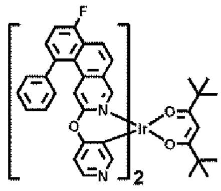

364

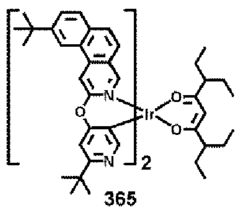

365

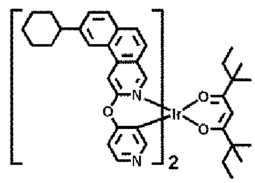

366

**13.** An organic light-emitting device comprising:

a first electrode,
a second electrode, and
an organic layer disposed between the first electrode and the second electrode and comprising an emission layer, wherein the organic layer comprises at least one organometallic compound of any of claims 1-12;
preferably wherein
the first electrode is an anode,
the second electrode is a cathode,
the organic layer further comprises a hole transport region disposed between the first electrode and the emission layer and an electron transport region disposed between the emission layer and the second electrode,
the hole transport region comprises a hole injection layer, a hole transport layer, an electron blocking layer, a buffer layer, or any combination thereof, and
the electron transport region comprises a hole blocking layer, an electron transport layer, an electron injection layer, or any combination thereof.

**14.** The organic light-emitting device of claim 13, wherein

the emission layer comprises the organometallic compound;
preferably wherein
the emission layer further comprises a host, and an amount of the host in the emission layer is larger than an amount of the organometallic compound in the emission layer.

**15.** A diagnostic composition comprising at least one organometallic compound of any of claims 1-12.

## Patentansprüche

**1.** Metallorganische Verbindung, dargestellt durch Formel 1:

<Formel 1> $M(L_1)_{n1}(L_2)_{n2}$

wobei, in Formel 1,

M Iridium (Ir), Osmium (Os), Titan (Ti), Hafnium (Hf), Europium (Eu), Rhodium (Rh) oder Ruthenium (Ru) ist,
$L_1$ ein Ligand ist, der durch Formel 2 dargestellt ist,
n1 1, 2 oder 3 ist, und wenn n1 2 oder mehr ist, zwei oder mehrere $L_1$ gleich oder verschieden voneinander sind,
$L_2$ ein einzähniger Ligand, ein zweizähniger Ligand, ein dreizähniger Ligand oder ein vierzähniger Ligand ist,
n2 0, 1, 2, 3 oder 4 ist, und wenn n2 2 oder mehr ist, zwei oder mehrere $L_2$ gleich oder verschieden voneinander sind, und

$L_1$ und $L_2$ voneinander verschieden sind,

<Formel 2>

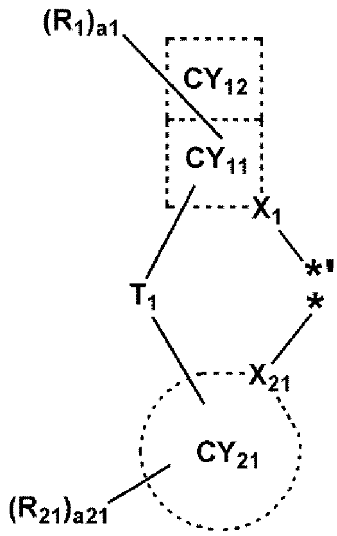

wobei, in Formel 2,

$X_1$ and $X_{21}$ jeweils unabhängig C oder N sind,
Ring $CY_{11}$, Ring $CY_{12}$ und Ring $CY_{21}$ jeweils unabhängig eine carbocyclische $C_5$-$C_{30}$-Gruppe oder eine heterocyclische $C_1$-$C_{30}$-Gruppe sind, wobei Ring $CY_{11}$ und Ring $CY_{12}$ miteinander kondensiert sind,
$T_1$ *-N($R_2$)-*', *-B($R_2$)-*', *-P($R_2$)-*', *-S-*', *-Se-*', oder *-0-*' ist, wobei * und *'jeweils eine Bindungsstelle zu einem benachbarten Atom angeben,
$R_1$ bis $R_2$ und $R_{21}$ jeweils unabhängig Wasserstoff, Deuterium, -F, -Cl, -Br, -I, -$SF_5$, eine Hydroxylgruppe, eine Cyanogruppe, eine Nitrogruppe, eine Aminogruppe, eine Amidinogruppe, eine Hydrazinogruppe, eine Hydrazonogruppe, eine Carbonsäuregruppe oder ein Salz davon, eine Sulfonsäuregruppe oder ein Salz davon, eine Phosphorsäuregruppe oder ein Salz davon, eine substituierte oder unsubstituierte $C_1$-$C_{60}$-Alkylgruppe, eine substituierte oder unsubstituierte $C_2$-$C_{60}$-Alkenylgruppe, eine substituierte oder unsubstituierte $C_2$-$C_{60}$-Alkinylgruppe, eine substituierte oder unsubstituierte $C_1$-$C_{60}$-Alkoxygruppe, eine substituierte oder unsubstituierte $C_3$-$C_{10}$-Cycloalkylgruppe, eine substituierte oder unsubstituierte $C_1$-$C_{10}$-Heterocycloalkylgruppe, eine substituierte oder unsubstituierte $C_3$-$C_{10}$-Cycloalkenylgruppe, eine substituierte oder unsubstituierte $C_1$-$C_{10}$-Heterocycloalkenylgruppe, eine substituierte oder unsubstituierte $C_6$-$C_{60}$-Arylgruppe, eine substituierte oder unsubstituierte $C_6$-$C_{60}$-Aryloxygruppe, eine substituierte oder unsubstituierte $C_6$-$C_{60}$-Arylthiogruppe, eine substituierte oder unsubstituierte $C_1$-$C_{60}$-Heteroarylgruppe, eine substituierte oder unsubstituierte monovalente nichtaromatische kondensierte polycyclische Gruppe, eine substituierte oder unsubstituierte monovalente nichtaromatische kondensierte heteropolycyclische Gruppe, -N($Q_1$)($Q_2$), -Si($Q_3$)($Q_4$)($Q_5$),-Ge($Q_3$)($Q_4$)($Q_5$), -B($Q_6$)($Q_7$), -P(=O)($Q_8$)($Q_9$) oder -P($Q_8$)($Q_9$) sind,
a1 und a21 jeweils unabhängig voneinander eine ganze Zahl von 0 bis 20 sind,
zwei oder mehrere aus einer Vielzahl von $R_1$ optional verbunden sind, um eine carbocyclische $C_5$-$C_{30}$-Gruppe, die unsubstituiert, oder mit mindestens einem $R_{10a}$ substituiert ist oder eine heterocyclische $C_1$-$C_{30}$-Gruppe, die unsubstituiert oder mit mindestens einem $R_{10a}$ substituiert ist, zu bilden,
zwei oder mehrere einer Vielzahl von $R_{21}$ optional verbunden sind, um eine carbocyclische $C_5$-$C_{30}$-Gruppe, die unsubstituiert oder mit mindestens einem $R_{10a}$ substituiert ist, oder eine heterocyclische $C_1$-$C_{30}$-Gruppe, die unsubstituiert oder mit mindestens einem $R_{10a}$ substituiert ist, zu bilden,
zwei oder mehrere von $R_1$ bis $R_3$ und $R_{21}$ optional verbunden sind, um eine carbocyclische $C_5$-$C_{30}$-Gruppe, die unsubstituiert oder mit mindestens einem $R_{10a}$ substituiert ist, oder eine heterocyclische $C_1$-$C_{30}$-Gruppe, die unsubstituiert oder mit mindestens einem $R_{10a}$ substituiert ist, zu bilden,
$R_{10a}$ gleich wie definiert in Verbindung mit $R_{21}$ ist,
* und *' jeweils eine Bindungsstelle an M in Formel 1 angeben, und
ein Substituent(en) der substituierten $C_1$-$C_{60}$-Alkylgruppe, der substituierten $C_2$-$C_{60}$-Alkenylgruppe, der substituierten $C_2$-$C_{60}$-Alkinylgruppe, der substituierten $C_1$-$C_{60}$-Alkoxygruppe, der substituierten $C_3$-$C_{10}$-Cycloalkyl-

gruppe, der substituierten $C_1$-$C_{10}$-Heterocycloalkylgruppe, der substituierten $C_3$-$C_{10}$-Cycloalkenylgruppe, der substituierten $C_1$-$C_{10}$-Heterocycloalkenylgruppe, der substituierten $C_6$-$C_{60}$-Arylgruppe, der substituierten $C_6$-$C_{60}$-Aryloxygruppe, der substituierten $C_6$-$C_{60}$-Arylthiogruppe, der substituierten $C_1$-$C_{60}$-Heteroarylgruppe, der substituierten monovalenten nichtaromatischen kondensierten polycyclischen Gruppe, und der substituierten monovalenten nichtaromatischen kondensierten heteropolycyclischen Gruppe wie folgt ist:

Deuterium, -F, -Cl, -Br, -I, $-CD_3$, $-CD_2H$, $-CDH_2$, $-CF_3$, $-CF_2H$, $-CFH_2$, eine Hydroxylgruppe, eine Cyanogruppe, eine Nitrogruppe, eine Aminogruppe, eine Amidinogruppe, eine Hydrazingruppe, eine Hydrazongruppe, eine Carbonsäuregruppe oder ein Salz davon, eine Sulfonsäuregruppe oder ein Salz davon, eine Phosphorsäuregruppe oder ein Salz davon, eine $C_1$-$C_{60}$-Alkylgruppe, eine $C_2$-$C_{60}$-Alkenylgruppe, eine $C_2$-$C_{60}$-Alkinylgruppe oder eine $C_1$-$C_{60}$-Alkoxygruppe;
eine $C_1$-$C_{60}$-Alkylgruppe, eine $C_2$-$C_{60}$-Alkenylgruppe, eine $C_2$-$C_{60}$-Alkinylgruppe, oder eine $C_1$-$C_{60}$-Alkoxygruppe, jeweils substituiert mit Deuterium, -F, -Cl, -Br, -I, $-CD_3$, $-CD_2H$,$-CDH_2$, $-CF_3$, $-CF_2H$, $-CFH_2$, eine Hydroxylgruppe, eine Cyanogruppe, eine Nitrogruppe, eine Amidinogruppe, eine Hydrazingruppe, eine Hydrazongruppe, eine Carbonsäuregruppe oder ein Salz davon, eine Sulfonsäuregruppe oder ein Salz davon, eine Phosphorsäuregruppe oder ein Salz davon, eine $C_3$-$C_{10}$-Cycloalkylgruppe, eine $C_1$-$C_{10}$-Heterocycloalkylgruppe,eine $C_3$-$C_{10}$-Cycloalkenylgruppe, eine $C_1$-$C_{10}$-Heterocycloalkenylgruppe, eine $C_6$-$C_{60}$-Arylgruppe, eine $C_6$-$C_{60}$-Aryloxygruppe, eine $C_6$-$C_{60}$-Arylthiogruppe, eine $C_7$-$C_{60}$-Arylalkylgruppe, eine $C_1$-$C_{60}$-Heteroarylgruppe, eine $C_1$-$C_{60}$-Heteroaryloxygruppe, eine $C_1$-$C_{60}$-Heteroarylthiogruppe, eine $C_2$-$C_{60}$-Heteroarylalkylgruppe, eine monovalente nichtaromatische kondensierte polycyclische Gruppe, eine monovalente nichtaromatische kondensierte heteropolycyclische Gruppe,$-N(Q_{11}(Q_{12})$, $Si(Q_{13})(Q_{14})(Q_{15})$, $-Ge(Q_{13})(Q_{14})(Q_{15})$, $-B(Q_{16})(Q_{17})$, $-P(=O)(Q_{18})(Q_{19})$, $-P(Q_{18})(Q_{19})$ oder eine beliebige Kombination davon;
eine $C_3$-$C_{10}$-Cycloalkylgruppe, eine $C_1$-$C_{10}$-Heterocycloalkylgruppe,eine $C_3$-$C_{10}$-Cycloalkenylgruppe, eine $C_1$-$C_{10}$-Heterocycloalkenylgruppe, eine $C_6$-$C_{60}$-Arylgruppe, eine $C_6$-$C_{60}$-Aryloxygruppe, eine $C_6$-$C_{60}$-Arylthiogruppe, eine $C_1$-$C_{60}$-Heteroarylgruppe, eine monovalente nichtaromatische kondensierte polycyclische Gruppe, oder eine monovalente nichtaromatische kondensierte heteropolycyclische Gruppe, jeweils unsubstituiert oder substituiert mit Deuterium, -F, -Cl, -Br, -I, $-CD_3$, $-CD_2H$, $-CDH_2$, $-CF_3$, $-CF_2H$, $-CFH_2$, eine Hydroxylgruppe, eine Cyanogruppe, eine Nitrogruppe, eine Aminogruppe, eine Amidinogruppe, eine Hydrazinogruppe, eine Hydrazonogruppe, eine Carbonsäuregruppe oder ein Salz davon, eine Sulfonsäuregruppe oder ein Salz davon, eine Phosphorsäuregruppe oder ein Salz davon, eine $C_1$-$C_{60}$-Alkylgruppe, eine $C_2$-$C_{60}$-Alkenylgruppe, eine $C_2$-$C_{60}$-Alkinylgruppe, eine $C_1$-$C_{60}$-Alkoxygruppe, eine $C_3$-$C_{10}$-Cycloalkylgruppe, eine $C_1$-$C_{10}$-Heterocycloalkylgruppe,eine $C_3$-$C_{10}$-Cycloalkenylgruppe, eine $C_1$-$C_{10}$-Heterocycloalkenylgruppe, eine $C_6$-$C_{60}$-Arylgruppe, eine $C_6$-$C_{60}$-Aryloxygruppe, eine $C_6$-$C_{60}$-Arylthiogruppe, eine $C_1$-$C_{60}$-Heteroarylgruppe, eine monovalente nichtaromatische kondensierte polycyclische Gruppe, eine monovalente nichtaromatische kondensierte heteropolycyclische Gruppe, $-N(Q_{21})(Q_{22})$, $-Si(Q_{23})(Q_{24})(Q_{25})$,$-Ge(Q_{23})(Q_{24})(Q_{25})$, $-B(Q_{26})(Q_{27})$, $-P(=O)(Q_{28})(Q_{19})$, $-P(Q_{28})(Q_{29})$ oder eine beliebige Kombination davon;
$-N(Q_{31})(Q_{32})$, $-Si(Q_{33})(Q_{34})(Q_{35})$, $-Ge(Q_{33})(Q_{34})(Q_{35})$, $-B(Q_{36})(Q_{37})$, $-P(=O)(Q_{38})(Q_{39})$ oder $-P(Q_{38})(Q_{39})$; oder
eine beliebige Kombination davon, und
$Q_1$ bis $Q_9$, $Q_{11}$ bis $Q_{19}$, $Q_{21}$ bis $Q_{29}$ und $Q_{31}$ bis $Q_{39}$ jeweils unabhängig Wasserstoff; Deuterium; -F; -Cl; -Br; -I; eine Hydroxylgruppe; eine Cyanogruppe; eine Nitrogruppe; eine Amidinogruppe; eine Hydrazingruppe; eine Hydrazongruppe; eine Carbonsäuregruppe oder ein Salz davon; eine Sulfonsäuregruppe oder ein Salz davon; eine Phosphorsäuregruppe oder ein Salz davon; eine $C_1$-$C_{60}$-Alkylgruppe unsubstituiert oder substituiert mit Deuterium, eine $C_1$-$C_{60}$-Alkylgruppe, eine $C_6$-$C_{60}$-Arylgruppe oder eine beliebige Kombination davon; eine $C_2$-$C_{60}$-Alkenylgruppe; eine $C_2$-$C_{60}$-Alkinylgruppe, eine $C_1$-$C_{60}$-Alkoxygruppe; eine $C_3$-$C_{10}$-Cycloalkylgruppe; eine $C_1$-$C_{10}$-Heterocycloalkylgruppe; eine $C_3$-$C_{10}$-Cycloalkenylgruppe; eine $C_1$-$C_{10}$-Heterocycloalkenylgruppe; eine $C_6$-$C_{60}$-Arylgruppe unsubstituiert oder substituiert mit Deuterium, eine $C_1$-$C_{60}$-Alkylgruppe, eine $C_6$-$C_{60}$-Arylgruppe oder eine beliebige Kombination davon; eine $C_6$-$C_{60}$-Aryloxygruppe, eine $C_6$-$C_{60}$-Arylthiogruppe; eine $C_7$-$C_{60}$-Arylalkylgruppe, eine $C_1$-$C_{60}$-Heteroarylgruppe; eine $C_1$-$C_{60}$-Heteroaryloxygruppe; eine $C_1$-$C_{60}$-Heteroarylthiogruppe; eine $C_2$-$C_{60}$-Heteroarylalkylgruppe, eine monovalente nicht-aromatische kondensierte polycyclische Gruppe; oder eine monovalente nicht-aromatische kondensierte heteropolycyclische Gruppe sind.

**2.** Metallorganische Verbindung nach Anspruch 1, wobei

M Ir oder Os ist und die Summe von n1 und n2 3 oder 4 ist; und/oder

wobei
$X_1$ N ist und $X_{21}$ C ist.

**3.** Metallorganische Verbindung nach Anspruch 1 oder 2, wobei Ring $CY_{11}$, Ring $CY_{12}$ und Ring $CY_{21}$ jeweils unabhängig eine Cyclopentengruppe, eine Cyclohexengruppe, eine Benzolgruppe, eine Naphthalingruppe, eine Anthracengruppe, eine Phenanthrengruppe, eine Triphenylengruppe, eine Pyrengruppe, eine Chrysengruppe, eine 1,2,3,4-Tetrahydronaphthalingruppe, eine Pyrrolgruppe, eine Borolgruppe, eine Phospholgruppe, eine Cyclopentadiengruppe, eine Silolgruppe, eine Germolgruppe, eine Thiophengruppe, eine Selenophengruppe, eine Furangruppe, eine Indolgruppe, eine Benzoborolgruppe, eine Benzophospholgruppe, eine Indengruppe, eine Benzosilolgruppe, eine Benzogermolgruppe, eine Benzothiophengruppe, eine Benzoselenophengruppe, eine Benzofurangruppe, eine Carbazolgruppe, eine Dibenzoborolgruppe, eine Dibenzophospholgruppe, eine Fluorengruppe, eine Dibenzosilolgruppe, eine Dibenzogermolgruppe, eine Dibenzothiophengruppe, eine Dibenzoselenophengruppe, eine Dibenzofurangruppe, eine Dibenzothiophen-5-Oxidgruppe, eine 9H-Fluoren-9-ongruppe, eine Dibenzothiophen-5,5-dioxidgruppe, eine Azaindolgruppe, eine Azabenzoborolgruppe, eine Azabenzophospholgruppe, eine Azaindengruppe, eine Azabenzosilolgruppe, eine Azabenzogermolgruppe, eine Azabenzothiophengruppe, eine Azabenzoselenophengruppe, eine Azabenzofurangruppe, eine Azacarbazolgruppe, eine Azadibenzoborolgruppe, eine Azadibenzophospholgruppe, eine Azafluorengruppe, eine Azadibenzosilolgruppe, eine Azadibenzogermolgruppe, eine Azadibenzothiophengruppe, eine Azadibenzoselenophengruppe, eine Azadibenzofurangruppe, eine Azadibenzothiophen-5-Oxidgruppe, eine Aza-9H-Fluoren-9-ongruppe, eine Azadibenzothiophen-5,5-dioxidgruppe, eine Pyridingruppe, eine Pyrimidingruppe, eine Pyrazingruppe, eine Pyridazingruppe, eine Triazingruppe, eine Chinolingruppe, eine Isochinolingruppe, eine Benzochinolingruppe, eine Benzoisochinolingruppe, eine Chinoxalingruppe, eine Chinazolingruppe, eine Phenanthrolingruppe, eine Pyrazolgruppe, eine Imidazolgruppe, eine Triazolgruppe, eine Azaborolgruppe, eine Azaphospholgruppe, eine Azacyclopentadiengruppe, eine Azasilolgruppe, eine Azagermolgruppe, eine Azaselenophengruppe, eine Oxazolgruppe, eine Isooxazolgruppe, eine Thiazolgruppe, eine Isothiazolgruppe, eine Oxadiazolgruppe, eine Thiadiazolgruppe, eine Benzopyrazolgruppe, eine Benzimidazolgruppe, eine Benzoxazolgruppe, eine Benzothiazolgruppe, eine Benzoxadiazolgruppe, eine Benzothiadiazolgruppe, eine 5,6,7,8-Tetrahydroisochinolingruppe oder eine 5,6,7,8-Tetrahydrochinolingruppe sind; und/oder wobei $T_1$ *-O-*' ist.

**4.** Organometallische Verbindung nach einem der Ansprüche 1-3, wobei
$R_1$ bis $R_2$ und $R_{21}$ jeweils unabhängig wie folgt sind:

Wasserstoff, Deuterium, -F, -Cl, -Br, -I, eine Hydroxylgruppe, eine Cyanogruppe, eine Nitrogruppe, eine Aminogruppe, eine Amidinogruppe, eine Hydrazingruppe, eine Hydrazongruppe, eine Carbonsäuregruppe oder ein Salz davon, eine Sulfonsäuregruppe oder ein Salz davon, eine Phosphorsäuregruppe oder ein Salz davon, $-SF_5$, eine $C_1$-$C_{20}$-Alkylgruppe oder eine $C_1$-$C_{20}$-Alkoxygruppe;
eine $C_1$-$C_{20}$-Alkylgruppe und eine $C_1$-$C_{20}$-Alkoxygruppe, jeweils substituiert mit Deuterium, -F, -Cl, -Br, -I, $-CD_3$, $-CD_2H$, $-CDH_2$, $-CF_3$, $-CF_2H$, $-CFH_2$, eine Hydroxylgruppe, eine Cyanogruppe, eine Nitrogruppe, eine Aminogruppe, eine Amidinogruppe, eine Hydrazingruppe, eine Hydrazongruppe, eine Carbonsäuregruppe oder ein Salz davon, eine Sulfonsäuregruppe oder ein Salz davon, eine Phosphorsäuregruppe oder ein Salz davon, eine $C_1$-$C_{10}$-Alkylgruppe, eine Cyclopentylgruppe, eine Cyclohexylgruppe, eine Cycloheptylgruppe, eine Cyclooctylgruppe, an Adamantylgruppe, eine Norbornylgruppe, eine Norbornenylgruppe, eine Cyclopentenylgruppe, eine Cyclohexenylgruppe, eine Cycloheptenylgruppe, eine Bicyclo[1.1.1]pentylgruppe, eine Bicyclo[2.1.1]hexylgruppe, eine Bicyclo[2.2.1]heptylgruppe, eine Bicyclo[2.2.2]octylgruppe, eine ($C_1$-$C_{20}$-Alkyl)cyclopentylgruppe, eine ($C_1$-$C_{20}$-Alkyl)cyclohexylgruppe, eine ($C_1$-$C_{20}$-Alkyl)cycloheptylgruppe, eine ($C_1$-$C_{20}$-Alkyl)cyclooctylgruppe, eine ($C_1$-$C_{20}$-Alkyl)adamantanylgruppe, eine ($C_1$-$C_{20}$-Alkyl)norbornanylgruppe, eine ($C_1$-$C_{20}$-Alkyl)norbornenylgruppe, eine ($C_1$-$C_{20}$-Alkyl)cyclopentenylgruppe, eine ($C_1$-$C_{20}$-Alkyl)cyclohexenylgruppe, eine ($C_1$-$C_{20}$-Alkyl)cycloheptenylgruppe, eine ($C_1$-$C_{20}$-Alkyl)bicyclo[1.1.1 ]pentylgruppe, eine ($C_1$-$C_{20}$-Alkyl)bicyclo[2.1.1]hexylgruppe, eine ($C_1$-$C_{20}$-Alkyl)bicyclo[2.2.1]heptylgruppe, eine ($C_1$-$C_{20}$-Alkyl)bicyclo[2.2.2]octylgruppe, eine Phenylgruppe, eine ($C_1$-$C_{20}$-Alkyl)phenylgruppe, eine Biphenylgruppe, eine Terphenylgruppe, eine Naphthylgruppe, eine Pyridinylgruppe, eine Pyrimidinylgruppe oder eine beliebige Kombination davon;
eine Cyclopentylgruppe, eine Cyclohexylgruppe, eine Cycloheptylgruppe, eine Cyclooctylgruppe, eine Adamantylgruppe, eine Norbornylgruppe, eine Norbornenylgruppe, eine Cyclopentenylgruppe, eine Cyclohexenylgruppe, eine Cycloheptenylgruppe, eine Bicyclo[1.1.1]pentylgruppe, eine Bicyclo[2.1.1]hexylgruppe, eine Bicyclo[2.2.1]heptylgruppe, eine Bicyclo[2.2.2]octylgruppe, eine Phenylgruppe, eine ($C_1$-$C_{20}$-Alkyl)phenylgruppe, eine Biphenylgruppe, eine Terphenylgruppe, eine Naphthylgruppe, eine Fluorenylgruppe, eine Phenanthrenylgruppe, eine Anthracenylgruppe, eine Fluoranthenylgruppe, eine Triphenylenylgruppe, eine Pyrenylgruppe, eine Chrysenylgruppe, eine Pyrrolylgruppe, eine Thiophenylgruppe, eine Furanylgruppe, eine Imidazolylgruppe,

eine Pyrazolylgruppe, eine Thiazolylgruppe, eine Isothiazolylgruppe, eine Oxazolylgruppe, eine Isoxazolylgruppe, eine Pyridinylgruppe, eine Pyrazinylgruppe, eine Pyrimidinylgruppe, eine Pyridazinylgruppe, eine Isoindolylgruppe, eine Indolylgruppe, eine Indazolylgruppe, eine Purinylgruppe, eine Chinolinylgruppe, eine Isochinolinylgruppe, eine Benzoquinolinylgruppe, eine Chinoxalinylgruppe, eine Chinazolinylgruppe, eine Cinnolinylgruppe, eine Carbazolylgruppe, eine Phenanthrolinylgruppe, eine Benzimidazolylgruppe, eine Benzofuranylgruppe, eine Benzothiophenylgruppe, eine Isobenzothiazolylgruppe, eine Benzoxazolylgruppe, eine Isobenzoxazolylgruppe, eine Triazolylgruppe, eine Tetrazolylgruppe, eine Oxadiazolylgruppe, eine Triazinylgruppe, eine Dibenzofuranylgruppe, eine Dibenzothiophenylgruppe, eine Benzocarbazolylgruppe, eine Dibenzocarbazolylgruppe, eine Imidazopyridinylgruppe, eine Imidazopyrimidinylgruppe, eine Azacarbazolylgruppe, eine Azadibenzofuranylgruppe, oder eine Azadibenzothiophenylgruppe, jeweils unsubstituiert oder substituiert mit Deuterium, -F, -Cl, -Br, -I, $-CD_3$, $-CD_2H$, $-CDH_2$, $-CF_3$, $-CF_2H$, $-CFH_2$, eine Hydroxylgruppe, eine Cyanogruppe, eine Nitrogruppe, eine Aminogruppe, eine Amidinogruppe, eine Hydrazingruppe, eine Hydrazongruppe, eine Carbonsäuregruppe oder ein Salz davon, eine Sulfonsäuregruppe oder ein Salz davon, eine Phosphorsäuregruppe oder ein Salz davon, eine $C_1$-$C_{20}$-Alkylgruppe, eine Deuterium-haltige $C_2$-$C_{20}$ Alkylgruppe, eine $C_1$-$C_{20}$-Alkoxygruppe, eine Cyclopentylgruppe, eine Cyclohexylgruppe, eine Cycloheptylgruppe, eine Cyclooctylgruppe, eine Adamantylgruppe, eine Norbornylgruppe, eine Norbornenylgruppe, eine Cyclopentenylgruppe, eine Cyclohexenylgruppe, eine Cycloheptenylgruppe, eine Bicyclo[1.1.1]pentylgruppe, eine Bicyclo[2.1.1]hexylgruppe, eine Bicyclo[2.2.1]heptylgruppe, eine Bicyclo[2.2.2]octylgruppe, eine ($C_1$-$C_{20}$-Alkyl)cyclopentylgruppe, eine ($C_1$-$C_{20}$-Alkyl)cyclohexylgruppe, eine ($C_1$-$C_{20}$-Alkyl)cycloheptylgruppe, eine ($C_1$-$C_{20}$-Alkyl)cyclooctylgruppe, eine ($C_1$-$C_{20}$-Alkyl)adamantanylgruppe, eine ($C_1$-$C_{20}$-Alkyl)norbornanylgruppe, eine ($C_1$-$C_{20}$-Alkyl)norbornenylgruppe, eine ($C_1$-$C_{20}$-Alkyl)cyclopentenylgruppe, eine ($C_1$-$C_{20}$-Alkyl)cyclohexenylgruppe, eine ($C_1$-$C_{20}$-Alkyl)cycloheptenylgruppe, eine ($C_1$-$C_{20}$-Alkyl)bicyclo[1.1.1]pentylgruppe, eine ($C_1$-$C_{20}$-Alkyl)bicyclo[2.1.1]hexylgruppe, eine ($C_1$-$C_{20}$-Alkyl)bicyclo[2.2.1]heptylgruppe, eine ($C_1$-$C_{20}$-Alkyl)bicyclo[2.2.2]octylgruppe, eine Phenylgruppe, eine ($C_1$-$C_{20}$-Alkyl)phenylgruppe, eine Biphenylgruppe, eine Terphenylgruppe, eine Naphthylgruppe, eine Fluorenylgruppe, eine Phenanthrenylgruppe, eine Anthracenylgruppe, eine Fluoranthenylgruppe, eine Triphenylenylgruppe, eine Pyrenylgruppe, eine Chrysenylgruppe, eine Pyrrolylgruppe, eine Thiophenylgruppe, eine Furanylgruppe, eine Imidazolylgruppe, eine Pyrazolylgruppe, eine Thiazolylgruppe, eine Isothiazolylgruppe, eine Oxazolylgruppe, eine Isoxazolylgruppe, eine Pyridinylgruppe, eine Pyrazinylgruppe, eine Pyrimidinylgruppe, eine Pyridazinylgruppe, eine Isoindolylgruppe, eine Indolylgruppe, eine Indazolylgruppe, eine Purinylgruppe, eine Chinolinylgruppe, eine Isochinolinylgruppe, eine Benzochinolinylgruppe, eine Chinoxalinylgruppe, eine Chinazolinylgruppe, eine Cinnolinylgruppe, eine Carbazolylgruppe, eine Phenanthrolinylgruppe, eine Benzimidazolylgruppe, eine Benzofuranylgruppe, eine Benzothiophenylgruppe, eine Isobenzothiazolylgruppe, eine Benzoxazolylgruppe, eine Isobenzoxazolylgruppe, eine Triazolylgruppe, eine Tetrazolylgruppe, eine Oxadiazolylgruppe, eine Triazinylgruppe, eine Dibenzofuranylgruppe, eine Dibenzothiophenylgruppe, eine Benzocarbazolylgruppe, eine Dibenzocarbazolylgruppe, eine Imidazopyridinylgruppe, eine Imidazopyrimidinylgruppe, eine Azacarbazolylgruppe, eine Azadibenzofuranylgruppe, eine Azadibenzothiophenylgruppe oder eine beliebige Kombination davon; oder

$-N(Q_1)(Q_2)$, $-Si(Q_3)(Q_4)(Q_5)$, $-Ge(Q_3)(Q_4)(Q_5)$, $-B(Q_6)(Q_7)$, $-P(=O)(Q_8)(Q_9)$ oder-$P(Q_8)(Q_9)$ und $Q_1$ bis $Q_9$ jeweils unabhängig wie folgt sind:

$-CH_3$, $-CD_3$, $-CD_2H$, $-CDH_2$, $-CH_2CH_3$, $-CH_2CD_3$, $-CH_2CD_2H$, $-CH_2CDH_2$, $-CHDCH_3$,$-CHDCD_2H$, $-CHDCDH_2$, $-CHDCD_3$, $-CD_2CD_3$, $-CD_2CD_2H$ oder $-CD_2CDH_2$; oder
eine n-Propylgruppe, eine iso-Propylgruppe, eine n-Butylgruppe, eine sec-Butylgruppe, eine iso-Butylgruppe, eine tert-Butylgruppe, eine n-Pentylgruppe, eine tert-Pentylgruppe, eine neo-Pentylgruppe, eine iso-Pentylgruppe, eine sec-Pentylgruppe, eine 3-Pentylgruppe, eine seciso-Pentylgruppe, eine Phenylgruppe, eine Biphenylgruppe oder eine Naphthylgruppe, jeweils unsubstituiert oder substituiert mit Deuterium, einer $C_1$-$C_{10}$-Alkylgruppe, einer Phenylgruppe oder einer beliebigen Kombination davon.

**5.** Metallorganische Verbindung nach einem der Ansprüche 1-4, wobei eine durch

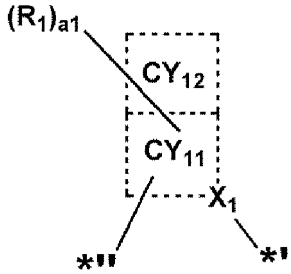

dargestellte Gruppe in Formel 2 eine Gruppe ist, die durch eine der Formeln CY1-1 bis CY1-69 dargestellt ist:

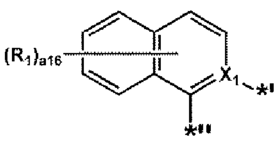

CY1-1

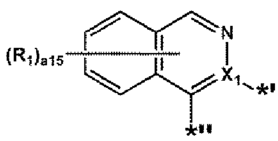

CY1-2

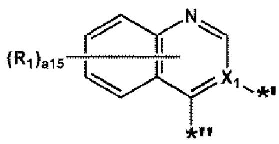

CY1-3

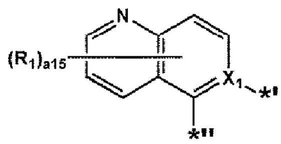

CY1-4

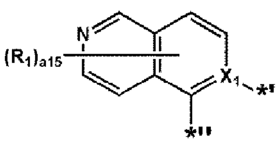

CY1-5

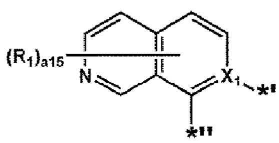

CY1-6

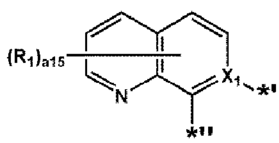

CY1-7

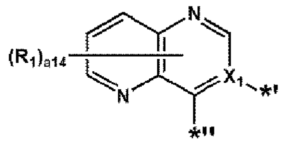

CY1-8

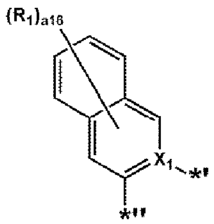

CY1-9

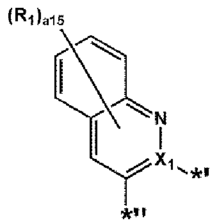

CY1-10

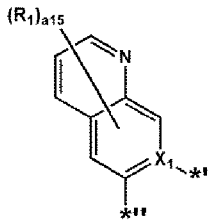

CY1-11

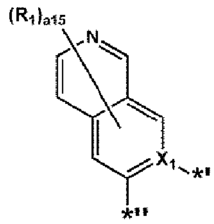

CY1-12

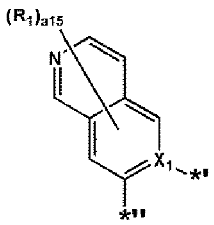

CY1-13

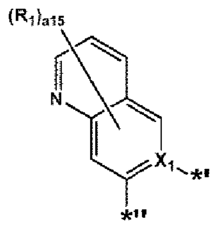

CY1-14

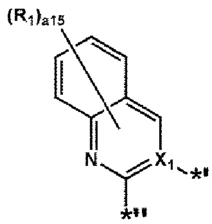

CY1-15

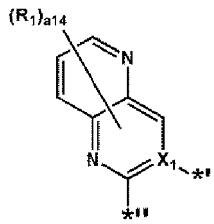

CY1-16

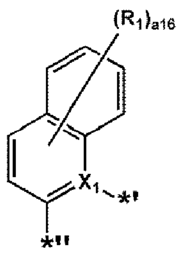

CY1-17

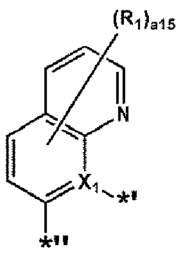

CY1-18

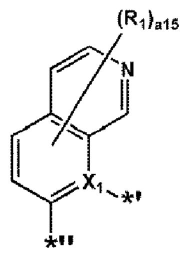

CY1-19

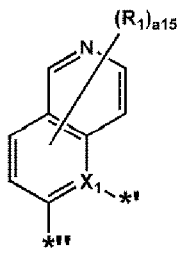

CY1-20

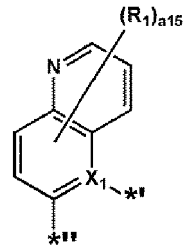
CY1-21

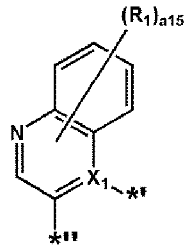
CY1-22

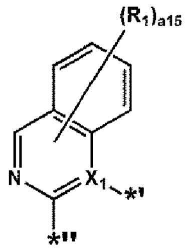
CY1-23

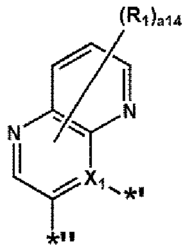
CY1-24

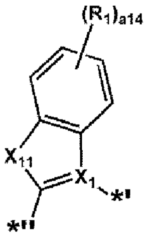
CY1-25

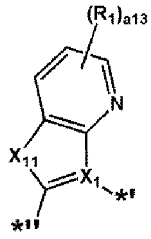
CY1-26

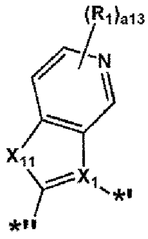
CY1-27

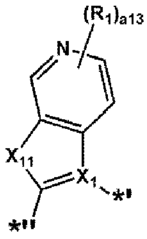
CY1-28

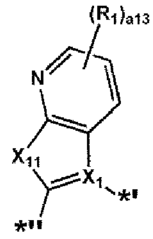
CY1-29

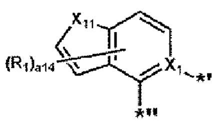
CY1-30

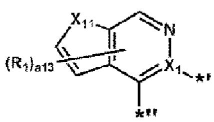
CY1-31

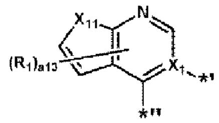
CY1-32

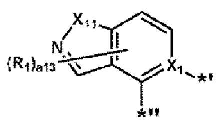
CY1-33

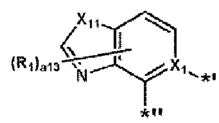
CY1-34

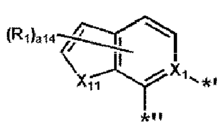
CY1-35

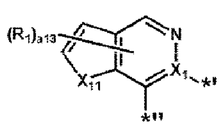
CY1-36

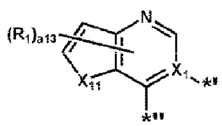
CY1-37

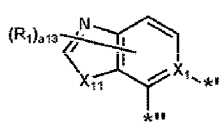
CY1-38

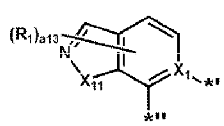
CY1-39

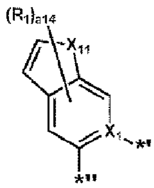
CY1-40

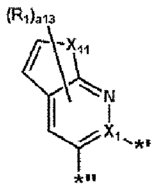
CY1-41

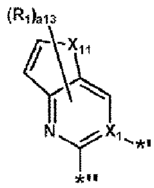
CY1-42

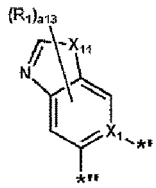
CY1-43

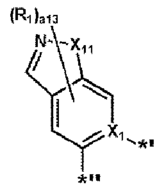
CY1-44

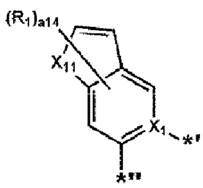
CY1-45

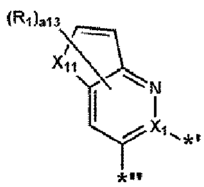
CY1-46

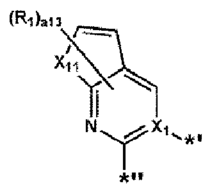
CY1-47

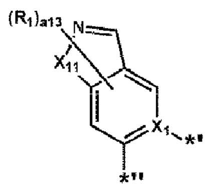
CY1-48

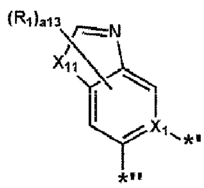
CY1-49

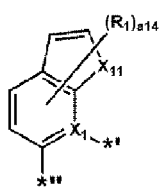
CY1-50

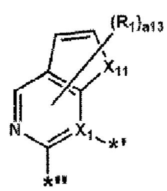
CY1-51

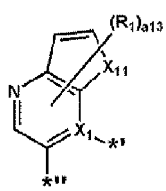
CY1-52

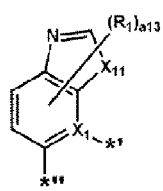
CY1-53

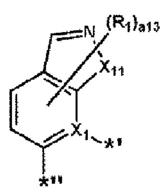
CY1-54

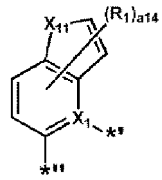
CY1-55

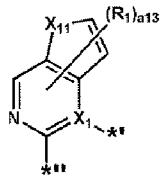
CY1-56

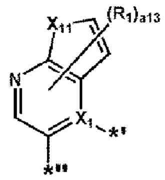
CY1-57

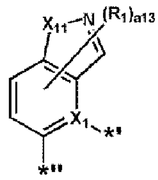
CY1-58

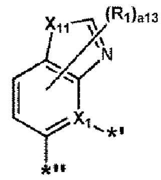
CY1-59

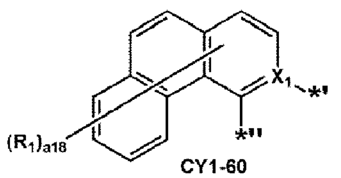
CY1-60

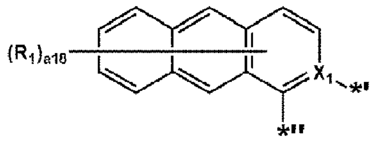
CY1-61

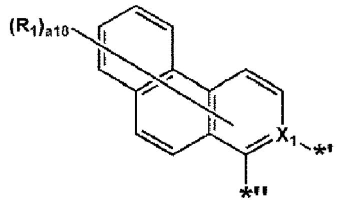
CY1-62

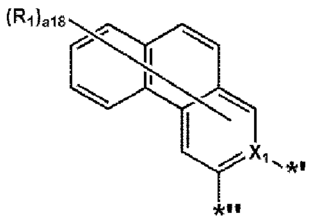
CY1-63

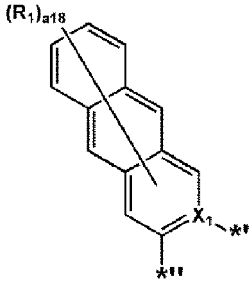
CY1-64

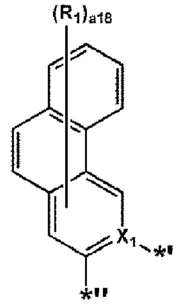
CY1-65

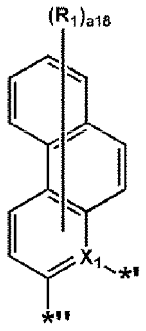
CY1-66

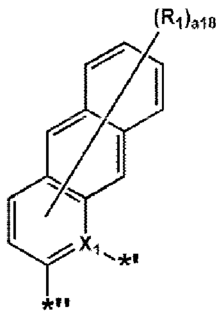
CY1-67

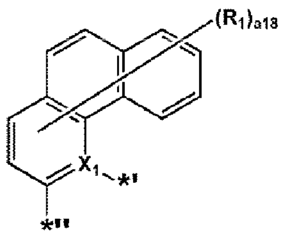
CY1-68

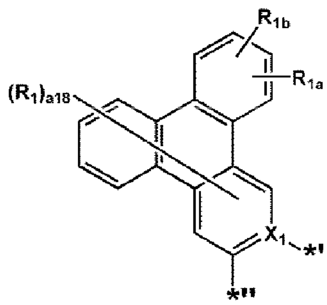
CY1-69

,

wobei, in Formeln CY1-1 bis CY1-69,

$X_1$ und $R_1$ jeweils gleich wie definiert in Anspruch 1 sind,
$X_{11}$ O, S, Se, $N(R_{19})$, $C(R_{19a})(R_{19b})$ oder $Si(R_{19a})(R_{19b})$ ist,
$R_{19}$, $R_{19a}$, $R_{19b}$, $R_{1a}$ und $R_{1b}$ jeweils gleich wie definiert in Verbindung mit $R_1$ in Anspruch 1 sind,
a18 eine ganze Zahl von 0 bis 8 ist,
a16 eine ganze Zahl von 0 bis 6 ist,
a15 eine ganze Zahl von 0 bis 5 ist,
a14 eine ganze Zahl von 0 bis 4 ist,
a13 eine ganze Zahl von 0 bis 3 ist,
*" eine Bindungsstelle an $T_1$ in Formel 2 angibt, und
*' eine Bindungsstelle an M in Formel 1 angibt.

**6.** Metallorganische Verbindung nach einem der Ansprüche 1-5, wobei eine Gruppe, dargestellt durch

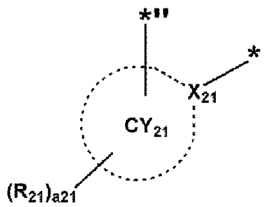

in Formel 2, eine Gruppe ist, die durch eine der Formeln CY21-1 bis CY21-25 dargestellt ist:

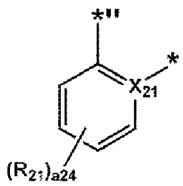
CY21-1

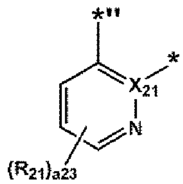
CY21-2

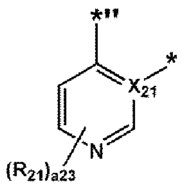
CY21-3

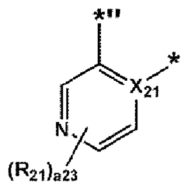
CY21-4

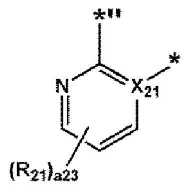
CY21-5

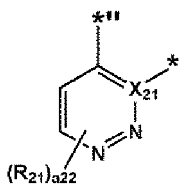
CY21-6

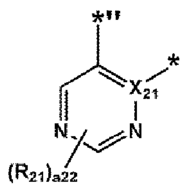
CY21-7

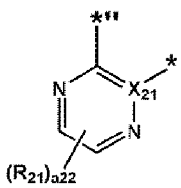
CY21-8

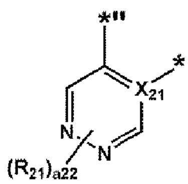
CY21-9

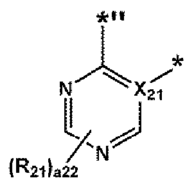
CY21-10

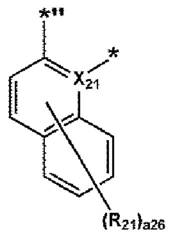
CY21-11

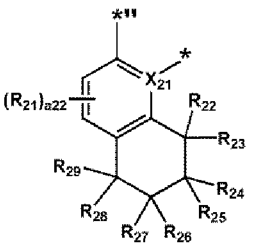
CY21-12

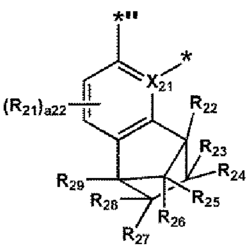
CY21-13

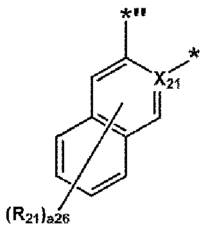
CY21-14

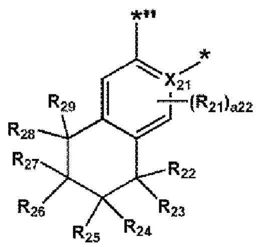
CY21-15

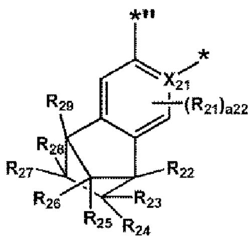
CY21-16

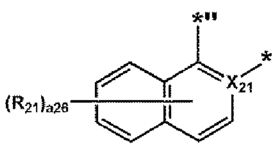
CY21-17

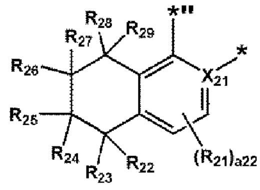
CY21-18

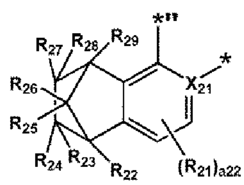
CY21-19

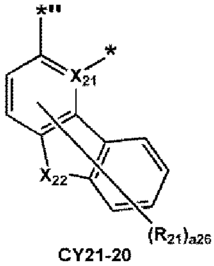
CY21-20

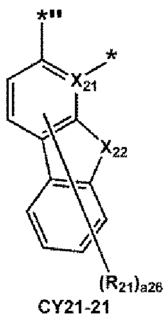
CY21-21

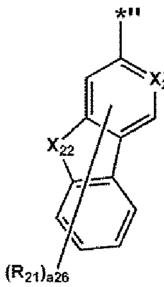
CY21-22

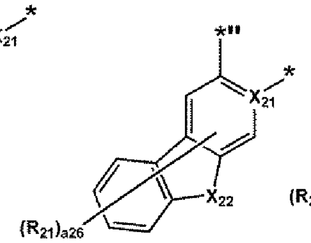
CY21-23

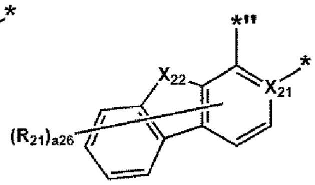
CY21-24

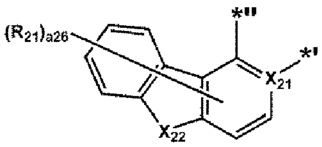
CY21-25

,

wobei, in den Formeln CY21-1 bis CY21-25,

$X_{21}$ und $R_{21}$ jeweils gleich wie definiert in Anspruch 1 sind,
$X_{22}$ $C(R_{22})(R_{23})$, $N(R_{22})$, O, S oder $Si(R_{22})(R_{23})$ ist,
$R_{22}$ bis $R_{29}$ jeweils gleich wie definiert in Verbindung mit $R_{21}$ in Anspruch 1 sind,
a26 eine ganze Zahl von 0 bis 6 ist,
a24 eine ganze Zahl von 0 bis 4 ist,
a23 eine ganze Zahl von 0 bis 3 ist,
a22 eine ganze Zahl von 0 bis 2 ist,
*" eine Bindungsstelle zu $T_1$ in Formel 2 angibt und
*' eine Bindungsstelle zu M in Formel 1 angibt;
vorzugsweise wobei eine Gruppe, dargestellt durch

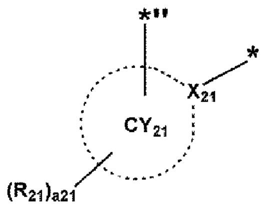

in Formel 2, eine Gruppe ist, die durch eine der Formeln CY21(1) bis CY21(56) und Formel CY21-20 bis CY21-25 dargestellt ist:

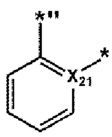
CY21(1)

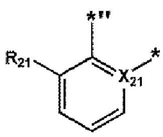
CY21(2)

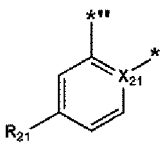
CY21(3)

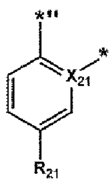
CY21(4)

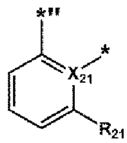
CY21(5)

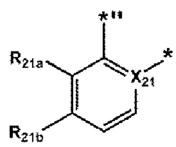
CY21(6)

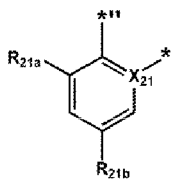
CY21(7)

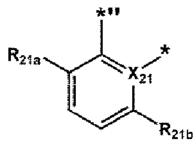
CY21(8)

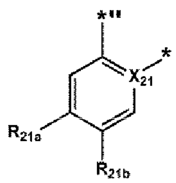
CY21(9)

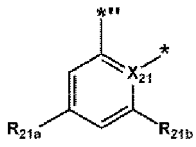
CY21(10)

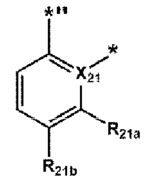
CY21(11)

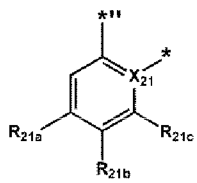
CY21(12)

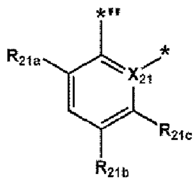
CY21(13)

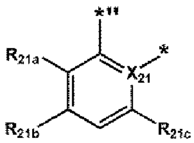
CY21(14)

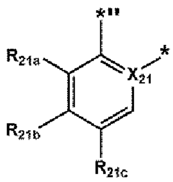
CY21(15)

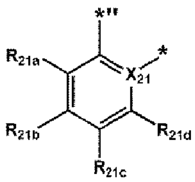
CY21(16)

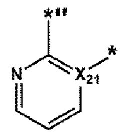
CY21(17)

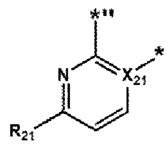
CY21(18)

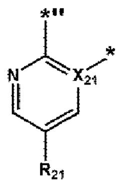
CY21(19)

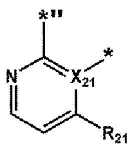
CY21(20)

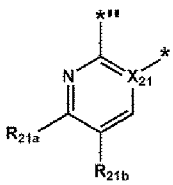
CY21(21)

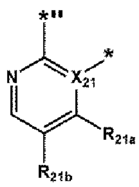
CY21(22)

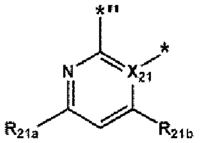
CY21(23)

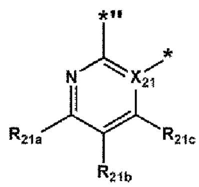
CY21(24)

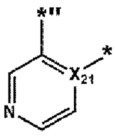
CY21(25)

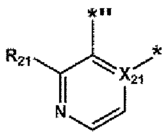
CY21(26)

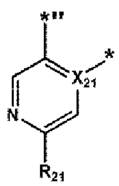
CY21(27)

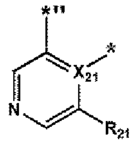
CY21(28)

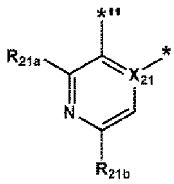
CY21(29)

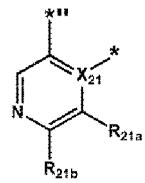
CY21(30)

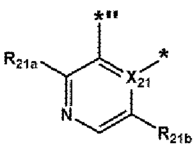
CY21(31)

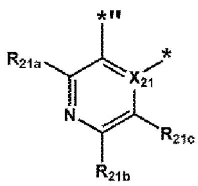
CY21(32)

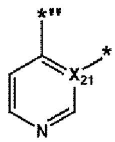
CY21(33)

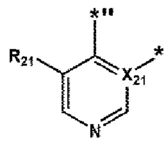
CY21(34)

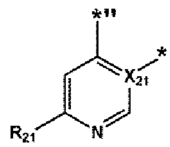
CY21(35)

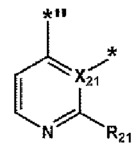
CY21(36)

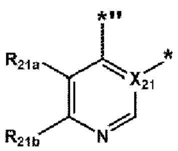
CY21(37)

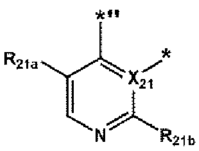
CY21(38)

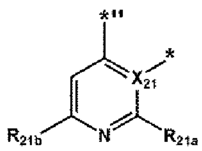
CY21(39)

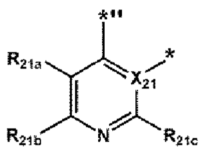
CY21(40)

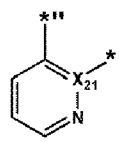
CY21(41)

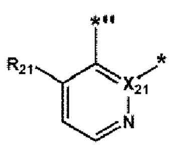
CY21(42)

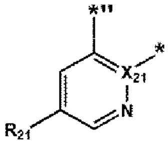
CY21(43)

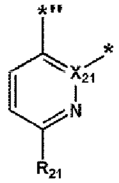
CY21(44)

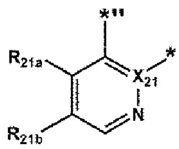
CY21(45)

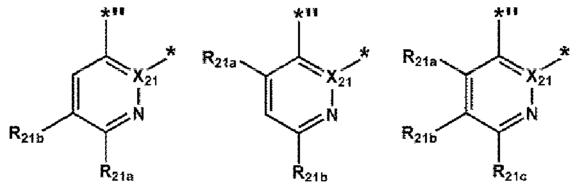
CY21(46)

CY21(47)

CY21(48)

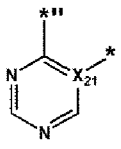
CY21(49)

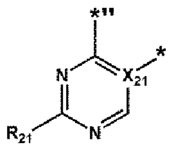
CY21(50)

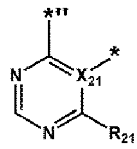
CY21(51)

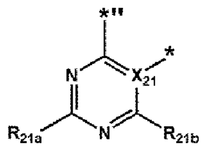
CY21(52)

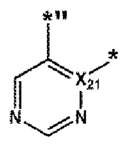
CY21(53)

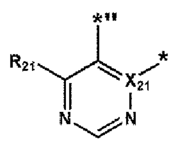
CY21(54)

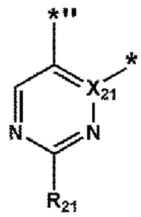
CY21(55)

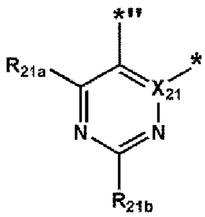
CY21(56)

,

wobei in Formeln CY21(1) bis CY21(56),

$X_{21}$ und $R_{21}$ jeweils gleich wie definiert in Anspruch 1 sind,
$R_{21a}$ bis $R_{21d}$ jeweils gleich wie definiert in Verbindung mit $R_{21}$ in Anspruch 1 sind, wobei jedes von $R_{21}$ und $R_{21a}$ bis $R_{21d}$ nicht Wasserstoff ist,
*" eine Bindungsstelle an $T_1$ in Formel 2 angibt, und
*' eine Bindungsstelle an M in Formel 1 angibt.

**7.** Metallorganische Verbindung nach einem der Ansprüche 1-6, wobei $L_2$ in Formel 1 ein zweizähniger Ligand ist, der jeweils über O, S, Se, N, C, P, Si oder As mit M in Formel 1 verbunden ist.

**8.** Metallorganische Verbindung nach einem der Ansprüche 1-6, wobei $L_2$ in Formel 1 ein zweizähniger Ligand ist, der durch Formel 3 dargestellt ist:

<Formel 3>

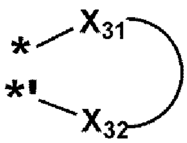

,

wobei, in Formel 3, $X_{31}$ und $X_{32}$ jeweils unabhängig O, S, Se oder N sind,

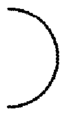

eine verbindende Gruppe angibt, die $X_{31}$ und $X_{32}$ miteinander verbindet, und * und *'jeweils eine Bindungsstelle zu M in Formel 1 angeben.

**9.** Metallorganische Verbindung nach einem der Ansprüche 1-6, wobei $L_2$ in Formel 1 eine Gruppe ist, dargestellt durch eine der Formeln 3A bis 3F:

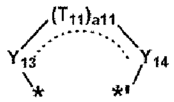 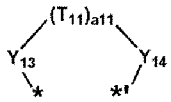 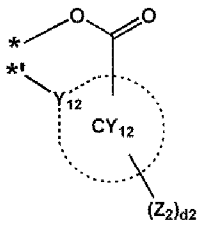 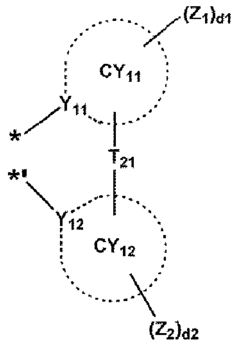 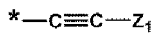 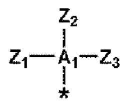

3A 3B 3C 3D 3E 3F ,

wobei in Formeln 3A bis 3F,

$Y_{13}$ O, N, $N(Z_1)$, $P(Z_1)(Z_2)$ oder $As(Z_1)(Z_2)$ ist,
$Y_{14}$ O, N, $N(Z_3)$, $P(Z_3)(Z_4)$ oder $As(Z_3)(Z_4)$ ist,
$T_{11}$ eine Einfachbindung, eine Doppelbindung, $*-C(Z_{11})(Z_{12})-*'$, $*-C(Z_{11})=C(Z_{12})-*'$, $*=C(Z_{11})-*'$, $*-C(Z_{11})=*'$, $*=C(Z_{11})-C(Z_{12})=C(Z_{13})-*'$, $*-C(Z_{11})=C(Z_{12})-C(Z_{13})=*'$, $*-N(Z_{11})-*'$ oder eine carbocyclische $C_5$-$C_{30}$-Gruppe ist, unsubstituiert oder substituiert mit mindestens einem $Z_{11}$,
a11 eine ganze Zahl von 1 bis 10 ist, wenn a11 2 oder mehr ist, zwei oder mehrere $T_{11}$ (s) gleich oder verschieden voneinander sind,
$Y_{11}$ und $Y_{12}$ jeweils unabhängig C oder N sind,
$T_{21}$ eine Einfachbindung, ein Doppelknochen, O, S, $C(Z_{11})(Z_{12})$, $Si(Z_{11})(Z_{12})$ oder $N(Z_{11})$ ist,
Ring $CY_{11}$ und Ring $CY_{12}$ jeweils unabhängig eine carbocyclische $C_5$-$C_{30}$-Gruppe oder eine heterocyclische $C_1$-$C_{30}$-Gruppe sind,
$A_1$ P oder As ist,
$Z_1$ bis $Z_4$ und $Z_{11}$ bis $Z_{13}$ jeweils gleich wie definiert in Verbindung mit $R_{21}$ in Anspruch 2 sind,
d1 und d2 jeweils unabhängig eine ganze Zahl von 0 bis 10 sind, und
* und *' jeweils eine Bindungsstelle zu M in Formel 1 angeben.

**10.** Metallorganische Verbindung nach einem der Ansprüche 1-6, wobei $L_2$ in Formel 1 eine Gruppe ist, dargestellt durch eine der Formeln 3-1(1) bis 3-1(66) und 3-1(301) bis 3-1(309):

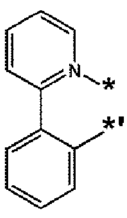 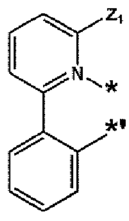 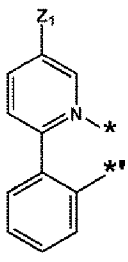 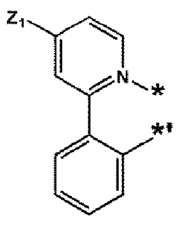 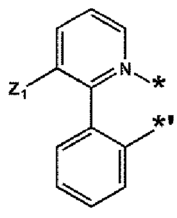

3-1(1) 3-1(2) 3-1(3) 3-1(4) 3-1(5)

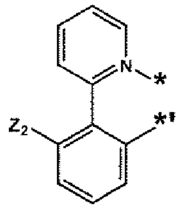 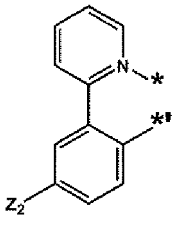 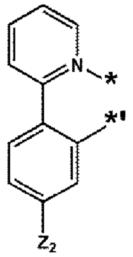 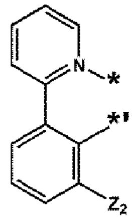 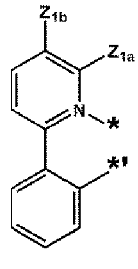

3-1(6) 3-1(7) 3-1(8) 3-1(9) 3-1(10)

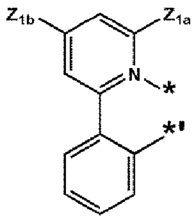
3-1(11)

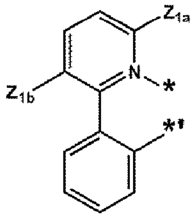
3-1(12)

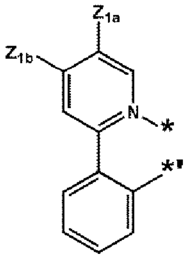
3-1(13)

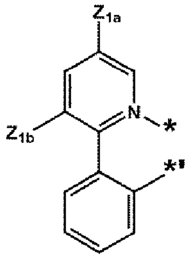
3-1(14)

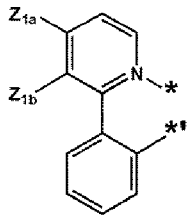
3-1(15)

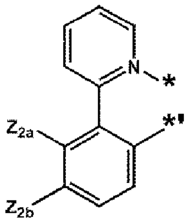
3-1(16)

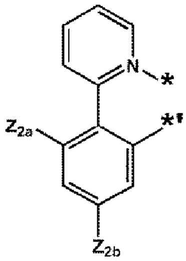
3-1(17)

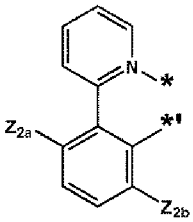
3-1(18)

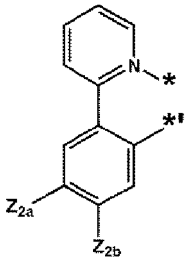
3-1(19)

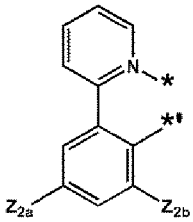
3-1(20)

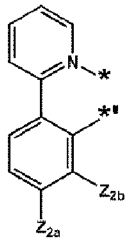
3-1(21)

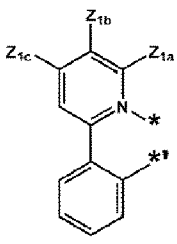
3-1(22)

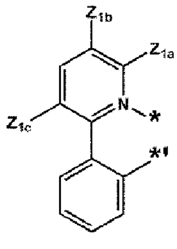
3-1(23)

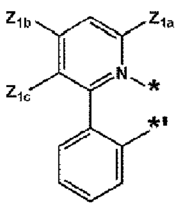
3-1(24)

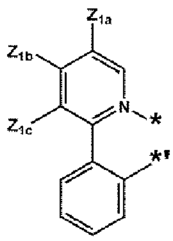
3-1(25)

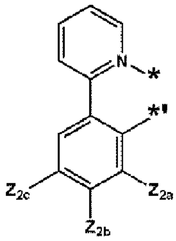
3-1(26)

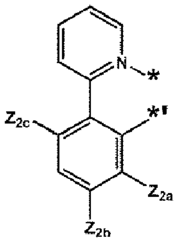
3-1(27)

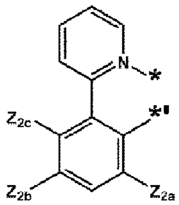
3-1(28)

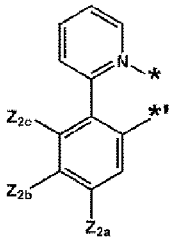
3-1(29)

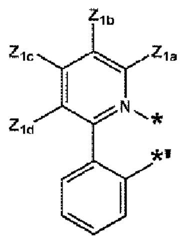
3-1(30)

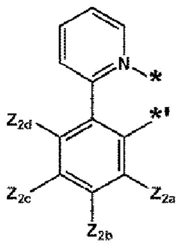
3-1(31)

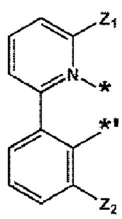
3-1(32)

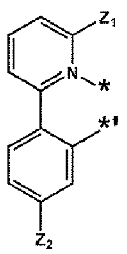
3-1(33)

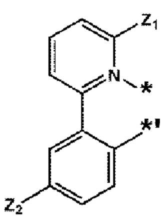
3-1(34)

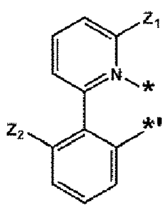
3-1(35)

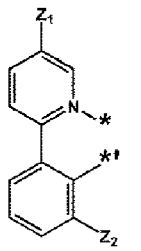
3-1(36)

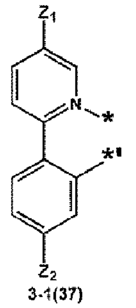
3-1(37)

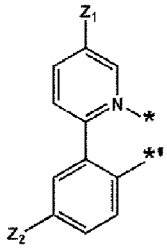
3-1(38)

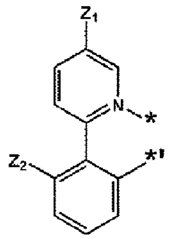
3-1(39)

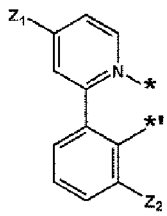
3-1(40)

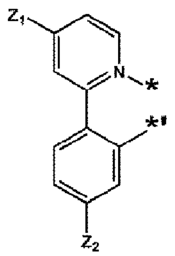
3-1(41)

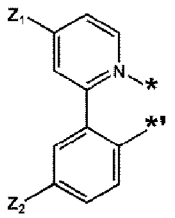
3-1(42)

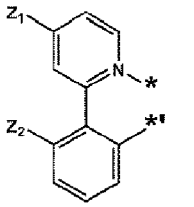
3-1(43)

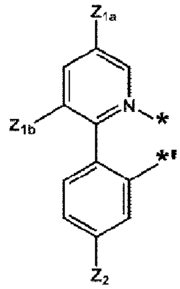
3-1(44)

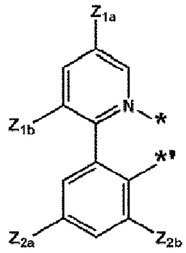
3-1(45)

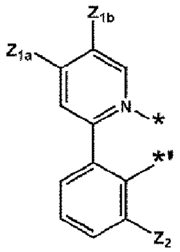
3-1(46)

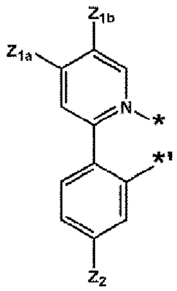
3-1(47)

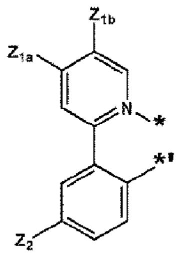
3-1(48)

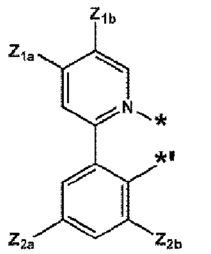
3-1(49)

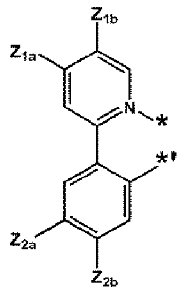
3-1(50)

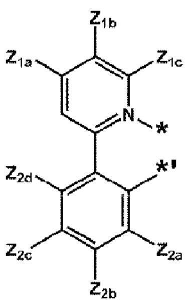
3-1(51)

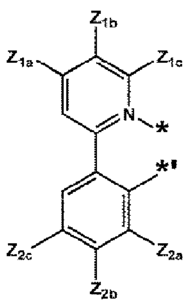
3-1(52)

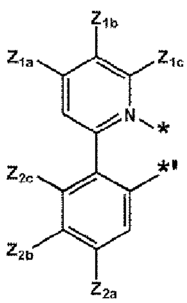
3-1(53)

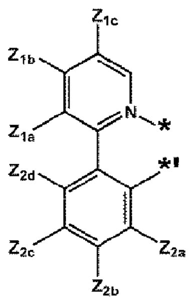
3-1(54)

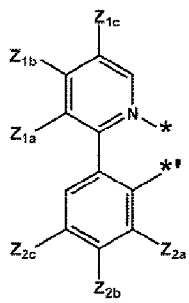
3-1(55)

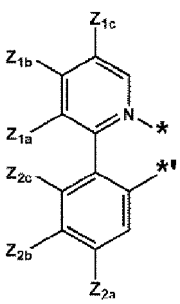
3-1(56)

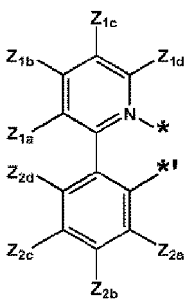
3-1(57)

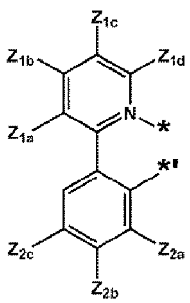
3-1(58)

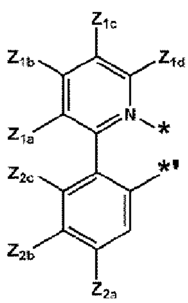
3-1(59)

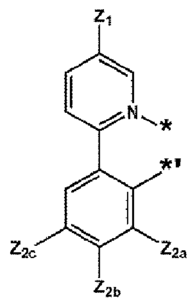
3-1(60)

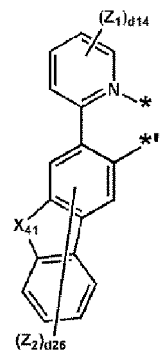
3-1(61)

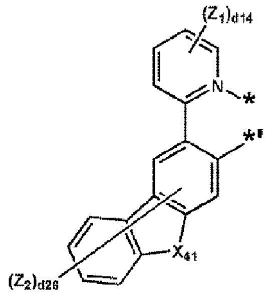
3-1(62)

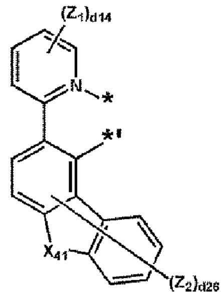
3-1(63)

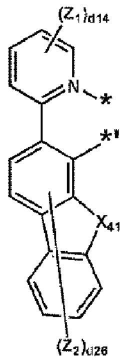
3-1(64)

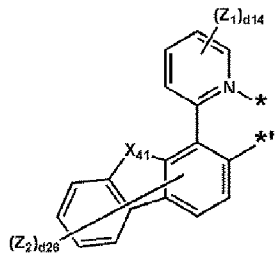
3-1(65)

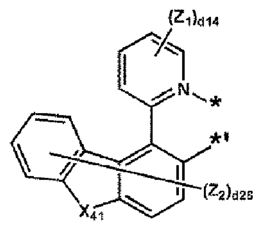
3-1(66)

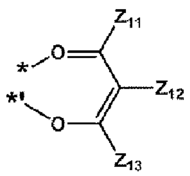
3-1(301)

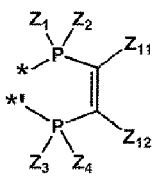
3-1(302)

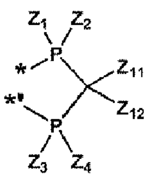
3-1(303)

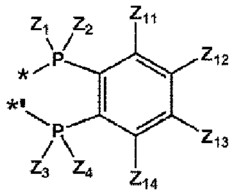
3-1(304)

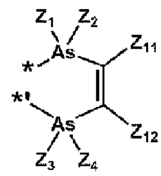
3-1(305)

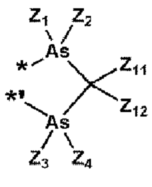
3-1(306)

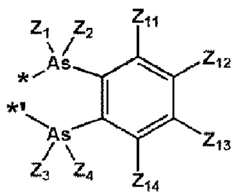
3-1(307)

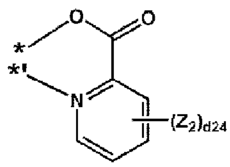
3-1(308)

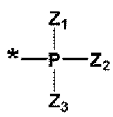
3-1(309)

,

wobei in den Formeln 3-1(1) bis 3-1(66) und 3-1(301) bis 3-1(309),

$X_{41}$ O, S, $N(Z_{21})$, $C(Z_{21})(Z_{22})$ oder $Si(Z_{21})(Z_{22})$ ist,
$Z_1$ bis $Z_4$, $Z_{1a}$, $Z_{1b}$, $Z_{1c}$, $Z_{1d}$, $Z_{2a}$, $Z_{2b}$, $Z_{2c}$, $Z_{2d}$ und $Z_{11}$ bis $Z_{14}$ jeweils gleich sind wie definiert in Verbindung mit $R_{21}$ in Anspruch 1,
d14 eine ganze Zahl von 0 bis 4 ist,
d26 eine ganze Zahl von 0 bis 6 ist, und
* und *' jeweils eine Bindungsstelle zu M in Formel 1 angeben.

**11.** Metallorganische Verbindung nach einem der Ansprüche 1-6, wobei $L_2$ in Formel 1 eine Gruppe ist, dargestellt durch Formel 3-1-1:

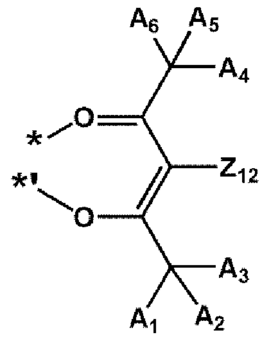

3-1-1 ?

wobei in Formel 3-1-1,

$Z_{12}$ gleich wie definiert in Verbindung mit $R_{21}$ in Anspruch 1 ist,
$A_2$ und $A_5$ jeweils unabhängig Wasserstoff, Deuterium, eine substituierte oder unsubstituierte $C_1$-$C_{60}$-Alkylgruppe, eine substituierte oder unsubstituierte $C_2$-$C_{60}$-Alkenylgruppe, eine substituierte oder unsubstituierte $C_2$-$C_{60}$-Alkinylgruppe, eine substituierte oder unsubstituierte $C_1$-$C_{60}$-Alkoxygruppe, eine substituierte oder unsubstituierte $C_3$-$C_{10}$-Cycloalkylgruppe, eine substituierte oder unsubstituierte $C_1$-$C_{10}$-Heterocycloalkylgruppe,eine substituierte oder unsubstituierte $C_3$-$C_{10}$-Cycloalkenylgruppe, eine substituierte oder unsubstituierte $C_1$-$C_{10}$-Heterocycloalkenylgruppe, eine substituierte oder unsubstituierte $C_6$-$C_{60}$-Arylgruppe, eine substituierte oder unsubstituierte $C_6$-$C_{60}$-Aryloxygruppe, eine substituierte oder unsubstituierte $C_6$-$C_{60}$-Arylthiogruppe, eine substituierte oder unsubstituierte $C_1$-$C_{60}$-Heteroarylgruppe, eine substituierte oder unsubstituierte monovalente nichtaromatische kondensierte polycyclische Gruppe, oder eine substituierte oder unsubstituierte monovalente nichtaromatische kondensierte heteropolycyclische Gruppe sind,
$A_1$, $A_3$, $A_4$ und $A_6$ jeweils unabhängig eine substituierte oder unsubstituierte $C_1$-$C_{60}$-Alkylgruppe, eine substituierte oder unsubstituierte $C_2$-$C_{60}$-Alkenylgruppe, eine substituierte oder unsubstituierte $C_2$-$C_{60}$-Alkinylgruppe, eine substituierte oder unsubstituierte $C_1$-$C_{60}$-Alkoxygruppe, eine substituierte oder unsubstituierte $C_3$-$C_{10}$-Cycloalkylgruppe, eine substituierte oder unsubstituierte $C_1$-$C_{10}$-Heterocycloalkylgruppe,eine substituierte oder unsubstituierte $C_3$-$C_{10}$-Cycloalkenylgruppe, eine substituierte oder unsubstituierte $C_1$-$C_{10}$-Heterocycloalkenylgruppe, eine substituierte oder unsubstituierte $C_6$-$C_{60}$-Arylgruppe, eine substituierte oder unsubstituierte $C_6$-$C_{60}$-Aryloxygruppe, eine substituierte oder unsubstituierte $C_6$-$C_{60}$-Arylthiogruppe, eine substituierte oder unsubstituierte $C_1$-$C_{60}$-Heteroarylgruppe, eine substituierte oder unsubstituierte monovalente nichtaromatische kondensierte polycyclische Gruppe oder eine substituierte oder unsubstituierte monovalente nichtaromatische kondensierte heteropolycyclische Gruppe sind,
zwei oder mehrere von $A_1$ bis $A_6$ optional verbunden sind, um eine carbocyclische $C_5$-$C_{30}$-Gruppe, die unsubstituiert oder mit mindestens einem $R_{1a}$ substituiert ist, oder eine heterocyclische $C_1$-$C_{30}$-Gruppe, die unsubstituiert oder mit mindestens einem $R_{1a}$ substituiert ist, zu bilden,
$R_{1a}$ gleich wie definiert in Verbindung mit $Z_{12}$ ist,
ein Substituent(en) der substituierten $C_1$-$C_{60}$-Alkylgruppe, der substituierten $C_2$-$C_{60}$-Alkenylgruppe, der substituierten $C_2$-$C_{60}$-Alkinylgruppe, der substituierten $C_1$-$C_{60}$-Alkoxygruppe, der substituierten $C_3$-$C_{10}$-Cycloalkylgruppe, der substituierten $C_1$-$C_{10}$-Heterocycloalkylgruppe, der substituierten $C_3$-$C_{10}$-Cycloalkenylgruppe, der substituierten $C_1$-$C_{10}$-Heterocycloalkenylgruppe, der substituierten $C_6$-$C_{60}$-Arylgruppe, der substituierten $C_6$-$C_{60}$-Aryloxygruppe, der substituierten $C_6$-$C_{60}$-Arylthiogruppe, der substituierten $C_1$-$C_{60}$-Heteroarylgruppe, der substituierten monovalenten nicht-aromatischen kondensierten polycyclischen Gruppe, und der substituierten monovalenten nicht-aromatischen kondensierten heteropolycyclischen Gruppe, wie folgt ist:

Deuterium, -F, -Cl, -Br, -I, $-CD_3$, $-CD_2H$, $-CDH_2$, $-CF_3$, $-CF_2H$, $-CFH_2$, eine Hydroxylgruppe, eine Cyanogruppe, eine Nitrogruppe, eine Aminogruppe, eine Amidinogruppe, eine Hydrazingruppe, eine Hydrazongruppe, eine Carbonsäuregruppe oder ein Salz davon, eine Sulfonsäuregruppe oder ein Salz davon, eine Phosphorsäuregruppe oder ein Salz davon, eine $C_1$-$C_{60}$-Alkylgruppe, eine $C_2$-$C_{60}$-Alkenylgruppe, eine $C_2$-$C_{60}$-Alkinylgruppe oder eine $C_1$-$C_{60}$-Alkoxygruppe
eine $C_1$-$C_{60}$-Alkylgruppe, eine $C_2$-$C_{60}$-Alkenylgruppe, eine $C_2$-$C_{60}$-Alkinylgruppe oder eine $C_1$-$C_{60}$-Alkoxygruppe, jeweils substituiert mit Deuterium, -F, -Cl, -Br, -I, $-CD_3$, $-CD_2H$, - $CDH_2$, $-CF_3$, $-CF_2H$, $-CFH_2$, eine Hydroxylgruppe, eine Cyanogruppe, eine Nitrogruppe, eine Aminogruppe, eine Amidinogruppe, eine Hydrazingruppe, eine Hydrazongruppe, eine Carbonsäuregruppe oder ein Salz davon, eine Sulfonsäuregruppe oder ein Salz davon, eine Phosphorsäuregruppe oder ein Salz davon, eine $C_3$-$C_{10}$-Cycloalkylgruppe, eine $C_1$-$C_{10}$-Heterocycloalkylgruppe, eine $C_3$-$C_{10}$-Cycloalkenylgruppe, eine $C_1$-$C_{10}$-Heterocycloalkenylgruppe, eine $C_6$-$C_{60}$-Arylgruppe, eine $C_6$-$C_{60}$-Aryloxygruppe, eine $C_6$-$C_{60}$-Arylthiogruppe, eine $C_1$-$C_{60}$-Heteroarylgruppe, eine monovalente nicht-aromatische kondensierte polycyclische Gruppe, eine monovalente nicht-aromatische kondensierte heteropolycyclische Gruppe, $-N(Q_{11})(Q_{12})$, $-Si(Q_{13})(Q_{14})(Q_{15})$, $-Ge(Q_{13})(Q_{14})(Q_{15})$, $-B(Q_{16})(Q_{17})$, $-P(=O)(Q_{18})(Q_{19})$,$-P(Q_{18})(Q_{19})$ oder eine beliebige Kombination davon;

eine $C_3$-$C_{10}$-Cycloalkylgruppe, eine $C_1$-$C_{10}$-Heterocycloalkylgruppe,eine $C_3$-$C_{10}$-Cycloalkenylgruppe, eine $C_1$-$C_{10}$-Heterocycloalkenylgruppe, eine $C_6$-$C_{60}$-Arylgruppe, eine $C_6$-$C_{60}$-Aryloxygruppe, eine $C_6$-$C_{60}$-Arylthiogruppe, eine $C_1$-$C_{60}$-Heteroarylgruppe, eine monovalente nichtaromatische kondensierte polycyclische Gruppe, oder eine monovalente nichtaromatische kondensierte heteropolycyclische Gruppe, jeweils unsubstituiert oder substituiert mit Deuterium, -F, -Cl, -Br, -I, $-CD_3$, $-CD_2H$, $-CDH_2$, $-CF_3$, $-CF_2H$, $-CFH_2$, eine Hydroxylgruppe, eine Cyanogruppe, eine Nitrogruppe, eine Aminogruppe, eine Amidinogruppe, eine Hydrazingruppe, eine Hydrazongruppe, eine Carbonsäuregruppe oder ein Salz davon, eine Sulfonsäuregruppe oder ein Salz davon, eine Phosphorsäuregruppe oder ein Salz davon, eine $C_1$-$C_{60}$-Alkylgruppe, eine $C_2$-$C_{60}$-Alkenylgruppe, eine $C_2$-$C_{60}$-Alkinylgruppe, eine $C_1$-$C_{60}$-Alkoxygruppe, eine $C_3$-$C_{10}$-Cycloalkylgruppe, eine $C_1$-$C_{10}$-Heterocycloalkylgruppe,eine $C_3$-$C_{10}$-Cycloalkenylgruppe, eine $C_1$-$C_{10}$-Heterocycloalkenylgruppe, eine $C_6$-$C_{60}$-Arylgruppe, eine $C_6$-$C_{60}$-Aryloxygruppe, eine $C_6$-$C_{60}$-Arylthiogruppe, eine $C_1$-$C_{60}$-Heteroarylgruppe, eine monovalente nichtaromatische kondensierte polycyclische Gruppe und eine monovalente nichtaromatische kondensierte heteropolycyclische Gruppe, $-N(Q_{21})(Q_{22})$, $-Si(Q_{23})(Q_{24})(Q_{25})$,$-Ge(Q_{23})(Q_{24})(Q_{25})$, $-B(Q_{26})(Q_{27})$, $-P(=O)(Q_{28})(Q_{29})$, $-P(Q_{28})(Q_{29})$ oder eine beliebige Kombination davon;

$-N(Q_{31})(Q_{32})$, $-Si(Q_{33})(Q_{34})(Q_{35})$, $-Ge(Q_{33})(Q_{34})(Q_{35})$, $-B(Q_{36})(Q_{37})$, $-P(=O)(Q_{38})(Q_{39})$ oder $-P(Q_{38})(Q_{39})$; oder

eine beliebige Kombination davon, und

$Q_{11}$ bis $Q_{19}$, $Q_{21}$ bis $Q_{29}$ und $Q_{31}$ bis $Q_{39}$ jeweils unabhängig Wasserstoff; Deuterium; -F;-Cl; -Br; -I; eine Hydroxylgruppe; eine Cyanogruppe; eine Nitrogruppe; eine Amidinogruppe; eine Hydrazingruppe; eine Hydrazongruppe; eine Carbonsäuregruppe oder ein Salz davon; eine Sulfonsäuregruppe oder ein Salz davon; eine Phosphorsäuregruppe oder ein Salz davon; eine $C_1$-$C_{60}$-Alkylgruppe unsubstituiert oder substituiert mit Deuterium, eine $C_1$-$C_{60}$-Alkylgruppe, eine $C_6$-$C_{60}$-Arylgruppe oder eine beliebige Kombination davon; eine $C_2$-$C_{60}$-Alkenylgruppe, eine $C_2$-$C_{60}$-Alkinylgruppe; eine $C_1$-$C_{60}$-Alkoxygruppe, eine $C_3$-$C_{10}$-Cycloalkylgruppe; eine $C_1$-$C_{10}$-Heterocycloalkylgruppe; eine $C_3$-$C_{10}$-Cycloalkenylgruppe; eine $C_1$-$C_{10}$-Heterocycloalkenylgruppe; eine $C_6$-$C_{60}$-Arylgruppe unsubstituiert oder substituiert mit Deuterium, eine $C_1$-$C_{60}$-Alkylgruppe, eine $C_6$-$C_{60}$-Arylgruppe oder eine beliebige Kombination davon; eine $C_6$-$C_{60}$-Aryloxygruppe; eine $C_6$-$C_{60}$-Arylthiogruppe; eine $C_7$-$C_{60}$-Arylalkylgruppe, eine $C_1$-$C_{60}$-Heteroarylgruppe; eine $C_1$-$C_{60}$-Heteroaryloxygruppe; eine $C_1$-$C_{60}$-Heteroarylthiogruppe; eine $C_2$-$C_{60}$-Heteroarylalkylgruppe, eine monovalente nicht-aromatische kondensierte polycyclische Gruppe; oder eine monovalente nicht-aromatische kondensierte heteropolycyclische Gruppe sind.

**12.** Metallorganische Verbindung nach Anspruch 1, wobei die metallorganische Verbindung eine der Verbindungen 1 bis 366 ist:

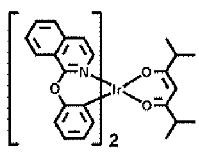
1

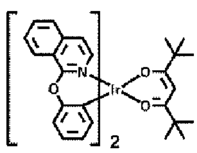
2

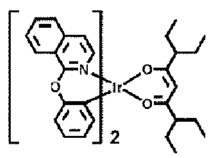
3

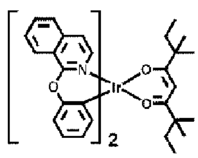
4

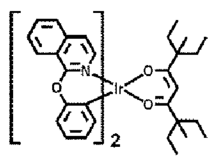
5

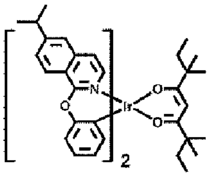
6

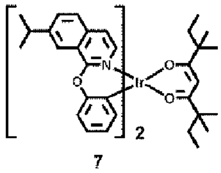
7

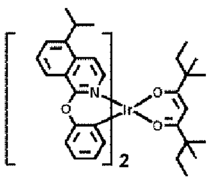
8

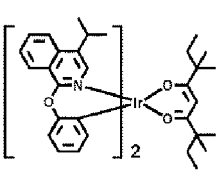
9

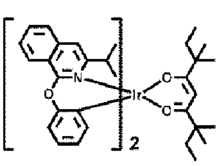
10

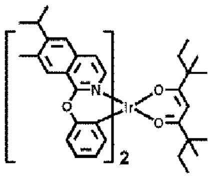
11

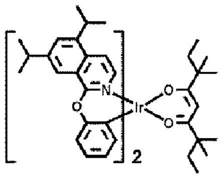
12

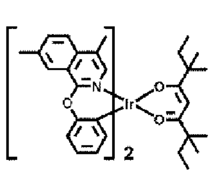
13

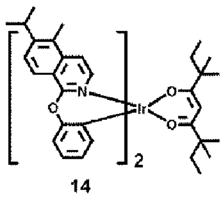
14

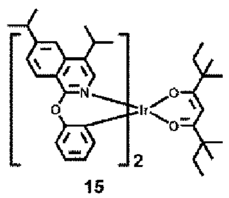
15

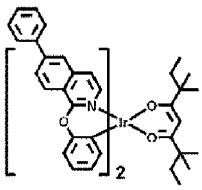
16

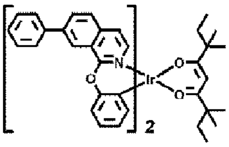
17

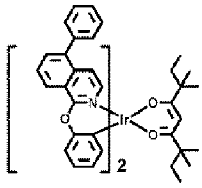
18

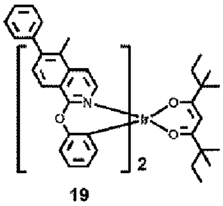
19

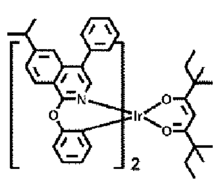
20

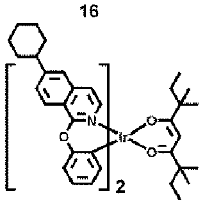
21

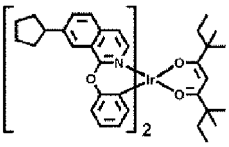
22

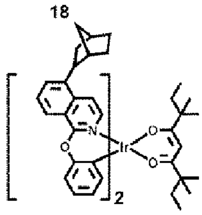
23

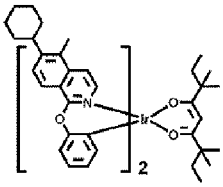
24

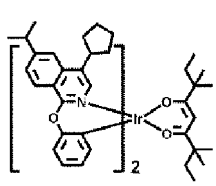
25

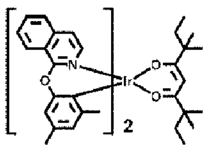
26

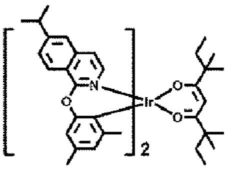
27

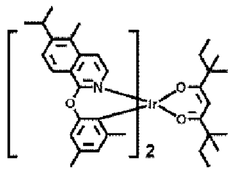
28

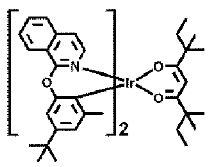
29

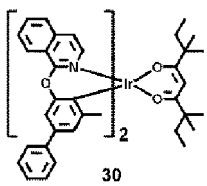
30

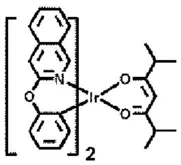
31

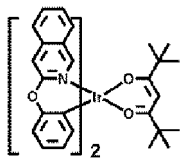
32

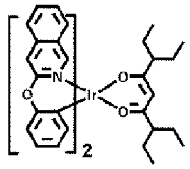
33

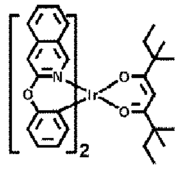
34

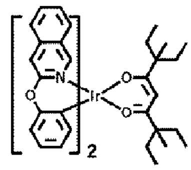
35

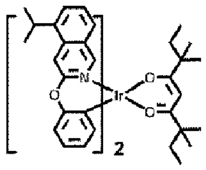
36

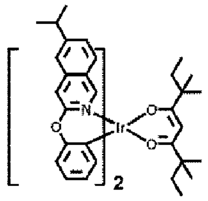
37

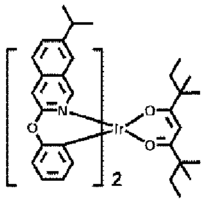
38

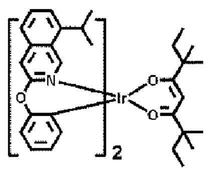
39

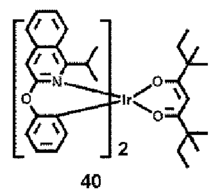
40

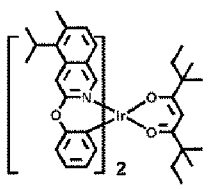
41

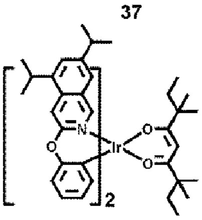
42

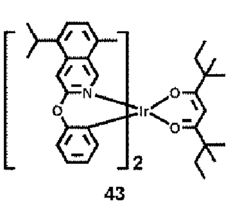
43

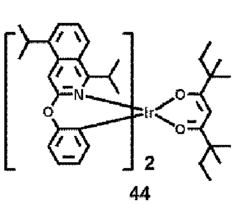
44

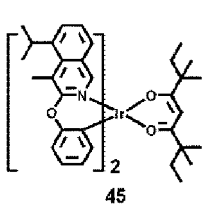
45

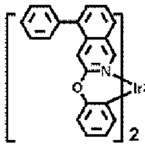
46

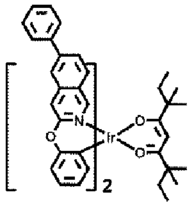
47

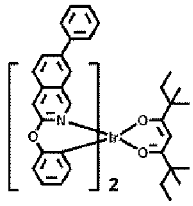
48

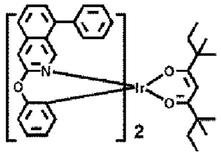
49

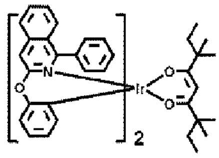
50

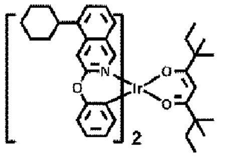
51

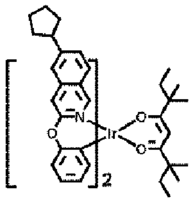
52

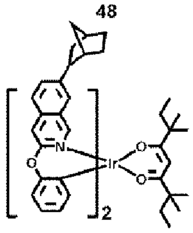
53

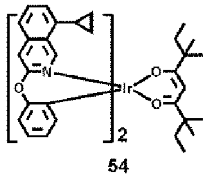
54

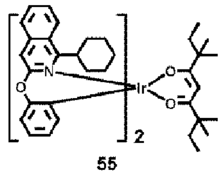
55

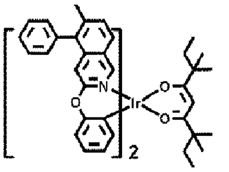
56

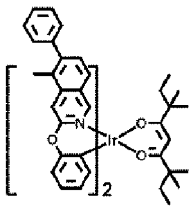
57

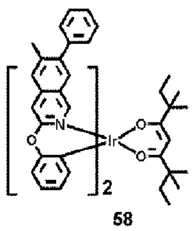
58

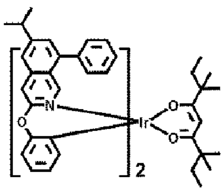
59

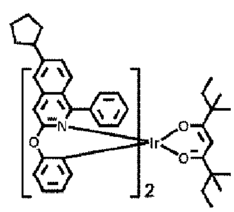
60

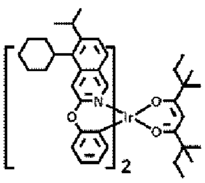
61

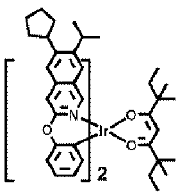
62

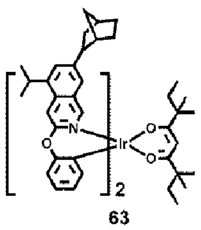
63

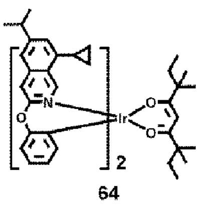
64

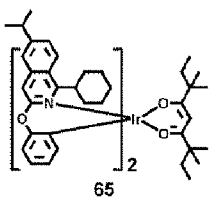
65

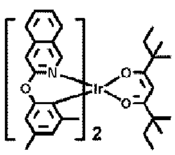
66

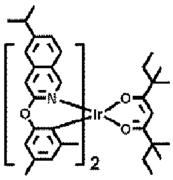
67

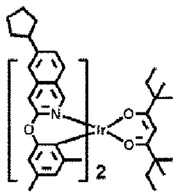
68

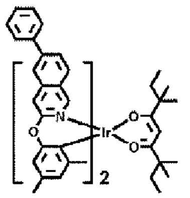
69

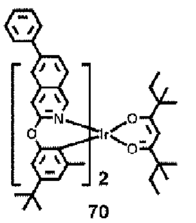
70

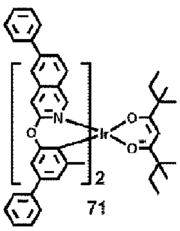
71

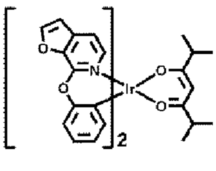
72

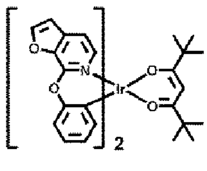
73

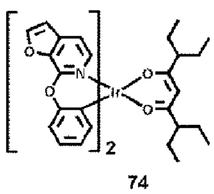
74

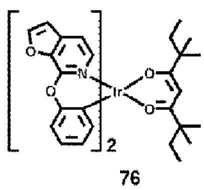
76

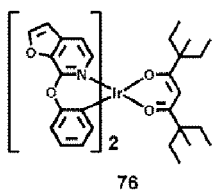
76

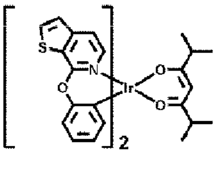
77

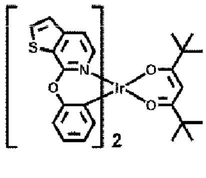
78

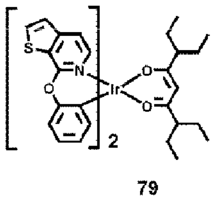
79

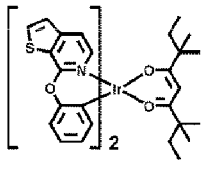
80

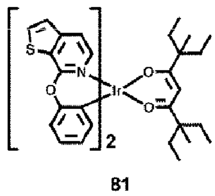
81

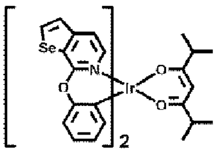
82
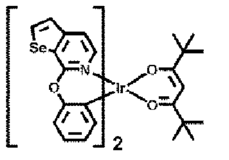
83
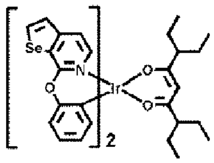
84
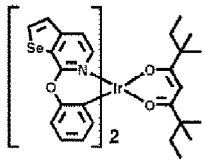
85
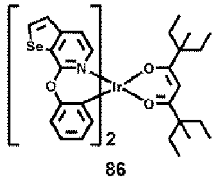
86
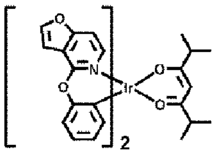
87
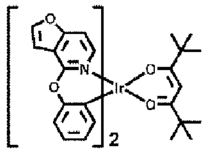
88
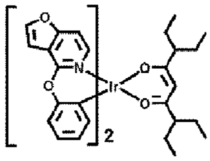
89
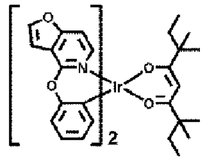
90
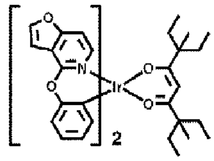
91
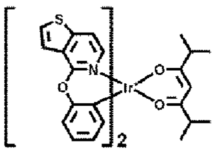
92
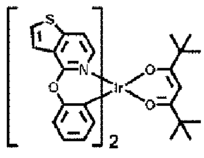
93
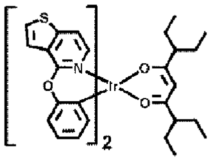
94
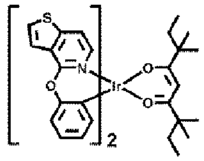
95
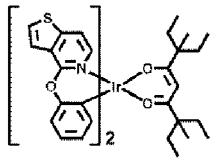
96
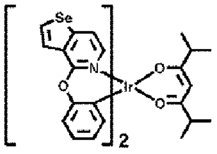
97
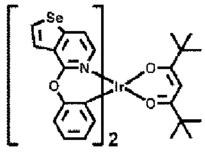
98
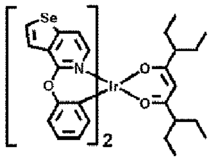
99
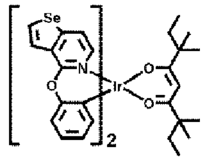
100
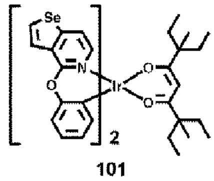
101
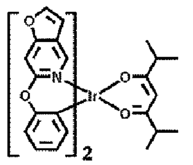
102
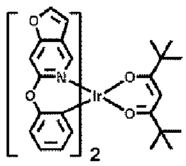
103
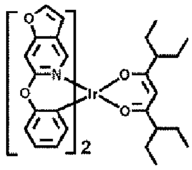
104
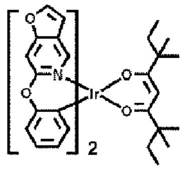
105
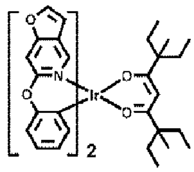
106
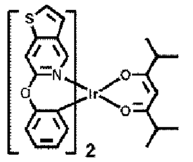
107
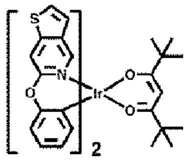
108
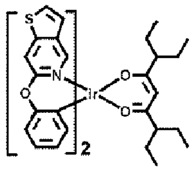
109
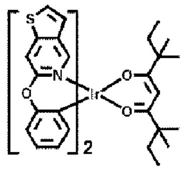
110
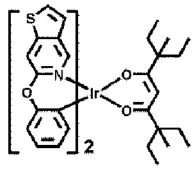
111
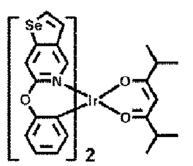
112
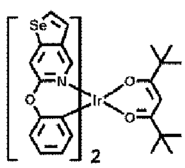
113
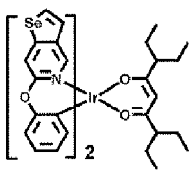
114
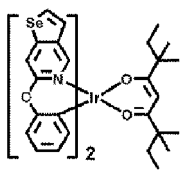
115
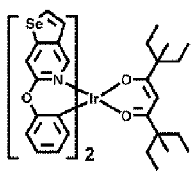
116

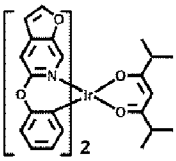
117

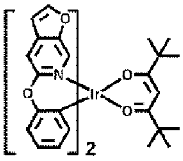
118

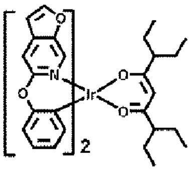
119

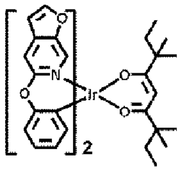
120

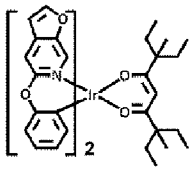
121

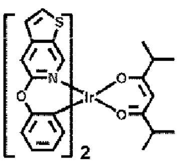
122

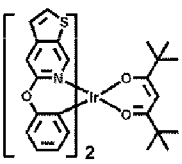
123

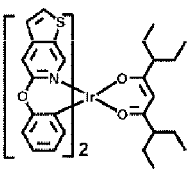
124

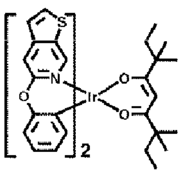
125

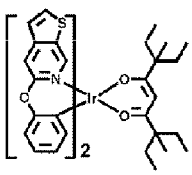
126

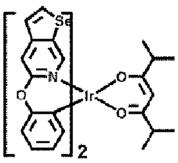
127

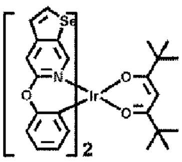
128

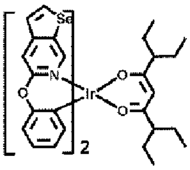
129

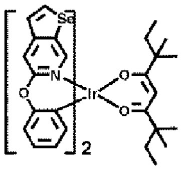
130

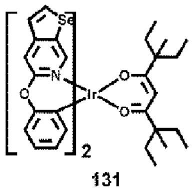
131

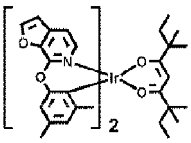
132

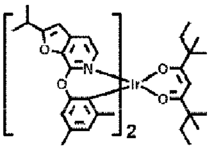
133

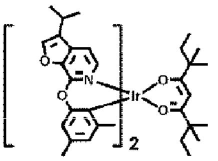
134

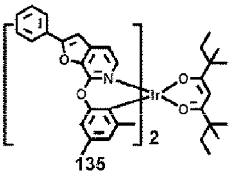
135

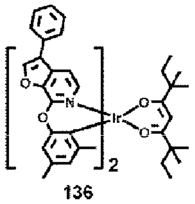
136

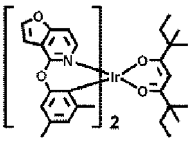
137

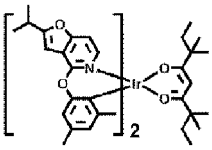
138

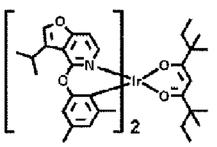
139

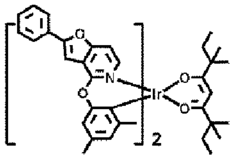
140

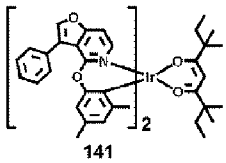
141

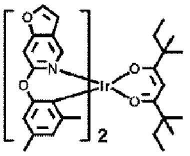
142

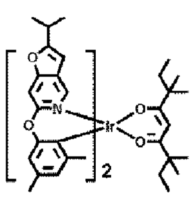
143

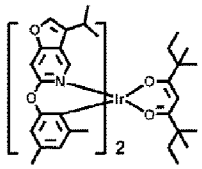
144

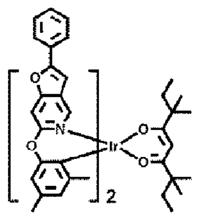
145

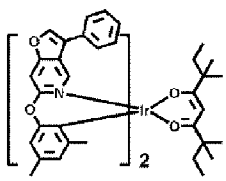
146

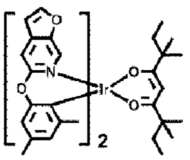
147

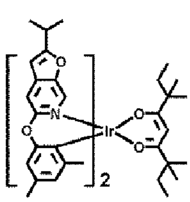
148

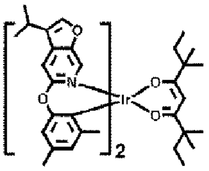
149

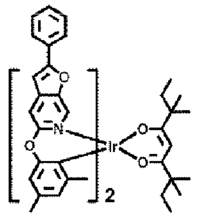
150

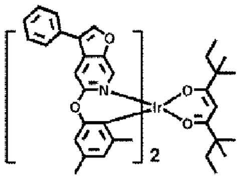
151

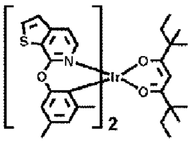
152

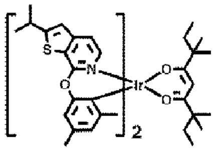
153

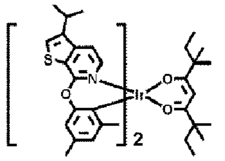
154

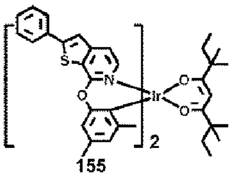
155

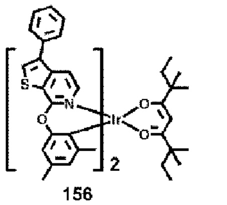
156

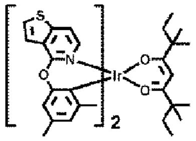
157

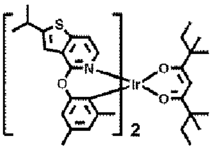
158

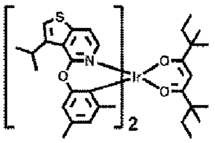
159

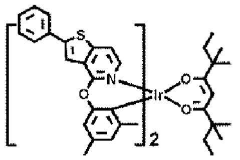
160

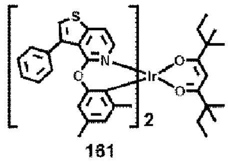
161

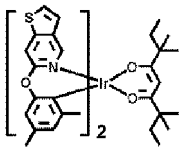
162

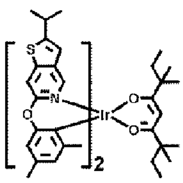
163

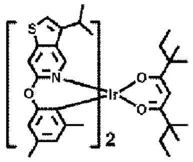
164

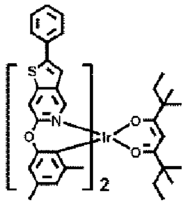
165

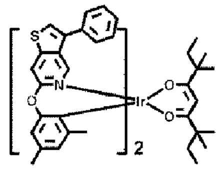
166

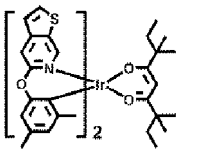
167

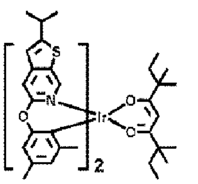
168

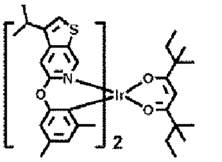
169

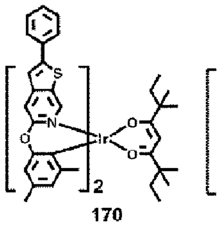
170

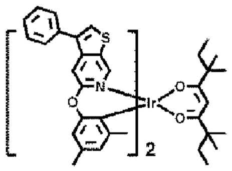
171

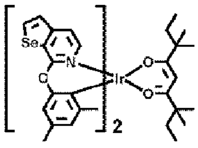
172

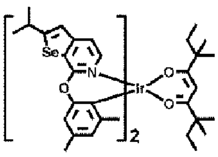
173

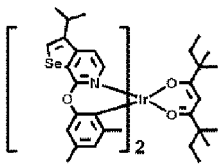
174

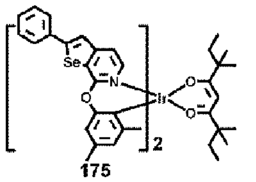
175

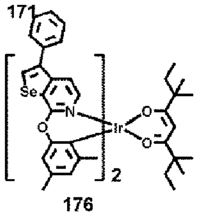
176

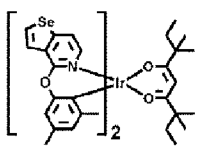
177

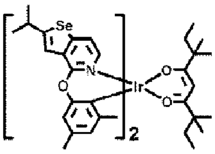
178

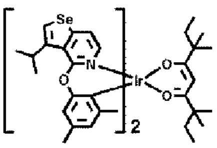
179

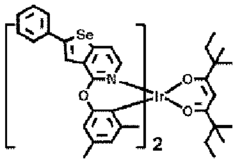
180

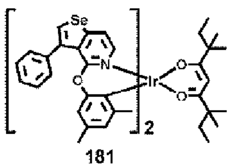
181

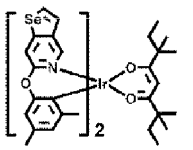
182

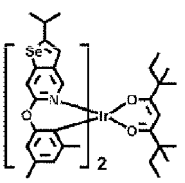
183

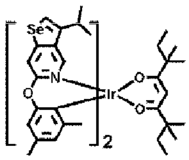
184

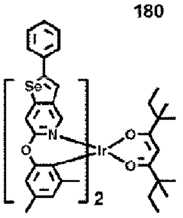
185

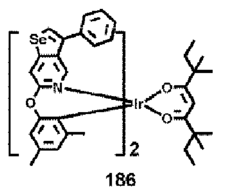
186

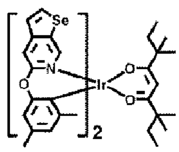
187

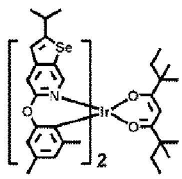
188

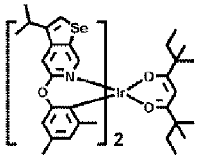
189

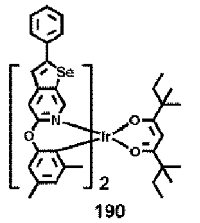
190

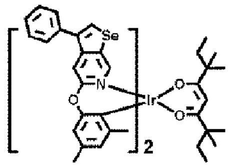
191

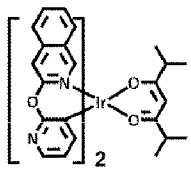
192

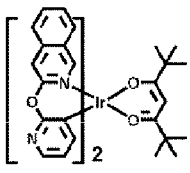
193

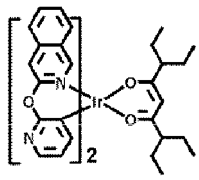
194

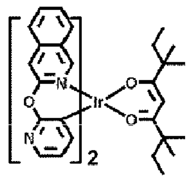
195

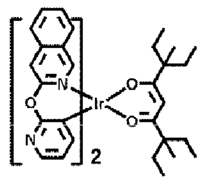
196

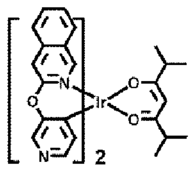
197

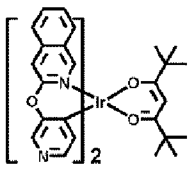
198

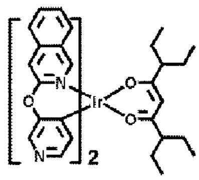
199

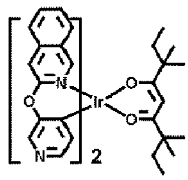
200

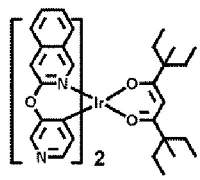
201

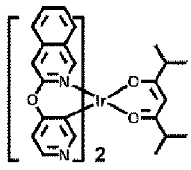
202

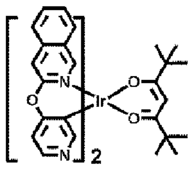
203

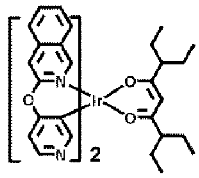
204

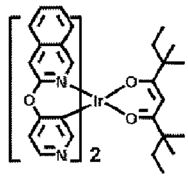
205

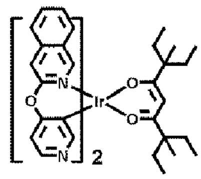
206

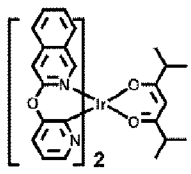
207

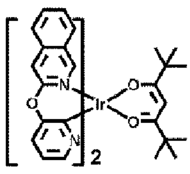
208

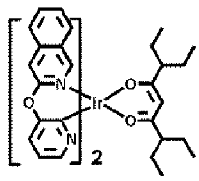
209

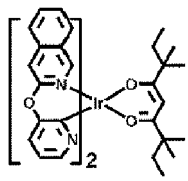
210

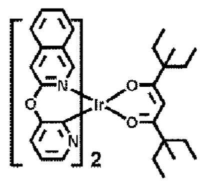
211

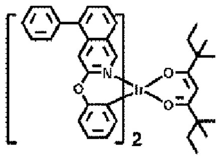
212

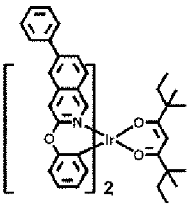
213

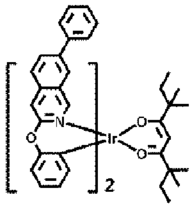
214

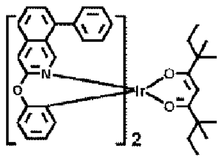
215

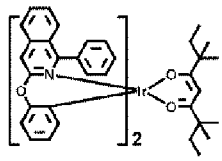
216

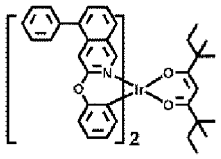
217

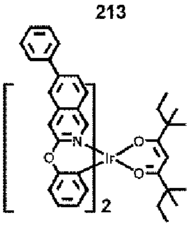
218

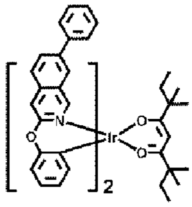
219

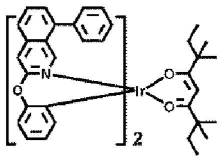
220

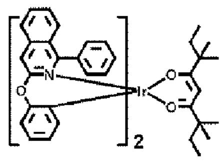
221

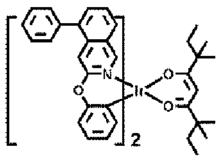
222

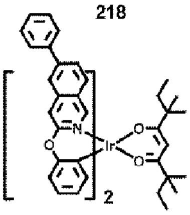
223

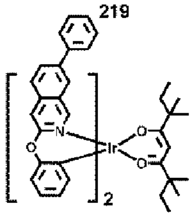
224

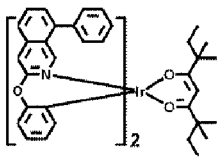
225

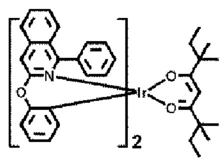
226

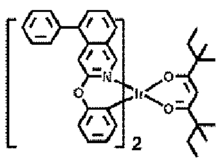
227

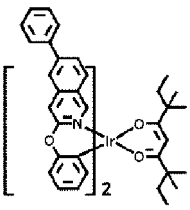
228

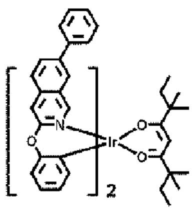
229

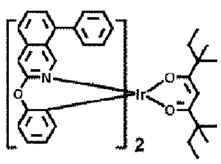
230

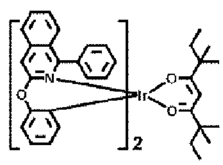
231

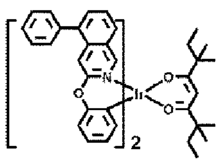
232

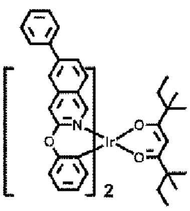
233

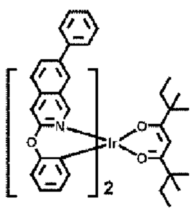
234

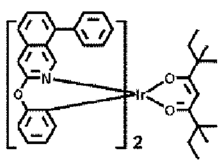
235

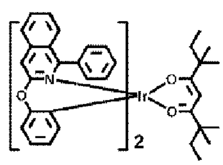
236

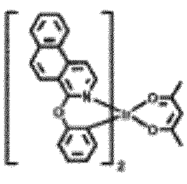
237

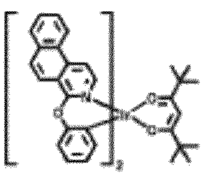
238

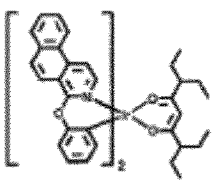
239

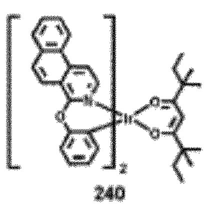
240

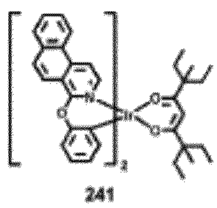
241

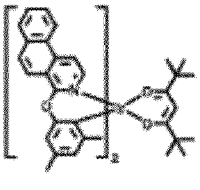
242

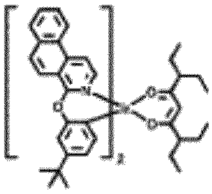
243

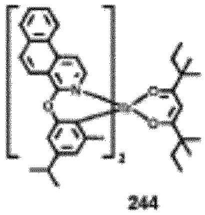
244

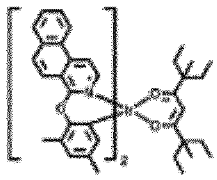
245

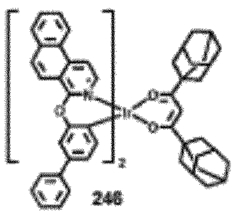
246

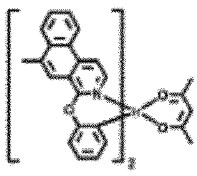

247

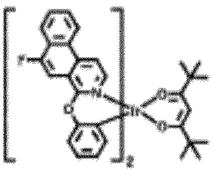

248

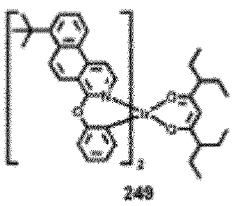

249

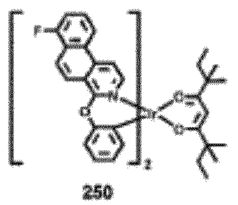

250

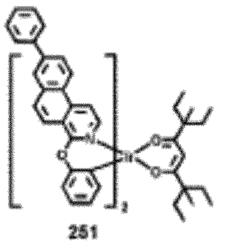

251

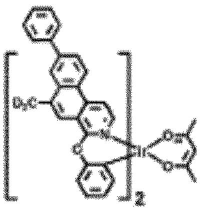

252

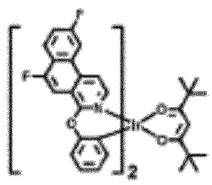

253

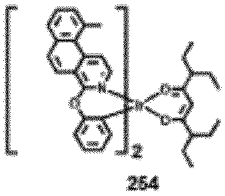

254

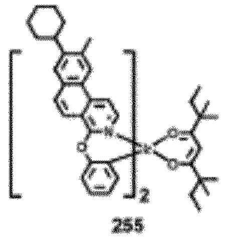

255

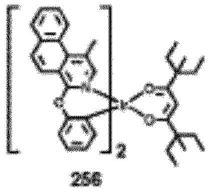

256

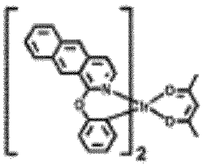

257

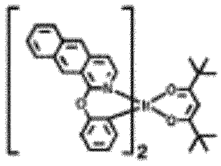

258

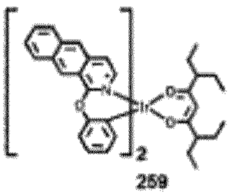

259

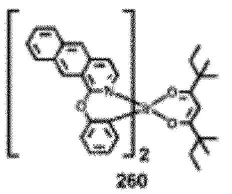

260

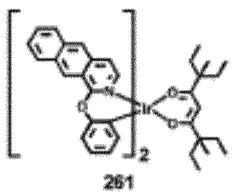

261

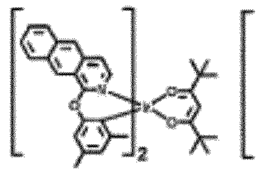

262

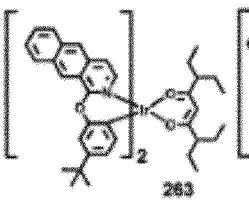

263

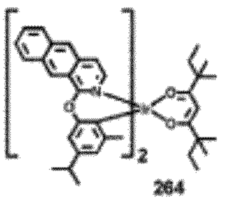

264

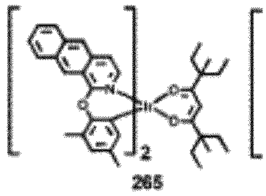

265

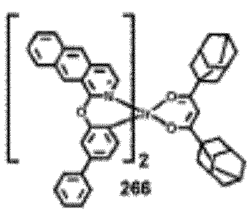

266

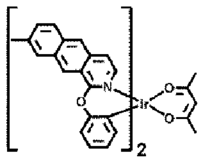

267

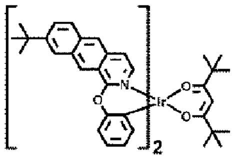

268

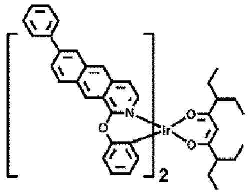

269

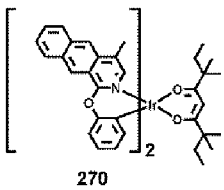

270

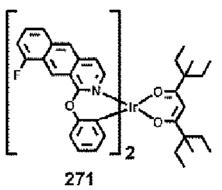

271

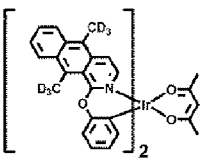

272

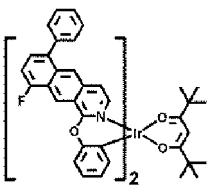

273

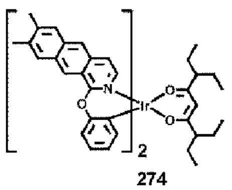

274

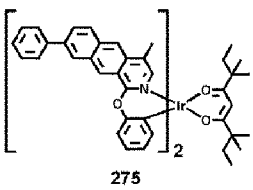

275

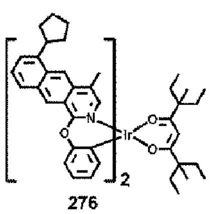

276

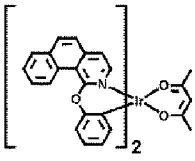
277
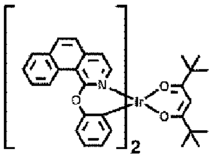
278
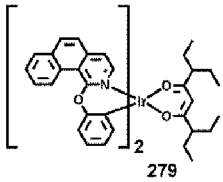
279
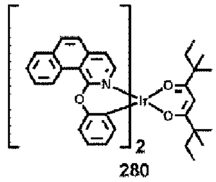
280
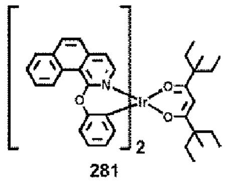
281

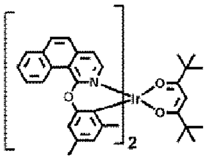
282
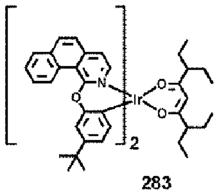
283
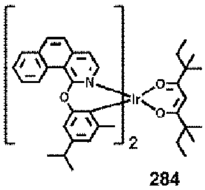
284
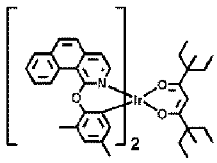
285
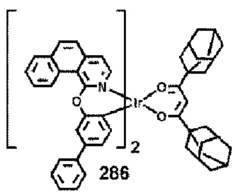
286

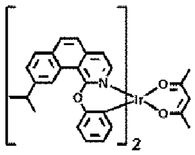
287
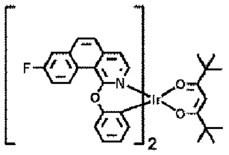
288
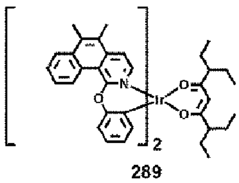
289
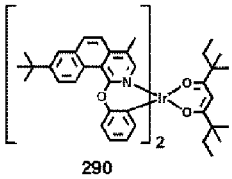
290
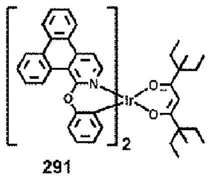
291

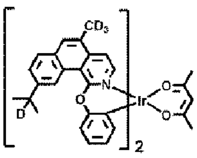
292
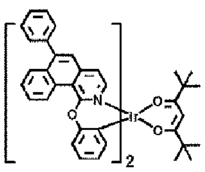
293
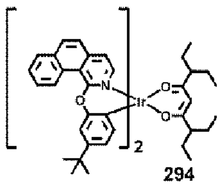
294
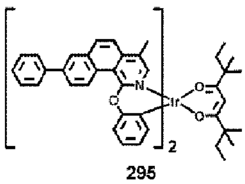
295
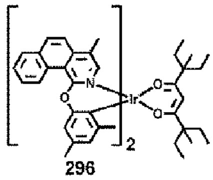
296

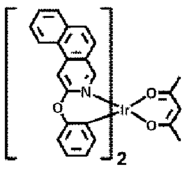
297
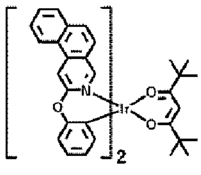
298
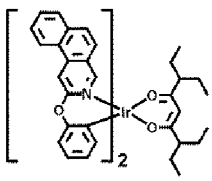
299
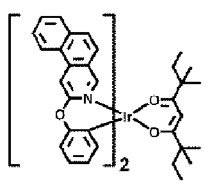
300
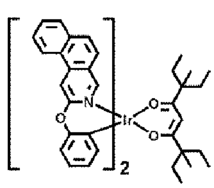
301

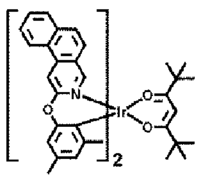
302
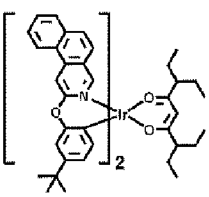
303
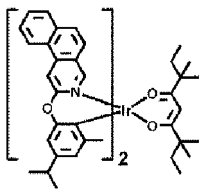
304
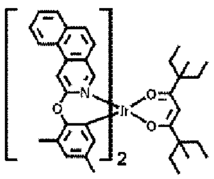
305
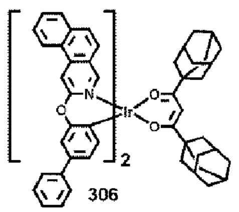
306

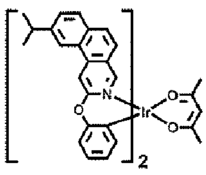
307
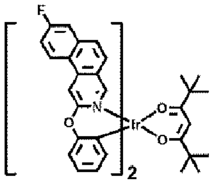
308
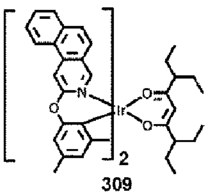
309
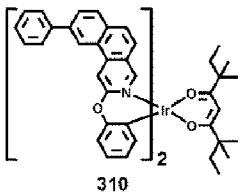
310
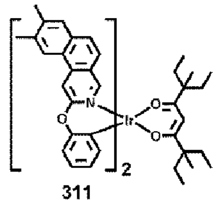
311

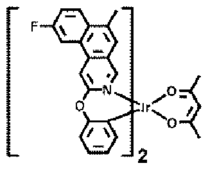

312

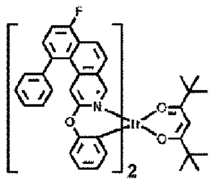

313

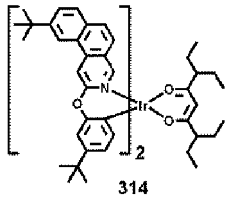

314

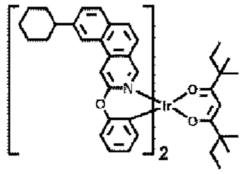

315

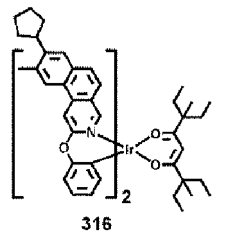

316

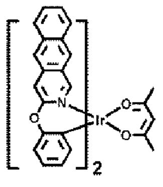

317

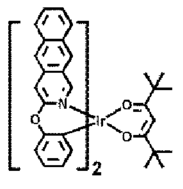

318

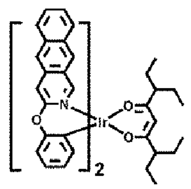

319

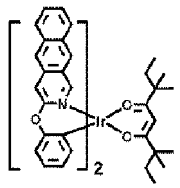

320

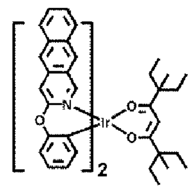

321

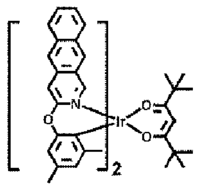

322

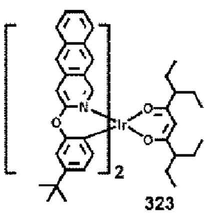

323

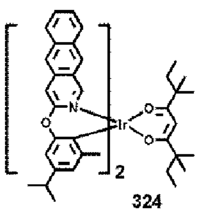

324

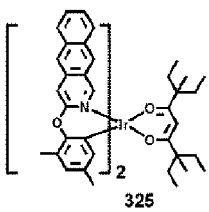

325

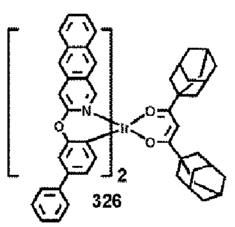

326

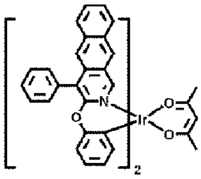

327

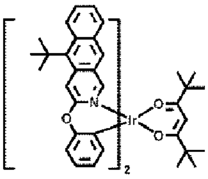

328

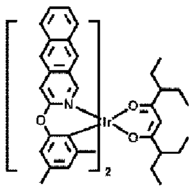

329

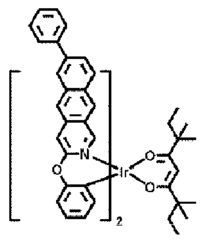

330

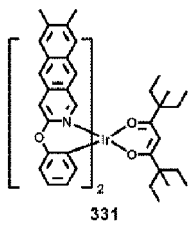

331

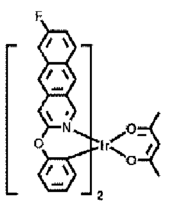

332

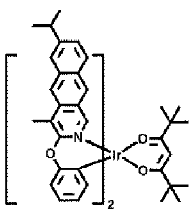

333

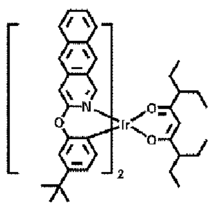

334

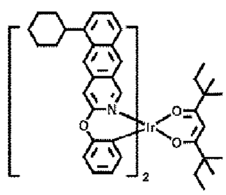

335

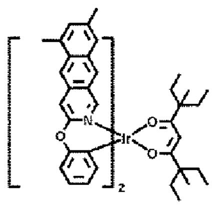

336

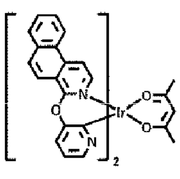

337

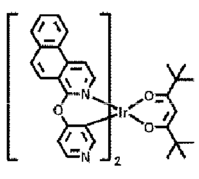

338

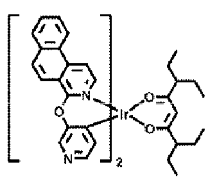

339

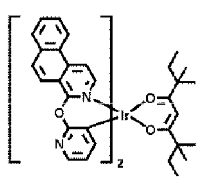

340

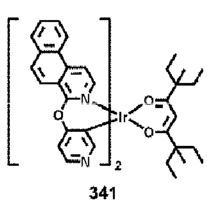

341

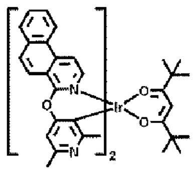
342
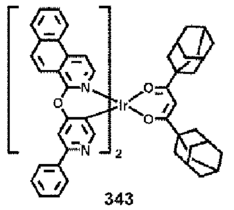
343
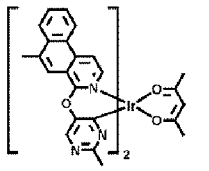
344
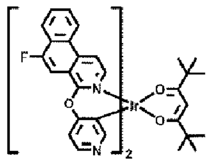
345
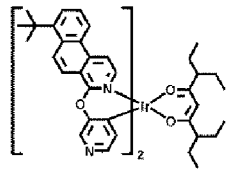
346

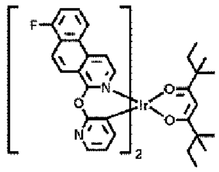
347
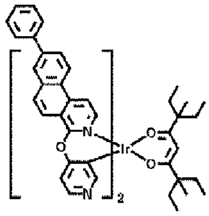
348
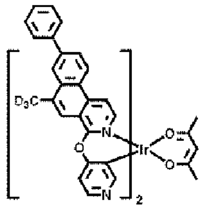
349
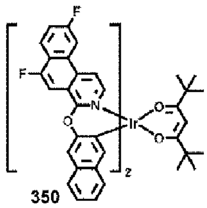
350
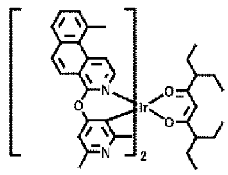
351

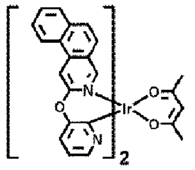
352
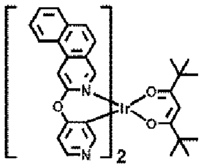
353
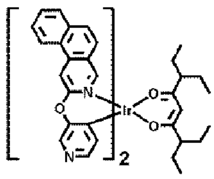
354
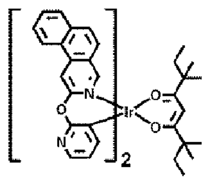
355
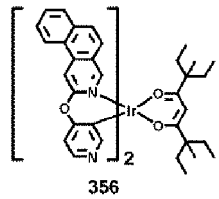
356

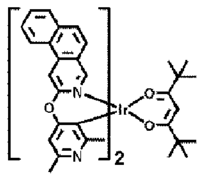
357
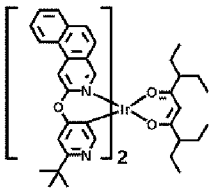
358
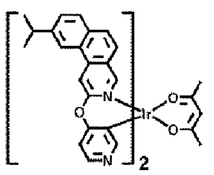
359
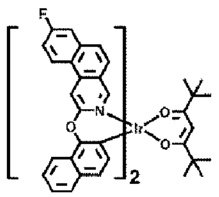
360
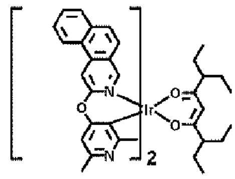
361

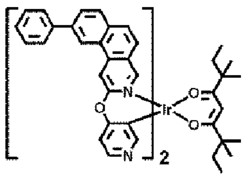
362
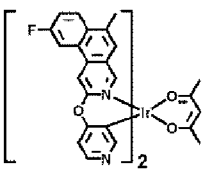
363
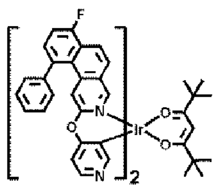
364
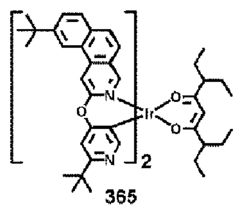
365
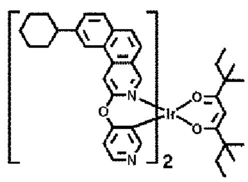
366

**13.** Organische lichtemittierende Vorrichtung, umfassend:

eine erste Elektrode,
eine zweite Elektrode; und
eine organische Schicht, die zwischen der ersten Elektrode und der zweiten Elektrode angeordnet ist und umfassend eine Emissionsschicht,
wobei die organische Schicht mindestens eine metallorganische Verbindung nach einem der Ansprüche 1-12 umfasst;
vorzugsweise wobei
die erste Elektrode eine Anode ist,
die zweite Elektrode eine Kathode ist,
die organische Schicht ferner einen Lochtransportbereich, angeordnet zwischen der ersten Elektrode und der Emissionsschicht, und einen Elektronentransportbereich, angeordnet zwischen der Emissionsschicht und der zweiten Elektrode, umfasst,
der Lochtransportbereich eine Lochinjektionsschicht, eine Lochtransportschicht, eine Elektronensperrschicht,

eine Pufferschicht oder eine beliebige Kombination davon umfasst, und
der Elektronentransportbereich eine Lochsperrschicht, eine Elektronentransportschicht, eine Elektroneninjektionsschicht oder eine beliebige Kombination davon umfasst.

**14.** Organische lichtemittierende Vorrichtung nach Anspruch 13, wobei die Emissionsschicht die metallorganische Verbindung umfasst;

vorzugsweise wobei
die Emissionsschicht ferner einen Wirt umfasst, und eine Menge des Wirts in der Emissionsschicht größer ist als eine Menge der metallorganischen Verbindung in der Emissionsschicht.

**15.** Diagnostische Zusammensetzung, umfassend mindestens eine metallorganische Verbindung nach einem der Ansprüche 1-12.

## Revendications

**1.** Composé organométallique représenté par la formule 1 :

<Formule 1> $M(L_1)_{n1}(L_2)_{n2}$

dans laquelle, dans la formule 1,

M représente un atome d'iridium (Ir), d'osmium (Os), de titane (Ti), de hafnium (Hf), d'europium (Eu), de rhodium (Rh), ou de ruthénium (Ru),
$L_1$ est un ligand représenté par la formule 2,
n1 vaut 1, 2 ou 3, et lorsque n1 vaut 2 ou plus, deux groupes $L_1$ ou plus sont identiques les uns aux autres ou différents les uns des autres,
$L_2$ représente un ligand monodenté, un ligand bidenté, un ligand tridenté ou un ligand tétradenté,
n2 vaut 0, 1, 2, 3 ou 4, et lorsque n2 vaut 2 ou plus, deux groupes $L_2$ ou plus sont identiques les uns aux autres ou différents les uns des autres, et
$L_1$ et $L_2$ sont différents l'un de l'autre,

<Formule 2>

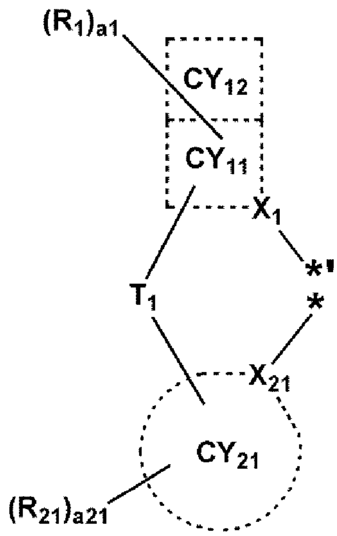

dans laquelle, dans la formule 2,

$X_1$ et $X_{21}$ représentent chacun indépendamment un atome C ou N,
le noyau $CY_{11}$, le noyau $CY_{12}$ et le noyau $CY_{21}$ représentent chacun indépendamment un groupe carbocyclique

en $C_5$ à $C_{30}$ ou un groupe hétérocyclique en $C_1$ à $C_{30}$, ledit noyau $CY_{11}$ et ledit noyau $CY_{12}$ étant condensés l'un à l'autre,

$T_1$ représente *-N($R_2$)-*', *-B($R_2$)-*', *-P($R_2$)-*', *-S-*', *-Se-*', ou *-O-*', * et *' indiquant chacun un site de liaison à un atome voisin,

$R_1$ à $R_2$ et $R_{21}$ représentant chacun indépendamment un atome d'hydrogène, un atome de deutérium, un groupe -F, -Cl, -Br, -I, -$SF_5$, un groupe hydroxy, un groupe cyano, un groupe nitro, un groupe amino, un groupe amidino, un groupe hydrazino, un groupe hydrazono, un groupe acide carboxylique ou un sel de celui-ci, un groupe acide sulfonique ou un sel de celui-ci, un groupe acide phosphorique ou un sel de celui-ci, un groupe $C_1$-$C_{60}$ alkyle substitué ou non substitué, un groupe $C_2$-$C_{60}$ alcényle substitué ou non substitué, un groupe $C_2$-$C_{60}$ alcynyle substitué ou non substitué, un groupe $C_1$-$C_{60}$ alcoxy substitué ou non substitué, un groupe $C_3$-$C_{10}$ cycloalkyle substitué ou non substitué, un groupe $C_1$-$C_{10}$ hétérocycloalkyle substitué ou non substitué, un groupe $C_3$-$C_{10}$ cycloalcényle substitué ou non substitué, un groupe $C_1$-$C_{10}$ hétérocycloalcényle substitué ou non substitué, un groupe $C_6$-$C_{60}$ aryle substitué ou non substitué, un groupe $C_6$-$C_{60}$ aryloxy substitué ou non substitué, un groupe $C_6$-$C_{60}$ arylthio substitué ou non substitué, un groupe $C_1$-$C_{60}$ hétéroaryle substitué ou non substitué, un groupe polycyclique condensé non aromatique monovalent substitué ou non substitué, un groupe hétéropolycyclique condensé non aromatique monovalent substitué ou non substitué, -N($Q_1$)($Q_2$), -Si($Q_3$)($Q_4$)($Q_5$), -Ge($Q_3$)($Q_4$)($Q_5$),-B($Q_6$)($Q_7$), -P(=O)($Q_8$)($Q_9$) ou -P($Q_8$)($Q_9$),

a1 et a21 représentent chacun indépendamment un entier allant de 0 à 20, deux groupes ou plus d'une pluralité de groupes $R_1$ sont éventuellement liés pour former un groupe carbocyclique en $C_5$ à $C_{30}$ qui est non substitué ou substitué par au moins un groupe $R_{10a}$ ou un groupe hétérocyclique en $C_1$ à $C_{30}$ qui est non substitué ou substitué par au moins un groupe $R_{10a}$,

deux groupes ou plus d'une pluralité de groupes $R_{21}$ sont éventuellement liés pour former un groupe carbocyclique en $C_5$ à $C_{30}$ qui est non substitué ou substitué par au moins un groupe $R_{10a}$ ou un groupe hétérocyclique en $C_1$ à $C_{30}$ qui est non substitué ou substitué par au moins un groupe $R_{10a}$,

deux groupes ou plus parmi les groupes $R_1$ à $R_3$ et $R_{21}$ sont éventuellement liés pour former un groupe carbocyclique en $C_5$ à $C_{30}$ qui est non substitué ou substitué par au moins un groupe $R_{10a}$ ou un groupe hétérocyclique en $C_1$ à $C_{30}$ qui est non substitué ou substitué par au moins un groupe $R_{10a}$,

$R_{10a}$ est le même groupe que celui définit en lien avec $R_{21}$,

* et *' indiquent chacun un site de liaison à M dans la formule 1, et

un ou des substituants parmi le groupe $C_1$-$C_{60}$ alkyle substitué, le groupe $C_2$-$C_{60}$ alcényle substitué, le groupe $C_2$-$C_{60}$ alcynyle substitué, le groupe $C_1$-$C_{60}$ alcoxy substitué, le groupe $C_3$-$C_{10}$ cycloalkyle substitué, le groupe $C_1$-$C_{10}$ hétérocycloalkyle substitué, le groupe $C_3$-$C_{10}$ cycloalcényle substitué, le groupe $C_1$-$C_{10}$ hétérocycloalcényle substitué, le groupe $C_6$-$C_{60}$ aryle substitué, le groupe $C_6$-$C_{60}$ aryloxy substitué, le groupe $C_6$-$C_{60}$ arylthio substitué, le groupe $C_1$-$C_{60}$ hétéroaryle substitué, le groupe polycyclique condensé non aromatique monovalent substitué, et le groupe hétéropolycyclique condensé non aromatique monovalent substitué est :

un atome de deutérium, un groupe -F, -Cl, -Br, -I, -$CD_3$, -$CD_2H$, -$CDH_2$, -$CF_3$, -$CF_2H$,-$CFH_2$, un groupe hydroxy, un groupe cyano, un groupe nitro, un groupe amino, un groupe amidino, un groupe hydrazino, un groupe hydrazono, un groupe acide carboxylique ou un sel de celui-ci, un groupe acide sulfonique ou un sel de celui-ci, un groupe acide phosphorique ou un sel de celui-ci, un groupe $C_1$-$C_{60}$ alkyle, un groupe $C_2$-$C_{60}$ alcényle, un groupe $C_2$-$C_{60}$ alcynyle, ou un groupe $C_1$-$C_{60}$ alcoxy ;

un groupe $C_1$-$C_{60}$ alkyle, un groupe $C_2$-$C_{60}$ alcényle, un groupe $C_2$-$C_{60}$ alcynyle, ou un groupe $C_1$-$C_{60}$ alcoxy, chacun substitué par un atome de deutérium, un groupe -F, -Cl, -Br, -I, - $CD_3$, -$CD_2H$, -$CDH_2$, -$CF_3$, -$CF_2H$, -$CFH_2$, un groupe hydroxy, un groupe cyano, un groupe nitro, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe $C_3$-$C_{10}$ cycloalkyle, un groupe $C_1$-$C_{10}$ hétérocycloalkyle, un groupe $C_3$-$C_{10}$ cycloalcényle, un groupe $C_1$-$C_{10}$ hétérocycloalcényle, un groupe $C_6$-$C_{60}$ aryle, un groupe $C_6$-$C_{60}$ aryloxy, un groupe $C_6$-$C_{60}$ arylthio, un groupe $C_7$-$C_{60}$ arylalkyle, un groupe $C_1$-$C_{60}$ hétéroaryle, un groupe $C_1$-$C_{60}$ hétéroaryloxy, un groupe $C_1$-$C_{60}$ hétéroarylthio, un groupe $C_2$-$C_{60}$ hétéroarylalkyle, un groupe polycyclique condensé non aromatique monovalent, un groupe hétéropolycyclique condensé non aromatique monovalent, -N($Q_{11}$)($Q_{12}$), -Si($Q_{13}$)($Q_{14}$)($Q_{15}$),-Ge($Q_{13}$)($Q_{14}$)($Q_{15}$), -B($Q_{16}$)($Q_{17}$), -P(=O)($Q_{18}$)($Q_{19}$), -P($Q_{18}$)($Q_{19}$), ou toute combinaison de ceux-ci ;

un groupe $C_3$-$C_{10}$ cycloalkyle, un groupe $C_1$-$C_{10}$ hétérocycloalkyle, un groupe $C_3$-$C_{10}$ cycloalcényle, un groupe $C_1$-$C_{10}$ hétérocycloalcényle, un groupe $C_6$-$C_{60}$ aryle, un groupe $C_6$-$C_{60}$ aryloxy, un groupe $C_6$-$C_{60}$ arylthio, un groupe $C_1$-$C_{60}$ hétéroaryle, un groupe polycyclique condensé non aromatique monovalent, ou un groupe hétéropolycyclique condensé non aromatique monovalent, chacun non substitué ou substitué par un atome de deutérium, un groupe -F, -Cl, -Br, -I, -$CD_3$, -$CD_2H$, -$CDH_2$, -$CF_3$, -$CF_2H$, -$CFH_2$, un groupe

hydroxy, un groupe cyano, un groupe nitro, un groupe amino, un groupe amidino, un groupe hydrazino, un groupe hydrazono, un groupe acide carboxylique ou un sel de celui-ci, un groupe acide sulfonique ou un sel de celui-ci, un groupe acide phosphorique ou un sel de celui-ci, un groupe $C_1$-$C_{60}$ alkyle, un groupe $C_2$-$C_{60}$ alcényle, un groupe $C_2$-$C_{60}$ alcynyle, un groupe $C_1$-$C_{60}$ alcoxy, un groupe $C_3$-$C_{10}$ cycloalkyle, un groupe $C_1$-$C_{10}$ hétérocycloalkyle, un groupe $C_3$-$C_{10}$ cycloalcényle, un groupe $C_1$-$C_{10}$ hétérocycloalcényle, un groupe $C_6$-$C_{60}$ aryle, un groupe $C_6$-$C_{60}$ aryloxy, un groupe $C_6$-$C_{60}$ arylthio, un groupe $C_1$-$C_{60}$ hétéroaryle, un groupe polycyclique condensé non aromatique monovalent, un groupe hétéropolycyclique condensé non aromatique monovalent, -N($Q_{21}$)($Q_{22}$), - Si($Q_{23}$)($Q_{24}$)($Q_{25}$), -Ge($Q_{23}$)($Q_{24}$)($Q_{25}$), -B($Q_{26}$)($Q_{27}$), -P(=O)($Q_{28}$)($Q_{19}$), -P($Q_{28}$)($Q_{29}$), ou toute combinaison de ceux-ci ;
-N($Q_{31}$)($Q_{32}$), -Si($Q_{33}$)($Q_{34}$)($Q_{35}$), -Ge($Q_{33}$)($Q_{34}$)($Q_{35}$), -B($Q_{36}$)($Q_{37}$), -P(=O)($Q_{38}$)($Q_{39}$) ou-P($Q_{38}$)($Q_{39}$) ; ou toute combinaison de ceux-ci, et
$Q_1$ à $Q_9$, $Q_{11}$ à $Q_{19}$, $Q_{21}$ à $Q_{29}$, et $Q_{31}$ à $Q_{39}$ représentent chacun indépendamment un atome d'hydrogène ; un atome de deutérium ; un groupe -F ; -Cl ; -Br ; -I ; un groupe hydroxy ; un groupe cyano ; un groupe nitro ; un groupe amidino ; un groupe hydrazine ; un groupe hydrazone ; un groupe acide carboxylique ou un sel de celui-ci ; un groupe acide sulfonique ou un sel de celui-ci ; un groupe acide phosphorique ou un sel de celui-ci ; un groupe $C_1$-$C_{60}$ alkyle non substitué ou substitué par un atome de deutérium, un groupe $C_1$-$C_{60}$ alkyle, un groupe $C_6$-$C_{60}$ aryle ou toute combinaison de ceux-ci ; un groupe $C_2$-$C_{60}$ alcényle ; un groupe $C_2$-$C_{60}$ alcynyle ; un groupe $C_1$-$C_{60}$ alcoxy ; un groupe $C_3$-$C_{10}$ cycloalkyle ; un groupe $C_1$-$C_{10}$ hétérocycloalkyle ; un groupe $C_3$-$C_{10}$ cycloalcényle ; un groupe $C_1$-$C_{10}$ hétérocycloalcényle ; un groupe $C_6$-$C_{60}$ aryle non substitué ou substitué par un atome de deutérium, un groupe $C_1$-$C_{60}$ alkyle, un groupe $C_6$-$C_{60}$ aryle ou toute combinaison de ceux-ci ; un groupe $C_6$-$C_{60}$ aryloxy ; un groupe $C_6$-$C_{60}$ arylthio ; un groupe $C_7$-$C_{60}$ arylalkyle ; un groupe $C_1$-$C_{60}$ hétéroaryle ; un groupe $C_1$-$C_{60}$ hétéroaryloxy ; un groupe $C_1$-$C_{60}$ hétéroarylthio ; un groupe $C_2$-$C_{60}$ hétéroarylalkyle ; un groupe polycyclique condensé non aromatique monovalent ; ou un groupe hétéropolycyclique condensé non aromatique monovalent.

**2.** Composé organométallique selon la revendication 1,

M représentant un atome Ir ou Os, et le somme de n1 et n2 valant 3 ou 4 ; et/ou
$X_1$ représentant un atome N et $X_{21}$ représentant un atome C.

**3.** Composé organométallique selon la revendication 1 ou 2,

le noyau $CY_{11}$, le noyau $CY_{12}$, et le noyau $CY_{21}$ représentant chacun indépendamment un groupe cyclopentène, un groupe cyclohexène, un groupe benzène, un groupe naphtalène, un groupe anthracène, un groupe phénanthrène, un groupe triphénylène, un groupe pyrène, un groupe chrysène, un groupe 1,2,3,4-tetrahydronaphtalène, un groupe pyrrole, un groupe borole, un groupe phosphole, un groupe cyclopentadiène, un groupe silole, un groupe germole, un groupe thiophène, un groupe sélénophène, un groupe furane, un groupe indole, un groupe benzoborole, un groupe benzophosphole, un groupe indène, un groupe benzosilole, un groupe benzogermole, un groupe benzothiophène, un groupe benzosélénophène, un groupe benzofurane, un groupe carbazole, un groupe dibenzoborole, un groupe dibenzophosphole, un groupe fluorène, un groupe dibenzosilole, un groupe dibenzogermole, un groupe dibenzothiophène, un groupe dibenzosélénophène, un groupe dibenzofurane, un groupe dibenzothiophène-5-oxyde, un groupe 9H-fluorène-9-one, un groupe dibenzothiophène-5,5-dioxyde, un groupe azaindole, un groupe azabenzoborole, un groupe azabenzophosphole, un groupe azaindène, un groupe azabenzosilole, un groupe azabenzogermole, un groupe azabenzothiophène, un groupe azabenzosélénophène, un groupe azabenzofurane, un groupe azacarbazole, un groupe azadibenzoborole, un groupe azadibenzophosphole, un groupe azafluorène, un groupe azadibenzosilole, un groupe azadibenzogermole, un groupe azadibenzothiophène, un groupe azadibenzosélénophène, un groupe azadibenzofurane, un groupe azadibenzothiophène-5-oxyde, un groupe aza-9H-fluorène-9-one, un groupe azadibenzothiophène-5,5-dioxyde, un groupe pyridine, un groupe pyrimidine, un groupe pyrazine, un groupe pyridazine, un groupe triazine, un groupe quinoline, un groupe isoquinoline, un groupe benzoquinoline, un groupe benzoisoquinoline, un groupe quinoxaline, un groupe quinazoline, un groupe phénanthroline, un groupe pyrazole, un groupe imidazole, un groupe triazole, un groupe azaborole, un groupe azaphosphole, un groupe azacyclopentadiène, un groupe azasilole, un groupe azagermole, un groupe azasélénophène, un groupe oxazole, un groupe isooxazole, un groupe thiazole, un groupe isothiazole, un groupe oxadiazole, un groupe thiadiazole, un groupe benzopyrazole, un groupe benzimidazole, un groupe benzoxazole, un groupe benzothiazole, un groupe benzoxadiazole, un groupe benzothiadiazole, un groupe 5,6,7,8-tétrahydroisoquinoline, ou un groupe 5,6,7,8-tétrahydroquinoline ; et/ou
$T_1$ représentant un groupe *-O-*'.

**4.** Composé organométallique selon l'une quelconque des revendications 1 à 3, $R_1$ à $R_2$ et $R_{21}$ représentant chacun indépendamment :

un atome d'hydrogène, un atome de deutérium, un groupe -F, -Cl, -Br, -I, un groupe hydroxy, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, $-SF_5$, un groupe $C_1$-$C_{20}$ alkyle, ou un groupe $C_1$-$C_{20}$ alcoxy ;

un groupe $C_1$-$C_{20}$ alkyle et un groupe $C_1$-$C_{20}$ alcoxy, chacun substitué par un atome de deutérium, un groupe-F, -Cl, -Br, -I, $-CD_3$, $-CD_2H$, $-CDH_2$, $-CF_3$, $-CF_2H$, $-CFH_2$, un groupe hydroxy, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe $C_1$-$C_{10}$ alkyle, un groupe cyclopentyle, un groupe cyclohexyle, un groupe cycloheptyle, un groupe cyclooctyle, un groupe adamantyle, un groupe norbornyle, un groupe norbornényle, un groupe cyclopentényle, un groupe cyclohexényle, un groupe cycloheptényle, un groupe bicyclo[1.1.1]pentyle, un groupe bicyclo[2.1.1]hexyle, un groupe bicyclo[2.2.1]heptyle, un groupe bicyclo[2.2.2]octyle, un groupe ($C_1$-$C_{20}$ alkyl)cyclopentyle, un groupe ($C_1$-$C_{20}$ alkyl)cyclohexyle, un groupe ($C_1$-$C_{20}$ alkyl)cycloheptyle, un groupe ($C_1$-$C_{20}$ alkyl)cyclooctyle, un groupe ($C_1$-$C_{20}$ alkyl)adamantanyle, un groupe ($C_1$-$C_{20}$ alkyl)norbornanyle, un groupe ($C_1$-$C_{20}$ alkyl)norbornényle, un groupe ($C_1$-$C_{20}$ alkyl)cyclopentényle, un groupe ($C_1$-$C_{20}$ alkyl)cyclohexényle, un groupe ($C_1$-$C_{20}$ alkyl)cycloheptényle, un groupe ($C_1$-$C_{20}$ alkyl)bicyclo[1.1.1 ]pentyle, un groupe ($C_1$-$C_{20}$ alkyl)bicyclo[2.1.1]hexyle, un groupe ($C_1$-$C_{20}$ alkyl)bicyclo[2.2.1]heptyle, un groupe ($C_1$-$C_{20}$ alkyl)bicyclo[2.2.2] octyle, un groupe phényle, un groupe ($C_1$-$C_{20}$ alkyl)phényle, un groupe biphényle, un groupe terphényle, un groupe naphtyle, un groupe pyridinyle, un groupe pyrimidinyle, ou toute combinaison de ceux-ci ;

un groupe cyclopentyle, un groupe cyclohexyle, un groupe cycloheptyle, un groupe cyclooctyle, un groupe adamantyle, un groupe norbornyle, un groupe norbornényle, un groupe cyclopentényle, un groupe cyclohexényle, un groupe cycloheptényle, un groupe bicyclo[1.1.1]pentyle, un groupe bicyclo[2.1.1]hexyle, un groupe bicyclo[2.2.1]heptyle, un groupe bicyclo[2.2.2]octyle, un groupe phényle, un groupe ($C_1$-$C_{20}$ alkyl)phényle, un groupe biphényle, un groupe terphényle, un groupe naphtyle, un groupe fluorényle, un groupe phénanthrényle, un groupe anthracényle, un groupe fluoranthényle, un groupe triphénylényle, un groupe pyrényle, un groupe chrysényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe quinoxalinyle, un groupe quinazolinyle, un groupe cinnolinyle, un groupe carbazolyle, un groupe phénanthrolinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe benzocarbazolyle, un groupe dibenzocarbazolyle, un groupe imidazopyridinyle, un groupe imidazopyrimidinyle, un groupe azacarbazolyle, un groupe azadibenzofuranyle, ou un groupe azadibenzothiophényle, chacun non substitué ou substitué par un atome de deutérium, un groupe -F, -Cl, -Br, -I, $-CD_3$, $-CD_2H$, $-CDH_2$, $-CF_3$, $-CF_2H$, $-CFH_2$, un groupe hydroxy, un groupe cyano, un groupe nitro, un groupe amino, un groupe amidino, un groupe hydrazine, un groupe hydrazone, un groupe acide carboxylique ou un sel de celui-ci, un acide sulfonique ou un sel de celui-ci, un groupe acide phosphorique ou un sel de celui-ci, un groupe $C_1$-$C_{20}$ alkyle, un groupe $C_2$-$C_{20}$ alkyle contenant du deutérium, un groupe $C_1$-$C_{20}$ alcoxy, un groupe cyclopentyle, un groupe cyclohexyle, un groupe cycloheptyle, un groupe cyclooctyle, un groupe adamantyle, un groupe norbornyle, un groupe norbornényle, un groupe cyclopentényle, un groupe cyclohexényle, un groupe cycloheptényle, un groupe bicyclo[1.1.l]pentyle, un groupe bicyclo[2.1.1]hexyle, un groupe bicyclo[2.2.1]heptyle, un groupe bicyclo[2.2.2]octyle, un groupe ($C_1$-$C_{20}$ alkyl)cyclopentyle, un groupe ($C_1$-$C_{20}$ alkyl)cyclohexyle, un groupe ($C_1$-$C_{20}$ alkyl)cycloheptyle, un groupe ($C_1$-$C_{20}$ alkyl)cyclooctyle, un groupe ($C_1$-$C_{20}$ alkyl)adamantanyle, un groupe ($C_1$-$C_{20}$ alkyl)norbornanyle, un groupe ($C_1$-$C_{20}$ alkyl)norbornényle, un groupe ($C_1$-$C_{20}$ alkyl)cyclopentényle, un groupe ($C_1$-$C_{20}$ alkyl)cyclohexényle, un groupe ($C_1$-$C_{20}$ alkyl)cycloheptényle, un groupe ($C_1$-$C_{20}$ alkyl)bicyclo[1.1.1]pentyle, un groupe ($C_1$-$C_{20}$ alkyl)bicyclo[2.1.1]hexyle, un groupe ($C_1$-$C_{20}$ alkyl)bicyclo[2.2.1]heptyle, un groupe ($C_1$-$C_{20}$ alkyl)bicyclo[2.2.2]octyle, un groupe phényle, un groupe ($C_1$-$C_{20}$ alkyl)phényle, un groupe biphényle, un groupe terphényle, un groupe naphtyle, un groupe fluorényle, un groupe phénanthrényle, un groupe anthracényle, un groupe fluoranthényle, un groupe triphénylényle, un groupe pyrényle, un groupe chrysényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un

groupe isoquinolinyle, un groupe benzoquinolinyle, un groupe quinoxalinyle, un groupe quinazolinyle, un groupe cinnolinyle, un groupe carbazolyle, un groupe phénanthrolinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe benzocarbazolyle, un groupe dibenzocarbazolyle, un groupe imidazopyridinyle, un groupe imidazopyrimidinyle, un groupe azacarbazolyle, un groupe azadibenzofuranyle, un groupe azadibenzothiophényle, ou toute combinaison de ceux-ci ; ou
$-N(Q_1)(Q_2)$, $-Si(Q_3)(Q_4)(Q_5)$, $-Ge(Q_3)(Q_4)(Q_5)$, $-B(Q_6)(Q_7)$, $-P(=O)(Q_8)(Q_9)$ ou $-P(Q_8)(Q_9)$, et $Q_1$ à $Q_9$ représentant chacun indépendamment :

$-CH_3$, $-CD_3$, $-CD_2H$, $-CDH_2$, $-CH_2CH_3$, $-CH_2CD_3$, $-CH_2CD_2H$, $-CH_2CDH_2$, $-CHDCH_3$, $-CHDCD_2H$, $-CHDCDH_2$, $-CHDCD_3$, $-CD_2CD_3$, $-CD_2CD_2H$ ou $-CD_2CDH_2$ ; ou
un groupe n-propyle, un groupe iso-propyle, un groupe n-butyle, un groupe sec-butyle, un groupe isobutyle, un groupe tert-butyle, un groupe n-pentyle, un groupe tert-pentyle, un groupe néo-pentyle, un groupe iso-pentyle, un groupe sec-pentyle, un groupe 3-pentyle, un groupe sec-iso-pentyle, un groupe phényle, un groupe biphényle ou un groupe naphtyle, chacun non substitué ou substitué par un atome de deutérium, un groupe $C_1$-$C_{10}$ alkyle, un groupe phényle, ou toute combinaison de ceux-ci.

**5.** Composé organométallique selon l'une quelconque des revendications 1 à 4, un groupe représenté par

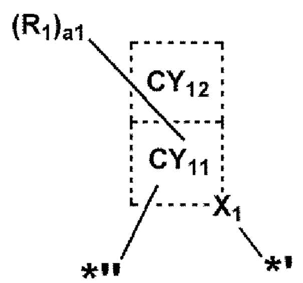

dans la formule 2 étant un groupe représenté par l'une des formules CY1-1 à CY1-69 :

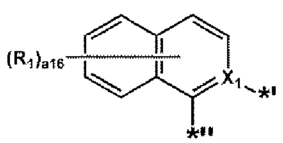
CY1-1

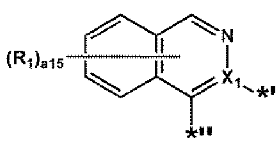
CY1-2

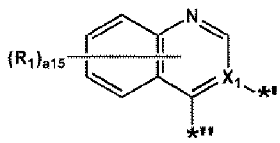
CY1-3

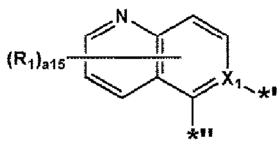
CY1-4

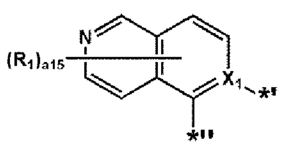
CY1-5

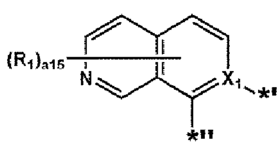
CY1-6

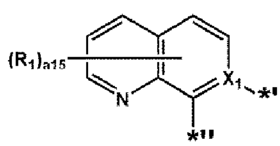
CY1-7

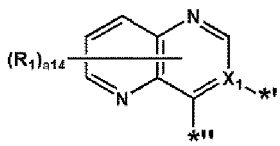
CY1-8

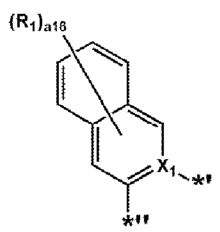
CY1-9

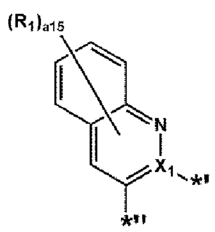
CY1-10

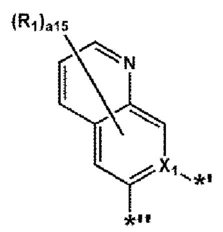
CY1-11

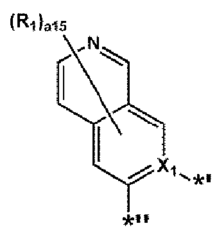
CY1-12

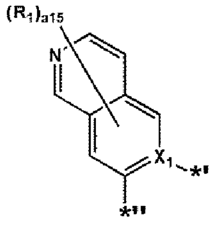
CY1-13

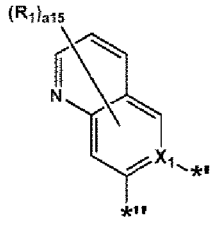
CY1-14

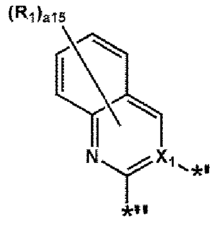
CY1-15

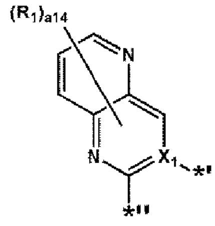
CY1-16

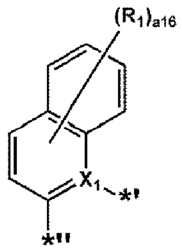
CY1-17

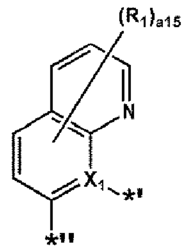
CY1-18

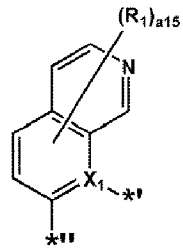
CY1-19

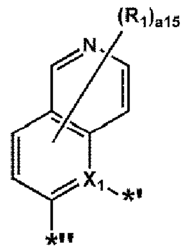
CY1-20

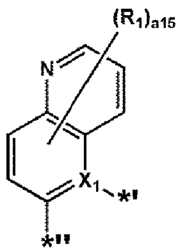
CY1-21

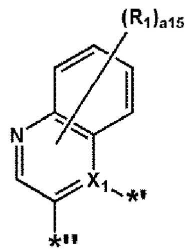
CY1-22

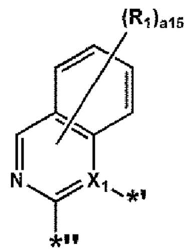
CY1-23

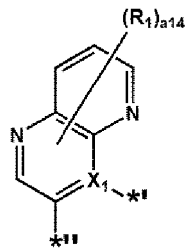
CY1-24

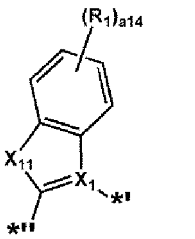
CY1-25

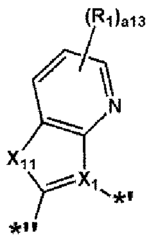
CY1-26

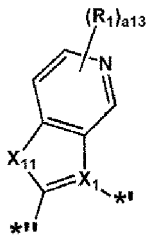
CY1-27

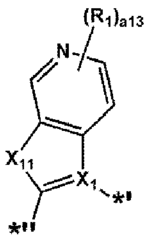
CY1-28

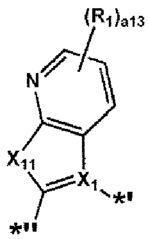
CY1-29

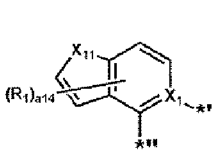
CY1-30

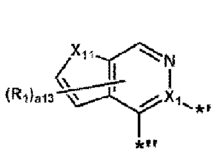
CY1-31

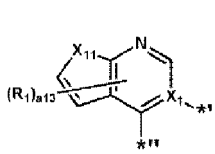
CY1-32

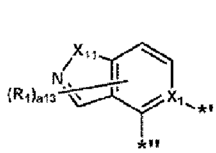
CY1-33

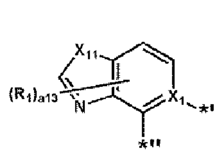
CY1-34

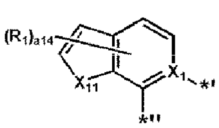
CY1-35

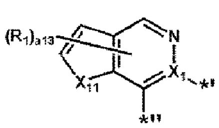
CY1-36

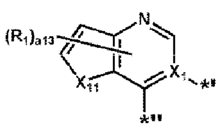
CY1-37

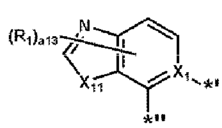
CY1-38

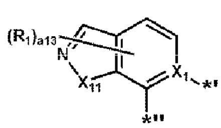
CY1-39

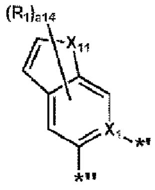
CY1-40

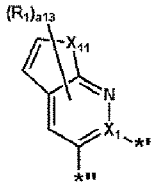
CY1-41

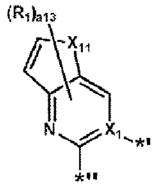
CY1-42

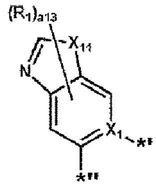
CY1-43

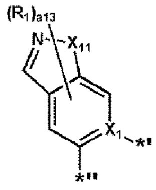
CY1-44

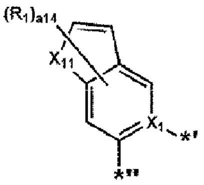
CY1-45

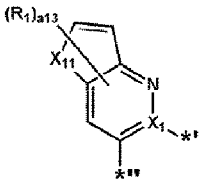
CY1-46

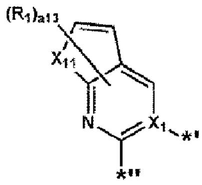
CY1-47

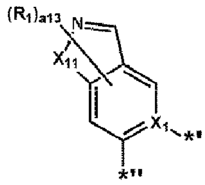
CY1-48

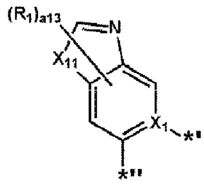
CY1-49

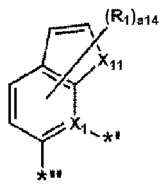
CY1-50

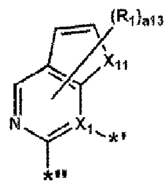
CY1-51

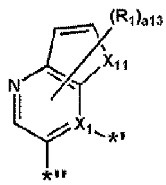
CY1-52

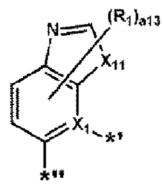
CY1-53

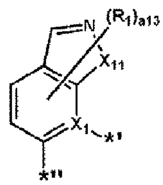
CY1-54

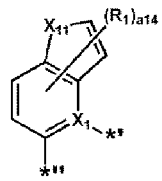
CY1-55

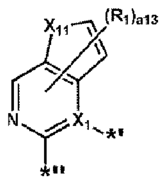
CY1-56

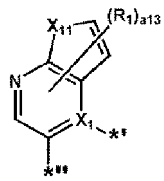
CY1-57

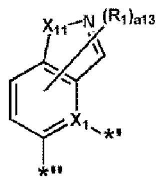
CY1-58

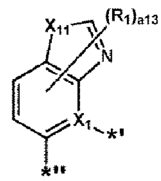
CY1-59

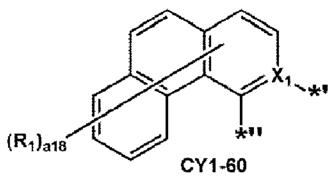
CY1-60

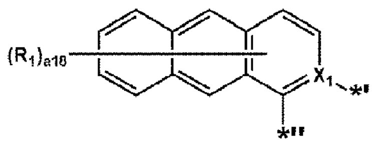
CY1-61

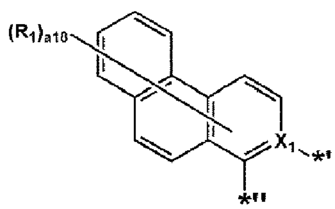
CY1-62

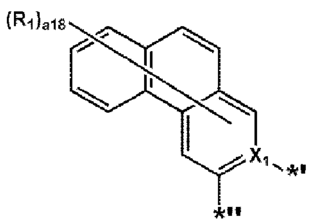
CY1-63

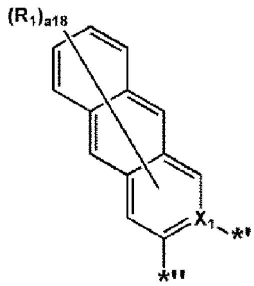
CY1-64

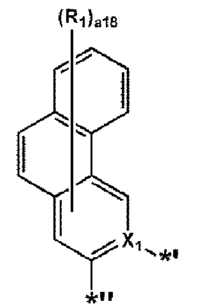
CY1-65

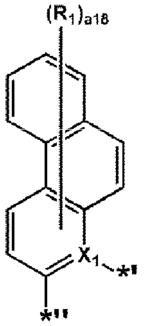
CY1-66

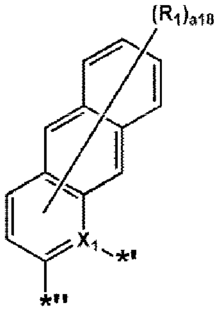
CY1-67

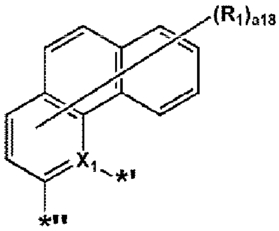
CY1-68

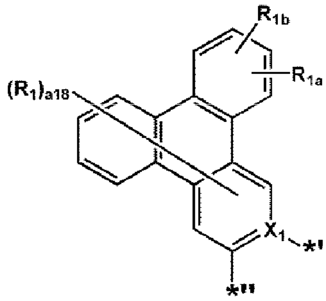
CY1-69

,

dans lesquelles, dans les formules CY1-1 à CY1-69,

$X_1$ et $R_1$ sont chacun identiques à ceux définis dans la revendication 1,
$X_{11}$ représente un atome O, S, Se, un groupe $N(R_{19})$, $C(R_{19a})(R_{19b})$ ou $Si(R_{19a})(R_{19b})$,
$R_{19}$, $R_{19a}$, $R_{19b}$, Ria et $R_{1b}$ sont chacun identiques à ceux définis en lien avec $R_1$ dans la revendication 1,
a18 représente un entier allant de 0 à 8,
a16 représente un entier allant de 0 à 6,
a15 représente un entier allant de 0 à 5,
a14 représente un entier allant de 0 à 4,
a13 représente un entier allant de 0 à 3,
*" indique un site de liaison à $T_1$ dans la formule 2, et
*' indique un site de liaison à M dans la formule 1.

**6.** Composé organométallique selon l'une quelconque des revendications 1 à 5, un groupe représenté par

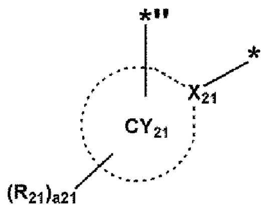

dans la formule 2 étant un groupe représenté par l'une des formules CY21-1 à CY21-25 :

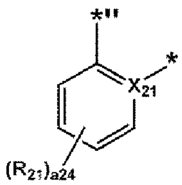
CY21-1

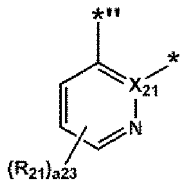
CY21-2

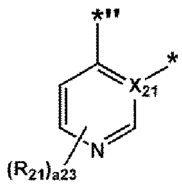
CY21-3

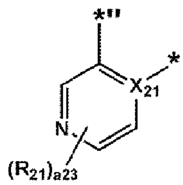
CY21-4

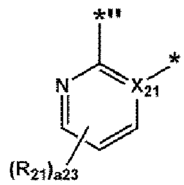
CY21-5

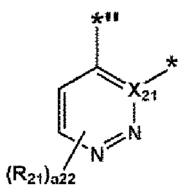
CY21-6

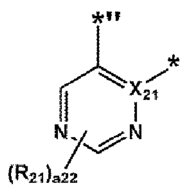
CY21-7

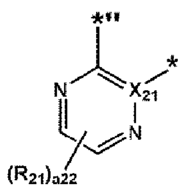
CY21-8

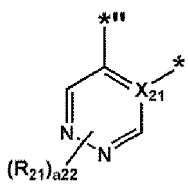
CY21-9

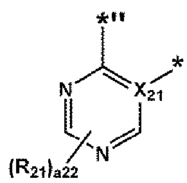
CY21-10

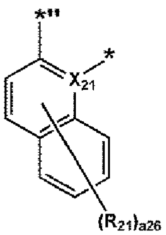
CY21-11

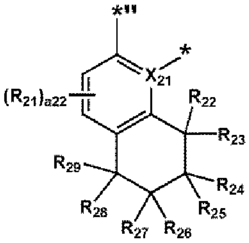
CY21-12

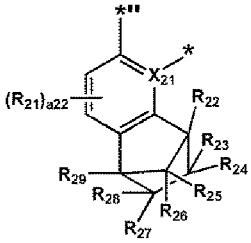
CY21-13

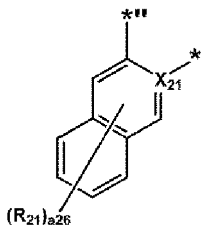
CY21-14

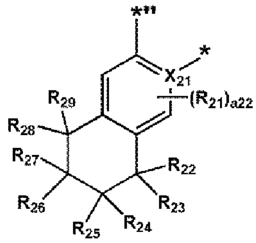
CY21-15

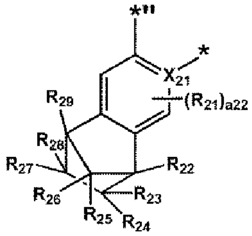
CY21-16

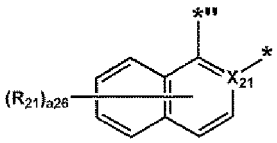
CY21-17

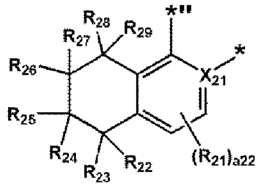
CY21-18

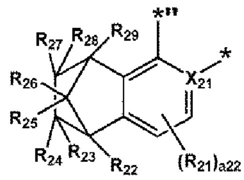
CY21-19

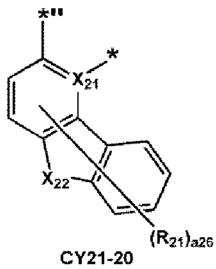
CY21-20

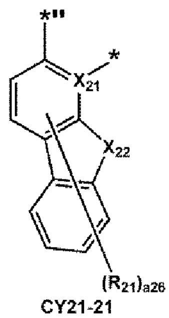
CY21-21

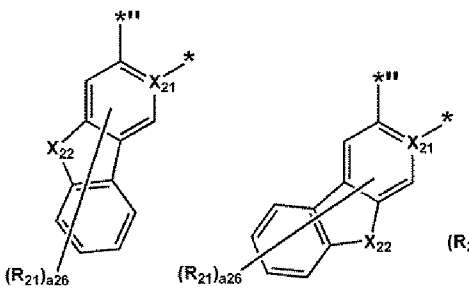
CY21-22

CY21-23

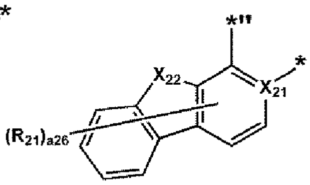
CY21-24

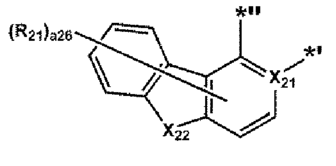
CY21-25

,

dans lesquelles, dans les formules CY21-1 à CY21-25,

$X_{21}$ et $R_{21}$ sont chacun identiques à ceux définis dans la revendication 1,
X22 représente un groupe $C(R_{22})(R_{23})$, N(R22), un atome O, S, ou un groupe Si(R22)(R23),
$R_{22}$ et $R_{29}$ sont chacun identiques à ceux définis en lien avec $R_{21}$ dans la revendication 1,
a26 représente un entier allant de 0 à 6,
a24 représente un entier allant de 0 à 4,
a23 représente un entier allant de 0 à 3,
a22 représente un entier allant de 0 à 2,
*" indique un site de liaison à $T_1$ dans la formule 2, et
*' indique un site de liaison à M dans la formule 1 ;
de préférence un groupe représenté par

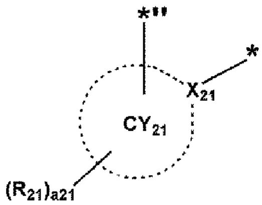

dans la formule 2 étant un groupe représenté par l'une des formules CY21(1) à CY21(56) et des formules CY21-20 à CY21-25 :

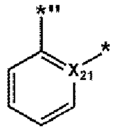
CY21(1)

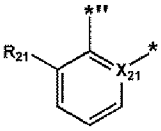
CY21(2)

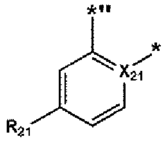
CY21(3)

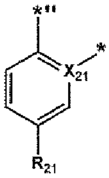
CY21(4)

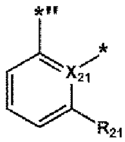
CY21(5)

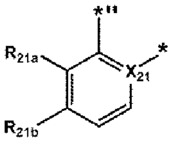
CY21(6)

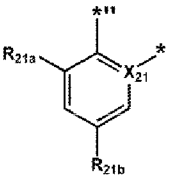
CY21(7)

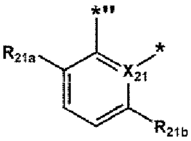
CY21(8)

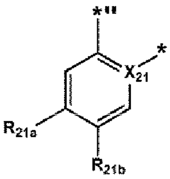
CY21(9)

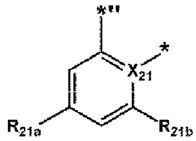
CY21(10)

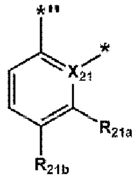
CY21(11)

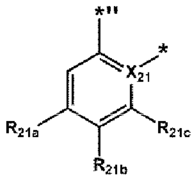
CY21(12)

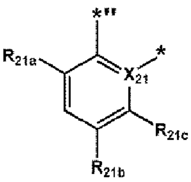
CY21(13)

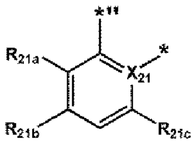
CY21(14)

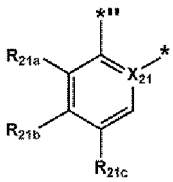
CY21(15)

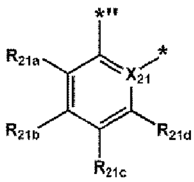
CY21(16)

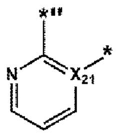
CY21(17)

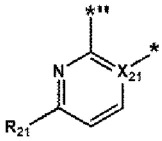
CY21(18)

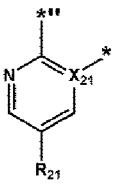
CY21(19)

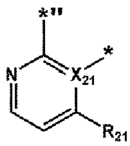
CY21(20)

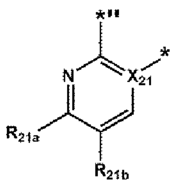
CY21(21)

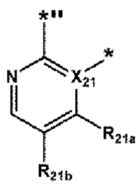
CY21(22)

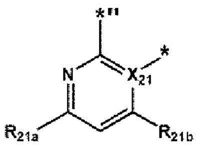
CY21(23)

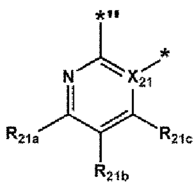
CY21(24)

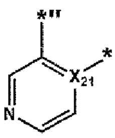
CY21(25)

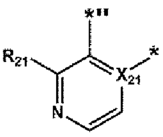
CY21(26)

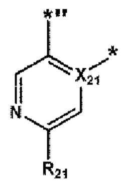
CY21(27)

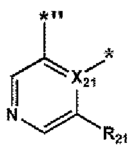
CY21(28)

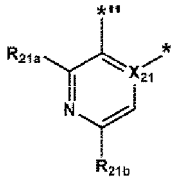
CY21(29)

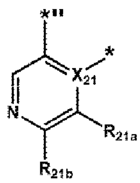
CY21(30)

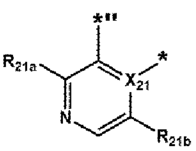
CY21(31)

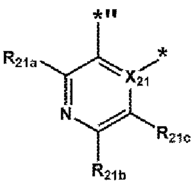
CY21(32)

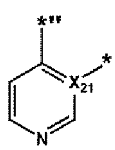
CY21(33)

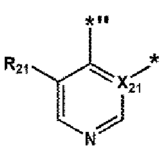
CY21(34)

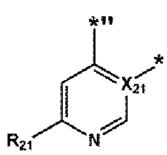
CY21(35)

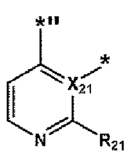
CY21(36)

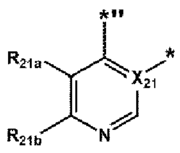
CY21(37)

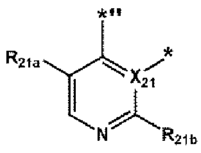
CY21(38)

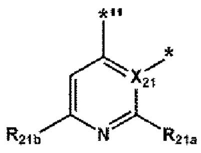
CY21(39)

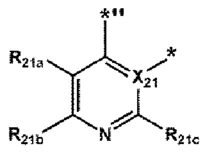
CY21(40)

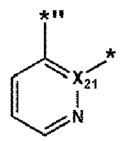
CY21(41)

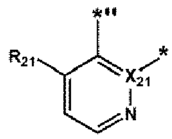
CY21(42)

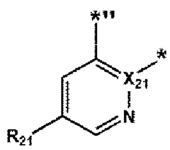
CY21(43)

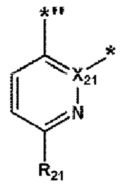
CY21(44)

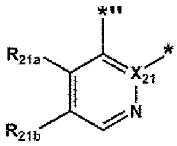
CY21(45)

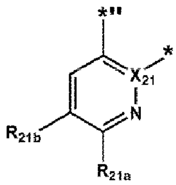
CY21(46)

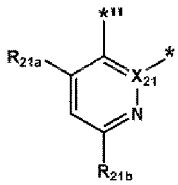
CY21(47)

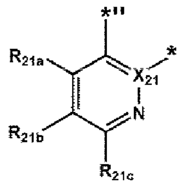
CY21(48)

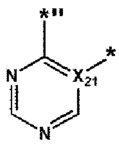
CY21(49)

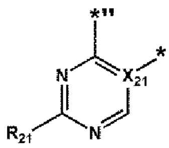
CY21(50)

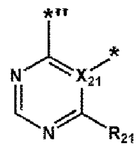
CY21(51)

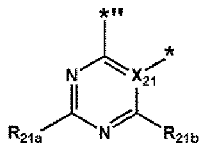
CY21(52)

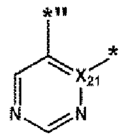
CY21(53)

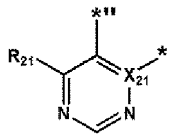
CY21(54)

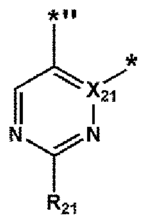
CY21(55)

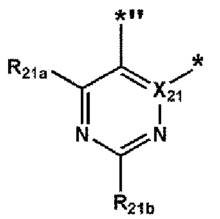
CY21(56)

,

dans lesquelles, dans les formules CY21(1) à CY21(56),

$X_{21}$ et $R_{21}$ sont chacun identiques à ceux définis dans la revendication 1
$R_{21a}$ à $R_{21d}$ sont chacun identiques à ceux définis en lien avec $R_{21}$ dans la revendication 1, chacun des groupes $R_{21}$ et $R_{21a}$ à $R_{21d}$ ne représentant pas un atome d'hydrogène,
*" indique un site de liaison à $T_1$ dans la formule 2, et
*' indique un site de liaison à M dans la formule 1.

7. Composé organométallique selon l'une quelconque des revendications 1 à 6, $L_2$ dans la formule 1 représentant un ligand bidenté chacun lié à M dans la formule 1 via un atome O, S, Se, N, C, P, Si ou As.

8. Composé organométallique selon l'une quelconque des revendications 1 à 6,

$L_2$ dans la formule 1 étant un ligand bidenté représenté par la formule 3

<Formule 3>

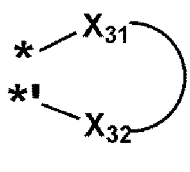

,

dans laquelle, dans la formule 3, $X_{31}$ et $X_{32}$ représentent chacun indépendamment un atome O, S, Se ou N,

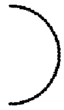

indique un groupe de liaison liant $X_{31}$ et $X_{32}$ ensemble, et

* et *' indique chacun un site de liaison à M dans la formule 1.

**9.** Composé organométallique selon l'une quelconque des revendications 1 à 6, $L_2$ dans la formule 1 étant un groupe représenté par l'une des formules 3A à 3F :

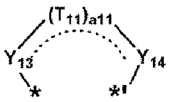

3A

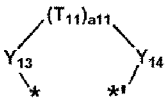

3B

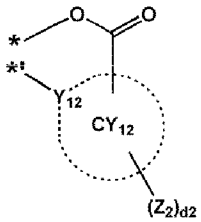

3C

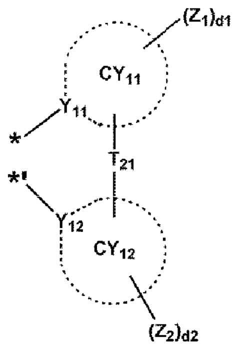

3D

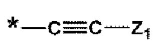

3E

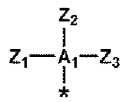

3F ,

dans laquelle, dans les formules 3A à 3F,

$Y_{13}$ représente un atome O, N, un groupe $N(Z_1)$, $P(Z_1)(Z_2)$ ou $AS(Z_1)(Z_2)$,
$Y_{14}$ représente un atome O, N, un groupe $N(Z_3)$, $P(Z_3)(Z_4)$ ou $AS(Z_3)(Z_4)$,
$T_{11}$ représente une liaison simple, une liaison double, un groupe $*-C(Z_{11})(Z_{12})-*'$, $*-C(Z_{11})=C(Z_{12})-*'$, $*=C(Z_{11})-*'$, $*-C(Z_{11})=*'$, $*=C(Z_{11})-C(Z_{12})=C(Z_{13})-*'$, $*-C(Z_{11})=C(Z_{12})-C(Z_{13})=*'$, $*-N(Z_{11})-*'$, ou un groupe carbocyclique en $C_5$ à $C_{30}$ non substitué ou substitué par au moins un groupe $Z_{11}$,
a11 représente un entier allant de 1 à 10, lorsque a11 vaut 2 ou plus, deux groupes $T_{11}$ ou plus sont identiques les uns aux autres ou différents les uns des autres,
$Y_{11}$ et $Y_{12}$ représentent chacun indépendamment un atome C ou N,
$T_{21}$ représente une liaison simple, un double os, un atome O, S, un groupe $C(Z_{11})(Z_{12})$, $Si(Z_{11})(Z_{12})$ ou $N(Z_{11})$,
le noyau $CY_{11}$ et le noyau $CY_{12}$ représentent chacun indépendamment un groupe carbocyclique en $C_5$ à $C_{30}$ ou un groupe hétérocyclique en $C_1$ à $C_{30}$,
$A_1$ représente un atome P ou As,
$Z_1$ à $Z_4$ et $Z_{11}$ à $Z_{13}$ sont chacun les mêmes que ceux définis en lien avec $R_{21}$ dans la revendication 2,
d1 et d2 représentent chacun indépendamment un entier allant de 0 à 10, et
* et *' indiquent chacun un site de liaison à M dans la formule 1.

**10.** Composé organométallique selon l'une quelconque des revendications 1 à 6,
$L_2$ dans la formule 1 étant un groupe représenté par l'une des formules 3-1(1) à 3-1(66) et 3-1(301) à 3-1(309) :

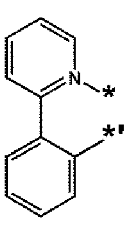

3-1(1)

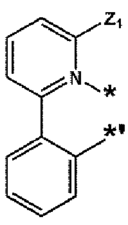

3-1(2)

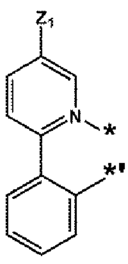

3-1(3)

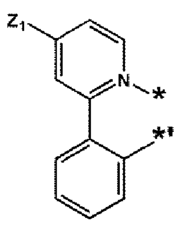

3-1(4)

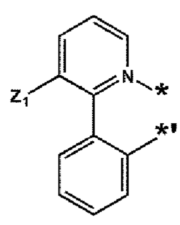

3-1(5)

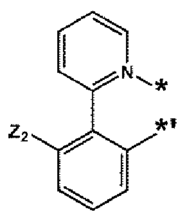
3-1(6)

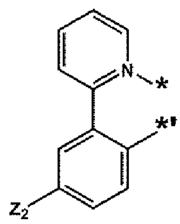
3-1(7)

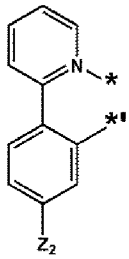
3-1(8)

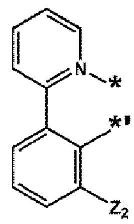
3-1(9)

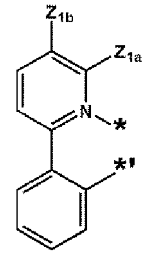
3-1(10)

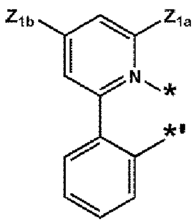
3-1(11)

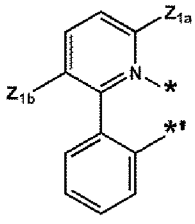
3-1(12)

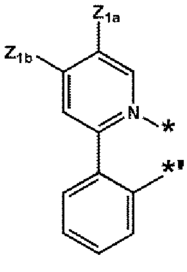
3-1(13)

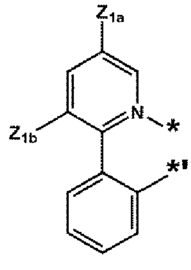
3-1(14)

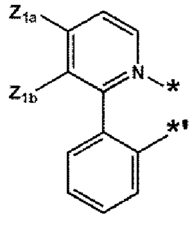
3-1(15)

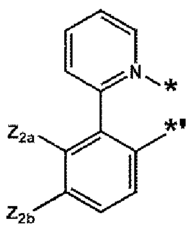
3-1(16)

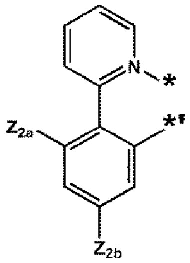
3-1(17)

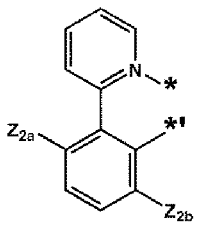
3-1(18)

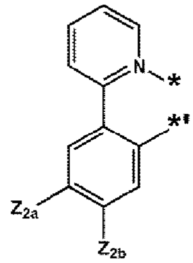
3-1(19)

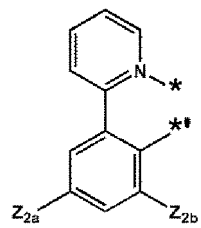
3-1(20)

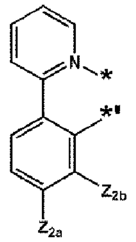
3-1(21)

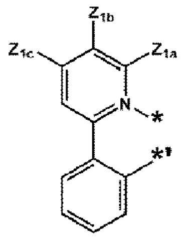
3-1(22)

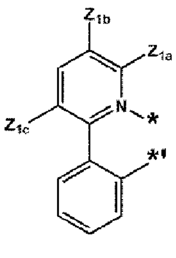
3-1(23)

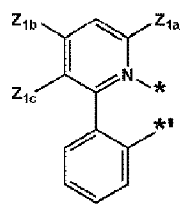
3-1(24)

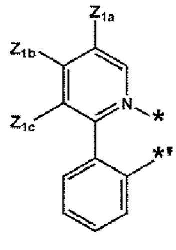
3-1(25)

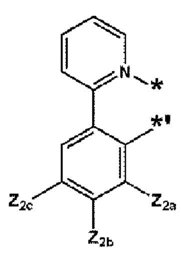
3-1(26)

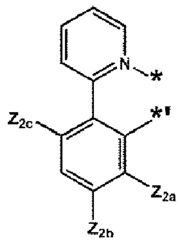
3-1(27)

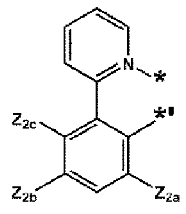
3-1(28)

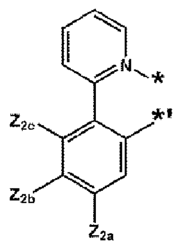
3-1(29)

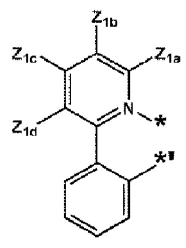
3-1(30)

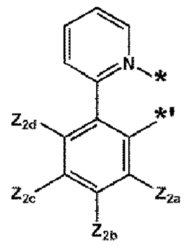
3-1(31)

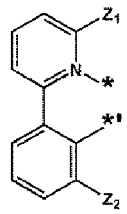
3-1(32)

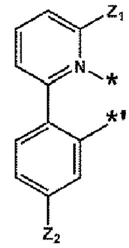
3-1(33)

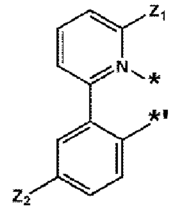
3-1(34)

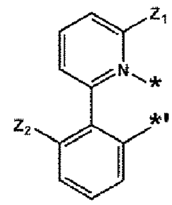
3-1(35)

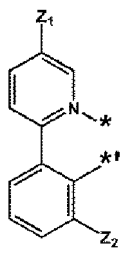
3-1(36)

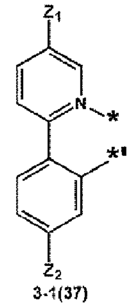
3-1(37)

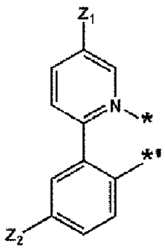
3-1(38)

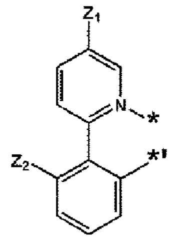
3-1(39)

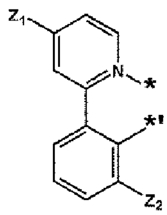
3-1(40)

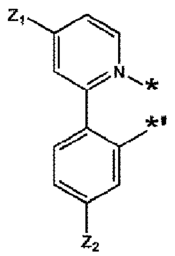
3-1(41)

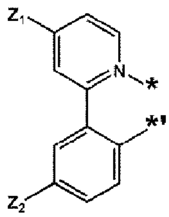
3-1(42)

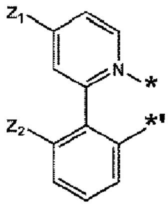
3-1(43)

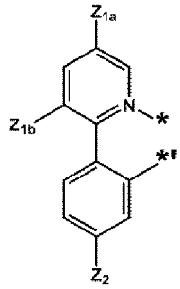
3-1(44)

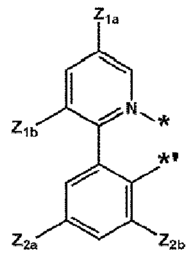
3-1(45)

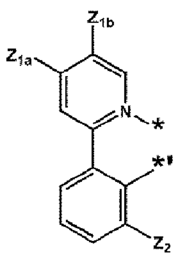
3-1(46)

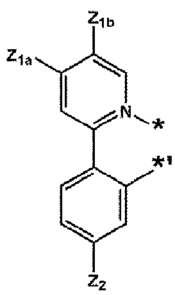
3-1(47)

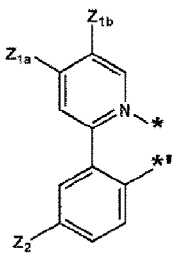
3-1(48)

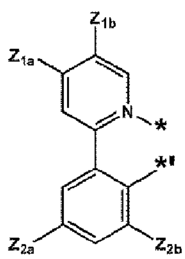
3-1(49)

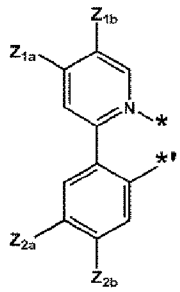
3-1(50)

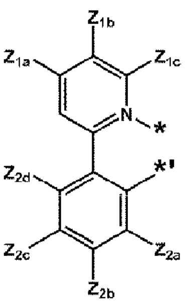
3-1(51)

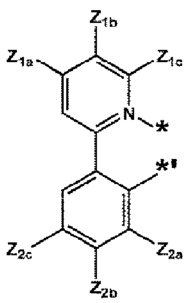
3-1(52)

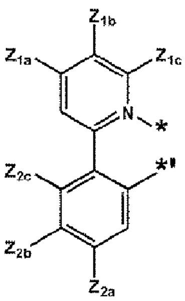
3-1(53)

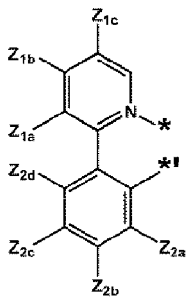
3-1(54)

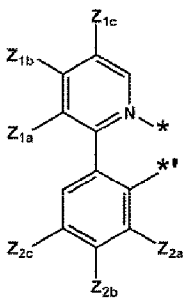
3-1(55)

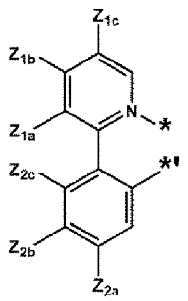
3-1(56)

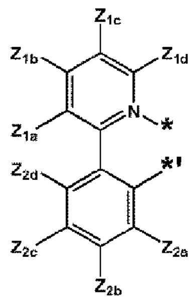
3-1(57)

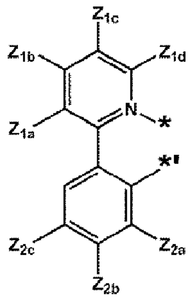
3-1(58)

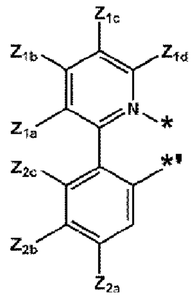
3-1(59)

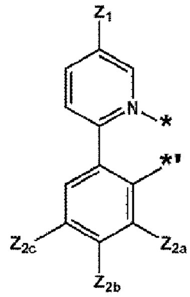
3-1(60)

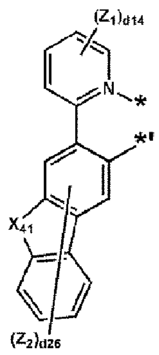
3-1(61)

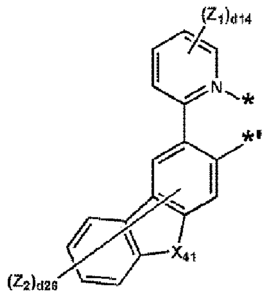
3-1(62)

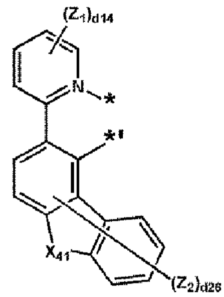
3-1(63)

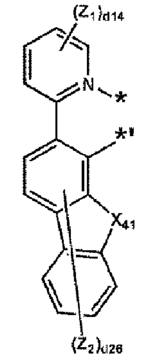
3-1(64)

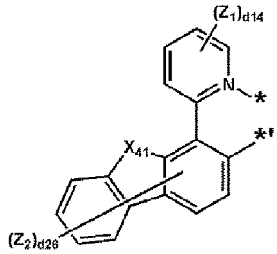
3-1(65)

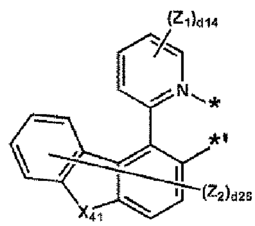
3-1(66)

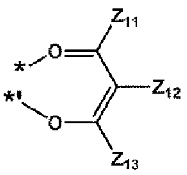
3-1(301)

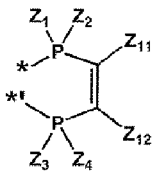
3-1(302)

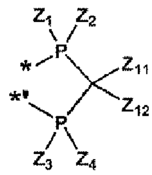
3-1(303)

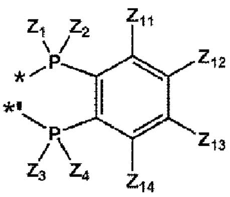
3-1(304)

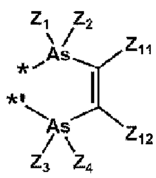
3-1(305)

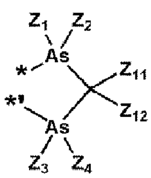
3-1(306)

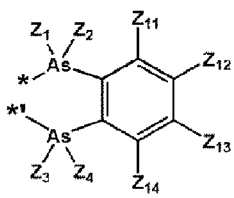
3-1(307)

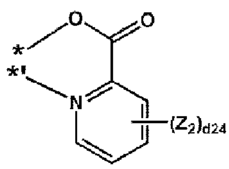
3-1(308)

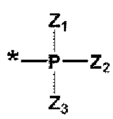
3-1(309)

,

dans lesquelles, dans les formules 3-1 (1) à 3-1 (66) et 3-1 (301) à 3-1 (309),

$X_{41}$ représente un atome O, S, un groupe $N(Z_{21})$, $C(Z_{21})(Z_{22})$ ou $Si(Z_{21})(Z_{22})$,
$Z_1$ à $Z_4$, $Z_{1a}$, $Z_{1b}$, $Z_{1c}$, $Z_{1d}$, $Z_{2a}$, $Z_{2b}$, $Z_{2c}$, $Z_{2d}$, et $Z_{11}$ à $Z_{14}$ sont chacun les mêmes que ceux définis en lien avec $R_{21}$ dans la revendication 1,
d14 représente un entier allant de 0 à 4,
d26 représente un entier allant de 0 à 6, et
* et *' indiquent chacun un site de liaison à M dans la formule 1.

**11.** Composé organométallique selon l'une quelconque des revendications 1 à 6, $L_2$ dans la formule 1 étant un groupe représenté par la formule 3-1-1 :

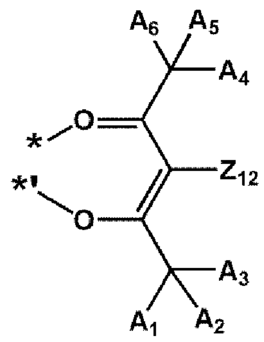

3-1-1 ?

dans laquelle, dans la formule 3-1-1,

$Z_{12}$ est le même que celui défini en lien avec $R_{21}$ dans la revendication 1,
$A_2$ et $A_5$ représentent chacun indépendamment un atome d'hydrogène, un atome de deutérium, un groupe $C_1$-$C_{60}$ alkyle substitué ou non substitué, un groupe $C_2$-$C_{60}$ alcényle substitué ou non substitué, un groupe $C_2$-$C_{60}$ alcynyle substitué ou non substitué, un groupe $C_1$-$C_{60}$ alcoxy substitué ou non substitué, un groupe $C_3$-$C_{10}$ cycloalkyle substitué ou non substitué, un groupe $C_1$-$C_{10}$ hétérocycloalkyle substitué ou non substitué, un groupe $C_3$-$C_{10}$ cycloalcényle substitué ou non substitué, un groupe $C_1$-$C_{10}$ hétérocycloalcényle substitué ou non substitué, un groupe $C_6$-$C_{60}$ aryle substitué ou non substitué, un groupe $C_6$-$C_{60}$ aryloxy substitué ou non substitué, un groupe $C_6$-$C_{60}$ arylthio substitué ou non substitué, un groupe $C_1$-$C_{60}$ hétéroaryle substitué ou non substitué, un groupe polycyclique condensé non aromatique monovalent substitué ou non substitué, ou un groupe hétéropolycyclique condensé non aromatique monovalent substitué ou non substitué,
$A_1$, $A_3$, $A_4$ et $A_6$ représentent chacun indépendamment un groupe $C_1$-$C_{60}$ alkyle substitué ou non substitué, un groupe $C_2$-$C_{60}$ alcényle substitué ou non substitué, un groupe $C_2$-$C_{60}$ alcynyle substitué ou non substitué, un groupe $C_1$-$C_{60}$ alcoxy substitué ou non substitué, un groupe $C_3$-$C_{10}$ cycloalkyle substitué ou non substitué, un groupe $C_1$-$C_{10}$ hétérocycloalkyle substitué ou non substitué, un groupe $C_3$-$C_{10}$ cycloalcényle substitué ou non substitué, un groupe $C_1$-$C_{10}$ hétérocycloalcényle substitué ou non substitué, un groupe $C_6$-$C_{60}$ aryle substitué ou non substitué, un groupe $C_6$-$C_{60}$ aryloxy substitué ou non substitué, un groupe $C_6$-$C_{60}$ arylthio substitué ou non substitué, un groupe $C_1$-$C_{60}$ hétéroaryle substitué ou non substitué, un groupe polycyclique condensé non aromatique monovalent substitué ou non substitué, ou un groupe hétéropolycyclique condensé non aromatique monovalent substitué ou non substitué,
deux groupes ou plus parmi $A_1$ à $A_6$ sont éventuellement liés pour former un groupe carbocyclique en $C_5$ à $C_{30}$ non substitué ou substitué par au moins un groupe Ria ou un groupe hétérocyclique en $C_1$ à $C_{30}$ non substitué ou substitué par au moins un groupe $R_{1a}$,
Ria est le même que celui défini en lien avec $Z_{12}$,
un ou des substituants parmi le groupe $C_1$-$C_{60}$ alkyle substitué, le groupe $C_2$-$C_{60}$ alcényle substitué, le groupe $C_2$-$C_{60}$ alcynyle substitué, le groupe $C_1$-$C_{60}$ alcoxy substitué, le groupe $C_3$-$C_{10}$ cycloalkyle substitué, le groupe $C_1$-$C_{10}$ hétérocycloalkyle substitué, le groupe $C_3$-$C_{10}$ cycloalcényle substitué, le groupe $C_1$-$C_{10}$ hétérocycloalcényle substitué, le groupe $C_6$-$C_{60}$ aryle substitué, le groupe $C_6$-$C_{60}$ aryloxy substitué, le groupe $C_6$-$C_{60}$ arylthio substitué, le groupe $C_1$-$C_{60}$ hétéroaryle substitué, le groupe polycyclique condensé non aromatique monovalent substitué, et le groupe hétéropolycyclique condensé non aromatique monovalent substitué est :

un atome de deutérium, un groupe -F, -Cl, -Br, -I, $-CD_3$, $-CD_2H$, $-CDH_2$, $-CF_3$, $-CF_2H$, $-CFH_2$, un groupe hydroxy, un groupe cyano, un groupe nitro, un groupe amino, un groupe amidino, un groupe hydrazino, un

groupe hydrazono, un groupe acide carboxylique ou un sel de celui-ci, un groupe acide sulfonique ou un sel de celui-ci, un groupe acide phosphorique ou un sel de celui-ci, un groupe $C_1$-$C_{60}$ alkyle, un groupe $C_2$-$C_{60}$ alcényle, un groupe $C_2$-$C_{60}$ alcynyle, ou un groupe $C_1$-$C_{60}$ alcoxy

un groupe $C_1$-$C_{60}$ alkyle, un groupe $C_2$-$C_{60}$ alcényle, un groupe $C_2$-$C_{60}$ alcynyle, ou un groupe $C_1$-$C_{60}$ alcoxy, chacun substitué par un atome de deutérium, un groupe -F, -Cl, -Br, -I, - $CD_3$, $-CD_2H$, $-CDH_2$, $-CF_3$, - $CF_2H$, $-CFH_2$, un groupe hydroxy, un groupe cyano, un groupe nitro, un groupe amino, un groupe amidino, un groupe hydrazino, un groupe hydrazono, un groupe acide carboxylique ou un sel de celui-ci, un groupe acide sulfonique ou un sel de celui-ci, un groupe acide phosphorique ou un sel de celui-ci, un groupe $C_3$-$C_{10}$ cycloalkyle, un groupe $C_1$-$C_{10}$ hétérocycloalkyle, un groupe $C_3$-$C_{10}$ cycloalcényle, un groupe $C_1$-$C_{10}$ hétérocycloalcényle, un groupe $C_6$-$C_{60}$ aryle, un groupe $C_6$-$C_{60}$ aryloxy, un groupe $C_6$-$C_{60}$ arylthio, un groupe $C_1$-$C_{60}$ hétéroaryle, un groupe polycyclique condensé non aromatique monovalent, un groupe hétéropolycyclique condensé non aromatique monovalent, $-N(Q_{11})(Q_{12})$, $-Si(Q_{13})(Q_{14})(Q_{15})$, - $Ge(Q_{13})(Q_{14})(Q_{15})$, $-B(Q_{16})(Q_{17})$, $-P(=O)(Q_{18})(Q_{19})$, $-P(Q_{18})(Q_{19})$, ou toute combinaison de ceux-ci ;

un groupe $C_3$-$C_{10}$ cycloalkyle, un groupe $C_1$-$C_{10}$ hétérocycloalkyle, un groupe $C_3$-$C_{10}$ cycloalcényle, un groupe $C_1$-$C_{10}$ hétérocycloalcényle, un groupe $C_6$-$C_{60}$ aryle, un groupe $C_6$-$C_{60}$ aryloxy, un groupe $C_6$-$C_{60}$ arylthio, un groupe $C_1$-$C_{60}$ hétéroaryle, un groupe polycyclique condensé non aromatique monovalent, ou un groupe hétéropolycyclique condensé non aromatique monovalent, chacun non substitué ou substitué par un atome de deutérium, un groupe -F, -Cl, -Br, -I, $-CD_3$, $-CD_2H$, $-CDH_2$, $-CF_3$, $-CF_2H$, $-CFH_2$, un groupe hydroxy, un groupe cyano, un groupe nitro, un groupe amino, un groupe amidino, un groupe hydrazino, un groupe hydrazono, un groupe acide carboxylique ou un sel de celui-ci, un groupe acide sulfonique ou un sel de celui-ci, un groupe acide phosphorique ou un sel de celui-ci, un groupe $C_1$-$C_{60}$ alkyle, un groupe $C_2$-$C_{60}$ alcényle, un groupe $C_2$-$C_{60}$ alcynyle, un groupe $C_1$-$C_{60}$ alcoxy, un groupe $C_3$-$C_{10}$ cycloalkyle, un groupe $C_1$-$C_{10}$ hétérocycloalkyle, un groupe $C_3$-$C_{10}$ cycloalcényle, un groupe $C_1$-$C_{10}$ hétérocycloalcényle, un groupe $C_6$-$C_{60}$ aryle, un groupe $C_6$-$C_{60}$ aryloxy, un groupe $C_6$-$C_{60}$ arylthio, un groupe $C_1$-$C_{60}$ hétéroaryle, un groupe polycyclique condensé non aromatique monovalent, un groupe hétéropolycyclique condensé non aromatique monovalent, $-N(Q_{21})(Q_{22})$, - $Si(Q_{23})(Q_{24})(Q_{25})$, $-Ge(Q_{23})(Q_{24})(Q_{25})$, $-B(Q_{26})(Q_{27})$, $-P(=O)(Q_{28})(Q_{19})$, $-P(Q_{28})(Q_{29})$, ou toute combinaison de ceux-ci ;

$-N(Q_{31})(Q_{32})$, $-Si(Q_{33})(Q_{34})(Q_{35})$, $-Ge(Q_{33})(Q_{34})(Q_{35})$, $-B(Q_{36})(Q_{37})$, $-P(=O)(Q_{38})(Q_{39})$ ou - $P(Q_{38})(Q_{39})$ ; ou toute combinaison de ceux-ci, et

$Q_{11}$ à $Q_{19}$, $Q_{21}$ à $Q_{29}$, et $Q_{31}$ à $Q_{39}$ représentent chacun indépendamment un atome d'hydrogène ; un atome de deutérium ; un groupe -F ; -Cl ; -Br ; -I ; un groupe hydroxy ; un groupe cyano ; un groupe nitro ; un groupe amidino ; un groupe hydrazine ; un groupe hydrazone ; un groupe acide carboxylique ou un sel de celui-ci ; un groupe acide sulfonique ou un sel de celui-ci ; un groupe acide phosphorique ou un sel de celui-ci ; un groupe $C_1$-$C_{60}$ alkyle non substitué ou substitué par un atome de deutérium, un groupe $C_1$-$C_{60}$ alkyle, un groupe $C_6$-$C_{60}$ aryle ou toute combinaison de ceux-ci ; un groupe $C_2$-$C_{60}$ alcényle ; un groupe $C_2$-$C_{60}$ alcynyle ; un groupe $C_1$-$C_{60}$ alcoxy ; un groupe $C_3$-$C_{10}$ cycloalkyle ; un groupe $C_1$-$C_{10}$ hétérocycloalkyle ; un groupe $C_3$-$C_{10}$ cycloalcényle ; un groupe $C_1$-$C_{10}$ hétérocycloalcényle ; un groupe $C_6$-$C_{60}$ aryle non substitué ou substitué par un atome de deutérium, un groupe $C_1$-$C_{60}$ alkyle, un groupe $C_6$-$C_{60}$ aryle ou toute combinaison de ceux-ci ; un groupe $C_6$-$C_{60}$ aryloxy ; un groupe $C_6$-$C_{60}$ arylthio ; un groupe $C_7$-$C_{60}$ arylalkyle ; un groupe $C_1$-$C_{60}$ hétéroaryle ; un groupe $C_1$-$C_{60}$ hétéroaryloxy ; un groupe $C_1$-$C_{60}$ hétéroarylthio ; un groupe $C_2$-$C_{60}$ hétéroarylalkyle ; un groupe polycyclique condensé non aromatique monovalent ; ou un groupe hétéropolycyclique condensé non aromatique monovalent.

**12.** Composé organométallique selon la revendication 1, ledit composé organométallique étant l'une des composés 1 à 366 :

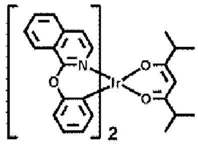
1

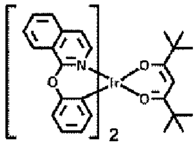
2

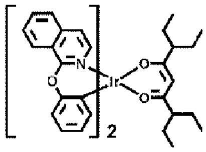
3

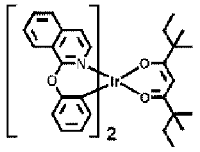
4

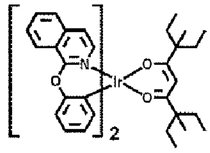
5

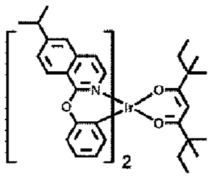
6

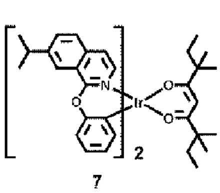
7

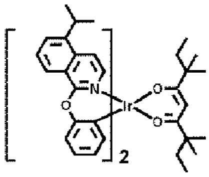
8

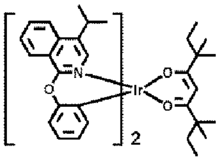
9

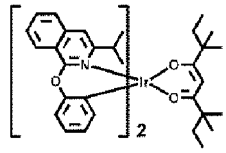
10

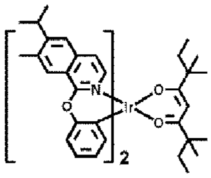
11

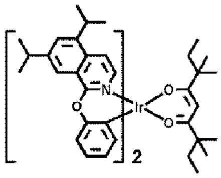
12

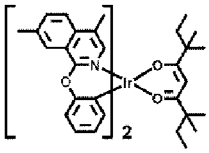
13

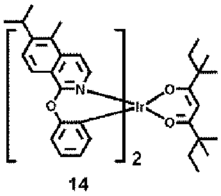
14

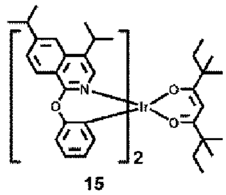
15

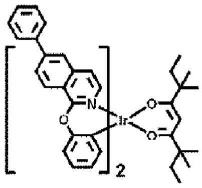
16

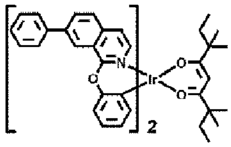
17

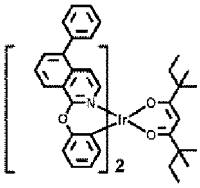
18

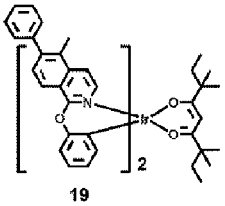
19

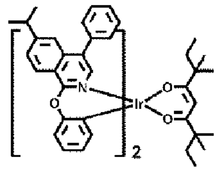
20

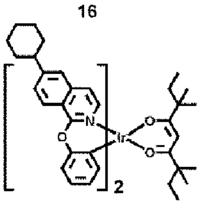
21

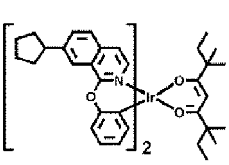
22

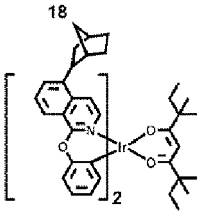
23

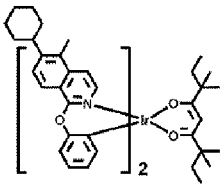
24

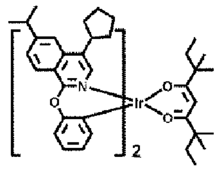
25

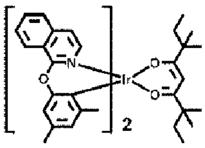
26

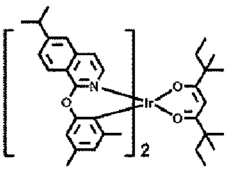
27

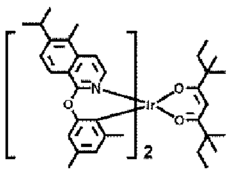
28

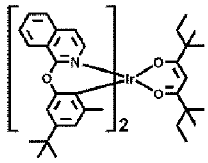
29

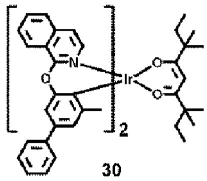
30

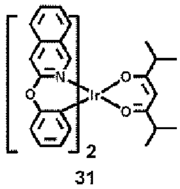
31

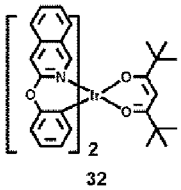
32

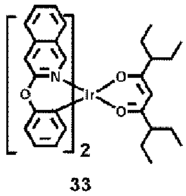
33

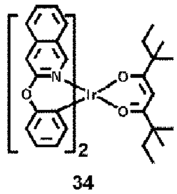
34

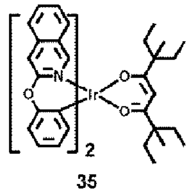
35

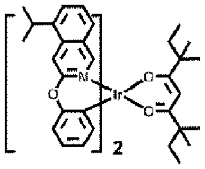
36
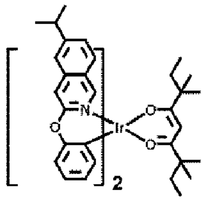
37
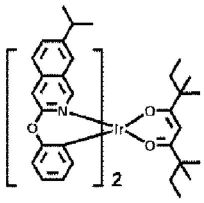
38
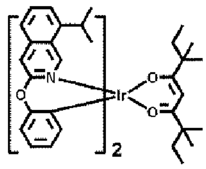
39
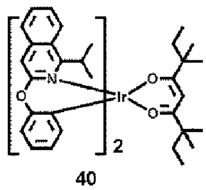
40
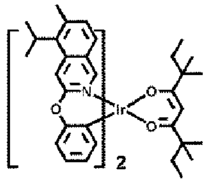
41
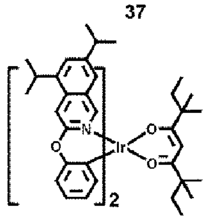
42
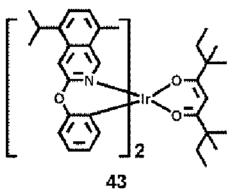
43
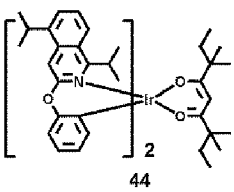
44
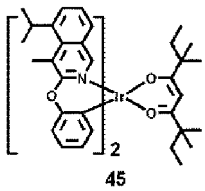
45
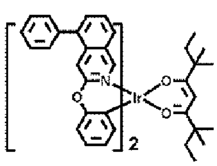
46
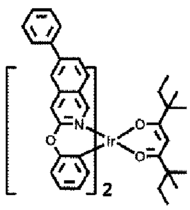
47
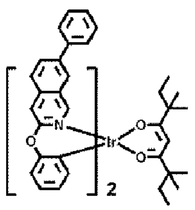
48
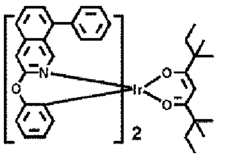
49
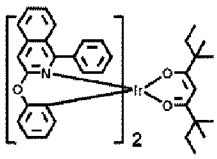
50
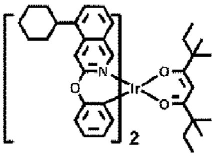
51
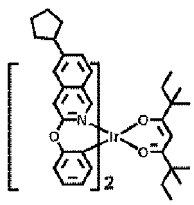
52
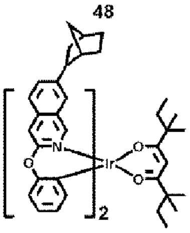
53
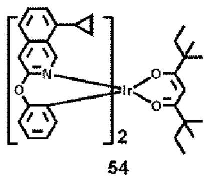
54
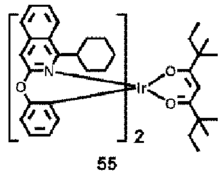
55
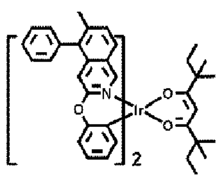
56
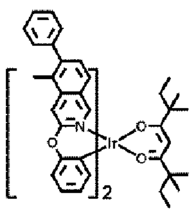
57
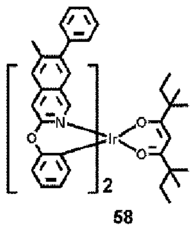
58
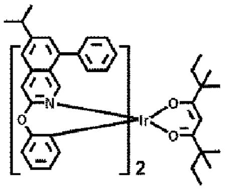
59
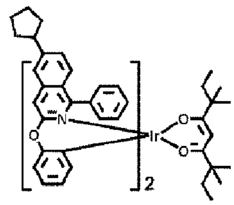
60
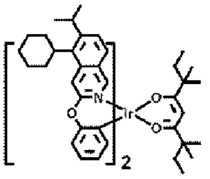
61
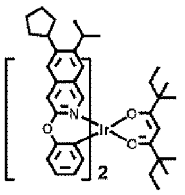
62
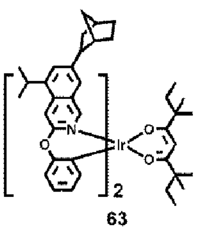
63
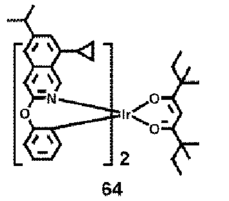
64
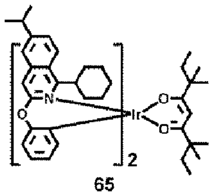
65
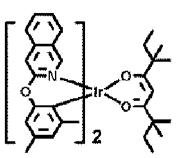
66
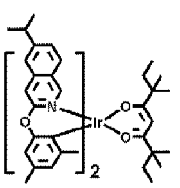
67
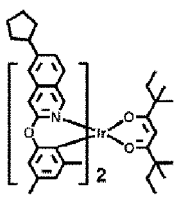
68
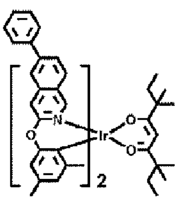
69
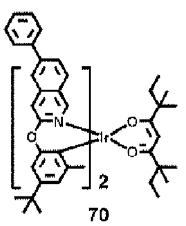
70
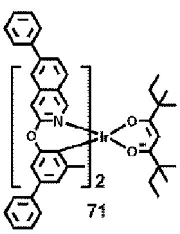
71

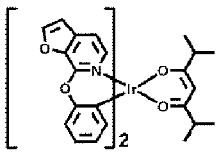
72
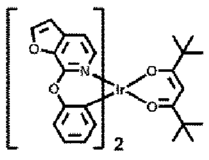
73
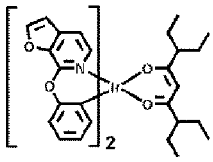
74
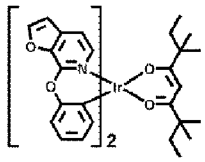
76
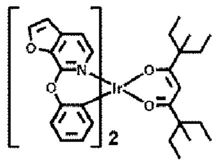
76

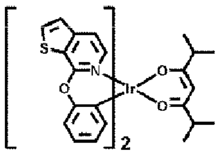
77
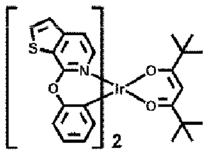
78
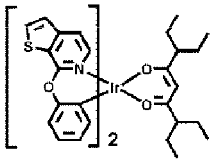
79
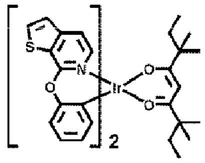
80
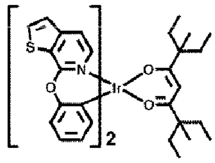
81

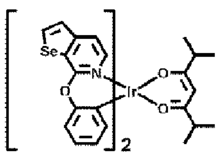
82
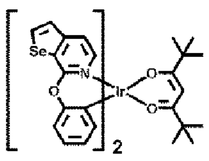
83
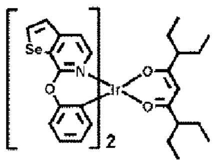
84
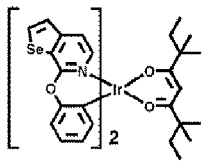
85
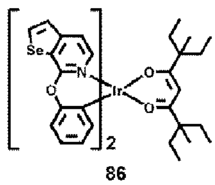
86

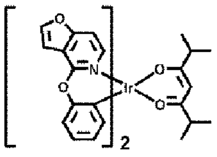
87
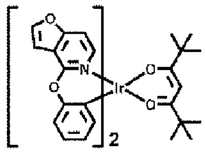
88
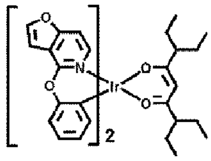
89
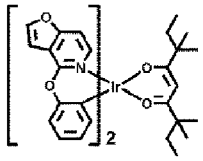
90
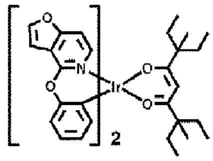
91

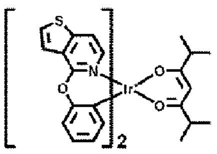
92
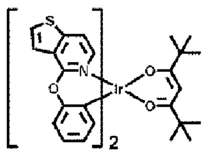
93
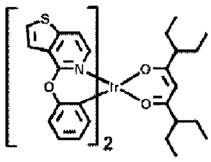
94
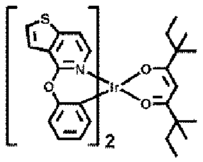
95
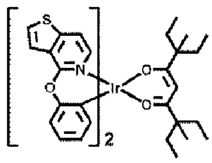
96

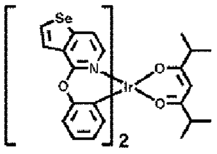
97
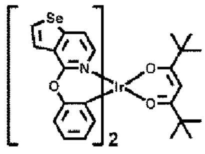
98
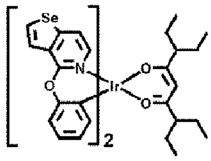
99
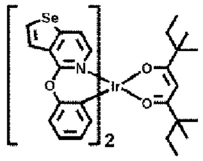
100
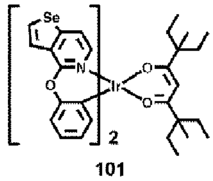
101

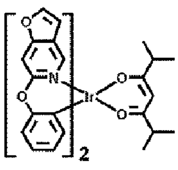
102
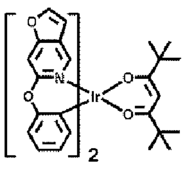
103
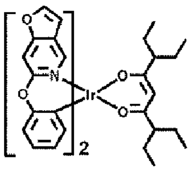
104
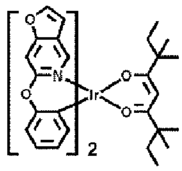
105
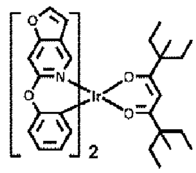
106

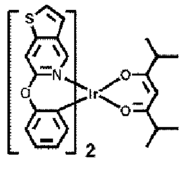
107
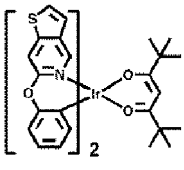
108
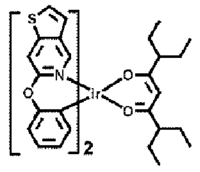
109
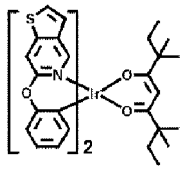
110
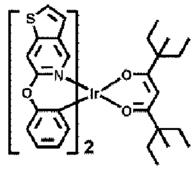
111

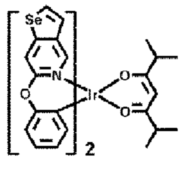
112
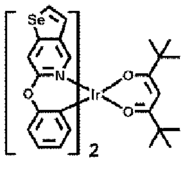
113
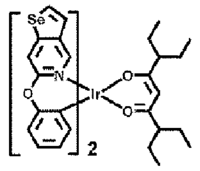
114
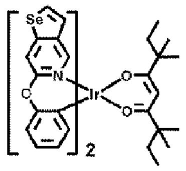
115
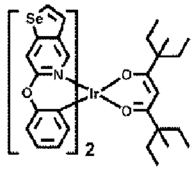
116

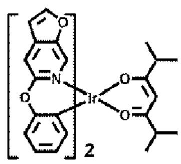
117
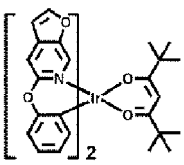
118
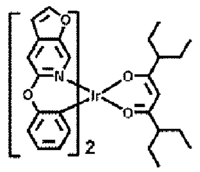
119
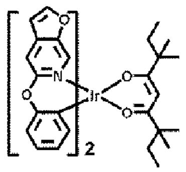
120
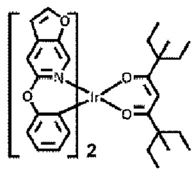
121

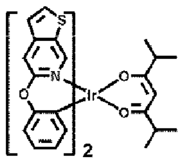
122
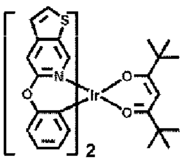
123
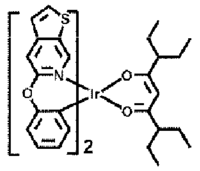
124
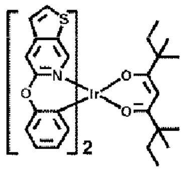
125
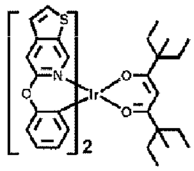
126

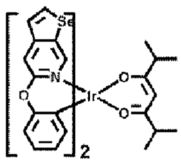
127
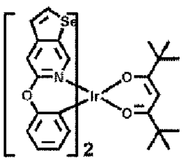
128
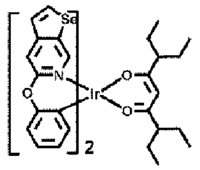
129
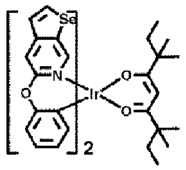
130
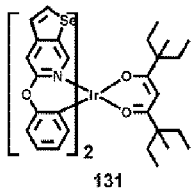
131

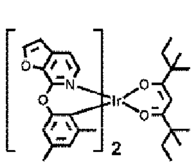
132
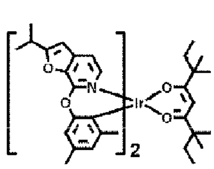
133
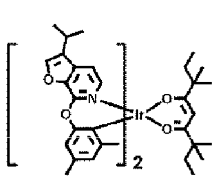
134
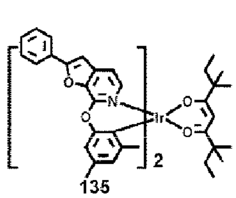
135
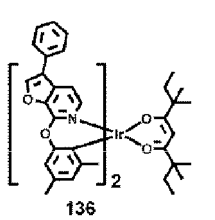
136

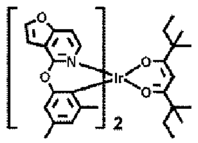
137
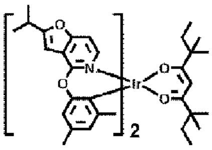
138
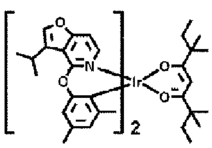
139
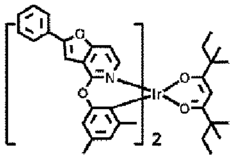
140
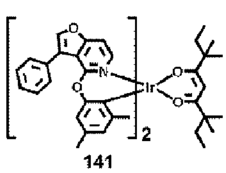
141

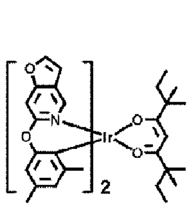
142
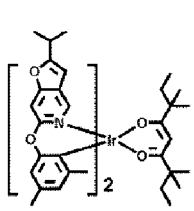
143
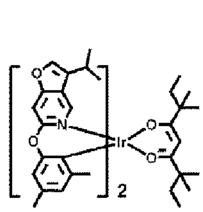
144
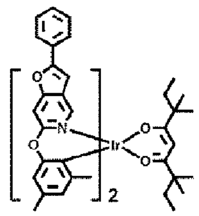
145
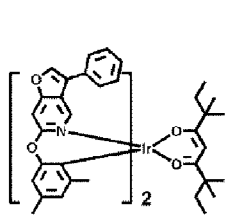
146

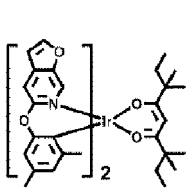
147
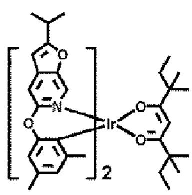
148
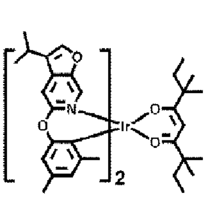
149
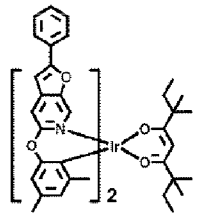
150
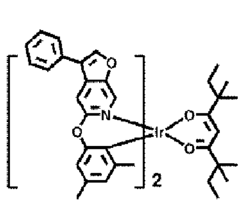
151

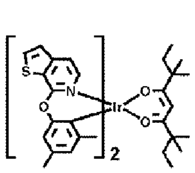
152
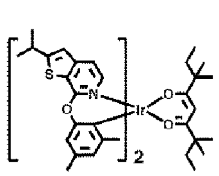
153
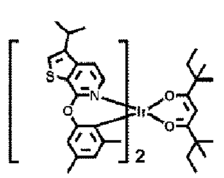
154
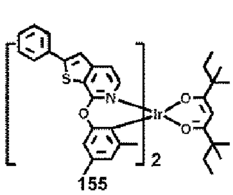
155
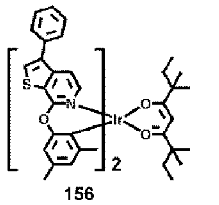
156

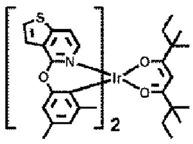
157
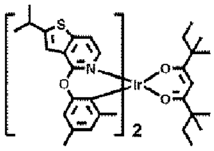
158
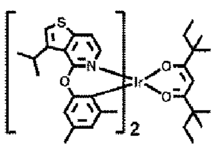
159
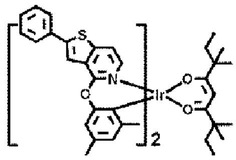
160
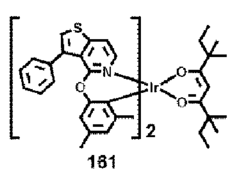
161

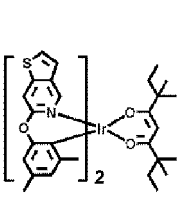
162
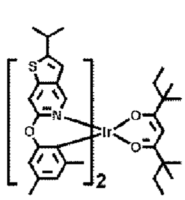
163
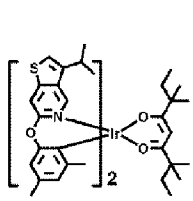
164
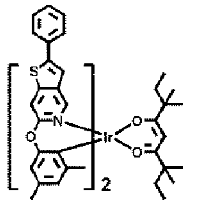
165
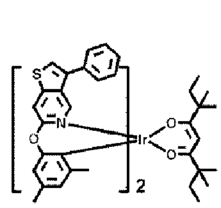
166

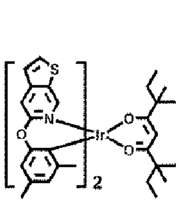
167
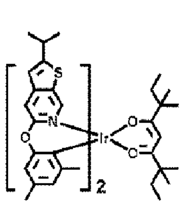
168
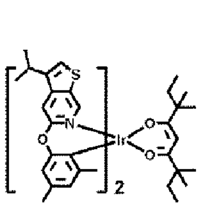
169
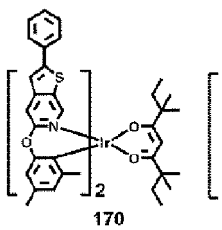
170
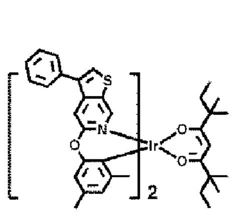
171

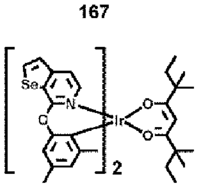
172
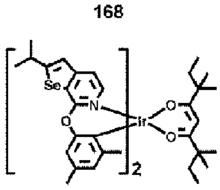
173
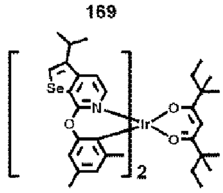
174
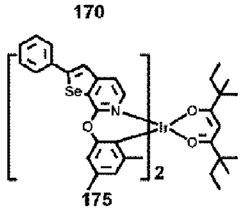
175
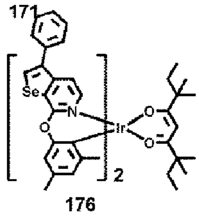
176

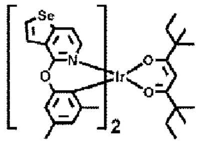
177

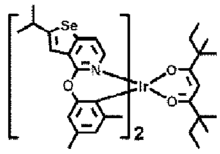
178

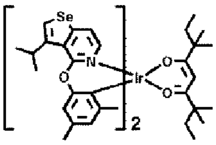
179

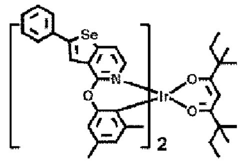
180

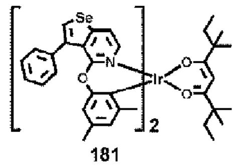
181

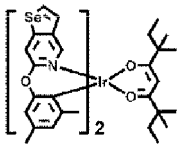
182

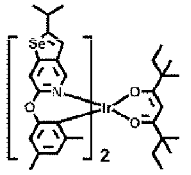
183

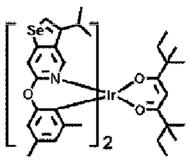
184

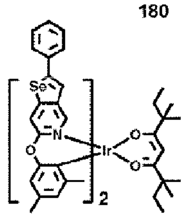
185

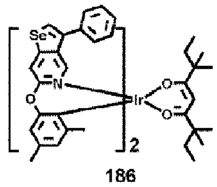
186

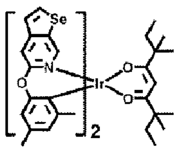
187

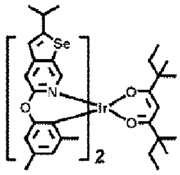
188

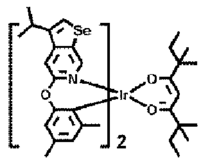
189

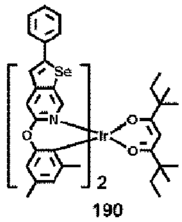
190

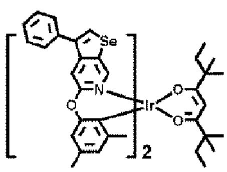
191

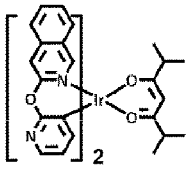
192

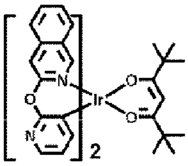
193

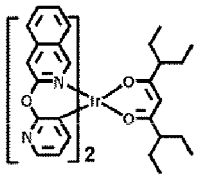
194

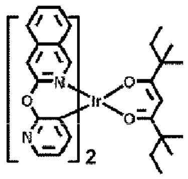
195

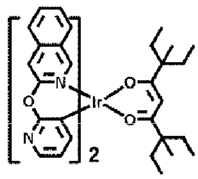
196

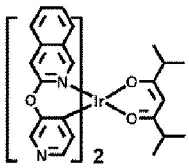
197

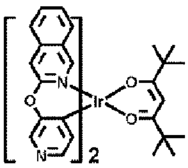
198

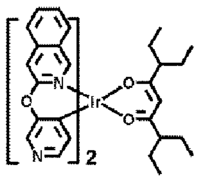
199

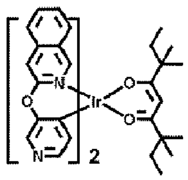
200

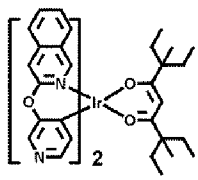
201

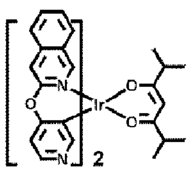
202

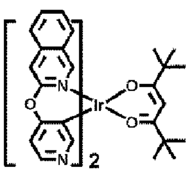
203

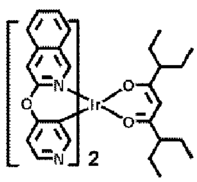
204

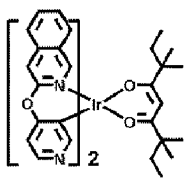
205

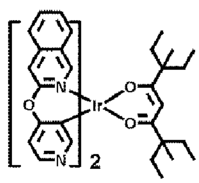
206

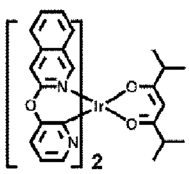
207

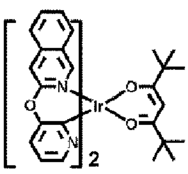
208

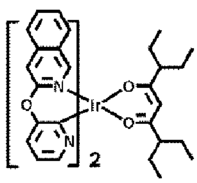
209

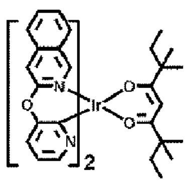
210

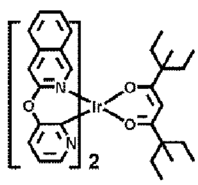
211

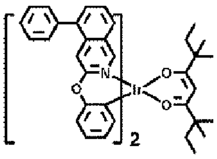
212
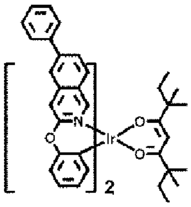
213
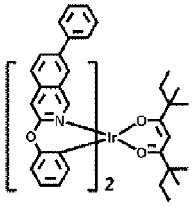
214
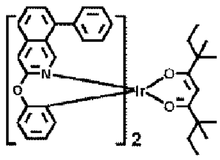
215
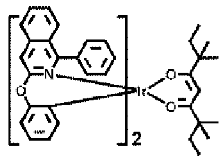
216

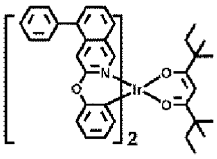
217
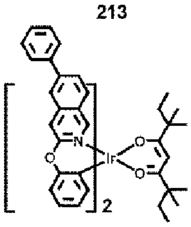
218
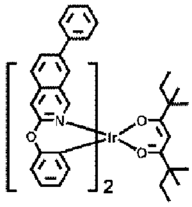
219
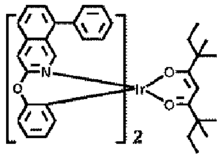
220
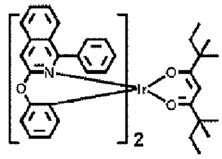
221

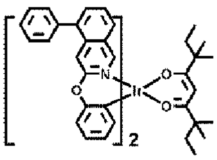
222
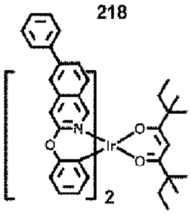
223
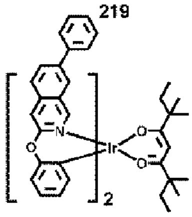
224
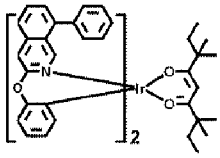
225
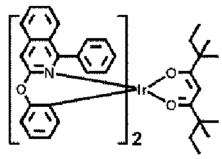
226

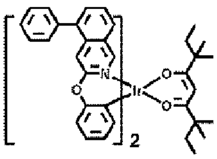
227
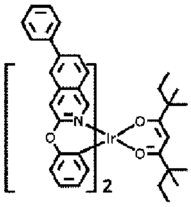
228
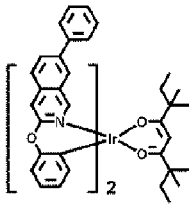
229
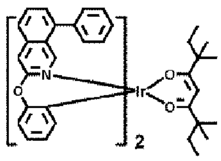
230
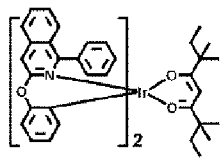
231

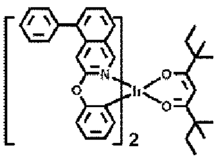
232
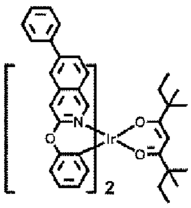
233
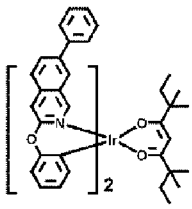
234
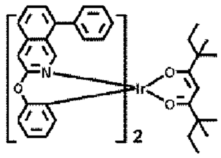
235
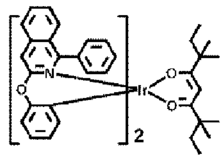
236

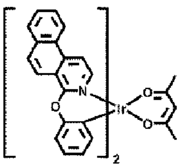
237
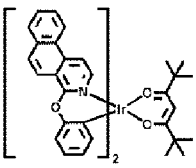
238
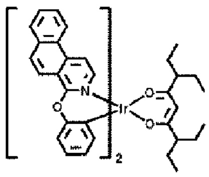
239
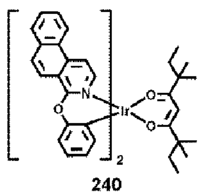
240
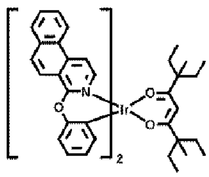
241

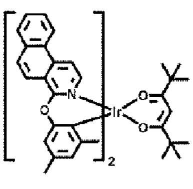
242
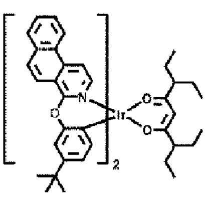
243
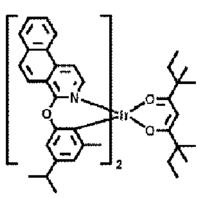
244
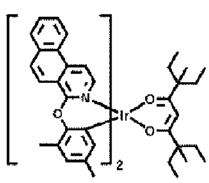
245
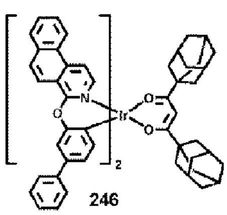
246

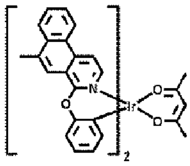
247
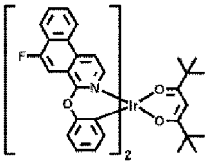
248
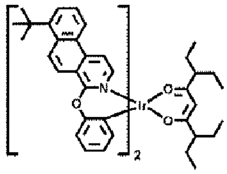
249
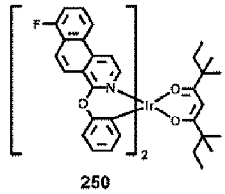
250
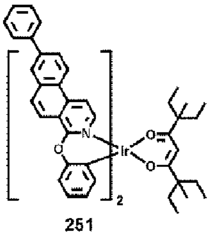
251

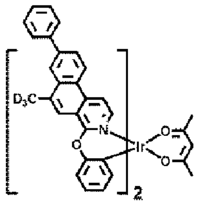
252
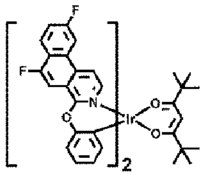
253
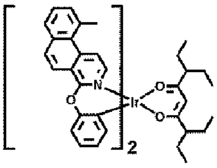
254
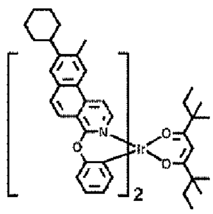
255
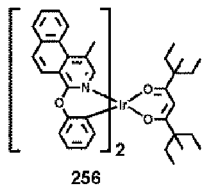
256

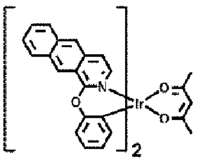
257
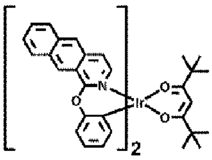
258
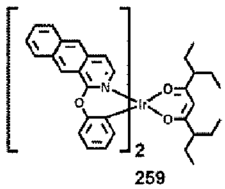
259
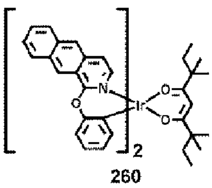
260
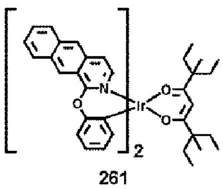
261

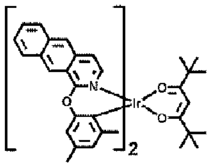
262
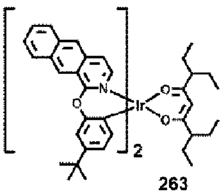
263
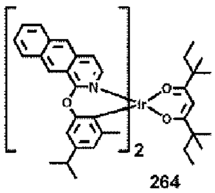
264
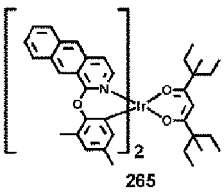
265
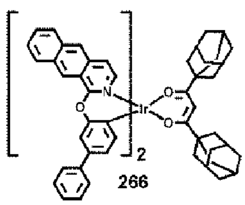
266

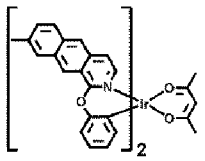
267
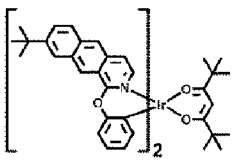
268
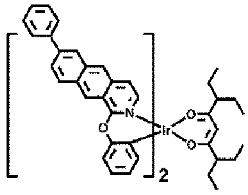
269
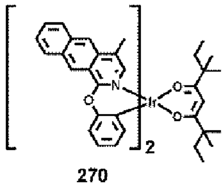
270
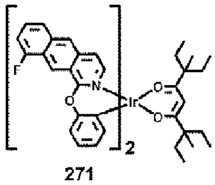
271

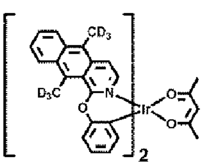
272
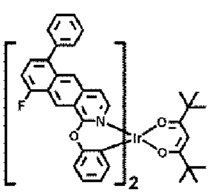
273
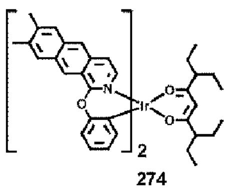
274
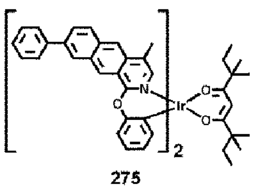
275
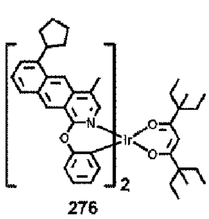
276

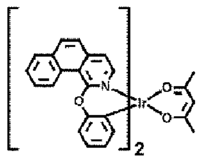
277
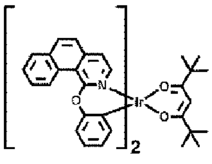
278
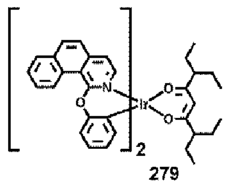
279
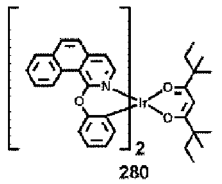
280
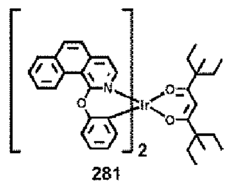
281

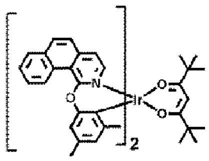
282
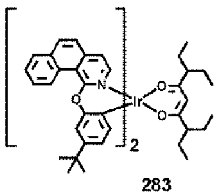
283
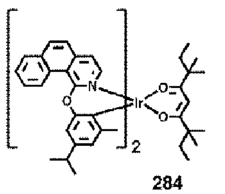
284
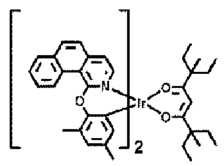
285
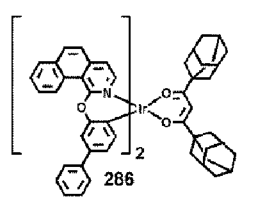
286

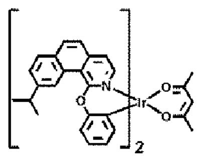
287
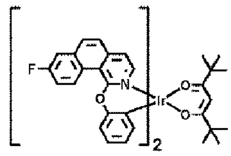
288
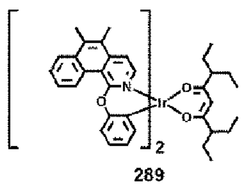
289
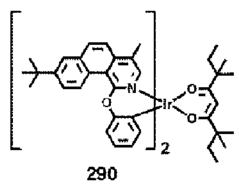
290
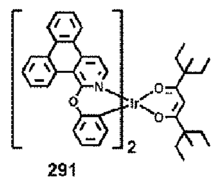
291

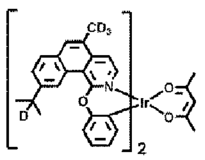
292
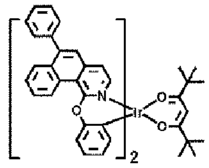
293
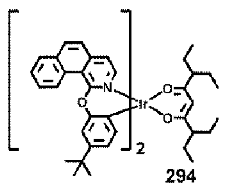
294
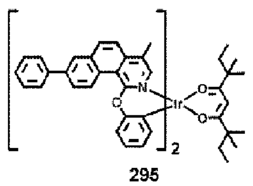
295
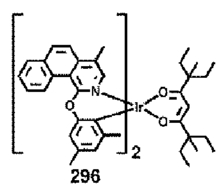
296

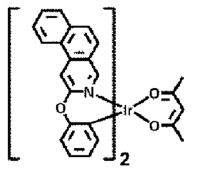
297
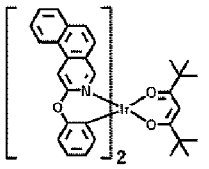
298
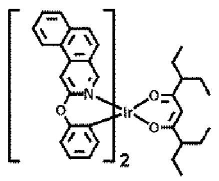
299
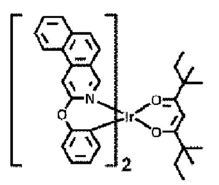
300
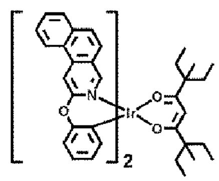
301

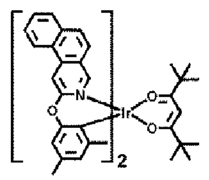
302
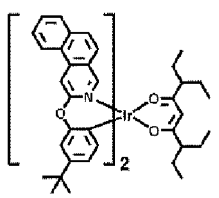
303
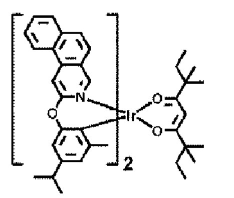
304
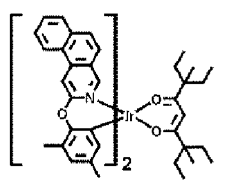
305
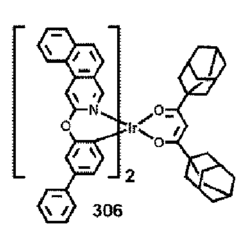
306

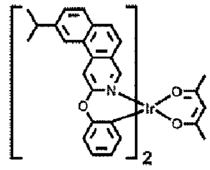
307
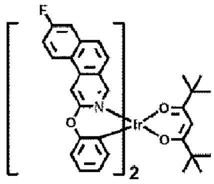
308
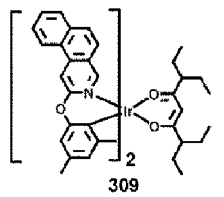
309
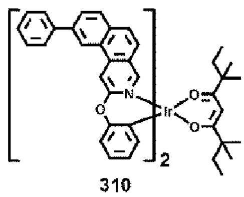
310
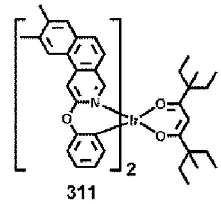
311

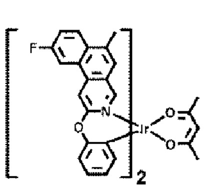
312

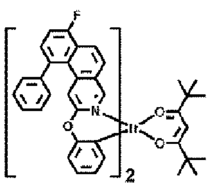
313

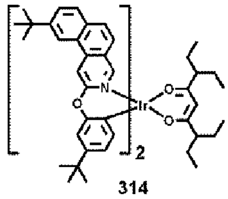
314

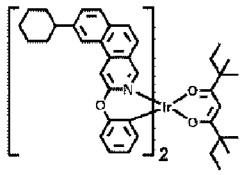
315

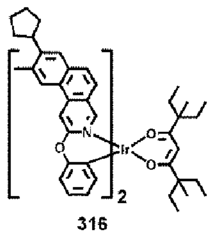
316

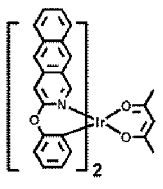
317

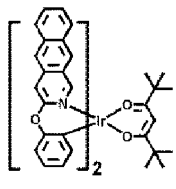
318

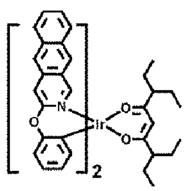
319

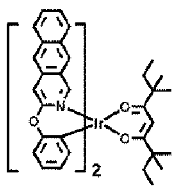
320

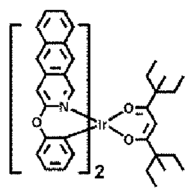
321

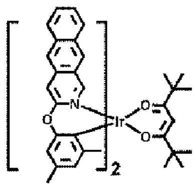
322

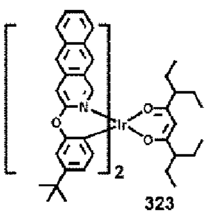
323

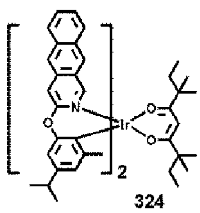
324

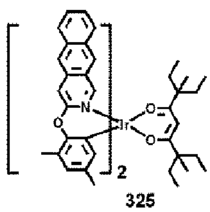
325

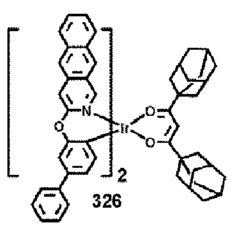
326

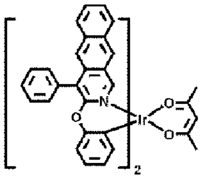
327

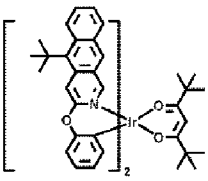
328

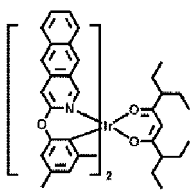
329

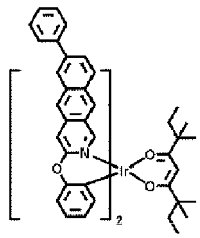
330

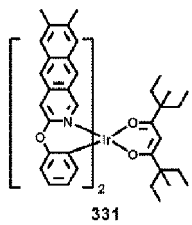
331

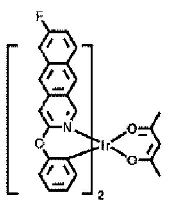
332

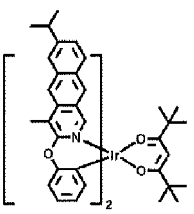
333

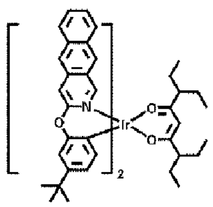
334

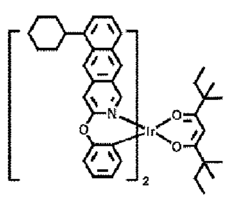
335

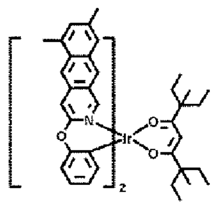
336

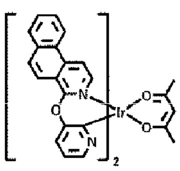
337

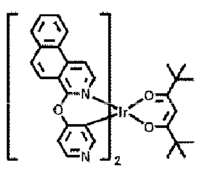
338

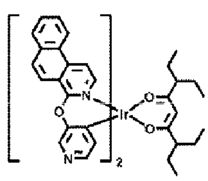
339

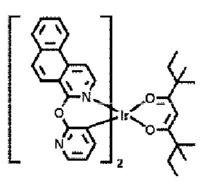
340

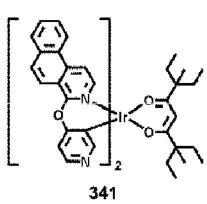
341

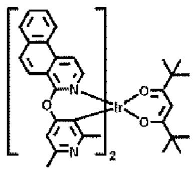
342
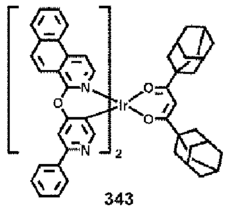
343
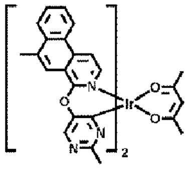
344
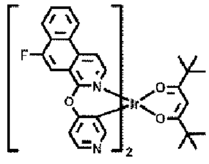
345
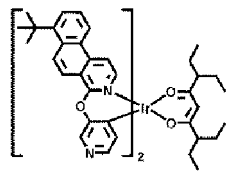
346

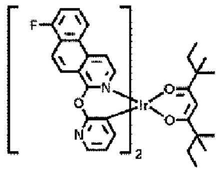
347
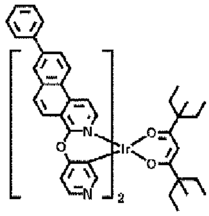
348
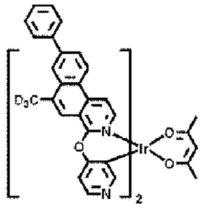
349
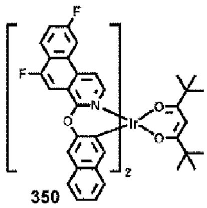
350
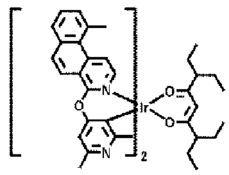
351

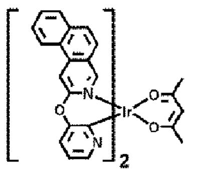
352
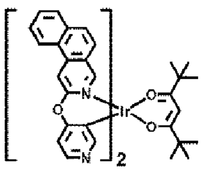
353
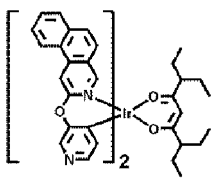
354
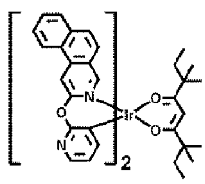
355
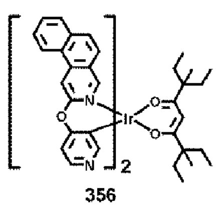
356

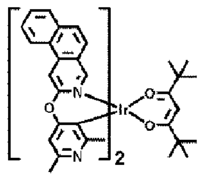
357
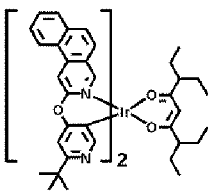
358
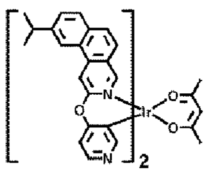
359
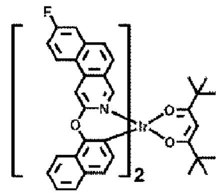
360
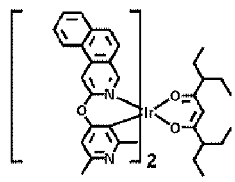
361

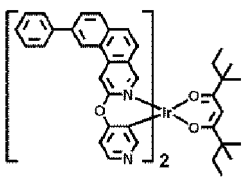
362
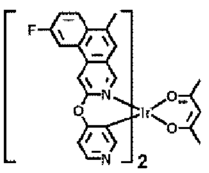
363
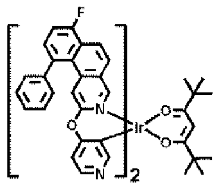
364
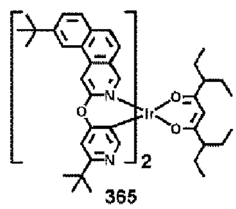
365
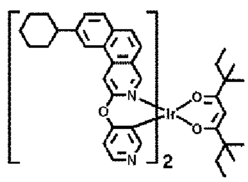
366

**13.** Dispositif électroluminescent organique comprenant :

une première électrode,
une seconde électrode, et
une couche organique disposée entre la première électrode et la seconde électrode et comprenant une couche d'émission,
ladite couche organique comprenant au moins un composé organométallique selon l'une quelconque des revendications 1 à 12 ;
de préférence
ladite première électrode étant une anode,
ladite seconde électrode étant une cathode,
ladite couche organique comprenant en outre une région de transport de trous disposée entre la première électrode et la couche d'émission et une région de transport d'électrons disposée entre la couche d'émission et la seconde électrode,
ladite région de transport de trous comprenant une couche d'injection de trous, une couche de transport de

trous, une couche de blocage d'électrons, une couche tampon, ou toute combinaison de celles-ci, et
ladite région de transport d'électrons comprenant une couche de blocage de trous, une couche de transport d'électrons, une couche d'injection d'électrons, ou toute combinaison de celles-ci.

**14.** Dispositif électroluminescent organique selon la revendication 13,

ladite couche d'émission comprenant le composé organométallique ;
de préférence
ladite couche d'émission comprenant en outre un hôte, et la quantité de l'hôte dans la couche d'émission étant plus grande que la quantité du composé organométallique dans la couche d'émission.

**15.** Composition de diagnostic comprenant au moins un composé organométallique selon l'une quelconque des revendications 1 à 12.

# FIGURE

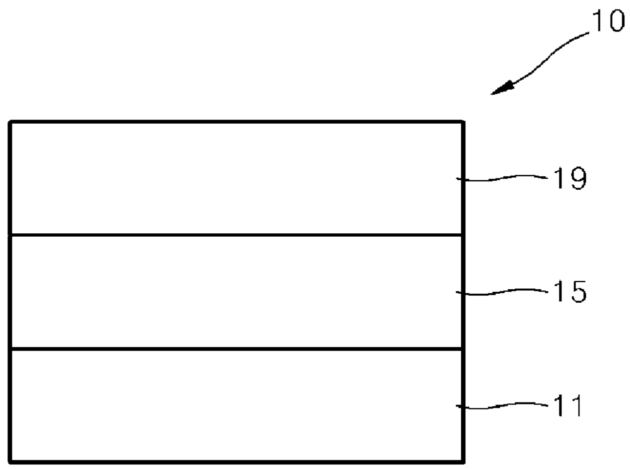

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- TW I421329
- CN 103012490